(19) **Europäisches Patentamt**
**European Patent Office**
**Office européen des brevets**

(11) **EP 4 575 610 A1**

(12) **EUROPEAN PATENT APPLICATION**
published in accordance with Art. 153(4) EPC

(43) Date of publication:
**25.06.2025 Bulletin 2025/26**

(21) Application number: **23862482.9**

(22) Date of filing: **07.09.2023**

(51) International Patent Classification (IPC):
***G02B 27/01*** (2006.01)   ***G02B 27/10*** (2006.01)

(52) Cooperative Patent Classification (CPC):
**G02B 1/11; G02B 6/00; G02B 6/10; G02B 6/12;**
**G02B 27/01; G02B 27/10; G02B 27/12; H05K 1/02**

(86) International application number:
**PCT/CN2023/117571**

(87) International publication number:
**WO 2024/051788 (14.03.2024 Gazette 2024/11)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **08.09.2022  CN 202211092291**
**30.12.2022  CN 202211731720**

(71) Applicant: **Huawei Technologies Co., Ltd.**
**Shenzhen, Guangdong 518129 (CN)**

(72) Inventors:
• **DING, Wuwen**
  **Shenzhen, Guangdong 518129 (CN)**
• **SUN, Peng**
  **Shenzhen, Guangdong 518129 (CN)**
• **ZHU, Lulu**
  **Shenzhen, Guangdong 518129 (CN)**

• **YANG, Jianhan**
  **Shenzhen, Guangdong 518129 (CN)**
• **ZHAO, Xiaoyu**
  **Shenzhen, Guangdong 518129 (CN)**
• **LIU, Qi**
  **Shenzhen, Guangdong 518129 (CN)**
• **DENG, Zhuoyong**
  **Shenzhen, Guangdong 518129 (CN)**
• **JIANG, Junnan**
  **Shenzhen, Guangdong 518129 (CN)**
• **LU, Yunkai**
  **Shenzhen, Guangdong 518129 (CN)**
• **GUO, Yanjun**
  **Shenzhen, Guangdong 518129 (CN)**

(74) Representative: **Maiwald GmbH**
**Engineering**
**Elisenhof**
**Elisenstrasse 3**
**80335 München (DE)**

(54) **OPTICAL WAVEGUIDE STRUCTURE AND MANUFACTURING METHOD THEREFOR, OPTICAL ASSEMBLY AND NEAR-TO-EYE DISPLAY DEVICE**

(57) This application provides a light combining unit, an optical component, an optical engine, an optical waveguide, a near-eye display device, and a method for fabricating an optical waveguide. Design of four prism units of the light combining unit makes an arrangement solution of a light emitting unit in the optical component more flexible, facilitating structural compactness of the near-eye display device and the optical engine. Specific structural design of the optical waveguide can improve diffraction efficiency of the optical waveguide, improve an image display effect, and resolve a ghost image problem, so that the near-eye display device has advantages such as lightweight. This application further provides a flexible optical waveguide. According to the method for fabricating an optical waveguide provided in this application, reliability of demolding in a fabrication process can be improved, structural stability of the optical waveguide can be improved, and an optical anti-reflection function can be improved.

1000

FIG. 1

## Description

This application claims priority to Chinese Patent Application No. 202211092291.2, filed with the China National Intellectual Property Administration on September 8, 2022 and entitled "AUGMENTED REALITY DEVICE AND DISPLAY METHOD THEREOF", and to Chinese Patent Application No. 202211731720.6, filed with the China National Intellectual Property Administration on December 30, 2022 and entitled "OPTICAL WAVEGUIDE STRUCTURE AND FABRICATION METHOD THEREOF, OPTICAL COMPONENT, AND NEAR-EYE DISPLAY DEVICE", both of which are incorporated herein by reference in their entireties.

## TECHNICAL FIELD

This application relates to the field of optical display technologies, and in particular, to an optical waveguide structure and a fabrication method thereof, an optical component, and a near-eye display device. The optical waveguide structure may be a grating structure, an out-coupling grating, an optical waveguide structure having a grating structure, or the like. The optical component may be an optical engine, a light combining unit, an optical component having an optical engine and a light combining unit, or the like.

## BACKGROUND

Near-eye display (near-eye display), also referred to as head-mounted display or wearable display, can be used to create a virtual image in a single-eye or dual-eye field of view. The near-eye display is a technology that uses a display device placed within a non-visible distance of human eyes to render light field information for the human eyes, thereby reconstructing a virtual scene in front of the human eyes.

Augmented reality (augmented reality, AR) is a new technology that "seamlessly" integrates real-world information and virtual-world information. It uses optics, computers, electronics, and the like to simulate and superimpose physical information (such as visual information, three-dimensional appearance, sound, taste, and tactile sense) that is difficult to experience in a particular time and space range of the real world. Both the real-world information and the virtual information are displayed simultaneously, with the two types of information complementing and augmenting each other. In visual augmented reality, a user combines a real world with a virtual image by using an optical display apparatus, to have an immersive visual experience of virtual-real combination.

The AR technology is applied to a near-eye display device, so that AR glasses are generated. The AR may implement many functions, and may be considered as a miniature mobile phone, and a status of the user can be determined by tracking a line-of-sight track of an eyeball, and a corresponding function may be enabled. A near-eye display technology product (for example, AR glasses) is developing toward a lighter, thinner, and more portable direction, and content rendered by the near-eye display device accordingly needs to be more comfortable, more authentic, and more smooth. Therefore, for the near-eye display device, an industry design development trend is: lightweight design, thin and small-sized design, improved optical display effect, and the like.

## SUMMARY

This application provides an optical waveguide structure and a fabrication method thereof, an optical component, and a near-eye display device. The optical waveguide structure may be a grating structure, an out-coupling grating, an optical waveguide structure having a grating structure, or the like. The optical component may be an optical engine, a light combining unit, an optical component having an optical engine and a light combining unit, or the like. In this way, the near-eye display device can be lightweight and thin, and have a small size, and an optical display effect can be improved.

According to a first aspect, a specific implementation of this application provides a light combining unit, used in an optical engine of a near-eye display device. The light combining unit includes a first prism unit, a second prism unit, a third prism unit, and a fourth prism unit, the first prism unit and the third prism unit are of a pentahedron structure, and the second prism unit and the fourth prism unit are of a tetrahedron structure. The first prism unit, the second prism unit, the third prism unit, and the fourth prism unit are assembled to form a hexahedron architecture, an interconnection position between the first prism unit and the second prism unit is a first surface, an interconnection position between the third prism unit and the fourth prism unit is a second surface, an interconnection position between the first prism unit and the fourth prism unit is a third surface, and an interconnection position between the second prism unit and the third prism unit is a fourth surface. A first optical splitting film is disposed on the first surface and the second surface, a second optical splitting film is disposed on the third surface and the fourth surface, and wavelength ranges of light rays reflected by the first optical splitting film and the second optical splitting film are different. The first surface and the second surface form a first diagonal plane of the hexahedron architecture, the third surface and the fourth surface form a second diagonal plane of the hexahedron structure, and an intersection line between the first diagonal plane and the second diagonal plane is a body diagonal of the hexahedron structure.

In this application, the first prism unit and the third prism unit in four prism units of the light combining unit are designed as pentahedron structures, and the second prism unit and the fourth prism unit in the four prism units are designed as tetrahedron structures. The four prism units can be assembled to form the hexahedron architecture. An optical splitting film is disposed on the first diagonal plane and the second diagonal plane, and the intersection line between the first diagonal plane and the second diagonal plane is the body diagonal of the hexahedron structure, so that the light combining unit can more flexibly match a light emitting unit, that is, there are a larger quantity of more flexible placement solutions for display screens of light emitting units. A proper placement solution may be used according to a specific use environment requirement. This facilitates structural compactness of the optical engine of the near-eye display device, and in particular, a flexible circuit board in the optical engine can be arranged extending along a mechanical part of the near-eye display device without bending, thereby saving space.

In a possible implementation, the first prism unit, the second prism unit, the third prism unit, and the fourth prism unit are all of integrated prism structures. This implementation provides the light combining unit including four prisms, which has advantages of a simple structure and flexibility of configuration with the light emitting unit.

In a possible implementation, the first optical splitting film is configured to reflect light in a first wavelength range and transmit light in a second wavelength range and light in a third wavelength range, and the second optical splitting film is configured to reflect light in the second wavelength range and transmit light in the first wavelength range and light in the third wavelength range. This solution defines a configuration solution of an optical splitting film in the light combining unit including four prisms. Configuration of the optical splitting film affects configuration of the light emitting unit, so that an optical engine obtained by combining the light combining unit and the light emitting unit can have advantages of a compact structure and space saving.

In a possible implementation, the first optical splitting film is configured to reflect light in a second wavelength range and transmit light in a first wavelength range and light in a third wavelength range, and the second optical splitting film is configured to reflect light in the first wavelength range and transmit light in the second wavelength range and light in the third wavelength range. This solution defines a configuration solution of an optical splitting film in the light combining unit including four prisms. Configuration of the optical splitting film affects configuration of the light emitting unit, so that an optical engine obtained by combining the light combining unit and the light emitting unit can have advantages of a compact structure and space saving.

In a possible implementation, the first prism unit includes a first sub-prism and a second sub-prism, and an interconnection position between the first sub-prism and the second sub-prism is a first sub-surface. The second prism unit includes a third sub-prism and a fourth sub-prism, and an interconnection position between the third sub-prism and the fourth sub-prism is a second sub-surface. The third prism unit includes a fifth sub-prism and a sixth sub-prism, and an interconnection position between the fifth sub-prism and the sixth sub-prism is a third sub-surface. The fourth prism unit includes a seventh sub-prism and an eighth sub-prism, and an interconnection position between the seventh sub-prism and the eighth sub-prism is a fourth sub-surface. The first sub-surface, the second sub-surface, the third sub-surface, and the fourth sub-surface form a third diagonal plane of the hexahedron structure, an intersection line between the third diagonal plane and the first diagonal plane is a body diagonal of the hexahedron structure, and a length of an intersection line between the third diagonal plane and the second diagonal plane is equal to an edge length of the hexahedron structure. This implementation provides the light combining unit including eight prisms. Compared with the four-prism architecture, this solution is a more flexible solution for matching with the light emitting unit. This solution can achieve configuration of more light emitting units, so that more application solutions of the optical engine are provided. A proper configuration solution of the light emitting unit may be selected according to a specific design requirement, providing better flexibility.

In a possible implementation, both the first sub-prism and the second sub-prism are pentahedron prisms. One of the third sub-prism and the fourth sub-prism is a tetrahedron prism, and the other is a pentahedron prism. Both the fifth sub-prism and the sixth sub-prism are pentahedron prisms. One of the seventh sub-prism and the eighth sub-prism is a tetrahedron prism, and the other is a pentahedron prism. This solution defines a specific form of each prism in the light combining unit including eight prisms. In this application, prisms of different forms are disposed, so that the light combining unit has an advantage of flexible arrangement of the light emitting unit.

In a possible implementation, a third optical splitting film is disposed on the third diagonal plane, and the third optical splitting film, the first optical splitting film, and the second optical splitting film are respectively configured to reflect light rays in different wavelength ranges. This solution defines a solution for disposing an optical splitting film in the light combining unit including eight prisms. Three optical splitting films are disposed, and the three optical splitting films are respectively configured to reflect light rays in different wavelength ranges, so that the light combining unit has an advantage of flexible arrangement of the light emitting unit.

In a possible implementation, the second optical splitting film and the third optical splitting film each include four sub-films, and the first optical splitting film is of an integrated structure. This solution defines specific structures of the second optical splitting film and the third optical splitting film, and a solution in which the first optical splitting film is of an integrated structure. The optical splitting film designed in this solution is used in the light combining unit including eight prisms. Because the first optical splitting film may be of an integrated structure, the first optical splitting film has advantages of a simple structure and convenient assembly.

In a possible implementation, the second optical splitting film includes two sub-films, and the first optical splitting film is of an integrated structure. The optical splitting film designed in this solution is used in the light combining unit including four prisms. Because the first optical splitting film may be of an integrated structure, the first optical splitting film has advantages of a simple structure and convenient assembly.

In a possible implementation, the first optical splitting film is a green-reflective and red-blue-transmissible film layer, the second optical splitting film is a blue-reflective and red-green-transmissible film layer, and the third optical splitting film is a red-reflective and blue-green-transmissible film layer. This solution specifically defines a specific configuration solution of three optical splitting films.

In a possible implementation, the hexahedron structure is a cube. Due to design of the cube structure, optical distances of light sources (to be specific, a first wavelength range emitting unit, a second wavelength range emitting unit, and a third wavelength range emitting unit) of different colors in the light emitting unit from a light incident surface to a light exit surface can keep consistent, that is, transmission paths of a red light ray emitted by the first wavelength range emitting unit, a blue light ray emitted by the second wavelength range emitting unit, and a green light ray emitted by the third wavelength range emitting unit in the light combining unit have a same length, and the transmission path of light is an optical distance. A same optical distance helps ensure definition of imaging of the optical engine. If an optical distance of light of a particular color is inconsistent with that of light of another color, an image projected by the optical engine is not clear enough, and the image is blurry.

According to a second aspect, a specific embodiment of this application provides an optical engine, including a light emitting unit, an optical imaging unit, and the light combining unit provided in any one of the possible implementations of the first aspect. The light combining unit is configured to combine monochromatic light emitted by the light emitting unit, and the optical imaging unit is located on a light exit side of the light combining unit. The optical engine provided in this application includes the light combining unit according to the first aspect, so that the optical engine has a more flexible configuration solution, and the optical engine can be configured in more environments in a near-eye display device. A structure of the optical engine can be more compact, which helps save space.

In a possible implementation, the light emitting unit includes a first wavelength range emitting unit, a second wavelength range emitting unit, and a third wavelength range emitting unit. The first wavelength range emitting unit exactly faces a first light incident surface of the hexahedron structure of the light combining unit, the second wavelength range emitting unit exactly faces a second light incident surface of the hexahedron structure of the light combining unit, and the third wavelength range emitting unit exactly faces a third light incident surface of the hexahedron structure of the light combining unit. The first light incident surface, the second light incident surface, and the third light incident surface are disposed perpendicular and adjacent to each other, both a normal direction of a light-emitting surface of the first wavelength range emitting unit and a normal direction of a light-emitting surface of the second wavelength range emitting unit are perpendicular to an optical axis of the optical imaging unit of the optical engine, and a normal direction of a light-emitting surface of the third wavelength range emitting unit is the same as an optical axis direction of the optical imaging unit of the optical engine. This solution provides a specific solution for disposing light incident surfaces of the light emitting unit and the light combining unit.

In a possible implementation, the light emitting unit includes a first wavelength range emitting unit, a second wavelength range emitting unit, and a third wavelength range emitting unit. A light-emitting surface of the first wavelength range emitting unit exactly faces a first light incident surface of the hexahedron structure of the light combining unit, a light-emitting surface of the second wavelength range emitting unit exactly faces a second light incident surface of the hexahedron structure of the light combining unit, and a light-emitting surface of the third wavelength range emitting unit exactly faces a third light incident surface of the hexahedron structure of the light combining unit. The first light incident surface and the second light incident surface are parallel to each other, the third light incident surface is perpendicular to the first light incident surface, and a normal direction of the light-emitting surface of the first wavelength range emitting unit, a normal direction of the light-emitting surface of the third wavelength range emitting unit, and a normal direction of the light-emitting surface of the second wavelength range emitting unit are all perpendicular to an optical axis of the optical imaging unit of the optical engine. This solution provides another specific solution for disposing light incident surfaces of the light emitting unit and the light combining unit.

In a possible implementation, an area of a light incident surface of the light combining unit is greater than an area of a light-emitting surface of a corresponding light emitting unit. In this way, it can be ensured that more light rays emitted by the light combining unit enter the optical imaging unit, thereby improving light ray transmission efficiency.

According to a third aspect, a specific embodiment of this application provides a near-eye display device, including a mechanical part and lenses. The mechanical part includes a temple and a frame, the temple is connected to the frame, the lens has an optical waveguide, the lens is fastened on the frame, the near-eye display device includes the optical engine provided in any one of the possible implementations of the second aspect, and the optical engine is fastened to the mechanical part. This solution provides the near-eye display device. Because the near-eye display device includes the optical engine according to the second aspect, there are more design solutions for the near-eye display device, and position arrangement of the optical engine is flexible. In addition, a structure of the optical engine can be more compact, which helps save space, and contributes to miniaturization of the near-eye display device.

In a possible implementation, the near-eye display device is provided with a controller, the light emitting unit includes a first flexible circuit board, a second flexible circuit board, and a third flexible circuit board, the first flexible circuit board is electrically connected between the first wavelength range emitting unit and the controller, the second flexible circuit board is electrically connected between the second wavelength range emitting unit and the controller, the third flexible circuit board is electrically connected between the third wavelength range emitting unit and the controller, and at least one of the first flexible circuit board, the second flexible circuit board, and the third flexible circuit board extends along the mechanical part without bending. In the near-eye display device provided in this solution, at least one of the flexible circuit boards of the optical engine does not need to be folded, that is, extends along the mechanical part without bending, which helps reduce a size of the entire machine. It may be understood that, if the flexible circuit board is folded, an overall size of the optical engine becomes larger due to folding of the flexible circuit board, and larger space is occupied in the near-eye display device.

In a possible implementation, the optical engine is fastened to the temple, at least one of the first flexible circuit board, the second flexible circuit board, and the third flexible circuit board extends along the temple without bending, an outer surface of the hexahedron structure of the light combining unit is a non-light-incident surface, the non-light-incident surface is adjacent to a light exit surface of the light combining unit, the non-light-incident surface faces an inner side of the temple, and the inner side of the temple is configured to be close to a human face. Such arrangement can further ensure that no light emitting unit is disposed on a side that is of the near-eye display device and that is close to the face, thereby reducing a risk of sensing heat by a user and improving user experience.

According to a fourth aspect, an optical component provided in this application includes an optical engine and an optical waveguide. The optical waveguide includes a waveguide substrate and an in-coupling grating, the waveguide substrate includes an oblique surface, the oblique surface is located at a position at which the in-coupling grating and the waveguide substrate are combined, or is located at a light incident side of a position at which the in-coupling grating and the waveguide substrate are combined, the in-coupling grating is configured to receive light of the optical engine, the oblique surface faces the optical engine, the optical engine has an optical axis, a direction perpendicular to the optical axis is a first direction, and an included angle between the oblique surface and the first direction is greater than or equal to a half of a field of view of the optical engine, so that an edge light ray of the field of view of the optical engine that is reflected by the in-coupling grating is capable of being deflected out of the optical engine. According to the optical component provided in this application, due to structural design of the optical waveguide, to be specific, due to design of a light incident position of the optical waveguide, a light ray reflected at a position of the in-coupling grating is deflected out of the optical engine, that is, a direction of the light ray reflected at the position of the in-coupling grating is outside an optical effective region of the optical engine, and does not return to the optical engine. In this way, the optical component can obtain high image display efficiency, and a ghost image problem is resolved. Specifically, the oblique surface is disposed on the waveguide substrate, and the included angle between the oblique surface and the first direction is greater than or equal to a half of the field of view of the optical engine, so that the edge light ray of the field of view of the optical engine that is reflected by the in-coupling grating is capable of being deflected from the optical engine.

In a possible implementation, the field of view of the optical engine is a horizontal field of view or a vertical field of view. This application defines that the field of view of the optical engine may be a horizontal field of view, or may be a vertical field of view. During calculation of an angle of the oblique surface, any field of view may be used to obtain a proper angle. This reflects flexibility of design of this solution.

In a possible implementation, the optical axis of the optical engine is a central axis of an optical effective region of the optical engine. It may be understood that the optical engine provided in this solution is a non-off-axis optical axis system, and the central axis of the optical effective region is the optical axis, which provides convenience for design of the optical engine.

In a possible implementation, the waveguide substrate is of an integrally formed structure, and the oblique surface is a structure formed by removing a part of material from the waveguide substrate. This solution defines a specific forming manner of the oblique surface. A part of material is removed from the waveguide substrate to form the oblique surface, to help ensure stability of a refractive index at a position of the oblique surface. That is, in a process of forming the oblique surface, it is not easy to change a refractive index of the waveguide substrate, thereby ensuring diffraction efficiency of the in-coupling grating, ensuring that a coupled-in light ray does not generate unnecessary deflection, and ensuring authenticity of a formed virtual image without distortion.

In a possible implementation, the in-coupling grating is formed on the oblique surface, an included angle between a light ray reflected by the in-coupling grating and the optical axis is a second angle, an included angle between an edge light ray of the field of view of the optical engine that is incident on the in-coupling grating and the optical axis is a first angle, and the second angle is greater than the first angle. This solution defines a solution of obtaining the oblique surface by removing a material, and defines a specific solution in which the in-coupling grating is located on the oblique surface. In this solution, the oblique surface and the in-coupling grating are disposed, so that an inclined state is formed between an angle at which the in-coupling grating is disposed and a main flat surface of the waveguide substrate. In this way, a part of light rays that are incident on the in-coupling grating are reflected, and the reflected light ray is directly deflected out of the optical engine. The optical component provided in this implementation does not have a ghost image phenomenon formed when a reflected light ray of an out-coupling grating enters the optical engine and then is reflected again.

In a possible implementation, the waveguide substrate includes a main flat surface, the oblique surface is inclined relative to the main flat surface, the in-coupling grating is formed on the main flat surface, in an extension direction of the optical axis, the oblique surface is located between the in-coupling grating and the optical engine, an edge light ray of the field of view of the optical engine is incident on the in-coupling grating through the oblique surface, and the edge light ray of the field of view of the optical engine that is reflected by the in-coupling grating is deflected out of the optical engine through the oblique surface. This solution defines a solution of obtaining the oblique surface by removing a material, and defines a solution in which the in-coupling grating is located on the main flat surface of the waveguide substrate. Because the oblique surface is disposed in an oblique manner relative to the main flat surface on which the in-coupling grating is located, a light ray that enters the optical waveguide from the oblique surface and then is projected onto the in-coupling grating is refracted at the position of the oblique surface. In this way, it can be ensured that an in-coupling grating reflected light ray reflected at the position of the in-coupling grating is deflected out of the optical engine. Therefore, the optical component provided in this implementation does not have a ghost image phenomenon formed when a reflected light ray of the out-coupling grating enters the optical engine and then is reflected again.

In this application, the in-coupling grating is formed on the main flat surface of the waveguide substrate. Because the main flat surface is an overall planar outer surface of the waveguide substrate, a fabrication process of the in-coupling grating has an advantage of easy fabrication, and there are advantages in both design and process steps. In an implementation of fabricating the in-coupling grating on the oblique surface, although a fabrication process is challenging, an optical path between the in-coupling grating and the optical engine is simpler, and it is easy to control optical transmission efficiency.

In a possible implementation, the waveguide substrate includes a waveguide body structure and an additional structure, the additional structure is fastened to a surface that is of the waveguide body structure and that faces the optical engine, the oblique surface is formed on the additional structure, and the oblique surface is located on a surface that is of the additional structure and that is away from the waveguide body structure. In this solution, the additional structure is added on the waveguide substrate, and the oblique surface is formed by using the additional structure. This solution has an advantage of protecting structural integrity of the waveguide substrate. The structural integrity of the waveguide substrate helps ensure life of the waveguide substrate. A waveguide substrate with no partial structure cut off has better strength and stability. An optical waveguide with good structure stability has stable optical transmission efficiency. This solution helps ensure life of the optical waveguide and optical transmission efficiency.

In a possible implementation, the in-coupling grating is formed on the oblique surface, a light ray that is incident from the in-coupling grating enters the waveguide body structure after passing through the additional structure, an included angle between a light ray reflected by the in-coupling grating and the optical axis is a second angle, an included angle between an edge light ray of the field of view of the optical engine that is incident on the in-coupling grating and the optical axis is a first angle, and the second angle is greater than the first angle. This solution defines a solution of a specific position of the in-coupling grating in a solution in which the additional structure and the waveguide substrate are combined. In this solution, the in-coupling grating is disposed on the oblique surface. In this way, an optical path of incident light of the in-coupling grating is simple, and it is easy to control energy of the incident light, helping improve light efficiency.

In a possible implementation, the waveguide body structure includes a main flat surface, the oblique surface is inclined relative to the main flat surface, the in-coupling grating is formed on the main flat surface, in an extension direction of the optical axis, the oblique surface is located between the in-coupling grating and the optical engine, an edge light ray of the field of view of the optical engine enters the additional structure and the waveguide body structure through the oblique surface and is incident on the in-coupling grating, and the edge light ray of the field of view of the optical engine that is reflected by the in-coupling grating passes through the waveguide body structure and the additional structure, is emitted from the oblique surface, and is deflected out of the optical engine. This solution defines a solution of a specific position of the in-coupling grating in the solution in which the additional structure and the waveguide substrate are combined. In this solution, the in-coupling grating is disposed on the main flat surface of the waveguide substrate. Because the main flat surface is an overall planar outer surface of the waveguide substrate, the fabrication process of the in-coupling grating has an advantage of easy fabrication, and there are advantages in both design and process steps.

In a possible implementation, a material of the additional structure is the same as a material of the waveguide body structure. In this solution, the materials are restricted to be the same, to obtain the additional structure whose refractive index is the same as or close to that of the waveguide body structure, thereby ensuring consistency of transmission that is of a light ray incident to the waveguide substrate and that is in the additional structure and the waveguide body structure. This avoids that diffraction efficiency is affected by light ray refraction or a required angle of incident light cannot be obtained due to different refractive indexes. Therefore, in this application, a refractive index and a material of the additional structure are restricted to be the same as those of the waveguide substrate, to ensure optical performance of the optical waveguide.

In a possible implementation, a refractive index of the additional structure is the same as a refractive index of the waveguide body structure. Specifically, the additional structure may be made of a high-refractive substrate material. The refractive index of the additional structure is restricted to be the same as or close to the refractive index of the waveguide body structure, to ensure consistency of transmission that is of a light ray incident to the waveguide substrate and that is in the additional structure and the waveguide body structure. This avoids that diffraction efficiency is affected by light ray refraction or a required angle of incident light cannot be obtained due to different refractive indexes.

As defined in this application, the refractive indexes being the same may be understood as being completely the same, or having a relatively small tolerance, or may be understood as being approximately the same, provided that an angle of incident light is within a design requirement range.

In a possible implementation, the additional structure and the waveguide body structure are bonded by using an optical adhesive, and a refractive index of the optical adhesive is the same as refractive indexes of the additional structure and the waveguide body structure. This solution defines a specific manner of connection between the additional structure and the waveguide body structure, and restricts the refractive index of the optical adhesive, so that refractive indexes of the waveguide substrate of the optical waveguide are consistent. This avoids that diffraction efficiency is affected by light ray refraction or a required angle of incident light cannot be obtained due to different refractive indexes.

In a possible implementation, the oblique surface on the additional structure is polished, to improve transmittance of light.

In a possible implementation, the additional structure and the waveguide body structure are combined in an intermolecular bonding manner. This solution defines a specific manner of connection between the additional structure and the waveguide body structure. The additional structure and the waveguide body structure are combined in the intermolecular bonding manner, to avoid using another medium, such as an optical adhesive, for connection. Combination between the additional structure and the waveguide body structure obtained in this solution is more direct, which helps ensure consistency of refractive indexes of the optical waveguide substrate. This avoids that diffraction efficiency is affected by light ray refraction or a required angle of incident light cannot be obtained due to different refractive indexes.

According to a fifth aspect, this application provides a near-eye display device, including a mechanical part and the optical component provided in any one of the possible implementations of the fourth aspect. The optical component is mounted on the mechanical part. According to the near-eye display device provided in this solution, a ghost image problem is resolved due to design of the optical component, and an advantageous image display effect is obtained.

The optical engine in the optical component provided in the fourth aspect of this application may also include the light combining unit provided in any one of the possible implementations of the first aspect of this application.

The optical engine in the optical component provided in the fourth aspect of this application is also the optical engine provided in any one of the possible implementations of the second aspect of this application.

The near-eye display device provided in the fifth aspect of this application may include the light combining unit provided in any one of the possible implementations of the first aspect of this application, and/or the optical engine provided in any one of the possible implementations of the second aspect of this application.

The near-eye display device provided in the third aspect of this application may include the optical component provided in any one of the possible implementations of the fourth aspect of this application.

According to a sixth aspect, this application provides an optical waveguide, to resolve a problem of waste of light rays and uneven light rays. The optical waveguide includes an in-coupling grating and an out-coupling grating, where the in-coupling grating is configured to couple a light ray into the optical waveguide and perform total internal reflection in the optical waveguide, the out-coupling grating is configured to couple a light ray out, the out-coupling grating includes a first region and a second region, the first region is located on a light incident side of the second region along a first direction, the first region includes a first sub-region and a second sub-region, the first sub-region and the second sub-region are arranged along a second direction, the second direction intersects with the first direction, types of gratings in both the first sub-region and the second sub-region are one-dimensional gratings, the second region is used to couple a light ray out, grating types of at least some gratings in the second region are two-dimensional gratings, a central axis of the second region extends and passes through the in-coupling grating, and the first sub-region and the second sub-region are distributed on two sides of the central axis. In this application, the one-dimensional gratings in the first region make most energy of light rays be transmitted to the second region, so that light propagation efficiency can be improved, light uniformity can be improved, fabrication difficulty can be reduced, and costs can be reduced.

In a possible implementation, both the first sub-region and the second sub-region are in contact with the second region. It may also be understood that there is no gap between the first sub-region and second sub-region and the second region. The second region is continuously fabricated, so that gratings of the second region have continuity, and light ray out-coupling efficiency can be improved.

In a possible implementation, a first spacing region is formed between the first sub-region and the second region, a second spacing region is formed between the second sub-region and the second region, and there is no grating structure in either the first spacing region or the second spacing region. This solution helps ensure that a fabricating yield and efficiency are improved in a process of fabricating the out-coupling grating.

In a possible implementation, a size of the first spacing region extending along the first direction is less than or equal to 4 millimeters, and a size of the second spacing region extending along the first direction is less than or equal to 4 millimeters. This solution defines the sizes of the first spacing region and the second spacing region in the first direction, to help ensure light ray utilization and intensity of a coupled-out light ray.

In a possible implementation, a center of the in-coupling grating is located on the central axis of the second region. This solution defines a relationship between the central axis of the second region and the in-coupling grating, that is, a connection line between a center of the second region and the center of the in-coupling grating may be considered as the central axis.

In a possible implementation, the first sub-region and the second sub-region are mirror-symmetrically distributed by using the central axis as a center. This solution restricts a relationship between the first sub-region and second sub-region and the central axis, and uses mirror-symmetric design, so that energy of light in the second region of the out-coupling grating is more balanced.

In a possible implementation, the first sub-region and the second sub-region have different areas. In this solution, specific sizes and forms of the first sub-region and the second sub-region may be adjusted according to a specific requirement, so that the optical waveguide has a wider application scenario.

In a possible implementation, a direction of a connection line between a center of the first sub-region and a center of the second sub-region is the second direction, and an included angle between the second direction and the central axis is less than 90 degrees. In this implementation, a position of the in-coupling grating is adjusted, so that specific structural forms of the first sub-region and the second sub-region in the first region change. However, the first sub-region and the second sub-region can still restrict a light beam propagation direction and improve light propagation efficiency.

In a possible implementation, a gate line extension direction of a one-dimensional grating in the first sub-region is a first gate line direction, a gate line extension direction of a one-dimensional grating in the second sub-region is a second gate line direction, a two-dimensional grating in the second region includes a first gate line and a second gate line arranged to intersect each other, an extension direction of the first gate line is the first gate line direction, and an extension direction of the second gate line is a second gate line direction. In this application, the extension direction of the first gate line is approximately the same as the first gate line direction, and the extension direction of the second gate line is approximately the same as the second gate line direction, so that image information transmitted by the optical waveguide is authentic, without image distortion, thereby ensuring an image display effect.

In a possible implementation, a distribution period of the one-dimensional grating in the first sub-region is the same as a distribution period of the first gate line; and/or a distribution period of the one-dimensional grating in the second sub-region is the same as a distribution period of the second gate line. In this solution, the period of the one-dimensional grating in the first sub-region is restricted to be the same as the period of the first gate line in the second region, and the period of the one-dimensional grating in the second sub-region is restricted to be the same as the period of the second gate line in the second region, to ensure that a coupled-out image is distortionless and adverse phenomena such as distortion of the image are not caused, and to ensure an image display effect.

In a possible implementation, an included angle between the first gate line direction and the second gate line direction is 60 degrees. In this solution, the included angle between the first gate line direction and the second gate line direction is 60 degrees, to restrict a light ray propagation direction, so that the light ray propagation direction matches a gate line direction of the two-dimensional grating in the second region 122. In this way, it can be ensured that more light rays are coupled out, and high light efficiency can be obtained.

In a possible implementation, the first sub-region is in contact with the second sub-region. In the first region provided in this solution, the one-dimensional grating in the first sub-region is connected to the one-dimensional grating in the second sub-region, so that optical conduction efficiency can be improved.

In a possible implementation, a third spacing region is formed between the first sub-region and the second sub-region. In this solution, the third spacing region is disposed between the first sub-region and the second sub-region, to help simplify a process of fabricating the one-dimensional grating in the first sub-region and the one-dimensional grating in the second sub-region. Grating structures at adjacent positions of the two sub-regions do not need to be accurately controlled, and it can be ensured that one-dimensional gratings in the two regions are fabricated more easily, provided that the third spacing region is reserved. This reduces fabrication costs and research and development costs.

In a possible implementation, there is no grating structure in the third spacing region, and a size of the third spacing region extending along the second direction is less than or equal to a maximum radial size of the in-coupling grating. In this solution, a relationship between the third spacing region and the maximum radial size of the in-coupling grating is restricted, so that a light ray transmitted by the in-coupling grating to the third spacing region can still be transmitted to the second region through the one-dimensional grating structures in the first sub-region and the second sub-region, to avoid waste of more light energy.

In a possible implementation, types of all gratings in the second region are two-dimensional gratings. The second region provided in this solution has advantages of a simple structure and ease of fabrication.

In a possible implementation, the second region includes N two-dimensional regions and N-1 one-dimensional regions, N ≥ 2, the N-1 one-dimensional regions each are located between two adjacent two-dimensional regions, one of the two-dimensional regions is adjacent to or close to the first region, a type of a grating in the one-dimensional region is a one-dimensional grating, and a type of a grating in the two-dimensional region is a two-dimensional grating. In this application, the two-dimensional grating and the one-dimensional grating are disposed in the second region, and the one-dimensional grating is disposed between two-dimensional gratings, to help adjust and control intensity of a coupled-out light ray, so that uniformity of an entire picture is better. Specifically, in the second region, light ray intensity of a part close to the first region is greater than light ray intensity of a part away from the first region. The one-dimensional region is disposed between adjacent two-dimensional regions. The one-dimensional grating in the one-dimensional region can reduce light intensity at a position of the one-dimensional region. In addition, the one-dimensional grating in the one-dimensional region can restrict the light ray propagation direction, so that light rays are propagated in a centralized manner to a two-dimensional region on a light exit side of the one-dimensional region. In this way, light intensity of the two-dimensional region can be supplemented. Therefore, overall, intensity uniformity of coupled-out light rays in the second region can be ensured.

In a possible implementation, the one-dimensional region includes a third sub-region and a fourth sub-region, and the third sub-region and the fourth sub-region are arranged along the second direction and distributed on two sides of the central axis. This solution provides specific design of the one-dimensional region. The first sub-region and the fourth sub-region are disposed, so that the second region has better light uniformity.

In a possible implementation, a gate line direction of a part of a grating in the two-dimensional region is the same as a gate line direction of a grating in the third sub-region, and a gate line direction of a part of a grating in the two-dimensional region is the same as a gate line direction of a grating in the fourth sub-region. This solution helps ensure image authenticity, ensure image quality, and avoid adverse phenomena such as image distortion.

According to a seventh aspect, this application provides a near-eye display device, including an optical engine and the optical waveguide provided in any one of the possible implementations of the sixth aspect. The optical engine is located on a light incident side of the in-coupling grating. The near-eye display device provided in this solution uses the optical waveguide according to the sixth aspect, so that an effect of a virtual image generated by the near-eye display device is better, and both light intensity and light uniformity are optimized.

The near-eye display device provided in the seventh aspect of this application may include any one or a combination of the following solutions: the light combining unit provided in any one of the possible implementations of the first aspect of this application, the optical engine provided in any one of the possible implementations of the second aspect of this application, and the optical component provided in the fourth aspect of this application.

The near-eye display device provided in the fifth aspect of this application may include the optical waveguide provided in any one of the possible implementations of the sixth aspect of this application.

The near-eye display device provided in the third aspect of this application may include the optical waveguide provided in any one of the possible implementations of the sixth aspect of this application.

According to an eighth aspect, this application provides an optical waveguide, including an out-coupling grating. The out-coupling grating includes a plurality of sub-gratings arranged at intervals, a distance between two adjacent sub-gratings is L, 3 mm ≤ L ≤ 5 mm, L represents a distance between centers of the two adjacent sub-gratings, one of the sub-gratings is a first sub-grating, a separating region is provided between the first sub-grating and another sub-grating close to the first sub-grating, a maximum radial size of the first sub-grating is less than or equal to 1.5 mm, and there is no grating structure in the separating region. In the optical waveguide provided in this solution, the out-coupling grating is designed as the plurality of sub-gratings that are spaced apart from each other, and the maximum radial size of the sub-grating and the distance between adjacent sub-gratings are restricted, so that a light ray coupled out by the sub-grating is a fine light beam. The fine light beam may be understood as that a size of the light beam is small, and there may be only one light beam entering a pupil, so that the light beam does not fully fill the pupil. When the fine light beam enters a human eye for imaging, a depth of field becomes large. Therefore, regardless of where a user is focusing, the user can clearly see virtual images when observing the virtual images with different parallaxes, without paying attention to where a virtual image distance of the virtual image is actually located, thereby resolving a problem that a virtual image distance of an optical waveguide is a fixed value, and eliminating a VAC problem.

In a possible implementation, a maximum radial size of the first sub-grating is D, and 0.5 mm ≤ D ≤ 1 mm. In this solution, a radial size of the first sub-grating is restricted to be greater than or equal to 0.5 mm, to ensure that the first sub-grating can have an out-coupling grating function, that is, can couple a light ray in the optical waveguide into the human eye. In this solution, the radial size of the first sub-grating is restricted to be less than or equal to 1 mm, to ensure that a light ray projected by the first sub-grating is a fine light beam, and even when a pupil size becomes small due to an environmental factor, a light beam projected by the first sub-grating onto a pupil is still a fine light beam and cannot fully fill the pupil.

In a possible implementation, a maximum radial size of each of the plurality of sub-gratings is D, and 0.25 mm ≤ D ≤ 0.75 mm, or 0.75 mm ≤ D ≤ 1.5 mm. This solution defines that all the sub-gratings can couple light to obtain a fine light beam, thereby resolving a VAC problem. For an environment of an outdoor bright place, a pupil of the human eye becomes small due to impact of the environment; therefore, in an implementation, a radial size range of each of the sub-gratings is small, and is specifically: 0.25 mm ≤ D ≤ 0.75 mm. For a dark indoor environment, because a pupil of the human eye becomes large due to impact of the environment; therefore, an implementation, a radial size range of each of the sub-gratings is large, and is specifically: 0.75 mm ≤ D ≤ 1.5 mm.

In a possible implementation, 3.5 mm ≤ L ≤ 4.5 mm. The range of the distance between the two adjacent sub-gratings defined in this implementation may meet a plurality of application environments and different application scenarios. This ensures that a light ray coupled out by the sub-grating is a fine light beam.

In a possible implementation, the plurality of sub-gratings are arranged in an array of multiple rows and multiple columns, and the array arrangement has a same row distance and a same column distance. This solution defines a specific array arrangement solution for the sub-gratings, to resolve a VAC problem.

In a possible implementation, the plurality of sub-gratings are arranged in multiple rows, an arrangement direction of sub-gratings in each row is a first direction, odd-numbered rows and even-numbered rows in the multiple rows of the sub-gratings are disposed in a staggered manner, a second direction is perpendicular to the first direction, and in the second direction, the sub-grating in the odd-numbered row exactly faces the separating region between two adjacent sub-gratings in the even-numbered row. This implementation provides a honeycomb-like array arrangement solution, which has the following benefits: In this solution, it can be ensured that a relative distance between fine light beams at a position of an eye movement space is a constant value, while in an orthogonal array arrangement solution, a distance between fine light beams in a diagonal direction is slightly greater than those in a horizontal direction and a vertical direction. In this solution, when the human eye moves in the eye movement space, for example, when the eye rotates or glasses slide, different fine light beams entering a pupil of the human eye change. Because a relative distance between fine gratings in a honeycomb-like arrangement manner is constant, even if the human eye moves relative to the eye movement space, it can be ensured that energy of light beams entering the human eye is equal. Therefore, an image change is more smooth, and use experience of the near-eye display device can be improved.

In a possible implementation, a distance between any two adjacently disposed sub-gratings is equal. Distances of the sub-gratings are restricted to be equal, so that uniformity of coupled-out light rays can be achieved.

In a possible implementation, an outer contour shape of the sub-grating is a circle, a square, or a hexagon.

In a possible implementation, each sub-grating includes grating microstructures arranged based on a preset period, and the preset period is 200 nm to 500 nm. A specific shape of the grating microstructure may be but is not limited to a hexagon, a parallelogram, a triangle, a trapezoid, or the like. In the sub-grating, due to arrangement of the grating microstructure, the sub-grating can couple a light ray out in the optical waveguide and project the light ray onto the human eye.

In a possible implementation, the plurality of sub-gratings are coplanar, that is, the plurality of sub-gratings are disposed on a same surface of the waveguide substrate. This solution has an advantage of conveniently controlling the distance between the sub-gratings, and it is easy to obtain accurate arrangement of the sub-gratings.

In a possible implementation, one of the two adjacent sub-gratings is located on a front surface of a waveguide substrate of the optical waveguide, the other of the two adjacent sub-gratings is located on a back surface of the waveguide substrate, a center of the sub-grating located on the front surface of the waveguide substrate is a center 1, a vertical projection of a center of the sub-grating located on the back surface of the waveguide substrate onto the front surface of the waveguide substrate is a center 2, and a distance between the two adjacent sub-gratings is a distance between the center 1 and the center 2. This solution provides a distribution architecture of out-coupling gratings distributed on the front surface and the back surface of the waveguide substrate.

In a possible implementation, the optical waveguide includes the waveguide substrate, an in-coupling grating, a relay grating, and the out-coupling grating, the relay grating is located between the in-coupling grating and the out-coupling grating, the out-coupling grating includes a first sub-grating region and a second sub-grating region, a distance between the first sub-grating region and the relay grating is less than a distance between the second sub-grating region and the relay grating, and a height of the sub-grating in the first sub-grating region is less than a height of the sub-grating in the second sub-grating region. In this solution, the out-coupling gratings are disposed by region, sub-gratings in different regions are designed with different heights, so that diffraction efficiency of the out-coupling grating can be adjusted, helping improve light uniformity.

In a possible implementation, the out-coupling grating includes a first edge and a second edge, the first edge is an edge that is of the out-coupling grating and that is close to the relay grating, the second edge is an edge that is of the out-coupling grating and that is away from the relay grating, and in a direction from the first edge to the second edge, heights of the sub-gratings exhibit a gradual increase trend. In this solution, the sub-gratings in the out-coupling grating are designed to gradually vary in height, so that diffraction efficiency of the out-coupling grating can be adjusted, helping improve light uniformity.

According to a ninth aspect, this application provides a near-eye display device, including an optical engine and the optical waveguide provided in any one of the possible implementations of the eighth aspect. The optical waveguide is configured to receive a light ray projected by the optical engine. The near-eye display device provided in this solution uses the optical waveguide according to the eighth aspect, to resolve a VAC problem, and improve an image display effect of the near-eye display device.

According to a tenth aspect, this application provides a near-eye display device, including an optical waveguide, a control unit, a pupil detection member, and a grating adjustment member. The optical waveguide includes an out-coupling grating, the out-coupling grating includes a plurality of sub-gratings, the plurality of sub-gratings are arranged in an array, a maximum radial size of each sub-grating is D, $D \leq 1.5$ mm, a distance between two adjacent sub-gratings is L', $D \leq L' \leq 4$ mm, and L' represents a distance between centers of the two adjacent sub-gratings. The pupil detection member is configured to detect a pupil size, the control unit is configured to receive a signal of the pupil detection member and drive the grating adjustment member, and the grating adjustment member is configured to control a part of the sub-gratings of the out-coupling grating to be turned on or off, so that a part of the sub-gratings are in a working state, where a distance between two adjacent sub-gratings in the working state is L, $3$ mm $\leq L \leq 5$ mm, and L represents a distance between centers of the two adjacent sub-gratings in the working state. Array arrangement of the sub-gratings disposed in this solution is dense, and the distance between adjacent sub-gratings may be zero, that is, the sub-gratings may be arranged in a manner of being in contact with each other one by one. A gap may alternatively be provided between adjacent sub-gratings. In this solution, an arrangement solution in which the distance between two adjacent sub-gratings is L' is used, and a part of the sub-gratings are turned on by using the grating adjustment member, so that in a sub-grating array in the working state, a range of the distance L between the centers of adjacent sub-gratings in the working state is: $3$ mm $\leq L \leq 5$ mm. In this solution, a switchable optical element is used, and the sub-grating is controlled to be on or off, so that the sub-gratings in the working state can respond to pupils of different sizes. For example, when a pupil size changes, the distance between the sub-gratings in the working state can be adjusted by using the grating adjustment member, thereby improving image display efficiency. In this solution, a virtual image distance does not need to be switched based on actual content, and system power consumption can be reduced.

The near-eye display device provided in the ninth aspect and the tenth aspect of this application may include any one or a combination of the following solutions: the light combining unit provided in any one of the possible implementations of the first aspect of this application, the optical engine provided in any one of the possible implementations of the second aspect of this application, the optical component provided in the fourth aspect of this application, and the optical waveguide provided in any one of the possible implementations of the sixth aspect.

The near-eye display device provided in the third aspect, the fifth aspect, or the seventh aspect of this application may include the optical waveguide provided in any one of the possible implementations of the eighth aspect.

According to an eleventh aspect, this application provides an optical waveguide, including a waveguide substrate and a grating structure formed on the waveguide substrate. The grating structure includes a plurality of core structures and a film structure. A refractive index of the film structure is different from a refractive index of the core structure, the plurality of core structures are sequentially arranged at intervals in a vector direction of the grating structure, each core structure includes a connection end, a free end, and a side surface, the connection end is connected to the waveguide substrate, the free end and the connection end are disposed opposite to each other in a height direction of the core structure, and the side surface is connected between the connection end and the free end. The film structure includes a film body, a first end part, and a second end part, the film body wraps the side surface of the core structure, the first end part and the second end part are respectively located at two ends of the film body, the first end part is connected to the waveguide substrate, the second end part and the free end of the core structure are coplanar, and the free ends of all the core structures and the second end part of the film structure jointly form an end face of the grating structure.

In this solution, diffraction efficiency and optical utilization are improved through variation of refractive indexes of a grating. Specifically, diffraction efficiency and optical utilization are improved by using different refractive indexes of the core structures and the film structures of the grating structure. The free end of the core structure and the second end part of the film structure jointly form the end face of the grating structure, so that diffraction efficiency of the grating structure is better. The grating structure has the core structure and the film structure with different refractive indexes only in the vector direction of the grating structure. In a height direction of the grating structure, because both the free end of the core structure and the second end part of the film structure are in an exposed state at a position of the end face of the grating structure, that is, the exterior of the core structure in the height direction is not wrapped by the film structure, diffraction efficiency of the grating structure can be ensured. If the free end of the core structure is wrapped by the film structure, a part that is of the film structure and that wraps the free end of the core structure generates a diffraction effect in the height direction of the grating structure. However, because diffraction in the height direction of the grating structure has a direction different from the vector direction of the grating structure, diffraction in the vector direction of the grating structure is negatively affected, that is, diffraction efficiency of the grating structure is reduced.

In a possible implementation, an end face of the free end of the core structure and an end face of the second end part of the film structure are coplanar. In the grating structure provided in this solution, the end face of the free end and the end face of the second end part are coplanar. The film structure may be fabricated by coating the core structure, and a film structure on a surface of the grating structure may be polished to be flat by using a process such as chemical mechanical polishing (CMP), to implement a coplanar structure. The coplanar structure provided in this solution is easy to implement and has low fabrication costs.

In a possible implementation, between adjacent core structures, the film structure includes at least three film layers, the at least three film layers are disposed in a stacked manner between the side surfaces of the adjacent core structures, the at least three film layers have different refractive indexes, and along the vector direction of the grating structure, refractive indexes of the at least three film layers exhibit a gradient trend of sine distribution. The grating with a sine gradient refractive index provided in this solution may have higher diffraction efficiency and a narrower full width at half maximum, and can meet a modulation requirement of incident efficiency at a specific angle, thereby improving light efficiency of an entire system.

In a possible implementation, between the adjacent core structures, the at least three film layers have different thicknesses.

A film layer with a largest thickness is adjacent to the core structure, and a thickness of the core structure is greater than that of the film layer with the largest thickness; or a film layer with a smallest thickness is adjacent to the core structure, and a thickness of the core structure is less than that of the film layer with the smallest thickness. In this solution, different refractive indexes are achieved by using differentiated thickness design.

In a possible implementation, one of the film layers includes multiple layers of first sub-films and multiple layers of second sub-films that are alternately arranged in one-to-one correspondence, a refractive index of the first sub-film is N1, a refractive index of the second sub-film is N2, a refractive index of the film layer that includes the multiple layers of first sub-films and the multiple layers of second sub-films is N, and N1 < N < N2. This solution provides a film layer refractive index modulation solution. A film layer that meets a condition is obtained by disposing multiple layers of first sub-films and multiple layers of second sub-films that are alternately arranged, and there are a plurality of fabrication processes, which has an advantage of easy implementation.

In a possible implementation, a part of the film structure between the adjacent core structures is a seamless structure. It may be understood that space between the adjacent core structures is filled by the film structure, and no gap is left. There is no gap inside the grating structure provided in this solution, so that diffraction efficiency of the grating structure is not easily affected by an environmental factor.

In a possible implementation, there is a gap in a middle position of the film structure between the adjacent core structures. This solution provides a solution in which there is a gap between the core structures, so that a refractive index can be modulated by using air, a fabrication process can be simplified, and costs can be reduced.

In a possible implementation, refractive indexes of any positions in the core structure are the same. This solution helps ensure stability of diffraction efficiency of the grating structure.

In a possible implementation, the core structure is formed on the waveguide substrate by using a nano-imprinting process or an etching process, and the film structure is fabricated by using a coating process. The coating fabrication process is easy to process in batches, and can improve fabrication efficiency of the grating structure.

In a possible implementation, a material of the core structure includes a metal oxide.

In a possible implementation, the optical waveguide includes an in-coupling grating, where the in-coupling grating includes a first in-coupling structure and a second in-coupling structure, the first in-coupling structure and the second in-coupling structure are disposed opposite to each other and are respectively located on a top surface and a bottom surface of the waveguide substrate, the first in-coupling structure and the second in-coupling structure have different grating tilt angles, and the grating structure is at least a part of the in-coupling grating. The first in-coupling structure and the second in-coupling structure may diffract light rays in different directions, so that more light rays are coupled into the waveguide substrate. That is, the first in-coupling structure and the second in-coupling structure are combined to achieve high diffraction efficiency within a large angle range.

In a possible implementation, each of the first in-coupling structure and the second in-coupling structure is the grating structure, a refractive index of a core structure of the first in-coupling structure is greater than a refractive index of a core structure of the second in-coupling structure, and a refractive index of a film structure of the first in-coupling structure is greater than a refractive index of a film structure of the second in-coupling structure. In this solution, the first in-coupling structure and the second in-coupling structure are restricted to have different refractive indexes, so that the in-coupling grating can diffract light with different angles or wavelengths.

In a possible implementation, an in-coupling grating and an out-coupling grating formed on the waveguide substrate are included. The out-coupling grating is the grating structure, the out-coupling grating includes a first region and a second region, and the first region is closer to the in-coupling grating than the second region. A refractive index difference between a core structure and a film structure of the out-coupling grating in the first region is a first value, a refractive index difference between a core structure and a film structure of the out-coupling grating in the second region is a second value, and the first value is less than the second value. This solution is used to modulate diffraction efficiency.

In a possible implementation, a relay grating is included. The relay grating is located between the in-coupling grating and the out-coupling grating, the relay grating is the grating structure, the relay grating includes a third region and a fourth region, the third region is closer to the in-coupling grating than the fourth region, a refractive index difference between a core structure and a film structure of the relay grating in the third region is a third value, a refractive index difference between a core structure and a film structure of the relay grating in the fourth region is a fourth value, the third value is less than the fourth value, and the fourth value is less than the first value. This solution is used to modulate diffraction efficiency.

In a possible implementation, the relay grating includes a first relay structure and a second relay structure, the first relay structure and the second relay structure are respectively disposed on a top surface and a bottom surface of the waveguide substrate, and the first relay structure and the second relay structure have different vector directions. This solution is used to modulate diffraction efficiency.

In a possible implementation, the first relay structure and the second relay structure each are the grating structure, and in the vector direction of the first relay structure, a refractive index difference between a core structure of the first relay structure and a film structure of the first relay structure gradually increases. This solution is used to modulate diffraction efficiency.

According to a twelfth aspect, this application provides a near-eye display device, including an optical engine and the optical waveguide provided in any one of the possible implementations of the eleventh aspect. The optical waveguide is configured to receive a light ray projected by the optical engine. The near-eye display device provided in this solution uses the optical waveguide provided in any one of the possible implementations of the eleventh aspect, so that the near-eye display device can have a good image display effect.

The near-eye display device provided in the twelfth aspect of this application may include any one or a combination of the following solutions: the light combining unit provided in any one of the possible implementations of the first aspect of this application, the optical engine provided in any one of the possible implementations of the second aspect of this application, the optical component provided in the fourth aspect of this application, the optical waveguide provided in any one of the possible implementations of the sixth aspect, and the optical waveguide provided in any one of the possible implementations of the eighth aspect.

The near-eye display device provided in the third aspect, the fifth aspect, the seventh aspect, the ninth aspect, or the tenth aspect of this application may include the optical waveguide provided in any one of the possible implementations of the eleventh aspect.

According to a thirteenth aspect, this application provides an optical waveguide, including an in-coupling region, an out-coupling region, and a light propagation region. An in-coupling grating is disposed in the in-coupling region, the in-coupling grating is configured to receive an incident light ray, the incident light ray undergoes total internal reflection in the light propagation region after entering the optical waveguide, an out-coupling grating is disposed in the out-coupling region, and the out-coupling grating is configured to couple a light ray out. In the light propagation region, the optical waveguide includes a medium layer and a first grating layer and a second grating layer located on two sides of the medium layer, at least one of the first grating layer and the second grating layer has different periods, and a refractive index of the medium layer is less than or equal to 1.5.

In a specific implementation of this application, total internal reflection propagation of a light ray in the light propagation region is implemented by using the first grating layer and the second grating layer located on the two sides of the medium layer. The refractive index of the medium layer is restricted to be less than or equal to 1.5, so that a separate medium layer cannot achieve total internal reflection propagation of a light ray. In this solution, a range of the refractive index of the medium layer is restricted, so that it can be ensured that the medium layer has an advantage of low density and a light weight, facilitating lightweight design of the optical waveguide. In this solution, at least one of the first grating layer and the second grating layer is restricted to have different periods, so that at least one of the first grating layer and the second grating layer can transmit ambient light, and can further achieve total internal reflection of a light ray transmitted inside the optical waveguide.

In a possible implementation, each of the first grating layer and the second grating layer has different periods. In this solution, each of the first grating layer and the second grating layer is restricted to have different periods, so that light transmission of the optical waveguide can be improved.

In a possible implementation, both the first grating layer and the second grating layer are volume holographic gratings. In this solution, the volume holographic gratings with different periods are multiplexed, so that the light propagation region can perform total internal reflection on an incident light ray entering the optical waveguide, and can further achieve good transmittance of ambient light. In addition, compared with another grating type (for example, a blazed grating or a slanted grating), the volume holographic grating has an advantage of lightness and thinness. Therefore, this solution facilitates lightweight design of the optical waveguide.

In a possible implementation, the optical waveguide further includes a relay grating, in a transmission direction of an optical path, the relay grating is located between the in-coupling region and the out-coupling region, and the first grating layer and the second grating layer in the light propagation region are located between the in-coupling grating and the out-coupling grating and surround the relay grating. This solution provides the optical waveguide architecture with the relay grating, where a position of the relay grating is not in the light propagation region, and the first grating layer and the second grating layer are distributed around the relay grating. In a specific implementation, the in-coupling grating, the out-coupling grating, the relay grating, the first grating layer, and the second grating layer may all be volume holographic gratings.

In a possible implementation, the out-coupling grating is a two-dimensional grating, the light propagation region is located between the in-coupling grating and the out-coupling grating, and the first grating layer and the second grating layer fill all regions between the in-coupling grating and the out-coupling grating. This solution provides a specific optical waveguide architecture without a relay grating, and the out-coupling grating is a two-dimensional grating. In this way, the light propagation region is formed in a region between the in-coupling grating and the out-coupling grating.

In a possible implementation, both a period of the out-coupling grating and a period of the relay grating need to meet a same condition as a period of the in-coupling grating, and period directions and sizes of the in-coupling grating, the relay grating, and the out-coupling grating need to form closed k-space. When this condition is met, it can be ensured that a virtual image projected by the optical waveguide is not distorted, that is, authenticity of the image can be ensured, improving an image display effect of the optical waveguide.

In a possible implementation, the optical waveguide further includes a first protection layer and a second protection layer. The first protection layer is located on a side that is of the first grating layer and that is away from the medium layer, and the first protection layer covers surfaces of the first grating layer, the in-coupling grating, and the out-coupling grating. The first protection layer is configured to protect the first grating layer, the in-coupling grating, and the out-coupling grating, so that the first grating layer, the in-coupling grating, and the out-coupling grating are protected from corrosion caused by external dust, air, or moisture. The second protection layer covers a surface of the second grating layer, to protect the second grating layer, so that the second grating layer is protected from corrosion caused by external dust, air, or moisture, thereby helping ensure diffraction efficiency and optical performance of the optical waveguide.

In a possible implementation, the optical waveguide includes a functional region and an edge region, the in-coupling grating, the out-coupling grating, and the first grating layer and the second grating layer in the light propagation region are disposed in the functional region, and a refractive index of the edge region is less than a refractive index of the functional region or a material of the edge region is different from a material of the functional region. According to the optical waveguide provided in this solution, the functional region and the edge region are combined, and the edge region may be made of a light material, which helps achieve lightweight of the optical waveguide.

In a possible implementation, period ranges of the first grating layer and the second grating layer are greater than or equal to 100 nm and less than or equal to 700 nm. Periods of the first grating layer and the second grating layer formed by using the solution of multiplexing the volume holographic grating correspond to incident angles. A grating period range is restricted to be greater than or equal to 100 nm and less than or equal to 700 nm, so that high diffraction efficiency can be obtained on the premise that the incident angle is ensured.

In a possible implementation, a volume shrinkage range of a material of the first grating layer and a volume shrinkage range of a material of the second grating layer are less than or equal to 0.1%. In this solution, grating structures with small volume shrinkage are used, so that transverse and longitudinal change rates of the first grating layer and the second grating layer can be reduced, thereby reducing changes of a period, a thickness, and a tilt angle, and ensuring that there is no large deviation between designed angles and efficiency and actual angles and efficiency of the first grating layer and of the second grating layer.

In a specific solution, film thicknesses of the first grating layer and the second grating layer may be greater than 20 μm. A bandwidth of an incident light ray of a combination of the first grating layer and the second grating layer is less than 5 nm (that is, an incident light ray with a narrow bandwidth), to achieve total internal reflection propagation of a coupled-in light ray. A process of fabricating the first grating layer and the second grating layer may be obtained through multi-time exposure, so that the first grating layer and the second grating layer have a plurality of periods, to achieve total internal reflection propagation of an incident light ray and further improve transmittance of ambient light.

In a possible implementation, the optical waveguide is a single-layer architecture, or the optical waveguide is a double-layer architecture, or the optical waveguide is a three-layer architecture. When the optical waveguide is a three-layer architecture, each layer of the optical waveguide includes the in-coupling grating, the out-coupling grating, the first grating layer, and the second grating layer. This solution defines the single-layer architecture or the three-layer architecture of the optical waveguide. In any architecture, the first grating layer and the second grating layer may be used as a medium for total internal reflection propagation of the light propagation region. This solution has an advantage of good flexibility.

According to a fourteenth aspect, this application provides a near-eye display device, including an optical engine and the optical waveguide provided in any one of the possible implementations of the thirteenth aspect. A light ray emitted by the optical engine is incident to the in-coupling grating to form an incident light ray. In a possible implementation, a bandwidth of the incident light ray is less than or equal to 5 nm. The near-eye display device provided in this application uses the optical waveguide provided in any one of the possible implementations of the thirteenth aspect, so that the near-eye display device can have advantages of a light weight and a small size, and can improve wearing experience of a user.

The near-eye display device provided in the fourteenth aspect of this application may include any one or a combination of the following solutions: the light combining unit provided in any one of the possible implementations of the first aspect of this application, the optical engine provided in any one of the possible implementations of the second aspect of this application, the optical component provided in the fourth aspect of this application, the optical waveguide provided in any one of the possible implementations of the sixth aspect, the optical waveguide provided in any one of the possible implementations of the eighth aspect, and the optical waveguide provided in any one of the possible implementations of the eleventh aspect.

The near-eye display device provided in the third aspect, the fifth aspect, the seventh aspect, the ninth aspect, the tenth aspect, or the twelfth aspect of this application may include the optical waveguide provided in any one of the possible implementations of the thirteenth aspect.

According to a fifteenth aspect, this application provides an optical waveguide, including a waveguide substrate and an antireflective layer. The antireflective layer is formed on a surface of the waveguide substrate, the antireflective layer includes a volume holographic material, the antireflective layer includes a high refractive index phase region and a low refractive index phase region that have different refractive indexes, the high refractive index phase region and the low refractive index phase region are disposed on the surface of the waveguide substrate in a stacked manner, the high refractive index phase region and the low refractive index phase region are different regions that are separated from each other, a refractive index range of the high refractive index phase region is 1.5 to 2.0, a refractive index range of the low refractive index phase region is 1.1 to 1.5, and a component in the high refractive index phase region is different from a component in the low refractive index phase region.

In this solution, an internal structure or an arrangement manner of internal components of the volume holographic material is changed, so that haze of the volume holographic material can be reduced. Specifically, in this solution, an internal structure of the antireflective layer forms a high refractive index phase region and a low refractive index phase region that are alternately distributed, and components in the high refractive index phase region and the low refractive index phase region are different. It may be understood that materials of a same component in the antireflective layer are aggregated in one phase region. For example, a component in the high refractive index phase region is polymers and nanoparticles, and a component in the low refractive index phase region is polymers formed by monomers, that is, subpolymers. In this way, a macromolecular compound and a sub-macromolecular compound are separated, instead of being mixed together, and it is not easy to form micro-region agglomeration. Therefore, a large polymer particle cannot be formed in the antireflective layer, so that the optical waveguide can have low haze, improving light transmission of the optical waveguide.

In a possible implementation, there are a plurality of high refractive index phase regions, there are a plurality of low refractive index phase regions, and the plurality of high refractive index phase regions and the plurality of low refractive index phase regions are alternately distributed in a direction perpendicular to the surface of the waveguide substrate. The alternate distribution may be understood as an arrangement manner of ABABAB. The low refractive index phase region is disposed between adjacent high refractive index phase regions in a stacked manner, or the high refractive index phase region is disposed between adjacent low refractive index phase regions in a stacked manner. This solution defines a specific architecture of the antireflective layer. The alternate distribution of the high-refractive-index phase regions and the low-refractive-index phase regions is used to resolve region-based management of material components in the antireflective layer, so as to avoid micro-region agglomeration, so that the optical waveguide has low haze, improving light transmission of the optical waveguide.

In a possible implementation, the volume holographic material is mainly a polymer material, and main elements of the polymer material include: one or more or all of C, H, O, N, S, and P. This solution defines a specific component of the volume holographic material, so that fabrication of the antireflective layer is implementable.

In a possible implementation, the volume holographic material includes nanoparticles. In this solution, the volume holographic material is restricted to have nanoparticles, and region division for different components is implemented by using the nanoparticles.

In a possible implementation, a diameter of the nanoparticle is 1 nm to 50 nm.

In a possible implementation, at least a part of the nanoparticles are distributed in the high refractive index phase region, and the nanoparticles distributed in the high refractive index phase region are one or more or all of titanium dioxide, zirconia, zinc sulfide, and carbon quantum dots; and/or

at least a part of the nanoparticles are distributed in the low refractive index phase region, and the nanoparticles distributed in the low refractive index phase region are one or both of silicon dioxide and magnesium fluoride. This solution defines a specific distribution solution of the nanoparticles. Nanoparticles of different materials may be selectively distributed in the high refractive index phase region or the low refractive index phase region.

In a possible implementation, a volume fraction content of the nanoparticles is 0 to 60%. In this solution, a volume fraction of the nanoparticles is restricted to control formation and refractive indexes of the high refractive index region and the low refractive index phase region, and resolve a haze problem of the optical waveguide. Specifically, a quantity of nanoparticles cannot be excessively large, and an excessively large quantity of nanoparticles may cause agglomeration of the nanoparticles and increase haze. The quantity of nanoparticles cannot be excessively small, and an excessively small quantity of nanoparticles may reduce a refractive index difference between different phase regions.

In a possible implementation, the high refractive index phase region and the low refractive index phase region are layer structures sequentially alternately disposed on the surface of the waveguide substrate in a stacked manner, and a thickness of a layer structure formed by the high refractive index phase region is the same as or different from a thickness of a layer structure formed by the low refractive index phase region.

In a possible implementation, a thickness range of each high refractive index phase region or a thickness range of each low refractive index phase region is from 100 nm to 1000 nm. For example, a thickness of each high refractive index phase region or a thickness of each low refractive index phase region is 200 nm. In this solution, the thickness range is restricted to control a wavelength range of light that can be transmitted by the antireflective layer, and antireflective films with different thicknesses correspond to different wavelength ranges.

In a possible implementation, the optical waveguide further includes an in-coupling grating and an out-coupling grating, both the in-coupling grating and the out-coupling grating are formed on the surface of the waveguide substrate, a non-grating region is provided on the surface of the waveguide substrate, the non-grating region is a region other than the in-coupling grating and the in-coupling grating, and at least a part of the antireflective layer is located in the non-grating region. This solution provides a specific optical waveguide architecture, where the optical waveguide includes the in-coupling grating and the out-coupling grating, and has no relay grating. In this solution, the antireflective layer is restricted to be located in the non-grating region of the optical waveguide, to improve transmission and light uniformity of ambient light in the non-grating region, so that a haze problem of the non-grating region can be resolved.

In a possible implementation, the optical waveguide further includes an in-coupling grating, a relay grating, and an out-coupling grating, the in-coupling grating, the relay grating, and the out-coupling grating are formed on the surface of the waveguide substrate, a non-grating region is provided on the surface of the waveguide substrate, the non-grating region is a region other than the in-coupling grating, the relay grating, and the out-coupling grating, and at least a part of the antireflective layer is located in the non-grating region. This solution provides a specific optical waveguide architecture, where the optical waveguide includes the in-coupling grating, the relay grating, and the out-coupling grating. In this solution, the antireflective layer is restricted to be located in the non-grating region of the optical waveguide, to improve transmission and light uniformity of ambient light in the non-grating region, so that a haze problem of the non-grating region can be resolved.

In a possible implementation, a part of the antireflective layer is located at a position of the out-coupling grating and forms, together with the out-coupling grating, a co-location structure, the co-location structure includes grating microstructures arranged along a vector direction of the out-coupling grating, and the co-location structure further includes the high refractive index phase region and the low refractive index phase region that are alternately distributed in a normal direction of the optical waveguide. In this solution, the antireflective layer is disposed at a position of the out-coupling grating, so that transmittance of the out-coupling grating can be improved. The out-coupling grating not only can couple a light ray in the optical waveguide into a human eye, but also can transmit ambient light. The position of the out-coupling grating of the optical waveguide provided in this solution has good transmission.

In a possible implementation, a surface that is of the out-coupling grating and that is connected to the waveguide substrate is an out-coupling bottom surface of the out-coupling grating, a surface that is of the out-coupling grating and that is away from the waveguide substrate is an out-coupling top surface of the out-coupling grating, and a part of the antireflective layer that forms, together with the out-coupling grating, the co-location structure is formed between the out-coupling bottom surface and the out-coupling top surface. This solution defines a specific architecture in which the out-coupling grating and the antireflective layer form the co-location structure. In this solution, no volume holographic material needs to be added to a region other than the out-coupling grating, but instead, the antireflective layer structure is obtained by performing dual-beam exposure based on the out-coupling grating, so that diffraction efficiency of the out-coupling grating can be ensured or not affected as much as possible. If a material is added outside the out-coupling top surface to fabricate the antireflective layer, the added material affects diffraction efficiency of the out-coupling grating.

In a possible implementation, a material of the out-coupling grating is a volume holographic material, and the co-location structure is fabricated by using a holographic multiplexing technology. The optical waveguide provided in this solution has advantages of a simple fabrication process and easy implementation.

In a possible implementation, the optical waveguide includes a grating structure, the grating structure is a volume holographic material, the grating structure is formed on the surface of the waveguide substrate, the antireflective layer and the grating structure are formed by using a dual-beam exposure process, and an angular bisector of an included angle between two light beams in the dual-beam exposure process for forming the antireflective layer is parallel to the surface of the waveguide substrate. In this solution, in a process of fabricating the antireflective layer and the grating structure by using the dual-beam exposure process, the angular bisector of the included angle between the two light beams in the dual-beam exposure process is restricted to be parallel to the surface of the waveguide substrate. A vector direction of the antireflective layer obtained in such a manner is a direction perpendicular to the surface of the waveguide substrate, that is, the antireflective layer is an architecture that is stacked on the surface of the waveguide substrate. Because the vector direction of the antireflective layer is different from a vector direction of the grating structure, in the optical waveguide provided in this solution, introduction of the antireflective layer does not affect diffraction of the grating structure.

According to a sixteenth aspect, this application provides a near-eye display device, including an optical engine and the optical waveguide provided in any one of the possible implementations of the fifteenth aspect. The optical engine is located on a light incident side of the optical waveguide.

The near-eye display device provided in the sixteenth aspect of this application may include any one or a combination of the following solutions: the light combining unit provided in any one of the possible implementations of the first aspect of this application, the optical engine provided in any one of the possible implementations of the second aspect of this application, the optical component provided in the fourth aspect of this application, the optical waveguide provided in any one of the possible implementations of the sixth aspect, the optical waveguide provided in any one of the possible implementations of the eighth aspect, the optical waveguide provided in any one of the possible implementations of the eleventh aspect, and the optical waveguide provided in any one of the possible implementations of the thirteenth aspect.

The near-eye display device provided in the third aspect, the fifth aspect, the seventh aspect, the ninth aspect, the tenth aspect, the twelfth aspect, or the fourteenth aspect of this application may include the optical waveguide provided in any one of the possible implementations of the fifteenth aspect.

According to a seventeenth aspect, this application provides a method for fabricating an optical waveguide. The method for fabricating an optical waveguide is used to fabricate the optical waveguide provided in any one of the possible implementations of the fifteenth aspect. The method for fabricating an optical waveguide includes:

> providing a substrate, where the substrate is a waveguide substrate of the optical waveguide;
> disposing a material layer on a surface of the substrate, where the material layer includes a volume holographic material;
> performing pre-processing on the substrate having the material layer;
> performing a dual-beam exposure process, so that the material layer forms a structure having a high refractive index phase region and a low refractive index phase region that are alternately distributed; and
> performing curing for formation, so that the material layer is modulated into an antireflective layer on the waveguide substrate.

In a possible implementation, the material layer includes a polymer, a monomer, a photoinitiating system, and a solvent. The polymer is a polymer containing C, H, O, and N with a molecular weight greater than 1000. The monomer includes at least one of acrylate, acrylamide, sulfhydryl-containing compound, an allyl compound, or vinyl compound. The photoinitiating system is used to absorb laser energy and form an active material, so that the active material reacts with the monomer, to convert the monomer into a subpolymer.

In a possible implementation, a light source of the dual-beam exposure process includes two expanded coherent laser beams, the two expanded coherent laser beams interfere with each other to form light intensity with sine wave distribution, so as to form high light intensity regions and low light intensity regions on the material layer. Energy absorbed by the photoinitiating system in the high light intensity region is greater than energy absorbed by the photoinitiating system in the low light intensity region, so that the active material in the high light intensity region is more than the active material in the low light intensity region. In this way, the polymer is separated from the subpolymer, to form an alternate distribution architecture of the high refractive index phase region and the low refractive index phase region.

In a possible implementation, the polymer includes at least one of polyether, polyvinyl acetate, polyvinyl acetate-propylene copolymer, polyethylene, polypropylene, polyvinyl chloride, polyethylene terephthalate, polystyrene, polycarbonate, polyurethane, polyester polyol, cellulose acetate, or polyvinyl alcohol.

In a possible implementation, the material layer is disposed on the surface of the substrate by using a coating process.

In a possible implementation, the step of performing pre-processing on the substrate having the material layer includes: performing high-temperature processing at 25°C to 100°C, or low-voltage processing, or light-proof processing, or room-temperature placement processing.

In a possible implementation, the step of performing curing for formation includes: performing high-temperature curing for formation and light curing for formation, where a temperature for the high-temperature curing for formation is 40°C to 150°C, light intensity for the light curing for formation is 0.1 mWcm$^{-2}$ to 5000 mWcm$^{-2}$, a wavelength range for the light curing for formation is 254 nm to 1000 nm, and a type of light for the light curing for formation includes any one of UVA, UVB, UVC, visible light, or infrared light.

In a possible implementation, in the step of performing a dual-beam exposure process, an included angle between two light beams is a first angle.

In a possible implementation, the method for fabricating an optical waveguide further includes: fabricating a grating structure by using the dual-beam exposure process, where the grating structure is formed through exposure by using two light beams whose included angle is a second angle, the grating structure and at least a part of the antireflective layer may be located at a same position on the substrate, and the first angle is different from the second angle.

According to an eighteenth aspect, this application provides an optical waveguide, used in a near-eye display device. The optical waveguide includes a first waveguide substrate, a first grating structure, and a first filling layer, the first grating structure is formed on a surface of the first waveguide substrate, the first filling layer and the first waveguide substrate are disposed in a stacked manner, the first filling layer and the first waveguide substrate jointly form a closed surrounding architecture, and the first grating structure is located inside the surrounding architecture, so that the first grating structure is isolated from outside air, where a difference between a refractive index of the first filling layer and a refractive index of air is less than or equal to 0.2. In an implementation of this application, a filling layer is disposed around a periphery of a grating structure on the waveguide substrate, and the filling layer is used to protect the grating structure and the waveguide substrate, so as to protect the optical waveguide and improve life and optical performance of the optical waveguide. Specifically, in this solution, the first filling layer is disposed to protect the first waveguide substrate and the first grating structure, so that the first waveguide substrate and the first grating structure are isolated from outside air, and it can be ensured that the first waveguide substrate and the first grating structure avoid long-term exposure to water and oxygen environments, resolving problems such as easy aging, corrosion, and hazing of the optical waveguide. The optical waveguide can be further prevented from being damaged by an external impact force. In this implementation provided by this application, service life and optical performance of the optical waveguide can be ensured.

In a possible implementation, the first filling layer includes a grating contact surface, and the grating contact surface has periodically arranged microstructures the same as those of the first grating structure, so that the grating contact surface of the first filling layer is attached to a surface of the microstructures of the first grating structure. In this solution, the first filling layer and the first grating structure are in contact without air gaps. The grating contact surface of the first filling layer is attached to the surface of the microstructures of the first grating structure, that is, a part of the first filling layer is filled in a gap formed by the first grating structure and the periodically arranged microstructures. In the optical waveguide provided in this implementation, there is no air gap around a periphery of the first grating structure, and the first grating structure is completely in contact with the first filling layer, to implement complete isolation from air. In this way, life of the first grating structure can be improved.

In a possible implementation, the first filling layer includes a grating contact surface, the grating contact surface is planar in shape, and there are periodically arranged slits between the first filling layer and the first grating structure. In this solution, a slit is allowed between the grating contact surface and the surface of the first grating structure. A fabrication process of the first filling layer provided in this solution has a low precision requirement, and is easy to fabricate.

In a possible implementation, light transmission of the first filling layer is greater than or equal to 80%. This solution defines the light transmission of the first filling layer, so that light transmission of the optical waveguide can be ensured.

In a possible implementation, a thickness of the first filling layer is less than or equal to 1000 $\mu$m. In this solution, the thickness of the first filling layer is restricted to ensure the refractive index and the light transmission of the optical waveguide, so that the optical waveguide has a lightweight advantage.

In a possible implementation, a material of the first filling layer includes any one or a combination of an aerogel material, a resin material, an inorganic material, or an organic material.

In a possible implementation, a material of the first filling layer is a silicon dioxide aerogel. Specifically, pores are introduced into a silicon dioxide material to form a silicon dioxide aerogel. Air shares a part of the refractive index. For example, if porosity of silicon dioxide is 50%, a composite refractive index is 1.5*50% + 1*50% = 1.25. The silicon dioxide aerogel may be used as the material of the first filling layer. The silicon dioxide aerogel is a solid-state material, formed by interconnection of nanosilica particles, with a three-dimensional porous network structure having nanometer-scale pores. The pores are fully filled with air. The refractive index is adjusted by adjusting the pores of the silicon dioxide aerogel. Currently, it is possible for an aerogel to include air with a volume proportion of 90% or higher. A pure silicon dioxide aerogel is transparent and colorless, with a refractive index as low as 1.007, which is close to a refractive index of air. In addition, because most of a volume is air, density is very low. In addition, the aerogel has good light transmission and hardness. Currently, it is possible for the aerogel to achieve 95% light transmission and can bear thousands of times of a weight of the aerogel.

In a possible implementation, the optical waveguide further includes a first cover plate, the first cover plate is fastened to the first waveguide substrate, the first filling layer is disposed between the first cover plate and the first waveguide substrate in a stacked manner, and the first filling layer is attached to the first cover plate. This solution provides an optical waveguide architecture with the first cover plate. The first filling layer is filled between the first cover plate and the first waveguide substrate, so that there is no air gap between the first cover plate and the first waveguide substrate. The first filling layer provides support for the first cover plate, to prevent the first cover plate from being damaged by external stress.

In a possible implementation, the first cover plate is fastened to the first waveguide substrate by using a dispensing structure, and the dispensing structure is distributed around the first filling layer. This solution provides a solution for fastening the first cover plate and the first waveguide substrate. A structure for fastening through dispensing is easy to operate. In addition, because the first filling layer already covers most of an area of the first waveguide substrate, an adhesive does not cause destructive impact on optical performance of the first waveguide substrate.

In a possible implementation, the optical waveguide further includes a second grating structure, a second filling layer, and a second cover plate, the second grating structure and the first grating structure are distributed on two opposite sides of the first waveguide substrate, the second filling layer and the first waveguide substrate are disposed in a stacked manner, the second filling layer and the first waveguide substrate jointly enclose and surround the second grating structure, a difference between a refractive index of the second filling layer and the refractive index of air is less than or equal to 0.2, the second cover plate is fastened to the first waveguide substrate, the second filling layer is disposed between the second cover plate and the first waveguide substrate in a stacked manner, and the second filling layer is attached to the second cover plate. This solution provides a single-layer double-sided optical waveguide architecture, to protect the second grating structure by using the second filling layer and the second cover plate.

In a possible implementation the optical waveguide further includes a second waveguide substrate and a third grating structure, the third grating structure is formed on the second waveguide substrate, the second waveguide substrate and the first waveguide substrate are disposed in a stacked manner, a third filling layer is disposed between the second waveguide substrate and the first optical waveguide substrate, and a difference between a refractive index of the third filling layer and the refractive index of air is less than or equal to 0.2. This solution provides a double-layer optical waveguide architecture, and the third filling layer is disposed between the first waveguide substrate and the second waveguide substrate, to protect the third grating structure.

In a possible implementation, the optical waveguide further includes at least two second waveguide substrates, a third grating structure is disposed on each second waveguide substrate, the at least two second waveguide substrates are disposed in a stacked manner on a side that is of the first waveguide substrate and that is away from the first filling layer, third filling layers are respectively disposed between the second waveguide substrate and the first waveguide substrate and between adjacent second waveguide substrates, the third filling layer and the second waveguide substrate jointly surround the third grating structure, and a difference between a refractive index of the third filling layer and the refractive index of air is less than or equal to 0.2. This solution provides a multi-layer optical waveguide architecture, where the third filling layer is filled between adjacent layers, to protect the third grating structure, and provide support and connection between multiple layers of waveguide substrates.

In a possible implementation, the optical waveguide further includes a second waveguide substrate, the second waveguide substrate and the first waveguide substrate are disposed in a stacked manner, a third grating structure is disposed on a surface of the second waveguide substrate, the third grating structure and the first grating structure are disposed opposite to each other, the first filling layer is filled between the first waveguide substrate and the second waveguide substrate, and the first filling layer covers the second waveguide substrate and the third grating structure. A top surface of the first waveguide substrate and a bottom surface of the second waveguide substrate in the optical waveguide provided in this implementation may be used as surface layers of the optical waveguide, and no other cover plate structure needs to be disposed, which facilitates design of lightness and thinness of the optical waveguide. The optical waveguide provided in this solution has a lightweight advantage.

According to a nineteenth aspect, this application provides an optical waveguide, including a first waveguide substrate, a first grating structure, a waveguide filling structure, a third grating structure, and a first filling layer. The first grating structure is formed on a surface of the first waveguide substrate, the waveguide filling structure wraps the first grating structure and covers the first waveguide substrate, the third grating structure is formed on a surface that is of the waveguide filling structure and that is away from the first waveguide substrate, the first filling layer covers the waveguide filling structure, the first filling layer and the waveguide filling structure jointly form a closed surrounding architecture, and the third grating structure is located in the surrounding architecture, so that the third grating structure is isolated from outside air, where a difference between a refractive index of the first filling layer and a refractive index of air is less than or equal to 0.2. In this solution, a layer of grating structure is constructed by using the waveguide filling structure. In another implementation, multiple layers (two or more layers) of grating structures may alternatively be constructed by using the waveguide filling structure. This solution provides a multi-layer architecture constructed on a basis of a single-layer waveguide substrate by using the waveguide filling structure. The waveguide filling structure and the first filling layer are used to protect the layers of grating structures. An outermost first filling layer is combined with a cover plate, to further provide support and protection for the cover plate.

In a possible implementation, a difference between a refractive index of the waveguide filling structure and a refractive index of the first waveguide substrate is between 0 and 0.5. This solution defines a range of the refractive index difference between the waveguide filling structure and the first waveguide substrate. This range is used for restriction, so that all the layers of grating structures can achieve diffraction efficiency, and both the waveguide filling structure and the first waveguide substrate have a function of total internal reflection of a light ray.

In a possible implementation, the optical waveguide further includes a first cover plate, and the first cover plate is located on a side that is of the first filling layer and that is away from the waveguide filling structure. In this solution, the first cover plate is disposed as a protection layer of the optical waveguide, and the first filling layer can provide support and protection for the first cover plate, to prevent the first cover plate from being damaged by external stress.

In a possible implementation, an edge of the waveguide filling structure is recessed relative to the first waveguide substrate, to reserve a position at the edge of the first waveguide substrate for disposing a dispensing structure, where the dispensing structure is fastened to the first cover plate and the first waveguide substrate. This solution defines a fastening manner between the first cover plate and the first waveguide substrate. Structural stability of the optical waveguide can be ensured through dispensing connection.

According to a twentieth aspect, this application provides a near-eye display device, including an optical engine and the optical waveguide according to any one of the possible implementations of the eighteenth aspect or the optical waveguide according to any one of the possible implementations of the nineteenth aspect. The optical waveguide is located on a light exit side of the optical engine.

The near-eye display device provided in the twentieth aspect of this application may include any one or a combination of the following solutions: the light combining unit provided in any one of the possible implementations of the first aspect of this application, the optical engine provided in any one of the possible implementations of the second aspect of this application, the optical component provided in the fourth aspect of this application, the optical waveguide provided in any one of the possible implementations of the sixth aspect, the optical waveguide provided in any one of the possible implementations of the eighth aspect, the optical waveguide provided in any one of the possible implementations of the eleventh aspect, the optical waveguide provided in any one of the possible implementations of the thirteenth aspect, and the optical waveguide provided in any one of the possible implementations of the fifteenth aspect.

The near-eye display device provided in the third aspect, the fifth aspect, the seventh aspect, the ninth aspect, the tenth aspect, the twelfth aspect, the fourteenth aspect, or the sixteenth aspect of this application may include the optical waveguide according to any one of the possible implementations of the eighteenth aspect or the optical waveguide according to any one of the possible implementations of the nineteenth aspect.

According to a twenty-first aspect, this application provides a method for fabricating an optical waveguide, including:

providing a first cover plate, and coating a first filling material on the first cover plate, to form a first filling layer on the first cover plate;
providing a first waveguide substrate, where a first grating structure is disposed on the first waveguide substrate;
aligning the first cover plate and the first waveguide substrate, so that the first filling layer and the first waveguide substrate are combined and jointly enclose and surround the first grating structure; and
fastening the first cover plate to the first waveguide substrate, so that the first filling layer and the first waveguide substrate jointly form a closed surrounding architecture, the first grating structure is located in the surrounding architecture, and the first grating structure is isolated from outside air, where a difference between a refractive index of the first filling layer and a refractive index of air is less than or equal to 0.2.

According to a twenty-second aspect, this application provides a method for fabricating an optical waveguide, including:

providing a first waveguide substrate, where a first grating structure is disposed on the first waveguide substrate;
providing a rigid mother mold, where the rigid mother mold has a grating mold structure, and the grating mold structure has a same form as the first grating structure;
performing hydrophobic processing on a surface that is of the rigid mother mold and that carries the grating mold structure and a surface of the grating mold structure;
coating a first filling material on the rigid mother mold, to form a first filling layer;
attaching a first cover plate to the first filling layer, so that the first cover plate and the first filling layer are combined together;
performing demolding, so that the first cover plate and the first filling layer are separated from the rigid mother mold;
aligning the first cover plate and the first waveguide substrate, so that the first filling layer and the first waveguide substrate jointly form a closed surrounding architecture, the first grating structure is located in the surrounding architecture, and the first grating structure is isolated from outside air, where a difference between a refractive index of the first filling layer and a refractive index of air is less than or equal to 0.2; and
fastening the first cover plate and the first waveguide substrate.

According to a twenty-third aspect, this application provides a method for fabricating an optical waveguide, including:

providing an optical waveguide intermediate structure, where the optical waveguide intermediate structure includes a first waveguide substrate, a first grating structure, and a first cover plate, the first grating structure is formed on a surface of the first waveguide substrate, the first cover plate and the first waveguide substrate are disposed in a stacked manner and are fastened, and a gap is formed between the first cover plate and the first waveguide substrate and between the first cover plate and the first grating structure;
providing an injection hole on the first cover plate; and
injecting a filling material through the injection hole to form a first filling layer, where the first filling layer and the first waveguide substrate jointly form a closed surrounding architecture, and the first grating structure is located in the surrounding architecture, so that the first grating structure is isolated from outside air, where a difference between a refractive index of the first filling layer and a refractive index of air is less than or equal to 0.2.

According to a twenty-fourth aspect, this application provides a method for fabricating an optical waveguide, including:

providing a first waveguide substrate, where a first grating structure is disposed on the first waveguide substrate;
coating a filling material on a surface of the first waveguide substrate and a surface of the first grating structure to form a first filling layer, where the first filling layer and the first waveguide substrate jointly form a closed surrounding architecture, and the first grating structure is located in the surrounding architecture, so that the first grating structure is isolated from outside air, where a difference between a refractive index of the first filling layer and a refractive index of air is less than or equal to 0.2;
disposing a dispensing structure on an edge of the first filling layer and a surface of the first waveguide substrate; and
fastening a first cover plate to the dispensing structure, so that the first cover plate is fastened to the first waveguide structure.

According to a twenty-fifth aspect, this application provides an optical waveguide, including a waveguide substrate and a grating structure. The grating structure is combined with the waveguide substrate, the waveguide substrate includes a first substrate layer and a second substrate layer, a refractive index of the first substrate layer is less than a refractive index of the second substrate layer, a difference between the refractive index of the second substrate layer and the refractive index of the first substrate layer is greater than or equal to 0.1, and a thickness of the second substrate layer is 50 microns to 300 microns. The grating structure is located on a side that is of the second substrate layer and that is away from the first substrate layer, and/or the grating structure is located between the first substrate layer and the second substrate layer. In this solution, the waveguide substrate is designed as a composite material formed by stacking the first substrate layer and the second substrate layer, and the thickness of the second substrate layer and the refractive index difference between the first substrate layer and the second substrate layer are restricted, so that lightweight of the optical waveguide can be achieved.

In a possible implementation, a material of the first substrate layer is glass, and the refractive index of the first substrate layer is less than or equal to 1.55. In this solution, the material and the refractive index range of the first substrate layer are restricted, so that the first substrate layer is a material with a low refractive index, and features low density, a light weight, and a small thickness. In this implementation provided in this application, a weight of the waveguide substrate and a thickness of the waveguide substrate can be reduced, and further, a weight of the optical waveguide and a thickness of the optical waveguide can be reduced. Therefore, lightweight of the optical waveguide can be achieved while total internal reflection propagation (optical performance) of a light ray can be achieved in the optical waveguide.

In a possible implementation, the refractive index of the second substrate layer is greater than or equal to 1.65. In this solution, a range of the refractive index of the second substrate layer is restricted, so that the second substrate layer can meet a function of total internal reflection propagation of light.

In a possible implementation, a material of the second substrate layer is one or a combination of at least two of TiO2, silicon nitride, gallium nitride, and a high-refractive resin material.

In a possible implementation, the first substrate layer is configured to carry, in a process of fabricating the second substrate layer, a material for forming the second substrate layer, where the second substrate layer and the first substrate layer are combined into an integrated structure by using a fabrication process. This solution facilitates lightweight implementation of the optical waveguide.

In a possible implementation, groove-shaped microstructures are formed on a surface of the first substrate layer by using an etching process, and the second substrate layer is formed on the surface of the first substrate layer and is combined with the groove-shaped microstructures, to form at least a part of the grating structure. This solution defines that the grating structure may be formed between the first substrate layer and the second substrate layer. The groove-shaped microstructures formed by using the etching process help achieve overall lightweight of the optical waveguide. Disposing the grating structure at this position can further improve diffraction efficiency of the optical waveguide.

In a possible implementation, at least a part of a grating layer is disposed on the surface of the first substrate layer, at least a part of the grating structure is located at the grating layer, and the second substrate layer is directly formed, by using a fabrication process, on a surface that is of the grating layer and that is away from the first substrate layer. This solution defines a specific manner of fabricating the grating structure between the first substrate layer and the second substrate layer by using the grating layer, which helps improve diffraction efficiency of the optical waveguide.

In a possible implementation, the thickness of the waveguide substrate is less than 0.35 mm. The first substrate layer is not only configured to carry the second substrate layer in a process of fabricating the optical waveguide, but also configured to protect the second substrate layer and the grating structure from corrosion caused by external dust, air, or moisture, thereby ensuring diffraction efficiency of the optical waveguide.

In a possible implementation, at least a part of the grating structure is formed on a surface that is of the second substrate layer and that is away from the first substrate layer. This solution provides a solution in which a grating structure disposed on the surface that is of the second substrate layer and that is away from the first substrate layer. The design in this solution makes design of the optical waveguide more flexible.

In a possible implementation, a protection layer is disposed on the side that is of the second substrate layer and that is away from the first substrate layer. The protection layer is configured to protect the second substrate layer and the grating structure.

In a possible implementation, the optical waveguide includes a functional region and an edge region, the edge region surrounds the functional region, the waveguide substrate and the grating structure are located in the functional region, a waveguide edge body is disposed in the edge region, the waveguide edge body is combined with an edge of the waveguide substrate, the waveguide edge body has light transmission, and density of the waveguide edge body is less than density of a material of the first waveguide substrate. In this embodiment, density of an edge region is less than density of the first substrate layer. Therefore, the edge region located on an outer side of the waveguide substrate helps achieve lightweight of the optical waveguide.

In a possible implementation, a material of the waveguide edge body is a resin material. In this solution, the material of the waveguide edge body is restricted to achieve lightweight of the optical waveguide.

In a possible implementation, a refractive index of the waveguide edge body is 1.55 to 1.75. In this solution, a range of the refractive index of the waveguide edge body is restricted to achieve lightweight of the optical waveguide.

In a possible implementation, the optical waveguide further includes a wrapping layer, the wrapping layer fully or half wraps the waveguide substrate and the grating structure, an outer surface of the wrapping layer includes a first surface, and the first surface is a curved surface, to correct different myopia degrees. In this solution, the wrapping layer, the waveguide substrate, and the grating structure are used, so that the optical waveguide can be adapted to different degrees of myopia.

In a possible implementation, at least one surface of the wrapping layer has different curvatures. In this solution, the wrapping layer is restricted to have a surface with different curvatures, so that the wrapping layer not only can compensate for an angle deviation caused by a refractive index difference between the waveguide substrate and the wrapping layer, but also can be used to correct different degrees of myopia.

According to a twenty-sixth aspect, this application provides a near-eye display device, including an optical engine and the optical waveguide provided in any one of the possible implementations of the twenty-fifth aspect. The optical waveguide is located on a light exit side of the optical engine.

The near-eye display device provided in the twenty-sixth aspect of this application may include any one or a combination of the following solutions: the light combining unit provided in any one of the possible implementations of the first aspect of this application, the optical engine provided in any one of the possible implementations of the second aspect of this application, the optical component provided in the fourth aspect of this application, the optical waveguide provided in any one of the possible implementations of the sixth aspect, the optical waveguide provided in any one of the possible implementations of the eighth aspect, the optical waveguide provided in any one of the possible implementations of the eleventh aspect, the optical waveguide provided in any one of the possible implementations of the thirteenth aspect, the optical waveguide provided in any one of the possible implementations of the fifteenth aspect, the optical waveguide according to any one of the possible implementations of the eighteenth aspect, and the optical waveguide according to any one of the possible implementations of the nineteenth aspect.

The near-eye display device provided in the third aspect, the fifth aspect, the seventh aspect, the ninth aspect, the tenth aspect, the twelfth aspect, the fourteenth aspect, the sixteenth aspect, or the twentieth aspect of this application may include the optical waveguide according to any one of the possible implementations of the twenty-fifth aspect.

According to a twenty-seventh aspect, an embodiment of this application provides a method for fabricating an optical waveguide, including: fabricating a first grating layer on a substrate layer, where the first grating layer has a first grating structure, so that the first grating layer and the substrate layer are disposed in a stacked manner; fabricating a second grating layer by using a grating structure mold, where the second grating layer is fabricated on a side that is of the first grating layer and that is away from the substrate layer, the second grating layer has a second grating structure, and there is an adhesion enhancement layer between the first grating layer and the second grating layer; and removing the grating structure mold, so that the substrate layer, the first grating layer, and the second grating layer are combined to form an optical waveguide. Specifically, a first imprint material layer is spin-coated on the substrate layer, a first grating structure mold is provided, the first grating structure mold is pressed onto the first imprint material layer by using a nano-imprinting process, then the first imprint material layer is cured, and the first grating layer is obtained after demolding. Then the second grating layer is fabricated by using a second grating structure mold, and the first grating layer is bonded to the second grating layer by using the adhesion enhancement layer.

In this application, the adhesion enhancement layer is disposed between the first grating layer and the second grating layer, so that the first grating layer is separated from the second grating layer. Therefore, during fabrication of the second grating layer, the first grating layer is not affected by a pressure or an impact force, and a probability of deformation and damage of the first grating layer is reduced. In addition, firmness between the second grating layer and the adhesion enhancement layer can be maintained by utilizing an adhesion characteristic of the adhesion enhancement layer after they are connected, thereby improving reliability of demolding. In addition, the second grating layer may be bonded to the first grating layer by using the adhesion enhancement layer, thereby improving connection strength between the first grating layer and the second grating layer, avoiding loosening between the first grating layer and the second grating layer, and facilitating subsequent processing of the optical waveguide.

In a possible implementation, the step of fabricating a second grating layer by using a grating structure mold includes: fabricating a medium layer on the first grating layer; coating the adhesion enhancement layer on the medium layer; coating a second imprint material layer on the adhesion enhancement layer; and fabricating the second grating structure on the second imprint material layer by using the grating structure mold, to form the second grating layer. Specifically, the grating structure mold in the foregoing step should be the second grating structure mold, and is used to fabricate the second grating layer. The medium layer is fabricated on the first grating layer before the adhesion enhancement layer is coated, so that the medium layer can form mechanical protection for the first grating layer, and it is ensured that the first grating layer is not easily deformed in a process of imprinting the second grating layer. In addition, fabrication of the medium layer on a surface of the first grating layer can further improve a refractive index of a light ray at the first grating layer, thereby achieving excellent optical performance of the optical waveguide.

In a possible implementation, before the step of fabricating a second grating layer by using a grating structure mold, the fabrication method includes: performing anti-sticking processing on a working surface of the grating structure mold, where in a process of fabricating the second grating layer on the second imprint material layer by using the grating structure mold, the working surface is in contact with the second imprint material layer. Anti-sticking processing is performed on the working surface, in order that demolding can be performed more smoothly after the second imprint material layer is cured into the second grating layer, the second grating layer is prevented from being adhered to the second grating structure mold, and damage to integrity of the second grating layer is avoided.

In a possible implementation, the step of fabricating a medium layer on the first grating layer includes: forming the medium layer on the first grating layer by using a coating process. Fabrication of the medium layer by using the coating process has the following advantages: A technology of the process is simple, and mass production is easy to implement.

In a possible implementation, a material of the medium layer includes an oxide or a nitride. In a possible implementation, a refractive index of the medium layer is 1.8 to 2.3. The medium layer has a high refractive index, which can effectively improve optical efficiency and improve a field of view of an electronic device having the optical waveguide structure. In another implementation, the refractive index of the medium layer may alternatively be greater than 2.3.

In a possible implementation, the step of fabricating a medium layer on the first grating layer further includes: performing surface processing on the medium layer by using a chemical-mechanical grinding process. Specifically, a surface parallel to (or approximately parallel to) the substrate layer may be formed on a side that is of the medium layer fabricated by using the step in the foregoing implementation and that faces away from the first grating layer. A purpose of processing the surface is to improve roughness of the surface, thereby improving adhesion of the surface of the medium layer and avoiding detachment of the adhesion enhancement layer.

In a possible implementation, a refractive index of the second imprint material layer is 1.6 to 1.9. In a possible implementation, a thickness of the second imprint material layer is 100 nm to 400 nm. The second imprint material layer has a high refractive index, which can effectively improve optical efficiency and improve a field of view of an electronic device having the optical waveguide structure. In another implementation, the refractive index of the second imprint material layer may alternatively be greater than 1.9. In addition, controlling the thickness of the second imprint material layer to be 100 nm to 400 nm can be ensured that the thickness of the obtained second grating layer does not exceed a maximum value of the range. In this way, an overall thickness of the optical waveguide structure can be effectively controlled, to achieve lightness and thinness of an electronic device having the optical waveguide structure.

In a possible implementation, a thickness of the adhesion enhancement layer is 0 nm to 20 nm. It may be understood that, the thickness of the adhesion enhancement layer is controlled to be within the range, so that connection strength between the first grating layer and the substrate layer can be ensured without affecting the overall thickness of the optical waveguide structure. When the thickness of the adhesion enhancement layer exceeds this range, an excessively large overall thickness of the optical waveguide structure is likely to be caused, and refraction of a light ray is affected.

In a possible implementation, the step of fabricating a second grating layer by using a grating structure mold includes: providing the grating structure mold; fabricating the second grating layer on the grating structure mold; and bonding the second grating layer connected to the grating structure mold to the first grating layer by using the adhesion enhancement layer. Specifically, the grating structure mold in the foregoing step should be the second grating structure mold, and is used to fabricate the second grating layer. The second grating layer is fabricated in advance on the grating structure mold, steps of fabricating the first grating layer and the second grating layer can be performed simultaneously, and structures of various layers do not need to be fabricated in sequence. After the first grating layer and the second grating layer are separately fabricated, they are bonded by using the adhesion enhancement layer, thereby improving manufacturing efficiency and facilitating large-scale production.

In a possible implementation, the step of fabricating a second grating layer by using a grating structure mold includes: first coating the adhesion enhancement layer on a surface that is of the second grating layer and that is away from the grating structure mold, and then bonding the first grating layer to the adhesion enhancement layer. Specifically, the second grating layer should be fabricated by coating the second imprint material layer on the second grating structure mold. Before the second imprint material layer is cured, an adhesion enhancement layer may be disposed on a surface that is of the second imprint material layer and that is away from the second grating structure mold, then the second imprint material layer together with the second grating structure mold is disposed on the first grating layer, and then the second imprint material layer is cured. The adhesion enhancement layer disposed in this manner may be completely covered on the first grating layer by using a deformable characteristic of the second imprint material layer, thereby improving uniformity of the adhesion enhancement layer.

In a possible implementation, the fabrication method further includes: fabricating the medium layer on the first grating layer, and bonding the second grating layer connected to the grating structure mold to the medium layer by using the adhesion enhancement layer. The medium layer is fabricated on the first grating layer before the adhesion enhancement layer is coated, so that the medium layer can form mechanical protection for the first grating layer, and it is further ensured that the first grating layer is not easily deformed in a process of imprinting the second grating layer. In addition, fabrication of the medium layer on a surface of the first grating layer can further improve a refractive index of a light ray at the first grating layer, thereby achieving excellent optical performance of an optical waveguide structure.

In a possible implementation, a surface form of the medium layer is the same as a surface form of the first grating layer. The medium layer may be fabricated on a surface of the first grating layer by using the coating process, and forms of two opposite surfaces of the medium layer are the same as the surface form of the first grating layer. It may be understood that, the medium layer may form a thin film layer on the surface of the first grating layer, to ensure a light reflection effect of the first grating layer. In comparison with the foregoing implementation in which the medium layer is fabricated and has a flat surface, the medium layer in this implementation is thinner, and can implement a thinning effect on the optical waveguide structure, thereby manufacturing a lighter and thinner electronic device.

In a possible implementation, a refractive index of the medium layer is 1.8 to 2.3, and a thickness of the medium layer is 0 nm to 50 nm. A specific material of the medium layer may be an oxide such as titanium dioxide. The refractive index of the medium layer is designed to be 1.8 to 2.3, so that the medium layer can have a high refractive index, and a light ray emitted by an optical engine can achieve a better reflection effect on the first grating layer by using the medium layer, thereby achieving excellent optical performance of the optical waveguide structure.

In a possible implementation, in a process of bonding the second grating layer connected to the grating structure mold to the first grating layer by using the adhesion enhancement layer, the adhesion enhancement layer is in direct contact with the first grating layer. The adhesion enhancement layer is designed to be in direct contact with the first grating layer, that is, no medium layer is disposed between the adhesion enhancement layer and the first grating layer, so that a thinning effect of the optical waveguide structure can be achieved, thereby reducing a thickness of the optical waveguide structure without changing thicknesses of the layers.

In a possible implementation, before the step of fabricating the second grating layer on the grating structure mold, anti-sticking processing is performed on the working surface of the grating structure mold, and in a process of fabricating the second grating layer on the grating structure mold, the second grating layer is fabricated on the working surface. Anti-sticking processing is performed on the working surface, in order that demolding can be performed more smoothly after the second imprint material layer is cured into the second grating layer, the second grating layer is prevented from being adhered to the second grating structure mold, and damage to integrity of the second grating layer is avoided.

In a possible implementation, the step of fabricating the first grating layer on the substrate layer includes: coating a first imprint material layer on the substrate layer, and forming the first grating layer on the first imprint material layer by using a nano imprinting process, where a force borne by the first imprint material in a process of forming the first grating layer is a first pressure, a force borne by the first grating layer and the second grating layer in a process of bonding the second grating layer connected to the grating structure mold to the first grating layer by using the adhesion enhancement layer is a second pressure, and the second pressure is less than or equal to the first pressure. It may be understood that, both the first grating layer and the second grating layer fabricated by using the nano-imprinting process may have micro-nanostructures. During fabrication of the first grating layer, the substrate layer is below the first grating layer and has no micro-nanostructures. Therefore, in order to ensure formation of the first grating layer, a large first pressure may be used. During fabrication of the second grating layer on the first grating layer, the first grating layer has micro-nanostructures. To prevent the micro-nanostructures on the first grating layer from being damaged due to an excessively large imprinting force, the second pressure should be less than the first pressure, to protect the first grating layer.

In a possible implementation, a material of the first grating layer is different from a material of the second grating layer. It may be understood that the material of the first grating layer may be the same as or different from the material of the second grating layer. However, the first grating layer and the second grating layer come into contact with different substrates when being fabricated, and therefore different materials may be selected according to material characteristics to respectively fabricate the first grating layer and the second grating layer.

In a possible implementation, the first grating structure on the first grating layer and the second grating structure on the second grating layer have different structures. In a possible implementation, the first grating structure and the second grating structure have different sizes or periods. Specifically, the first grating structure is an in-coupling structure, and the second grating structure is an out-coupling structure. The first grating structure and the second grating structure are micro-nanostructures on the optical waveguide structure, and are configured to reflect light or transmit light. Therefore, the first grating structure and the second grating structure may be designed with different shapes, sizes, or periods based on light rays on which the first grating structure and the second grating structure need to act.

According to a twenty-eighth aspect, an embodiment of this application further provides an optical waveguide, including a substrate layer, a first grating layer, a second grating layer, and an adhesion enhancement layer. The first grating layer is disposed in a stacked manner with the substrate layer, where the first grating layer has a first grating structure. The second grating layer is disposed in a stacked manner on a side that is of the first grating layer and that is away from the substrate layer, the second grating layer has a second grating structure, and there is an adhesion enhancement layer between the first grating layer and the second grating layer.

In this application, the adhesion enhancement layer is disposed between the first grating layer and the second grating layer, so that the first grating layer is separated from the second grating layer. Therefore, during fabrication of the second grating layer, the first grating layer is not affected by a pressure or an impact force, and a probability of deformation and damage of the first grating layer is reduced. In addition, firmness between the second grating layer and the adhesion enhancement layer can be maintained by utilizing an adhesion characteristic of the adhesion enhancement layer after they are connected, thereby improving reliability of demolding. In addition, the second grating layer may be bonded to the first grating layer by using the adhesion enhancement layer, thereby improving connection strength between the first grating layer and the second grating layer, avoiding loosening between the first grating layer and the second grating layer, and facilitating subsequent processing of the optical waveguide structure.

In a possible implementation, there is a medium layer between the first grating layer and the adhesion enhancement layer.

In a possible implementation, a material of the medium layer includes an oxide or a nitride. In a possible implementation, a refractive index of the medium layer is 1.8 to 2.3.

In a possible implementation, a surface form of the medium layer is the same as a surface form of the first grating layer.

In a possible implementation, a thickness of the adhesion enhancement layer is 0 nm to 20 nm.

In a possible implementation, a refractive index of the first grating layer is 1.6 to 1.9, and in a possible implementation, a thickness of the first grating layer is 100 nm to 400 nm.

In a possible implementation, the first grating layer includes a first grating structure, the second grating layer includes a second grating structure, and the first grating structure and the second grating structure have different structures. In a possible implementation, the first grating structure and the second grating structure have different sizes or periods.

According to a twenty-ninth aspect, this application provides a near-eye display device, including an optical engine and the optical waveguide provided in any one of the possible implementations of the twenty -eighth aspect. The optical waveguide is located on a light exit side of the optical engine.

The near-eye display device provided in the twenty-ninth aspect of this application may include any one or a combination of the following solutions: the light combining unit provided in any one of the possible implementations of the first aspect of this application, the optical engine provided in any one of the possible implementations of the second aspect of this application, the optical component provided in the fourth aspect of this application, the optical waveguide provided in any one of the possible implementations of the sixth aspect, the optical waveguide provided in any one of the possible implementations of the eighth aspect, the optical waveguide provided in any one of the possible implementations of the eleventh aspect, the optical waveguide provided in any one of the possible implementations of the thirteenth aspect, the optical waveguide provided in any one of the possible implementations of the fifteenth aspect, the optical waveguide according to any one of the possible implementations of the eighteenth aspect, the optical waveguide according to any one of the possible implementations of the nineteenth aspect, and the optical waveguide according to any one of the possible implementations of the twenty -fifth aspect.

The near-eye display device provided in the third aspect, the fifth aspect, the seventh aspect, the ninth aspect, the tenth aspect, the twelfth aspect, the fourteenth aspect, the sixteenth aspect, the twentieth aspect, or the twenty -sixth aspect of this application may include the optical waveguide according to any one of the possible implementations of the twenty-eighth aspect.

According to a thirtieth aspect, this application provides an optical waveguide. The optical waveguide includes an optical waveguide body, a first anti-reflection layer, a filling body layer, a second anti-reflection layer, and a surface protection layer that are sequentially disposed in a stacked manner, the first anti-reflection layer is located between the optical waveguide body and the filling body layer, and a difference between a refractive index of the filling body layer and a refractive index of air is within a first preset range. The second anti-reflection layer is located between the filling body layer and the surface protection layer, a refractive index of the second anti-reflection layer exhibits a gradient change trend, a difference between a refractive index of a part that is of the second anti-reflection layer and that is close to the filling body layer and the refractive index of the filling body layer is within a second preset range, and a difference between a refractive index of a part that is of the second anti-reflection layer and that is close to the surface protection layer and a refractive index of the surface protection layer is within a second preset range.

In this application, the filling body layer is disposed between the optical waveguide body and the surface protection layer, to achieve support and protection for the optical waveguide body and the surface protection layer, and prevent optical performance of the optical waveguide body from being affected by an environment factor.

Because a refractive index of the filling body layer is small, for example, is close to that of air, there is a refractive index difference between the filling body layer and the surface protection layer, and there is also a refractive index difference between the filling body layer and the optical waveguide body. If the first anti-reflection layer and the second anti-reflection layer are not disposed, light ray reflection occurs at a connection position between the filling body layer and the optical waveguide body and at a connection position between the filling body layer and the surface protection layer. This reflection affects transmittance of the optical waveguide. Therefore, in this application, the first anti-reflection layer and the second anti-reflection layer are disposed to achieve an overall anti-reflection effect of the optical waveguide.

Specifically, the first anti-reflection layer may be formed on a surface of the optical waveguide body through coating, and total internal reflection of the optical waveguide body is achieved by using an optical interference principle. The first anti-reflection layer can mitigate scattering and absorption of the optical waveguide at an interface, and increase an anti-reflection and antireflective effect at the interface.

In an implementation, the first anti-reflection layer may be a single-layer film architecture. In this case, a refractive index of the first anti-reflection layer is related to refractive indexes of media at an upper interface and a lower interface, and is estimated to be a square root of a product of the two indexes, and a thickness of the first anti-reflection layer is 1/4 of an incident wavelength. Alternatively, the first anti-reflection layer may be a multi-layer film structure. If the first anti-reflection layer is a multi-layer film structure, an equivalent refractive index of the multi-layer film structure is required to be the foregoing value, to achieve a low reflectivity (which is theoretically reduced to 0) at an interface, thereby achieving a function of anti-reflection at the surface.

In a solution in which the second anti-reflection layer has a gradient refractive index, gradient changing refractive index design is formed between the surface protection layer and the filling body layer, to resolve a problem of light reflection between the surface protection layer and the filling body layer, and improve light transmission of the optical waveguide.

Specifically, in a possible implementation, a relief grating used for transmitting light rays may be formed on the surface of the optical waveguide body. Therefore, the filling body layer disposed between the optical waveguide body and the surface protection layer may further protect the relief grating from scratches.

In a possible implementation, the difference between the refractive index of the filling body layer and the refractive index of air is between 0.1 and 0.25, and/or a thickness of the filling body layer is 30 µm to 50 µm. The refractive index and the thickness of the filling body layer are controlled, to avoid an excessively large refractive index of the filling body layer, thereby helping control an overall refractive index of the optical waveguide to be within a proper range, and avoiding visual impairment of a user. In addition, this thickness can effectively achieve support for a wafer (the optical waveguide body), and avoid an excessively thick or thin optical waveguide.

In a possible implementation, the filling body layer includes a substrate and a refraction medium, and the refraction medium is dispersed in the substrate. The refraction medium may be added to a material for fabricating the filling body layer, and then the filling body layer is fabricated by using the fabrication method in the foregoing implementation. A specific material of the substrate may be a siloxane polymer. A specific form of the refraction medium is not limited. The refraction medium may be particulate microspheres, or may be a hollow region formed in the filling body layer. For example, the refraction medium may be a particle material, and a refractive index of the refraction medium may be different from a refractive index of the substrate. The refraction medium dispersed in the substrate may be used to adjust the refractive index of the filling body layer, so that the refractive index of the filling body layer can be within the range in the foregoing implementation.

In a possible implementation, the refraction medium is resin particles, and a refractive index of the resin particle is 1, and/or a particle size of the resin particle is 0.1 µm to 100 µm. A reason why the resin particles are used as the refraction medium is that the resin particles have good light transmission and light transmission for visible light is high. Therefore, adding the resin particles to the substrate does not affect light transmission of the filling body layer. In addition, using the resin particles as the refraction medium further facilitates stability of a structure of the filling body layer. Because chemical properties of the resin particles are similar to those of the siloxane polymer, after the filling body layer is fabricated and formed, the substrate and the refraction medium are not easily separated, and the substrate and the refraction medium have better adhesion and are easy to package. Then, a content and distribution of the resin particles, whose refractive index is 1, in the substrate are adjusted, to control the refractive index of the filling body layer. Moreover, the particle size of the resin particle is controlled to be within the foregoing range, which facilitates formation of the filling body layer. In addition, difficulty in manufacturing the resin particles is low, making industrial production easy. When the particle size of the resin particle is less than the foregoing range, a size of the resin particle is excessively small, and manufacturing difficulty is increased; or when the particle size of the resin particle is greater than the foregoing range, a size of the resin particle is excessively large, which is not conducive to formation of the filling body layer.

In a possible implementation, the resin particle is of an internal hollow structure. Specifically, the resin particle may be of a core-shell structure, a shell of the resin particle is made of a resin material, and a core may be air. A purpose of this design is to make the refractive index of the resin particles closer to the air.

In a possible implementation, the refractive index of the substrate is 1.4. A material of the substrate may use a siloxane polymer the same as a material of the first anti-reflection layer. A reason for using the siloxane polymer the same as the material of the first anti-reflection layer is that the filling body layer that uses the same material as the substrate is more easily bonded to the first anti-reflection layer, so that a layer separation phenomenon caused by different materials can be avoided. In addition, steps of replacing a material may be further reduced, and the same material is easy to obtain, which facilitates industrial production and cost reduction.

In a possible implementation, the filling body layer is an aerogel. The aerogel is used as the filling body layer, so that the step of mixing the substrate and the refraction medium can be eliminated, to simplify a preparation process, and further, manufacturing costs of the filling body layer can be reduced.

In a possible implementation, the refractive index of the second anti-reflection layer is 1.1 to 1.4, and/or a thickness of the second anti-reflection layer is 1 $\mu$m to 2 $\mu$m. The refractive index and the thickness of the second anti-reflection layer are controlled, to avoid an excessively large refractive index of the second anti-reflection layer, thereby helping control an overall refractive index of the optical waveguide to be within a proper range, and avoiding visual impairment of a user. In addition, this thickness can effectively achieve support for a wafer (the optical waveguide body), and avoid an excessively thick or thin optical waveguide.

In a possible implementation, the second anti-reflection layer includes a plurality of second anti-reflection sublayers disposed in a stacked manner, and a difference between refractive indexes of any two adjacent second anti-reflection sublayers is within a preset range. Designing the second anti-reflection layer as a plurality of second anti-reflection sublayers helps prepare the second anti-reflection layer step by step for a plurality of times, and improve formation precision of the second anti-reflection layer. In addition, refractive indexes of the second anti-reflection sublayers are not completely the same, which helps gradually reduce reflection of a light ray by using a plurality of different refractive indexes.

In a possible implementation, in a direction from the optical waveguide body to the surface protection layer, refractive indexes of the plurality of second anti-reflection sublayers increase along a gradient.

In a possible implementation, the second anti-reflection layer and the filling body layer are made of a same material but have different density; or the second anti-reflection layer and the filling body layer are formed by using a same fabrication process.

In a possible implementation, the first anti-reflection layer is formed on a surface of the optical waveguide body through coating.

According to a thirty-first aspect, this application further provides a near-eye display device, including the optical waveguide according to any one of the possible implementations of the thirtieth aspect.

The near-eye display device provided in the thirty-first aspect of this application may include any one or a combination of the following solutions: the light combining unit provided in any one of the possible implementations of the first aspect of this application, the optical engine provided in any one of the possible implementations of the second aspect of this application, the optical component provided in the fourth aspect of this application, the optical waveguide provided in any one of the possible implementations of the sixth aspect, the optical waveguide provided in any one of the possible implementations of the eighth aspect, the optical waveguide provided in any one of the possible implementations of the eleventh aspect, the optical waveguide provided in any one of the possible implementations of the thirteenth aspect, the optical waveguide provided in any one of the possible implementations of the fifteenth aspect, the optical waveguide according to any one of the possible implementations of the eighteenth aspect, the optical waveguide according to any one of the possible implementations of the nineteenth aspect, the optical waveguide according to any one of the possible implementations of the twenty-fifth aspect, and the optical waveguide according to any one of the implementations of the twenty-eighth aspect.

The near-eye display device provided in the third aspect, the fifth aspect, the seventh aspect, the ninth aspect, the tenth aspect, the twelfth aspect, the fourteenth aspect, the sixteenth aspect, the twentieth aspect, the twenty -sixth aspect, or the twenty-ninth aspect of this application may include the optical waveguide according to any one of the possible implementations of the thirtieth aspect.

According to a thirty-second aspect, this application further provides a method for preparing an optical waveguide, including: fabricating a first anti-reflection layer on an optical waveguide body, so that the first anti-reflection layer and the optical waveguide body are disposed in a stacked manner; fabricating a filling body layer on a side that is of the first anti-reflection layer and that is away from the optical waveguide body; fabricating a second anti-reflection layer on a side that is of the filling body layer and that is away from the first anti-reflection layer, where a refractive index of the second anti-reflection layer exhibits a gradient change trend; and fabricating a surface protection layer on a side that is of the second anti-reflection layer and that is away from the filling body layer. According to the optical waveguide prepared by using the foregoing fabrication method in this application, the filling body layer filled between the optical waveguide body and the surface protection layer can be utilized to achieve support and protection for the optical waveguide body and the surface protection layer.

In addition, the first anti-reflection layer can be utilized to mitigate scattering and absorption of the optical waveguide at an interface, and increase an anti-reflection and antireflective effect at the interface. In a solution in which the second anti-reflection layer has a gradient refractive index, gradient changing refractive index design is formed between the surface protection layer and the filling body layer, to resolve a problem of light reflection between the surface protection layer and the filling body layer, and improve light transmission of the optical waveguide.

In a possible implementation, the step of fabricating a filling body layer on a side that is of the first anti-reflection layer and that is away from the optical waveguide body includes: adding a refraction medium to a substrate material, and mixing them evenly to obtain a filling body material; coating the filling body material on the first anti-reflection layer by using a multi-time spin-coating method, roll coating with ultrasonic spraying, air spraying, or a Czochralski process; and curing the filling body material to obtain the filling body layer.

In a possible implementation, the step of adding a refraction medium to a substrate material includes: adding a refraction material to a dispersion liquid, and mixing them evenly; and fabricating the refraction medium from the refraction material by using a spray granulation method, where a particle size of the refraction medium is 0.1 μm to 100 μm. Compared with common drying, spray drying has a further function of granulation, can reduce a size of a finished product to some extent, and a shape is relatively regular.

In a possible implementation, the step of fabricating a filling body layer on a side that is of the first anti-reflection layer and that is away from the optical waveguide body includes: adding a silicon source material to a solvent, and performing coating on the first anti-reflection layer; and curing the silicon source material by using a two-step acid-base method and an alcohol supercritical drying method, to obtain the filling body layer. A purpose of the foregoing steps is to use an aerogel as the filling body layer, and fabricate, on the first anti-reflection layer by using a supercritical drying method and utilizing a pore-adjustable characteristic of the aerogel, an aerogel that meets a refractive index requirement. In comparison with the substrate and the refraction medium in the foregoing implementation, steps of fabricating the aerogel are simple, and material costs are low.

In a possible implementation, the step of fabricating a second anti-reflection layer on a side that is of the filling body layer and that is away from the first anti-reflection layer includes: fabricating, on the side that is of the filling body layer and that is away from the first anti-reflection layer, a plurality of second anti-reflection sublayers disposed in a stacked manner, where in a direction from the optical waveguide body to the surface protection layer, refractive indexes of the plurality of second anti-reflection sublayers increase along a gradient. The plurality of second anti-reflection sublayers may be fabricated one by one in a step-by-step fabrication manner, and raw material properties of the second anti-reflection sublayer may be adjusted to obtain the second anti-reflection sublayers with different refractive indexes.

In a possible implementation, the step of fabricating, on the side that is of the filling body layer and that is away from the first anti-reflection layer, a plurality of second anti-reflection sublayers disposed in a stacked manner includes: adding a refraction medium to a substrate material, and mixing them evenly to obtain a filling body material; mixing the filling body material and the substrate material based on a preset ratio to obtain a plurality of groups of second anti-reflection materials, where the plurality of groups of second anti-reflection materials have different refractive indexes; and sequentially coating and curing the plurality of groups of second anti-reflection materials on the filling body layer, to obtain the plurality of second anti-reflection sublayers disposed in a stacked manner. A characteristic of fabricating the second anti-reflection sublayer by using the method provided in the foregoing steps is that the filling body material provided in the foregoing implementation, supplemented with different proportions of substrate materials, may be utilized to obtain a plurality of second anti-reflection materials with different refractive indexes. An advantage is that preparation of the second anti-reflection sublayer can be continued by using an existing material of the filling body layer without adding a new ingredient, and without changing a process and a production line. This is applicable to mass production and costs are controllable.

In a possible implementation, the step of fabricating, on the side that is of the filling body layer and that is away from the first anti-reflection layer, a plurality of second anti-reflection sublayers disposed in a stacked manner includes: adding a silicon source material to a solvent to obtain a plurality of groups of second anti-reflection materials, where the plurality of groups of second anti-reflection materials have different volume ratios of the silicon source material to the solvent; and sequentially coating and curing the plurality of groups of second anti-reflection materials on the filling body layer, to obtain the plurality of second anti-reflection sublayers disposed in a stacked manner. A characteristic of fabricating the second anti-reflection sublayer by using the method provided in the foregoing steps is that the filling body material provided in the foregoing implementation, supplemented with different proportions of silicon source materials, may be utilized to fabricate an aerogel with a plurality of porosities by using second anti-reflection materials with different concentration ratios. An advantage is that preparation of the second anti-reflection sublayer can be continued by using an existing material of the filling body layer without adding a new ingredient, and without changing a process and a production line. This is applicable to mass production and costs are controllable.

According to a thirty-third aspect, this application provides an optical waveguide, used in a near-eye display device, and including a first waveguide substrate and a first grating structure formed on a surface of the first waveguide substrate. The first waveguide substrate is used for total internal reflection of an optical path, both the first waveguide substrate and the first grating structure are flexible, and the optical waveguide has a deformable characteristic, so that the optical waveguide is capable of adapting to different-curvature lenses of the near-eye display device. In this implementation, both the first waveguide substrate and the first grating structure are flexible, and it may be understood that all structures in the optical waveguide are flexible, so that the optical waveguide may be freely bent to match different-curvature lenses, thereby achieving lightness and thinness of the lens and contributing to lightweight of the near-eye display device.

In a possible implementation, a refractive index of the first waveguide substrate is greater than or equal to 1.6, and a thickness of the first waveguide substrate is less than 300 $\mu$m. In this solution, the refractive index and the thickness of the first waveguide substrate are restricted, so that arrangement of the first waveguide substrate can meet total internal reflection propagation of light in the first waveguide substrate, and thin design is ensured on a basis of good optical performance. The thickness of the first waveguide substrate is set to be within 300 $\mu$m, and a material of the first waveguide substrate is restricted, so that flexibility performance can be improved.

In a possible implementation, a material of the first waveguide substrate is flexible glass or a flexible optical resin material. In this solution, the material of the first waveguide substrate is restricted, to restrict flexibility performance of the first waveguide substrate.

In a possible implementation, the first grating structure is integrally formed in the first waveguide substrate. For example, the first grating structure is formed on the surface of the first waveguide substrate by using an etching process. In the optical waveguide provided in this implementation, the first grating structure is directly fabricated on the first waveguide substrate, without a need to additionally dispose a material layer for grating fabrication. The first grating structure and the first waveguide substrate are of an integrated structure, structural stability is better, diffraction efficiency is easy to modulate, and optical performance is easy to maintain.

In a possible implementation, the first grating structure is formed on the surface of the first waveguide substrate by using an etching process.

In a possible implementation, the first grating structure is formed on a first grating layer, the first grating layer and the first waveguide substrate are disposed in a stacked manner, the first grating layer is flexible, and a material of the first grating layer is an imprint adhesive.

In a possible implementation, a thickness of the first grating layer is greater than or equal to 0.2 $\mu$m and less than or equal to 1.2 $\mu$m, and a refractive index of the first grating layer is greater than or equal to 1.6. In this solution, a thickness range and a refractive index range of the first grating layer are restricted, to ensure flexibility performance of the first grating layer. In this solution, diffraction efficiency may be modulated by setting different refractive indexes.

In a possible implementation, the optical waveguide further includes a first modulation layer, the first modulation layer and the first waveguide substrate are disposed in a stacked manner, a part of the first modulation layer is filled in the first grating structure, and a difference between a refractive index of the first modulation layer and a refractive index of the first grating structure is greater than or equal to 0.1. In this solution, the first modulation layer is additionally disposed on a surface on which a grating of the optical waveguide is located. The first modulation layer covers the first grating structure, and the first modulation layer is configured to protect the first grating structure. In addition, the first modulation layer can modulate diffraction efficiency of the optical waveguide, so that diffraction efficiency of the optical waveguide can meet a requirement of a use scenario, allowing the optical waveguide to be applied to a large quantity of scenarios.

In a possible implementation, the refractive index of the first modulation layer is less than the refractive index of the first grating structure.

Specifically, the refractive index of the first modulation layer is greater than or equal to 1.9. This solution is mainly used to adjust diffraction efficiency of the first grating structure. Because there is the refractive index difference (the refractive index difference is greater than or equal to 0.1) between the first modulation layer and the first grating structure, diffraction efficiency changes. In order to ensure the refractive index difference between the first modulation layer and the first grating structure, the refractive index of the first modulation layer can be restricted to be within a range greater than or equal to 1.9.

In a possible implementation, the refractive index of the first modulation layer is greater than the refractive index of the first grating structure.

Specifically, this solution is mainly used to adjust diffraction efficiency of the first grating structure. Because there is a refractive index difference (the refractive index difference is greater than or equal to 0.1) between the first modulation layer and the first grating structure, diffraction efficiency changes. In order to ensure the refractive index difference between the first modulation layer and the first grating structure, the refractive index of the first modulation layer can be restricted to be within a range less than or equal to 1.6.

In a possible implementation, a first auxiliary grating structure is disposed on a surface that is of the first modulation layer and that is away from the first grating structure, and the first auxiliary grating structure is configured to modulate a light ray. The first auxiliary grating structure may be an in-coupling grating, a relay grating, or an out-coupling grating.

In a possible implementation, the optical waveguide further includes a second grating structure, and the first grating structure and the second grating structure are respectively located on two opposite sides of the first waveguide substrate. This solution defines a double-sided optical waveguide architecture, and diffraction efficiency of the optical waveguide is improved by combining the first grating structure and the second grating structure.

In a possible implementation, the optical waveguide further includes a second modulation layer, the second modulation layer and the first waveguide substrate are disposed in a stacked manner, a part of the second modulation layer is filled in the first grating structure, and a difference between a refractive index of the second modulation layer and a refractive index of the first grating structure is greater than 0.1.

In a possible implementation, the optical waveguide further includes a second waveguide substrate, an optical limiting layer, and a third grating structure, the second waveguide substrate is used for total internal reflection of the optical path, the second waveguide substrate is flexible, the optical limiting layer is disposed between the first waveguide substrate and the second waveguide substrate in a stacked manner, the optical limiting layer is also flexible and is transparent, a refractive index of the optical limiting layer is less than the refractive index of the first waveguide substrate and is also less than a refractive index of the second waveguide substrate, the optical limiting layer is configured to ensure total internal reflection of the first waveguide substrate and total internal reflection of the second waveguide substrate, and the third grating structure is formed on the second waveguide substrate. This solution provides a multi-layer optical waveguide architecture, and two layers of architectures are separated by a limiting layer to ensure independent working of each layer.

In a possible implementation, a thickness of the optical limiting layer is less than or equal to 100 $\mu$m. In this solution, the thickness of the optical limiting layer is controlled to be less than or equal to 100 $\mu$m, which helps control thinning of the optical waveguide, so that the optical waveguide forms a thin film architecture, to achieve a good attaching affect in a process of attaching the optical waveguide to a curved lens surface.

In a possible implementation, the optical waveguide further includes a flexible substrate layer, the flexible substrate layer is disposed in a stacked manner with the first waveguide substrate, and is located on a side that is of the first waveguide substrate and that is away from the first grating structure, the flexible substrate layer is transparent and has a refractive index less than the refractive index of the first waveguide substrate, and the flexible substrate layer is configured to be attached to a lens of the near-eye display device. In this solution, a flexible substrate layer is added onto the first waveguide substrate, and the flexible substrate layer is attached to the lens, so that the first waveguide substrate can be prevented from being directly attached to the lens. If the first waveguide substrate is directly attached to the lens, an adhesive for attaching may affect an optical parameter of the first waveguide substrate. The flexible substrate layer can protect the first waveguide substrate, to ensure optical performance of the optical waveguide.

According to a thirty-fourth aspect, this application provides a method for fabricating an optical waveguide. The fabrication method is used to fabricate the optical waveguide provided in any one of the possible implementations of the thirty-third aspect. The fabrication method includes:

providing a rigid substrate, where the rigid substrate includes a fabrication plane;
forming a sacrificial layer on the fabrication plane;
fabricating the optical waveguide on the sacrificial layer; and
dissolving the sacrificial layer to obtain the optical waveguide.

In a possible implementation, the step of fabricating the optical waveguide on the sacrificial layer includes:

disposing a first waveguide substrate on the sacrificial layer, where a refractive index of the first waveguide substrate is greater than or equal to 1.6, and a thickness of the first waveguide substrate is less than 300 $\mu$m; and
fabricating a first grating structure on the first waveguide substrate.

In a possible implementation, the step of fabricating the optical waveguide on the sacrificial layer includes:

providing an optical waveguide intermediate structure, where the optical waveguide intermediate structure is flexible and includes a first waveguide substrate and a first grating structure formed on a surface of the first waveguide substrate;
disposing the optical waveguide intermediate structure on the sacrificial layer, where the first grating structure is in full contact with the sacrificial layer; and
fabricating a second grating structure on a side that is of the first waveguide substrate and that is away from the first grating structure.

In a possible implementation, the step of fabricating the optical waveguide on the sacrificial layer includes:

disposing a first waveguide substrate on the sacrificial layer, where the first waveguide substrate is used for total internal reflection of an optical path, and the first waveguide substrate is flexible;
fabricating a first grating structure on the first waveguide substrate;

forming an optical limiting layer on the first grating structure, where the optical limiting layer is also flexible and is transparent, and a refractive index of the optical limiting layer is less than a refractive index of the first waveguide substrate;

fabricating a second waveguide substrate on the optical limiting layer, where the second waveguide substrate is used for total internal reflection of an optical path, and the second waveguide substrate is flexible; and

fabricating a third grating structure on the second waveguide substrate.

According to the method for fabricating an optical waveguide provided in this application, the optical waveguide is fabricated on the rigid substrate and the sacrificial layer by using a planar fabrication process, so that batch production is easy to implement. Then, the sacrificial layer is dissolved by using properties of the sacrificial layer to remove the rigid substrate, so as to form a flexible optical waveguide. The method for fabricating an optical waveguide provided in this application is easy to process, and has low fabrication costs. Flexibility performance of the optical waveguide can be ensured while an optical waveguide is being produced. In particular, a flexible optical waveguide whose surface has a relief grating may be fabricated on a large scale by using a nano-imprinting process.

According to a thirty-fifth aspect, this application provides a near-eye display device, including lenses and the optical waveguide provided in any one of the possible implementations of the thirty-third aspect. The lens includes a curved surface part, and the optical waveguide is attached to a surface layer or an intermediate layer of the curved surface part of the lens.

The near-eye display device provided in the thirty-fifth aspect of this application may include any one or a combination of the following solutions: the light combining unit provided in any one of the possible implementations of the first aspect of this application, the optical engine provided in any one of the possible implementations of the second aspect of this application, the optical component provided in the fourth aspect of this application, the optical waveguide provided in any one of the possible implementations of the sixth aspect, the optical waveguide provided in any one of the possible implementations of the eighth aspect, the optical waveguide provided in any one of the possible implementations of the eleventh aspect, the optical waveguide provided in any one of the possible implementations of the thirteenth aspect, the optical waveguide provided in any one of the possible implementations of the fifteenth aspect, the optical waveguide according to any one of the possible implementations of the eighteenth aspect, the optical waveguide according to any one of the possible implementations of the nineteenth aspect, the optical waveguide according to any one of the possible implementations of the twenty-fifth aspect, the optical waveguide according to any one of the implementations of the twenty-eighth aspect, and the optical waveguide according to any one of the possible implementations of the thirtieth aspect.

The near-eye display device provided in the third aspect, the fifth aspect, the seventh aspect, the ninth aspect, the tenth aspect, the twelfth aspect, the fourteenth aspect, the sixteenth aspect, the twentieth aspect, the twenty-sixth aspect, the twenty-ninth aspect, or the thirty-first aspect of this application may include the optical waveguide according to any one of the possible implementations of the thirty-third aspect.

**BRIEF DESCRIPTION OF DRAWINGS**

FIG. 1 is a diagram of a near-eye display device according to an implementation of this application;
FIG. 2 is a diagram of a near-eye display device according to an implementation of this application;
FIG. 3 is a diagram of the implementation shown in FIG. 1 or the implementation shown in FIG. 2 in another direction;
FIG. 4 is a planar diagram of a near-eye display device according to an implementation of this application;
FIG. 5 is a diagram of an optical engine according to an implementation of this application;
FIG. 6 is a three-dimensional diagram of a light combining unit according to an implementation of this application;
FIG. 7 is a three-dimensional exploded diagram of the light combining unit shown in FIG. 6;
FIG. 8 is an exploded diagram of the light combining unit shown in FIG. 6 in a state;
FIG. 9 is an exploded diagram of the light combining unit shown in FIG. 6 in a state;
FIG. 10A is a three-dimensional diagram of an optical engine according to an implementation of this application;
FIG. 10B is a diagram of an optical path of a second wavelength range emitting unit in the implementation provided in FIG. 10A;
FIG. 10C is a diagram of an optical waveguide according to an implementation;
FIG. 11 is a three-dimensional diagram of an optical engine according to an implementation of this application;
FIG. 12 is a three-dimensional diagram of an optical engine according to an implementation of this application;
FIG. 13 is a three-dimensional diagram of a light combining unit according to an implementation of this application;
FIG. 14 is a three-dimensional exploded diagram of the light combining unit shown in FIG. 13;
FIG. 15 is a three-dimensional exploded diagram of the light combining unit shown in FIG. 13 in a state;

FIG. 16 is a three-dimensional exploded diagram of the light combining unit shown in FIG. 13 in a state;

FIG. 17 is a three-dimensional exploded diagram of the light combining unit shown in FIG. 13 in a state;

FIG. 18 is a three-dimensional exploded diagram of the light combining unit shown in FIG. 13 in a state;

FIG. 19 is a three-dimensional diagram of an optical engine according to an implementation of this application;

FIG. 20 is a planar diagram of the optical engine shown in FIG. 19 in a direction;

FIG. 21 is an exploded diagram of a light combining unit and a light emitting unit in the optical engine shown in FIG. 19;

FIG. 22 is a diagram of an optical component according to an implementation of this application;

FIG. 23 is a diagram of a ghost image problem generated by the optical component shown in FIG. 22;

FIG. 24A and FIG. 24B are diagrams of an optical component according to an implementation of this application, where FIG. 24A and FIG. 24B are respectively diagrams of light rays emitted at a position B1 and a position B2 on a light emitting unit and reflected by an in-coupling grating;

FIG. 25A and FIG. 25B are diagrams of an optical component according to an implementation of this application, where FIG. 25A and FIG. 25B are respectively diagrams of light rays emitted at a position B1 and a position B2 on a light emitting unit and reflected by an in-coupling grating;

FIG. 26A and FIG. 26B are diagrams of an optical component according to an implementation of this application, where FIG. 26A and FIG. 26B are respectively diagrams of light rays emitted at a position B1 and a position B2 on a light emitting unit and reflected by an in-coupling grating;

FIG. 27A and FIG. 27B are diagrams of an optical component according to an implementation of this application, where FIG. 27A and FIG. 27B are respectively diagrams of light rays emitted at a position B1 and a position B2 on a light emitting unit and reflected by an in-coupling grating;

FIG. 28 schematically illustrates three position relationships between an additional structure and a waveguide body structure;

FIG. 29 schematically illustrates a parameter of a field of view of an optical engine;

FIG. 30 is a diagram of an optical waveguide according to an implementation of this application;

FIG. 31 is a diagram in which a two-dimensional grating divides light into eight propagation directions;

FIG. 32 is a diagram of light out-coupling efficiency of the optical waveguide shown in FIG. 31;

FIG. 33 is a diagram of an optical waveguide according to an implementation of this application;

FIG. 34 is a diagram of an optical waveguide according to an implementation of this application;

FIG. 35 is a diagram of an optical waveguide according to an implementation of this application;

FIG. 36 is a diagram of an optical waveguide according to an implementation of this application;

FIG. 37 is a diagram of an optical waveguide according to an implementation of this application;

FIG. 38 is a diagram of an optical waveguide according to an implementation of this application;

FIG. 39 is a diagram of an optical waveguide according to an implementation of this application;

FIG. 40 is a diagram of an optical waveguide according to an implementation of this application;

FIG. 41 is a diagram of an optical waveguide according to an implementation of this application;

FIG. 42A is a diagram of an optical waveguide according to an implementation of this application;

FIG. 42B is a diagram of an optical waveguide according to an implementation of this application;

FIG. 43 is a diagram of three different configurations of a virtual image distance and a parallax corresponding to a virtual image on a virtual image plane generated by an optical waveguide according to this application;

FIG. 44 is a diagram of an eye movement space formed by an out-coupling grating of an optical waveguide according to an implementation of this application;

FIG. 45 is a principle diagram of an optical path for forming a VAC phenomenon through wide beam imaging;

FIG. 46 is a principle diagram of an optical path for resolving a VAC problem through fine light beam imaging;

FIG. 47 is a diagram of an optical waveguide according to an implementation of this application, where an out-coupling grating in the optical waveguide includes an architecture of a plurality of sub-gratings;

FIG. 48 is a diagram of the out-coupling grating of the optical waveguide shown in FIG. 47;

FIG. 49A shows a specific structural form of two sub-gratings according to an implementation of this application;

FIG. 49B shows a specific structural form of two sub-gratings according to an implementation of this application;

FIG. 50 is a diagram of an optical waveguide according to an implementation of this application, where an out-coupling grating in the optical waveguide includes an architecture of a plurality of sub-gratings;

FIG. 51 is a diagram of an optical waveguide according to an implementation, where grating structures are disposed on two opposite sides of a waveguide substrate;

FIG. 52 is a diagram of a grating structure on a front surface of the waveguide substrate in FIG. 51;

FIG. 53 is a diagram of a grating structure on a back surface of the waveguide substrate in FIG. 51;

FIG. 54 is a diagram of two sub-gratings according to an implementation of this application;

FIG. 55 is a diagram of an out-coupling grating of an optical waveguide according to an implementation of this application;

FIG. 56 is a diagram of an optical waveguide according to an implementation of this application;

FIG. 57 is a diagram of a near-eye display device according to an implementation of this application;

FIG. 58 is a diagram of a control architecture between a control unit and an out-coupling grating in the near-eye display device shown in FIG. 57;

FIG. 59 shows an architecture of the out-coupling grating in the implementation shown in FIG. 57 and FIG. 58;

FIG. 60 is a diagram of a distribution architecture of sub-gratings in a working state of the out-coupling grating shown in FIG. 59;

FIG. 61 is a diagram of an optical waveguide according to an implementation of this application;

FIG. 62 is an exploded diagram of a part of a grating structure and a part of a waveguide substrate in FIG. 61;

FIG. 63 is a diagram of an end face of a grating structure of an optical waveguide according to an implementation of this application;

FIG. 64 is a diagram of curves showing a correspondence between an incident angle and diffraction efficiency for comparison between a grating structure with sinusoidal gradient refractive index distribution and a grating structure with a single-core structure;

FIG. 65 is an exploded diagram of a part of a grating structure and a part of a waveguide substrate of an optical waveguide according to an implementation of this application;

FIG. 66 is a diagram of a second film layer in a grating structure in an optical waveguide according to an implementation of this application;

FIG. 67 is a diagram of fabricating a core structure on a waveguide substrate;

FIG. 68 is a diagram of three steps of completing fabrication of a grating structure on a basis of the structure shown in FIG. 67;

FIG. 69 is a diagram of a core structure and a film structure on a waveguide substrate of an optical waveguide according to an implementation of this application;

FIG. 70 is a diagram of a grating structure on a waveguide substrate of an optical waveguide according to an implementation of this application;

FIG. 71 is a three-dimensional diagram of an optical waveguide according to an implementation of this application;

FIG. 72 is a planar diagram of an optical waveguide according to an implementation of this application;

FIG. 73 is a planar diagram of an optical waveguide according to an implementation of this application;

FIG. 74 is a planar diagram of an optical waveguide according to an implementation of this application;

FIG. 75 is a diagram of an optical waveguide according to an implementation of this application;

FIG. 76 is a diagram of K-space of a grating period of an optical waveguide according to an implementation of this application;

FIG. 77 is a diagram of K-space of a grating period of an optical waveguide according to an implementation of this application;

FIG. 78 is a diagram of an optical waveguide according to an implementation of this application;

FIG. 79 is a diagram of an optical waveguide according to an implementation of this application;

FIG. 80 is a diagram of diffraction efficiency of a single grating of an optical waveguide according to an implementation of this application;

FIG. 81 is a diagram of a wavelength bandwidth of an optical waveguide according to an implementation of this application;

FIG. 82 is a diagram of an angular bandwidth of an optical waveguide according to an implementation of this application;

FIG. 83 is a schematic flowchart of multi-exposure fabrication in a process of fabricating a first grating layer or a second grating layer of an optical waveguide according to an implementation of this application;

FIG. 84 is a diagram of an optical waveguide according to an implementation of this application;

FIG. 85 is a diagram of an optical waveguide according to an implementation of this application;

FIG. 86 is a diagram of an optical waveguide according to an implementation of this application;

FIG. 87 is a diagram of an optical waveguide according to an implementation of this application;

FIG. 88 is a diagram of an optical waveguide according to an implementation of this application;

FIG. 89 is a diagram of an optical waveguide according to an implementation of this application;

FIG. 90 is an enlarged diagram of a part I in FIG. 89;

FIG. 91 is a diagram of an optical waveguide according to an implementation of this application;

FIG. 92 is a diagram of a co-location structure formed by an antireflective layer and an out-coupling grating in an optical waveguide according to an implementation of this application;

FIG. 93 is a diagram of a co-location structure formed by an antireflective layer and an out-coupling grating in an optical waveguide according to an implementation of this application;

FIG. 94 is a diagram of an optical waveguide according to an implementation of this application;

FIG. 95 is a diagram of a specific method for fabricating a co-location structure formed by an antireflective layer and a grating structure;

FIG. 96 is a flowchart of a method for fabricating an optical waveguide according to an implementation of this application;

FIG. 97 is a diagram of changes of components in a process of performing dual-beam exposure on a material layer in a method for fabricating an optical waveguide according to an implementation of this application;

FIG. 98 is a diagram of an optical waveguide according to an implementation of this application;

FIG. 99 is a diagram of an optical waveguide according to an implementation of this application;

FIG. 100 is a diagram of an optical waveguide according to an implementation of this application;

FIG. 101 is a diagram of an optical waveguide according to an implementation of this application;

FIG. 102 is a diagram of an optical waveguide according to an implementation of this application;

FIG. 103 is a diagram of an optical waveguide according to an implementation of this application;

FIG. 104 is a diagram of an optical waveguide according to an implementation of this application;

FIG. 105 is a diagram of an optical waveguide according to an implementation of this application;

FIG. 106A is a diagram of an optical waveguide according to an implementation of this application;

FIG. 106B is a diagram of an optical waveguide according to an implementation of this application;

FIG. 106C is a diagram of an optical waveguide according to an implementation of this application;

FIG. 107 is a diagram of an optical waveguide according to an implementation of this application;

FIG. 108 is a diagram of an optical waveguide according to an implementation of this application;

FIG. 109 is a schematic flowchart of a method for fabricating an optical waveguide according to an implementation of this application;

FIG. 110 is a schematic flowchart of a method for fabricating an optical waveguide according to an implementation of this application;

FIG. 111 is a schematic flowchart of a method for fabricating an optical waveguide according to an implementation of this application;

FIG. 112 is a schematic flowchart of a method for fabricating an optical waveguide according to an implementation of this application;

FIG. 113 is a diagram of a cross-sectional structure of an optical waveguide according to an implementation of this application;

FIG. 114 is a diagram of a cross-sectional structure of an optical waveguide according to an implementation of this application;

FIG. 115 is a diagram of a cross-sectional structure of an optical waveguide according to an implementation of this application;

FIG. 116 is a diagram of a cross-sectional structure of an optical waveguide according to an implementation of this application;

FIG. 117 is a diagram of a cross-sectional structure of an optical waveguide according to an implementation of this application;

FIG. 118A is a diagram of a cross-sectional structure of an optical waveguide according to an implementation of this application;

FIG. 118B is a diagram of a cross-sectional structure of an optical waveguide according to an implementation of this application;

FIG. 118C is a diagram of a cross-sectional structure of an optical waveguide according to an implementation of this application;

FIG. 119 is a diagram of a cross-sectional structure of an optical waveguide according to an implementation of this application;

FIG. 120 is a diagram of a cross-sectional structure of an optical waveguide according to an implementation of this application;

FIG. 121 is a diagram of a cross-sectional structure of an optical waveguide according to an implementation of this application;

FIG. 122 is a planar diagram of an optical waveguide according to an implementation of this application;

FIG. 123 is a diagram of a cross-sectional structure, cut along A-A, of the optical waveguide shown in FIG. 122;

FIG. 124 is a diagram of another cross-sectional structure, cut along A-A, of the optical waveguide shown in FIG. 122;

FIG. 125 is a planar diagram of an optical waveguide according to an implementation of this application;

FIG. 126 is a diagram of a cross-sectional structure, cut along B-B, of the optical waveguide shown in FIG. 125;

FIG. 127 is a diagram of another cross-sectional structure, cut along B-B, of the optical waveguide shown in FIG. 125;

FIG. 128 is a diagram of an optical waveguide according to an implementation of this application;

FIG. 129 is an exploded diagram of a structure of each layer of an optical waveguide according to an implementation of this application;

FIG. 130 is a diagram of an optical path of a light ray propagated in the optical waveguide shown in FIG. 129;

FIG. 131 is a diagram of division of a first region and a second region of the optical waveguide shown in FIG. 129;

FIG. 132 is a diagram of a structure of a first grating layer according to an implementation of this application;

FIG. 133 is a diagram of a structure of a first grating layer in some other implementations;

FIG. 134 is a diagram of a structure of a second grating layer according to an implementation of this application;

FIG. 135 is a diagram of a structure of a second grating layer in some other implementations;

FIG. 136 is a diagram of a structure of a second grating layer in some other implementations;

FIG. 137 is a diagram of a structure of an optical waveguide including the first grating layer in FIG. 133 and the second grating layer in FIG. 135;

FIG. 138 is a diagram of a structure of an optical waveguide including the first grating layer in FIG. 132 and the second grating layer in FIG. 136;

FIG. 139 is a diagram of a structure of an optical waveguide including the first grating layer in FIG. 133 and the second grating layer in FIG. 136;

FIG. 140 is a flowchart of a method for fabricating an optical waveguide according to an implementation of this application;

FIG. 141 is a diagram of preparing a first grating layer in step S1 in FIG. 140;

FIG. 142 is a flowchart of steps of fabricating a second grating layer by using a grating structure mold in step S2 in FIG. 140;

FIG. 143 is a diagram of preparing a second grating layer in step S24 in FIG. 142;

FIG. 144 is a flowchart of steps of fabricating a second grating layer by using a grating structure mold in step S2 in FIG. 140 in another implementation;

FIG. 145 is a preparation diagram of bonding a second grating layer connected to a grating structure mold to a first grating layer by using an adhesion enhancement layer in step S24 in FIG. 144;

FIG. 146 is a diagram of an optical waveguide according to an implementation of this application;

FIG. 147 is a schematic cross-sectional view of layer structures of an optical waveguide according to an implementation of this application;

FIG. 148 is an exploded diagram of the layer structures of the optical waveguide in FIG. 147;

FIG. 149 is a schematic cross-sectional view of a filling body layer that is a substrate and a refraction medium according to an implementation of this application;

FIG. 150 is a schematic cross-sectional view of a filling body layer that is an aerogel according to an implementation of this application;

FIG. 151 is a schematic cross-sectional view of a second anti-reflection layer divided into a plurality of second anti-reflection sublayers according to an implementation of this application;

FIG. 152 is a schematic cross-sectional view of the second anti-reflection layer in FIG. 151 that includes four second anti-reflection sublayers;

FIG. 153 is a schematic cross-sectional view of a second anti-reflection layer divided into a plurality of second anti-reflection sublayers according to another implementation of this application;

FIG. 154 is a schematic cross-sectional view of a filling body layer and a second anti-reflection layer according to an implementation of this application;

FIG. 155 is a schematic cross-sectional view of a filling body layer and a second anti-reflection layer according to another implementation of this application;

FIG. 156 is a schematic cross-sectional view of an optical waveguide including an adhesion enhancement layer according to an implementation of this application;

FIG. 157 is a flowchart of a method for preparing an optical waveguide according to an implementation of this application;

FIG. 158 is a diagram of preparing a filling body layer in step S2 in FIG. 157;

FIG. 159 is a diagram of preparing a refraction medium in step S21 in FIG. 158;

FIG. 160 is a flowchart of steps of preparing a filling body layer in step S2 in FIG. 157;

FIG. 161 is a diagram of preparing another filling body layer in step S2 in FIG. 157;

FIG. 162 is a flowchart of steps of preparing another filling body layer in step S2 in FIG. 157;

FIG. 163 is a diagram of preparing a second anti-reflection layer in step S3 in FIG. 157;

FIG. 164 is a flowchart of step of preparing a second anti-reflection layer in step S3 in FIG. 157;

FIG. 165 is a diagram of preparing another second anti-reflection layer in step S3 in FIG. 157;

FIG. 166 is a diagram of an optical waveguide according to an implementation of this application;

FIG. 167 is a diagram of combining the optical waveguide shown in FIG. 166 with a lens of a near-eye display device;

FIG. 168 is a diagram of an optical waveguide according to an implementation of this application;

FIG. 169 is a diagram of an optical waveguide according to an implementation of this application;

FIG. 170 is a diagram of an optical waveguide according to an implementation of this application;

FIG. 171 is a diagram of an optical waveguide according to an implementation of this application;

FIG. 172A is a diagram of an optical waveguide according to an implementation of this application;

FIG. 172B is a diagram of an optical waveguide according to an implementation of this application;

FIG. 173A is a diagram of an optical waveguide according to an implementation of this application;

FIG. 173B is a diagram of an optical waveguide according to an implementation of this application;

FIG. 173C is a diagram of an optical waveguide according to an implementation of this application;

FIG. 174A is a diagram of an optical waveguide according to an implementation of this application;

FIG. 174B is a diagram of an optical waveguide according to an implementation of this application;

FIG. 175A is a diagram of an optical waveguide according to an implementation of this application;

FIG. 175B is a diagram of an optical waveguide according to an implementation of this application;

FIG. 175C is a diagram of an optical waveguide according to an implementation of this application;

FIG. 176A is a diagram of an optical waveguide according to an implementation of this application;
FIG. 176B is a diagram of an optical waveguide according to an implementation of this application;
FIG. 177 is a diagram of an optical waveguide according to an implementation of this application;
FIG. 178A is a diagram of an optical waveguide according to an implementation of this application;
FIG. 178B is a diagram of an optical waveguide according to an implementation of this application;
FIG. 178C is a diagram of an optical waveguide according to an implementation of this application;
FIG. 179A is a diagram of a method for fabricating an optical waveguide according to an implementation of this application;
FIG. 179B is a diagram of a method for fabricating an optical waveguide according to an implementation of this application;
FIG. 180A is a diagram of a method for fabricating an optical waveguide according to an implementation of this application; and
FIG. 180B is a diagram of a method for fabricating an optical waveguide according to an implementation of this application.

## DESCRIPTION OF EMBODIMENTS

The following embodiments of this application provide a near-eye display device. The near-eye display device may include but is not limited to an AR device. In a specific implementation, the near-eye display device provided in this application is in a form of AR glasses, a head-mounted device, or the like. The following describes the near-eye display device in this application by using an example in which the near-eye display device is AR glasses.

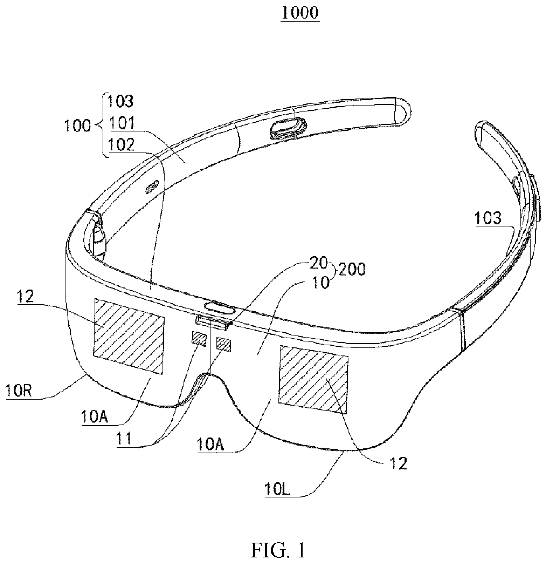

FIG. 1 is a diagram of a near-eye display device according to an implementation of this application. As shown in FIG. 1, a near-eye display device 1000 includes a mechanical part 100 and an optical component 200. The mechanical part 100 is configured to construct an overall appearance architecture of the near-eye display device 1000 and mount an internal optical device and an internal electronic component. The optical component 200 is an optical device. The mechanical part 100 includes a frame 102 and a temple, and the temple includes a right temple 101 and a left temple 103. The right temple 101 and the left temple 103 are respectively connected to two sides of the frame 102, and a connection between the temple and the frame 102 may be a rotatable connection or a fixed connection. When a user wears the near-eye display device 1000, the frame 102 is located in front of eyes of the user, and the temple (the right temple 101 and the left temple 103) is placed on ears of the user. The foregoing structure of the mechanical part 100 is merely an example, and may be designed as required in another embodiment. For example, the mechanical part may be a headband or a helmet of a head-mounted display device.

The optical component 200 includes a lens 10 and an optical engine 20. The lens 10 is mounted to the frame 102 and is configured to be worn in front of a human eye. The lens 10 has light transmission, and the lens 10 has an optical waveguide 10A. For example, the optical waveguide 10A may be of a diffractive optical waveguide structure. In an implementation, all areas on the lens 10 are the optical waveguide 10A, that is, the optical waveguide 10A forms a lens of the near-eye display device 1000. In another implementation, the optical waveguide 10A may alternatively form only a part of the lens 10. The optical waveguide 10A has an in-coupling grating 11 and an out-coupling grating 12. The optical engine 20 is configured to project a light ray onto the optical waveguide 10A. The optical engine 20 projects a light ray onto the in-coupling grating 11, the light ray is coupled by the in-coupling grating 11 into the optical waveguide 10A, undergoes total internal reflection in the optical waveguide 10A, and then is emitted by the out-coupling grating 12. The out-coupling grating 12 emits the light ray, to generate a virtual image to enter a human eye.

In the implementation shown in FIG. 1, the optical engine 20 is located between a left lens 10L and a right lens 10R, and the optical engine 20 is located in a region on the top of the frame 102. Light rays emitted by the optical engine 20 include two paths of light rays. One path of light rays enters an optical waveguide 10A on the left lens 10L through an in-coupling grating 11 on the left lens 10L, and then is emitted by an out-coupling grating 12 on the left lens 10L to form a virtual image. The other path of light rays emitted by the optical engine 20 enters an optical waveguide 10A on the right lens 10R through an in-coupling grating 11 on the right lens 10R, and then is emitted by an out-coupling grating 12 on the right lens 10R to form a virtual image. In the implementation shown in FIG. 1, both the optical engine 20 and the two in-coupling gratings 11 are located at an intersection of the left lens 10L and the right lens 10R, that is, an adjacent region.

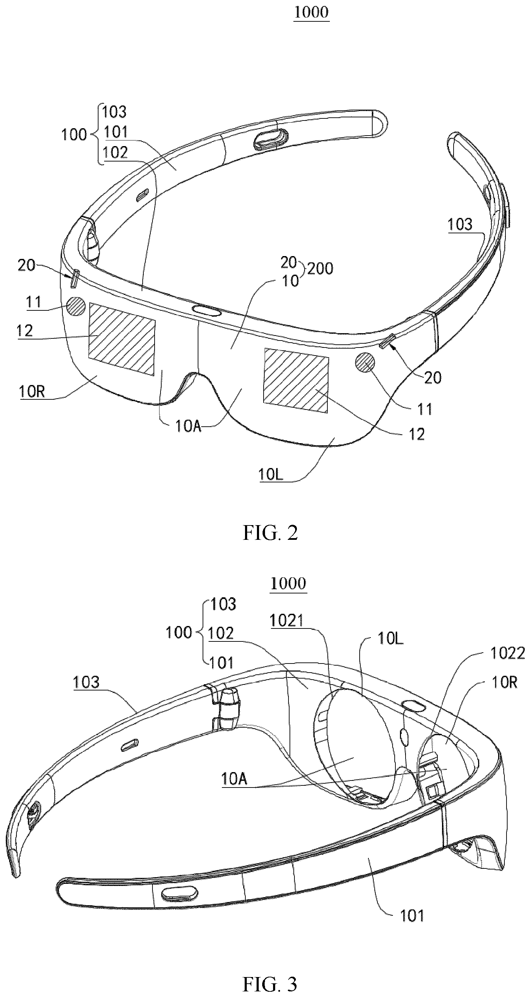

FIG. 2 is a diagram of a near-eye display device according to another implementation of this application. As shown in FIG. 2, a mechanical part 100 of the near-eye display device provided in this implementation is the same as the mechanical part 100 in the implementation shown in FIG. 1. In the implementation shown in FIG. 2, there are two optical engines 20 in an optical component 200, and the two optical engines 20 are respectively located at positions at which two temples are connected to a frame or at nearby positions. One optical engine 20 is located at a connection position between a left temple 103 and a frame 102 or at a position that is on a frame 10 and that is close to the left temple 103, and the other optical engine 20 is located at a connection position between a right temple 101 and the frame 102 or at a position that is on the frame 10 and that is close to the right temple 101. One optical engine 20 is located above the left side of the left lens 10L, and the other optical engine 20 is located above the right side of the right lens 10R. In the implementation shown in FIG. 2, two in-coupling gratings 11 are respectively located in an upper left corner of the left lens 10L and an upper right corner of the right lens 10R. For the left lens 10L, a light ray emitted by the optical engine 20 enters an optical waveguide 10A on the left lens 10L through an in-coupling grating 11 on the left lens 10L, and then is emitted by an out-coupling grating 12 on the left lens 10L to form a virtual image. Similarly, for the right lens 10R, a light ray emitted by the optical engine 20 enters an optical waveguide 10A on the right lens 10R through an in-coupling grating 11 on the right lens 10R, and then is emitted by an out-coupling grating 12 on the right lens 10R to form a virtual image.

FIG. 3 is a diagram of the implementation shown in FIG. 1 or the implementation shown in FIG. 2 in another direction. As shown in FIG. 3, the frame 102 surrounds and defines two clear aperture regions 1021 and 1022. When the near-eye display device 1000 is in a worn state, the two clear aperture regions 1021 and 1022 exactly face a left eye and a right eye respectively. Specifically, the left lens 10L and the right lens 10R are respectively disposed in correspondence with the two clear aperture regions 1021 and 1022. Space surrounded by the clear aperture region 1021 or 1022 is the optical waveguide 10A (or a part of the optical waveguide 10A).

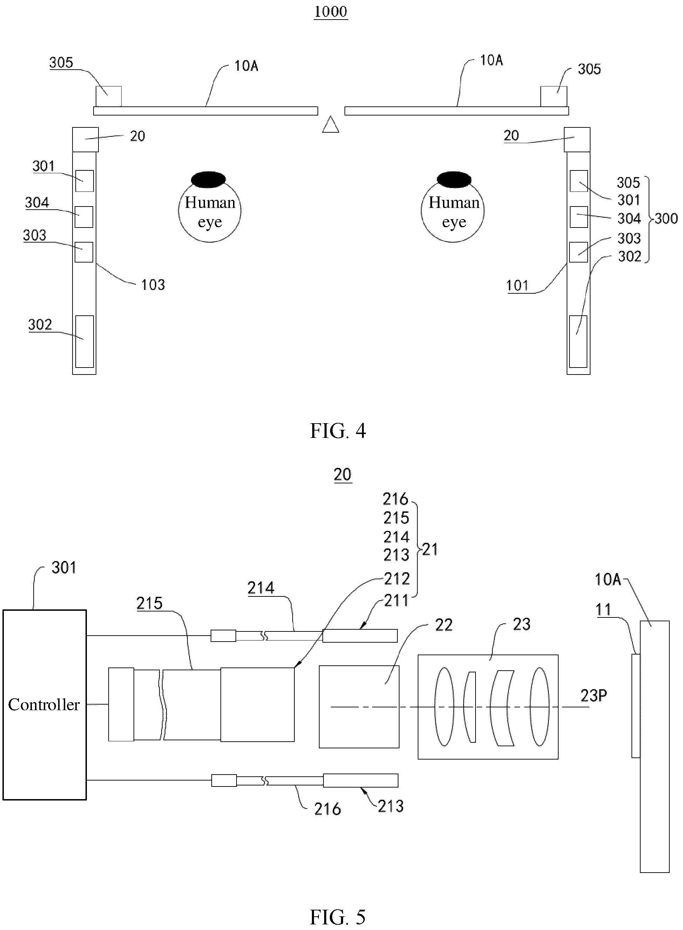

FIG. 4 is a planar diagram of a near-eye display device according to an implementation. As shown in FIG. 4, the near-eye display device 1000 further includes an electronic component 300. In an implementation, the electronic component 300 includes a controller 301, a battery 302, a voice apparatus 303, an antenna 304, a camera 305, and the like. There are two optical engines 20. One optical engine 20 is located at a position that is of the right temple 101 and that is close to an optical waveguide 10A on a lens, and the other optical engine 20 is located at a position that is of the left temple 103 and that is close to an optical waveguide 10A on a lens. In an implementation, there may also be two controllers 301. One controller 301 is located in the left temple 103 and is configured to drive the optical engine 20 mounted at the position of the left temple 103, and the other controller 301 is located in the right temple 101 and is configured to drive the optical engine 20 mounted at the position of the right temple 101. The controller 301 may be disposed on a mainboard of the near-eye display device 1000, and may be a CPU of the near-eye display device 1000. The controller 301 may be configured to control the optical engine 20 to be on or off. In an implementation, the battery 302 is configured to supply power to the near-eye display device 1000. There are also two batteries 302, respectively located on the left temple 103 and the right temple 101. The battery 302 is located at one end that is of the temple and that is away from the lens, to facilitate charging. A charging interface may be disposed on the temple. In an implementation, there are also two voice apparatuses 303 and two antennas 304, and one voice apparatus 303 and one antenna 304 are disposed in each temple. The antenna 304 is configured to receive and send a wireless signal, for example, a Wi-Fi signal, a Bluetooth signal, or a mobile communication signal. The voice apparatus 303 may be configured to input or output sound, and is, for example, a microphone or a speaker. In an implementation, there are two cameras 305, one camera 305 is located at a left edge position of the left lens, and the other camera 305 is located at a right edge position of the right lens. The camera 305 may be connected to an image processor, and the camera 305 is configured to shoot an image, transmit the image to the image processor, and process image information by using the image processor. In another implementation, electronic components such as a memory, a sensor, and a positioning component may be further disposed in the near-eye display device 1000. For example, the memory is configured to store image information, and the sensor may include a power sensor (such as a gyroscope), a biological sensor, a temperature sensor, a humidity sensor, and the like. The positioning component may include a GPS or BeiDou positioning device.

Solution 1: Optical engine

In an implementation, an embodiment of this application provides an optical engine. The optical engine is a self-luminous projection display system, and the optical engine is a light source for image display of a near-eye display device. After a light ray emitted by the optical engine enters an optical waveguide through an in-coupling grating of the optical waveguide, the light ray is coupled by an out-coupling grating of the optical waveguide into a human eye. The coupled-out light ray forms a virtual image, and therefore the human eye can see the virtual image. In an implementation, the optical engine is a micro-display full-color optical engine, so that a color image can be formed.

FIG. 5 is a diagram of an optical engine according to an implementation of this application. Refer to FIG. 5. In an implementation, an optical engine 20 includes a light emitting unit 21, a light combining unit 22, and an optical imaging unit 23. The light emitting unit 21 is located on a light incident side of the light combining unit 22, and the optical imaging unit 23 is located on a light exit side of the light combining unit 22. The light emitting unit 21 is electrically connected to a controller 301, and the controller 301 may control the light emitting unit 21 to be on or off or perform data transmission with the light emitting unit 21. The light emitting unit 21 is a light source of the optical engine 20. The light combining unit 22 is configured to combine monochromatic light emitted by the light emitting unit 21 to form a mixed light beam. The light combining unit 22 transmits the mixed light beam to the optical imaging unit 23. The optical imaging unit 23 is configured to receive the mixed light beam from the light combining unit 22. After passing through the optical imaging unit 23, the mixed light beam is emitted to an in-coupling grating 11 of an optical waveguide 10A. The optical imaging unit 23 may be a lens group, and an optical axis 23P of the optical imaging unit 23 may be an optical axis of the optical engine 20.

In the implementation shown in FIG. 5, the in-coupling grating 11 on the optical waveguide 10A is merely schematically shown, and does not represent a specific structural form of the optical waveguide 10A and the in-coupling grating 11.

In a specific implementation, the light emitting unit 21 includes a first wavelength range emitting unit 211, a second wavelength range emitting unit 212, and a third wavelength range emitting unit 213. The first wavelength range emitting unit 211, the second wavelength range emitting unit 212, and the third wavelength range emitting unit 213 may all be light emitting chips, for example, LED chips. In an implementation, the first wavelength range emitting unit 211 is a red light unit, for example, a red light LED. The second wavelength range emitting unit 212 is a blue light unit, for example, a blue light LED. The third wavelength range emitting unit 213 is a green light unit, for example, a green light LED. The first wavelength range emitting unit 211, the second wavelength range emitting unit 212, and the third wavelength range emitting unit 213 are respectively disposed at different light incident surface positions of the light combining unit 22. It may be understood that the first wavelength range emitting unit 211, the second wavelength range emitting unit 212, and the third wavelength range emitting unit 213 are disposed around the light combining unit 22, and light emitted by the first wavelength range emitting unit 211, the second wavelength range emitting unit 212, and the third wavelength range emitting unit 213 enters the light combining unit 22 from different directions.

With reference to FIG. 4 and FIG. 5, the light emitting unit 21 is electrically connected to the controller 301 in the near-eye display device 1000, and the controller 301 is configured to turn on or off the light emitting unit 21. A position relationship between elements shown in FIG. 5 cannot represent a position relationship between the light emitting unit 21 and the light combining unit 22 in an assembled state provided in any implementation. In this application, positions of the first wavelength range emitting unit 211, the second wavelength range emitting unit 212, and the third wavelength range emitting unit 213 in the light emitting unit 21 are moved, so that the first wavelength range emitting unit 211, the second wavelength range emitting unit 212, and the third wavelength range emitting unit 213 in the light emitting unit 21 are separated from the light combining unit 22. In this way, FIG. 5 forms a diagram in which the light emitting unit 21 and the light combining unit 22 are in an exploded state.

In an implementation, the light emitting unit 21 includes a first flexible circuit board 214, a second flexible circuit board 215, and a third flexible circuit board 216. The first flexible circuit board 214 is connected between the first wavelength range emitting unit 211 and the controller 301, the second flexible circuit board 215 is connected between the second wavelength range emitting unit 212 and the controller 301, and the third flexible circuit board 216 is connected between the third wavelength range emitting unit 213 and the controller 301.

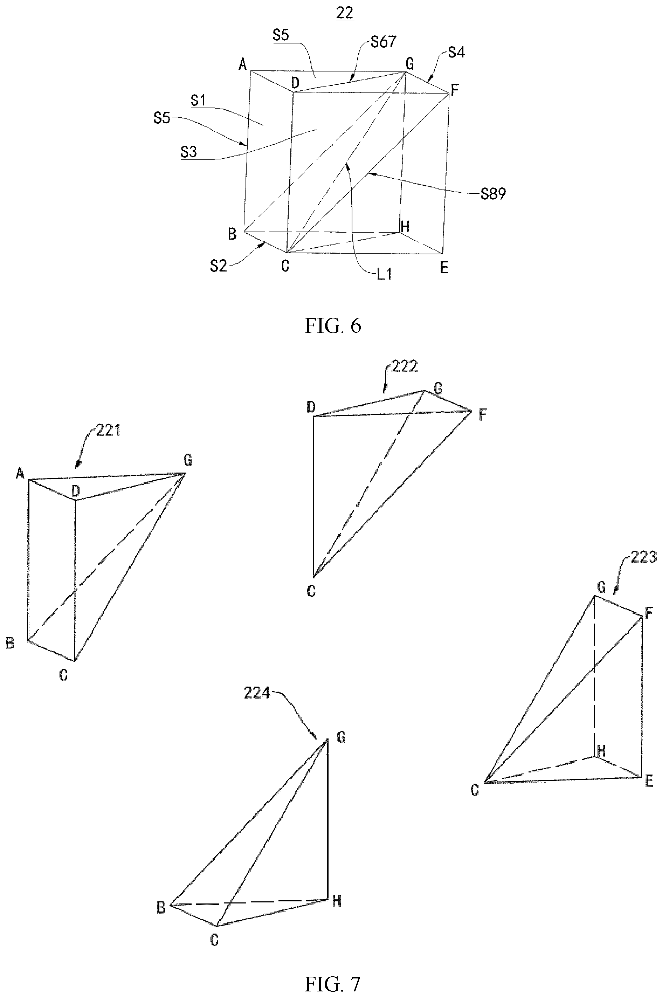

FIG. 6 is a three-dimensional diagram of a light combining unit 22 according to an implementation of this application. As shown in FIG. 6, the light combining unit 22 may be of a hexahedron structure. In this application, A, B, C, D, E, F, G and H are used to represent eight vertices of the light combining unit 22. An outer surface of the light combining unit 22 includes six outer surfaces of a hexahedron structure. In an implementation, four of the six outer surfaces are a first light incident surface S1, a second light incident surface S2, a third light incident surface S3, and a light exit surface S4, and the other two outer surfaces are non-light-incident surfaces S5. In an implementation, as shown in FIG. 6, four vertices of the first light incident surface S1 are A, B, C, and D; four vertices of the second light incident surface S2 are B, C, E, and H; four vertices of the third light incident surface S3 are C, D, F, and E; four vertices of the light exit surface S4 are E, F, G, and H; four vertices of one non-light-incident surface S5 are A, B, H, and G; and four vertices of the other non-light-incident surface S5 are A, D, F, and G. In this application, a specific position of each light incident surface is not limited, provided that the three light incident surfaces correspond to light emitting units with different wavelength ranges (or different colors) and it can be ensured that light rays that are incident from the three light incident surfaces to the light combining unit can be combined into one mixed light beam in the light combining unit and emitted from the light exit surface S4.

The light combining unit 22 provided in the implementation shown in FIG. 6 is four prism structures formed through cutting along two diagonal planes on a cube optical element. For example, four vertices of one of the two diagonal planes are C, D, G, and H; four vertices of the other of the two diagonal planes are B, C, F, and G; and an intersection line of the two diagonal planes is a body diagonal CG of a hexahedron structure.

FIG. 7 is a three-dimensional exploded diagram of the light combining unit shown in FIG. 6. Specific structural forms of the four prism structures are more clearly seen from FIG. 7. The four prism structures are respectively a first prism unit 221, a second prism unit 222, a third prism unit 223, and a fourth prism unit 224. The four prism structures are all special-shaped prisms. The first prism unit 221, the second prism unit 222, the third prism unit 223, and the fourth prism unit 224 are all integrated prism structures, and the four prism units are assembled together to form a hexahedron architecture. The first prism unit 221 and the third prism unit 223 are pentahedron structures (pentahedron prisms), and the second prism unit 222 and the fourth prism unit 224 are tetrahedron structures (tetrahedron prisms). In a specific implementation, the first prism unit 221 includes five vertices A, B, C, D, and G, and an outer surface of the first prism unit 221 includes four triangular surfaces and one square surface; the second prism unit 222 includes four vertices C, D, G, and F, and an outer surface of the second prism unit 222 includes four triangular surfaces; the third prism unit 223 includes five vertices C, E, F, G, and H, and a structural form and a size of the third prism unit 223 are the same as those of the first prism unit 221; and the fourth prism unit 224 includes four vertices B, C, H, and G, and a structural form and a size of the fourth prism unit 224 are the same as those of the second prism unit 222.

In an implementation, in a process of fabricating the light combining unit 22, a hexahedron structure may be first provided, and then the hexahedron structure is cut, that is, cut along two diagonal planes. As shown in FIG. 6, the two diagonal planes are respectively a first diagonal plane S67 (four vertices of the first diagonal plane S67 are C, D, G, and H) and a second diagonal plane S89 (four vertices of the second diagonal plane S89 are B, C, G, and F). After the cutting, an optical splitting film is disposed at a corresponding position. In an implementation, alternatively, the first prism unit 221, the second prism unit 222, the third prism unit 223, and the fourth prism unit 224 may be separately fabricated, and then the first prism unit 221, the second prism unit 222, the third prism unit 223, and the fourth prism unit 224 that are independent of each other are assembled. In addition, an optical splitting film is combined in an assembling process, to form a light combining unit.

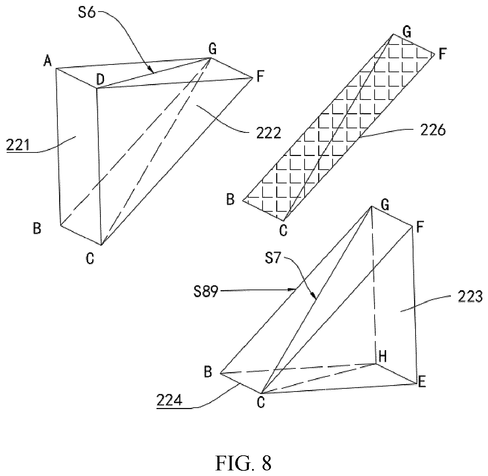

FIG. 8 is an exploded diagram of the light combining unit shown in FIG. 6 in a state. As shown in FIG. 8, an interconnection architecture formed through interconnection between the first prism unit 221 and the second prism unit 222 is in a pentahedron shape, an interconnection architecture formed through interconnection between the third prism unit 223 and the fourth prism unit 224 is in a pentahedron shape, and the two pentahedron interconnection architectures each are a half of a hexahedron structure. In an implementation, the hexahedron structure is a cube. An interconnection position between the first prism unit 221 and the second prism unit 222 is a first surface S6, and an interconnection position between the third prism unit 223 and the fourth prism unit 224 is a second surface S7. As shown in FIG. 8, the first surface S6 is triangular, and three vertices of the first surface S6 are C, D, and G; and the second surface S7 is triangular, and three vertices of the second surface S7 are C, H, and G.

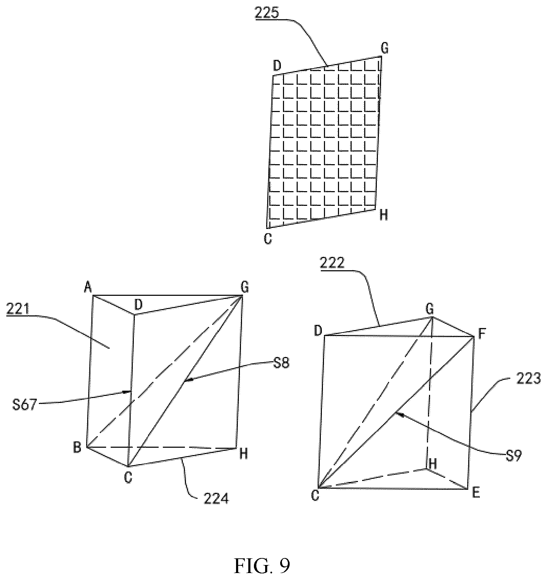

FIG. 9 is an exploded diagram of the light combining unit shown in FIG. 6 in a state. As shown in FIG. 9, an interconnection architecture formed through interconnection between the first prism unit 221 and the fourth prism unit 224 is in a tetrahedron shape, an interconnection architecture formed through interconnection between the second prism unit 222 and the third prism unit 223 is in a tetrahedron shape, and the two tetrahedron interconnection architectures each are a half of a hexahedron structure. An interconnection position between the first prism unit 221 and the fourth prism unit 224 is a third surface S8, and an interconnection position between the second prism unit 222 and the third prism unit 223 is a fourth surface S9. As shown in FIG. 9, the third surface S8 is triangular, and three vertices of the third surface S8 are B, C, and G; and the fourth surface S9 is triangular, and three vertices of the fourth surface S9 are C, G, and F.

With reference to FIG. 6, FIG. 8, and FIG. 9, the first surface S6 and the second surface S7 form the first diagonal plane S67 (four vertices of the first diagonal plane S67 are C, D, G, and H) of the hexahedron structure, and the third surface S8 and the fourth surface S9 form the second diagonal plane S89 (four vertices of the second diagonal plane S89 are B, C, G, and F) of the hexahedron structure, an intersection line L1 between the first diagonal plane S67 and the second diagonal plane S89 is a body diagonal of the hexahedron structure, and two vertices of the intersection line L1 are C and G.

With reference to FIG. 8 and FIG. 9, a first optical splitting film 225 is disposed on the first surface S6 and the second surface S7, and a second optical splitting film 226 is disposed on the third surface S8 and the fourth surface S9. In FIG. 8, a rectangle with vertices B, C, G, and F is schematically represented as the second optical splitting film 226, and in FIG. 9, a rectangle with vertices C, D, G, and H is schematically represented as the first optical splitting film 225. In an implementation, the first optical splitting film 225 may completely cover the first surface S6 and the second surface S7. In another implementation, a size and a shape of the first optical splitting film 225 may alternatively be adjusted as required. For example, the first optical splitting film 225 may cover only a partial region of the first surface S6 and the second surface S7, or the first optical splitting film 225 may be in another shape (for example, a circle or a polygon). Similarly, in an implementation, the second optical splitting film 226 may completely cover the third surface S8 and the fourth surface S9. In another implementation, a size and a shape of the second optical splitting film 226 may alternatively be adjusted as required. For example, the second optical splitting film 226 may cover only a partial region of the third surface S8 and the fourth surface S9, or the second optical splitting film 226 may be in another shape (for example, a circle or a polygon). The first optical splitting film 225 and the second optical splitting film 226 are configured to reflect light rays in different wavelength ranges. Alternatively, the first optical splitting film 225 and the second optical splitting film 226 are configured to reflect light rays of different colors. In this application, optical splitting films are disposed on interconnection surfaces of the four prism units, that is, the first optical splitting film 225 is disposed on the first diagonal plane S67, and the second optical splitting film 226 is disposed on the second diagonal plane S89. The first optical splitting film 225 and the second optical splitting film 226 can perform light splitting processing on light rays in different wavelength ranges, so that after entering the light combining unit 22, the light rays in three different wavelength ranges can be combined to form a mixed light beam and be emitted from the light exit surface S4. In an implementation, the light rays in different wavelength ranges may be light rays of different colors.

In an implementation, as shown in FIG. 8, the second optical splitting film 226 includes two sub-films. Specifically, the two sub-films are both triangular, and are respectively a sub-film BCG and a sub-film CGF. As shown in FIG. 9, the first optical splitting film 225 is of an integrated structure, to be specific, the first optical splitting film 225 is of a rectangular structure. In this implementation, in a process of assembling the first prism unit 221 and the fourth prism unit 224, the sub-film BCG of the second optical splitting film 226 is disposed between the first prism unit 221 and the fourth prism unit 224, and in a process of assembling the second prism unit 222 and the third prism unit 223, the sub-film CGF of the second optical splitting film 226 is disposed between the second prism unit 222 and the third prism unit 223. That is, an exploded diagram state shown in FIG. 9 is formed. Then two separate prism groups shown in FIG. 9 are interconnected. In an interconnection process, the first optical splitting film 225 is disposed at a position for interconnection. The optical splitting film designed in this solution is used in the light combining unit including four prisms. Because the first optical splitting film 225 may be of an integrated structure, the first optical splitting film 225 has advantages of a simple structure and convenient assembly.

It may be understood that, in another implementation, the first optical splitting film 225 is an architecture of two sub-films, and the second optical splitting film 226 is of an integrated structure. In another implementation, the first optical splitting film 225 and the second optical splitting film 226 each may be an architecture including two sub-films.

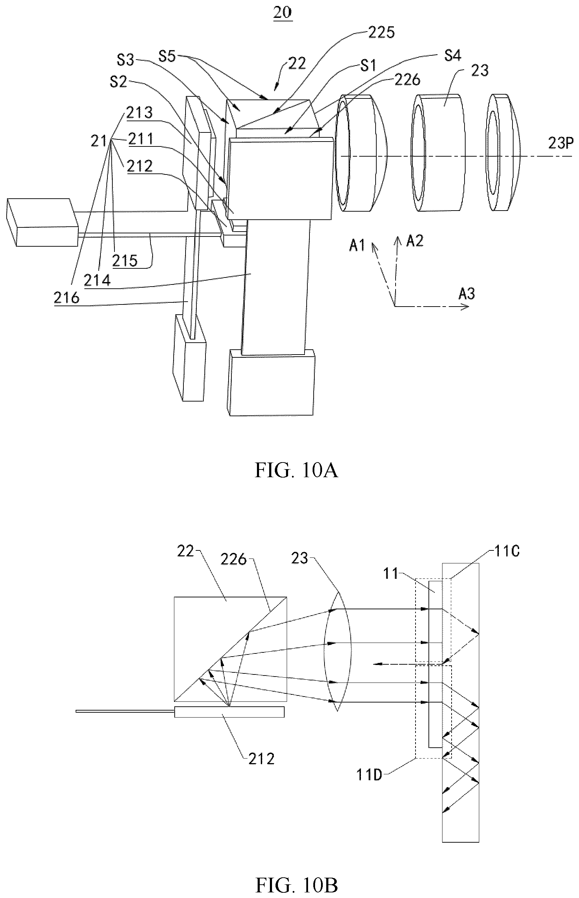

FIG. 10A is a three-dimensional diagram of an optical engine 20 according to an implementation of this application. FIG. 10A schematically shows a specific position relationship between the light combining unit 22 shown in FIG. 6 and a light emitting unit 21 in the optical engine 20. As shown in FIG. 10A, the light emitting unit 21 includes a first wavelength range emitting unit 211, a second wavelength range emitting unit 212, a third wavelength range emitting unit 213, a first flexible circuit board 214, a second flexible circuit board 215, and a third flexible circuit board 216. The first wavelength range emitting unit 211 exactly faces the first light incident surface S1 (a front side surface of the light combining unit 22 in FIG. 10A) of the hexahedron structure of the light combining unit 22. The second wavelength range emitting unit 212 exactly faces the second light incident surface S2 (a bottom surface of the light combining unit 22 in FIG. 10A) of the hexahedron structure of the light combining unit 22. The third wavelength range emitting unit 312 exactly faces the third light incident surface S3 (a left side surface of the light combining unit 22 in FIG. 10A) of the hexahedron structure of the light combining unit 22. In an implementation, the first light incident surface S1, the second light incident surface S2, and the third light incident surface S3 are perpendicular to each other and adjacent to each other, and the three light incident surfaces respectively correspond to three mutually adjacent outer surfaces of the hexahedron structure. Both a normal direction A1 of a light-emitting surface of the first wavelength range emitting unit 211 and a normal direction A2 of a light-emitting surface of the second wavelength range emitting unit 212 are perpendicular to an optical axis 23P of the optical imaging unit 23 of the optical engine 20, and a normal direction A3 of a light-emitting surface of the third wavelength range emitting unit 212 is the same as a direction of the optical axis 23P of the optical imaging unit 23 of the optical engine 20.

In this implementation, the first optical splitting film 225 is configured to reflect light in a first wavelength range and transmit light in a second wavelength range and light in a third wavelength range. In an implementation, the first optical splitting film 225 is a red-reflective and blue-green-transmissible film layer. All red light rays emitted by the first wavelength range emitting unit 211 are transmitted to the first optical splitting film 225, and the first optical splitting film 225 reflects the red light ray, so that after being reflected, the red light ray is emitted out of the light exit surface S4 along the direction of the optical axis 23P, and enters the optical imaging unit 23. The second optical splitting film 226 is configured to reflect light in a second wavelength range and transmit light in a first wavelength range and light in a third wavelength range. In an implementation, the second optical splitting film 226 is a blue-reflective and red-green-transmissible film layer. All blue light rays emitted by the second wavelength range emitting unit 212 are transmitted to the second optical splitting film 226, and the second optical splitting film 226 reflects the blue light ray, so that after being reflected, the blue light ray is emitted out of the light exit surface S4 along the direction of the optical axis 23P, and enters the optical imaging unit 23. After entering the light combining unit 22, the green light ray emitted by the third wavelength range emitting unit 213 passes through the first optical splitting film 225 and the second optical splitting film 226, and the green light ray is emitted out of the light exit surface S4 along the direction of the optical axis 23P and enters the optical imaging unit 23. Light rays of the three colors are all emitted from the light exit surface S4, and are emitted along the direction of the optical axis 23P, to form a mixed light beam.

An extension direction of the second flexible circuit board 215 in the optical engine 20 provided in the implementation shown in FIG. 10A is close to or the same as the direction of the optical axis 23P. With reference to FIG. 1, FIG. 2, and FIG. 3, when the optical engine 20 is mounted in the near-eye display device, the second flexible circuit board 215 may extend along the mechanical part 100 without folding the second flexible circuit board 215, that is, extend along the mechanical part without bending, which helps reduce a size of the entire device. It may be understood that, if the flexible circuit board is folded, an overall size of the optical engine becomes larger due to folding of the flexible circuit board, and larger space is occupied in the near-eye display device.

The optical engine provided in this application includes the foregoing light combining unit, so that the optical engine has a more flexible configuration solution, and the optical engine can be configured in more environments in a near-eye display device.

When the optical engine 20 provided in the implementation shown in FIG. 10A is mounted on the temple of the mechanical part, the temple includes an inner side surface and an outer side surface. The inner side surface of the temple is a part that is of the near-eye display device and that is close to a human face in the worn state, and the outer side surface is a part that is of the near-eye display device and that is away from the human face in the worn state. In an implementation, in this application, the first wavelength range emitting unit 211 is disposed close to the outer side surface of the temple, and a non-light-incident surface S5 (which is specifically the non-light-incident surface S5 disposed opposite to the first light incident surface S1) on the light combining unit 22 is close to the inner side surface of the temple. In this way, no light emitting unit is disposed on a side that is of the near-eye display device and that is close to a human face, so that a risk of heat perception by a user can be reduced, thereby improving user experience. In another implementation, alternatively, the second wavelength range emitting unit 212 may be disposed close to the outer side surface of the temple, and a non-light-incident surface S5 located on a top surface of the light combining unit 22 is close to the inner side surface of the temple. In an implementation, when the optical engine 20 provided in the implementation shown in FIG. 10A is mounted on the temple of the mechanical part, the light exit side of the optical engine 20 is an optical waveguide on a lens of the near-eye display device. In the implementation shown in FIG. 10A, the second wavelength range emitting unit 212 is located on a bottom side of the light combining unit 22, so that blue light energy at an exit pupil of the optical engine is weak at the top and strong at the bottom. A specific architecture of the optical engine 20 is used in conjunction with a structure of the optical waveguide, so that the optical waveguide can use a relatively strong part of blue light, thereby improving light efficiency. Specifically, the second wavelength range emitting unit 212 is placed close to a relay region (that is, a relay grating) of the optical waveguide. Therefore, this solution can improve light efficiency of the near-eye display device.

For the light combining unit 22, it may be understood that the light combining unit 22 includes prisms, and an optical film layer, for example, a first optical splitting film and a second optical splitting film, is disposed on the prisms. Transmittance or reflectivity of each film layer varies with an incident angle, for example, a larger incident angle on an optical splitting film (that is, a light splitting oblique surface of the prism) indicates lower light efficiency. The angle refers to an angle between a light ray and a normal line of the optical splitting film. Therefore, light intensity distribution at the exit pupil of the optical engine is uneven. FIG. 10B is a diagram of an optical path of the second wavelength range emitting unit 212 in the implementation provided in FIG. 10A. For example, light emitted by the second wavelength range emitting unit 212 is a blue light ray. A light ray enters the light combining unit 22 from the second wavelength range emitting unit 212 and is reflected by the second optical splitting film 226. As shown in FIG. 10B, an angle of a light ray reflected by a lower left corner part of the second optical splitting film 226 is small, and an angle of a light ray reflected by an upper right corner part of the second optical splitting film 226 is large. Light efficiency of the upper right corner part is low. In addition, after light rays reflected by the upper right corner part of the second optical splitting film 226 pass through the optical imaging unit 23, when the light rays are projected onto the in-coupling grating 11, a part of the light rays are reflected, and the reflected light ray is represented by a dashed line in FIG. 10B. Because intensity of a light ray emitted by the second wavelength range emitting unit 212 out of the optical engine is uneven, intensity of a light ray on the in-coupling grating 11 is also uneven. The in-coupling grating 11 includes a first in-coupling region 11C and a second in-coupling region 11D. As shown in FIG. 10B, in an implementation solution, the first in-coupling region 11C is located above the second in-coupling region. It may be understood that, in FIG. 10B, the first in-coupling region 11C and the second in-coupling region 11D are merely schematically framed by using a rectangular dashed box. In actual application, specific positions of the first in-coupling region 11C and the second in-coupling region 11D are not limited to the solution shown in FIG. 10B, and the first in-coupling region 11C and the second in-coupling region 11D may be connected or partially overlap. In this application, FIG. 10B is merely used to indicate that the first in-coupling region 11C is a region with low incident light ray energy, and the second in-coupling region 11D is a region with strong incident light ray energy.

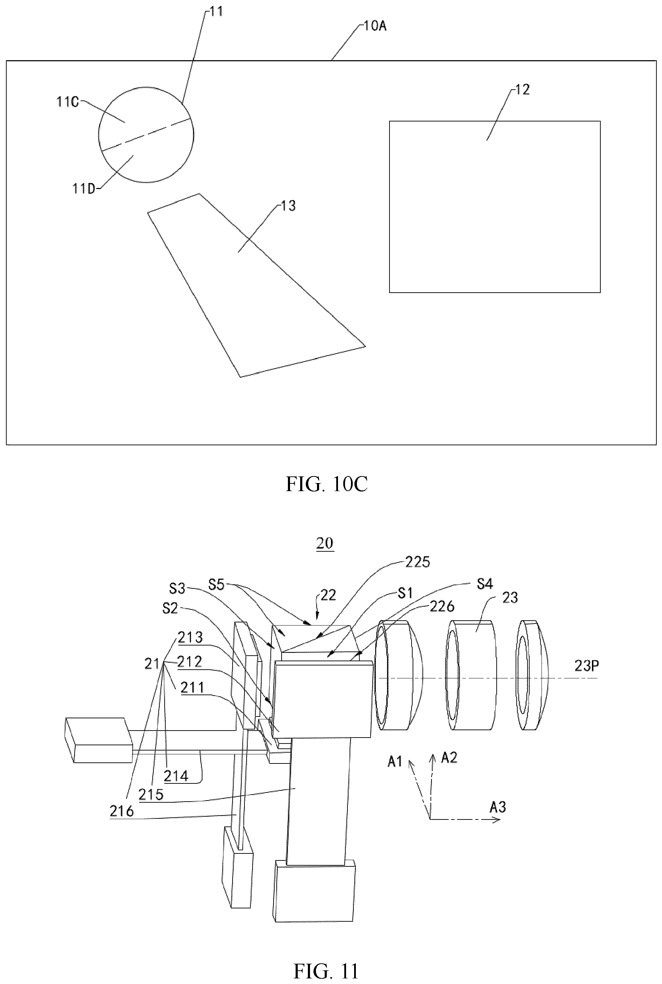

In an implementation of this application, due to an arrangement position of the second wavelength range emitting unit 212, more energy of light rays projected by the second wavelength range emitting unit 212 is concentrated to the second in-coupling region 11D of the in-coupling grating 11. Refer to FIG. 10C. FIG. 10C is a diagram of an optical waveguide according to an implementation, and shows a position relationship between the in-coupling grating 11 in FIG. 10B and another grating on an optical waveguide plane. Specifically, the optical waveguide 10A includes an in-coupling grating 11, a relay grating 13, and an out-coupling grating 12. A second in-coupling region D of the in-coupling grating 11 is disposed close to the relay grating 13, that is, a first in-coupling region 11C is located on a side away from the relay grating 13. In this way, with reference to FIG. 10B and FIG. 10C, it may be understood that, energy of more light of the second wavelength range emitting unit 212 may be concentrated in the second in-coupling region 11D. Because the second in-coupling region 11D is close to the relay grating 13, it can be ensured that energy of light projected by the second wavelength range emitting unit 212 onto the in-coupling grating 11 is better utilized, and more light energy of the second wavelength range emitting unit 212 can enter the relay grating 13 and is coupled out by the out-coupling grating 12 to the human eye. Therefore, when an arrangement direction of the optical engine provided in this application is used in conjunction with arrangement of the in-coupling grating 11, utilization of light sent by the second wavelength range emitting unit 212 can be improved.

In general, the optical waveguide does not fully utilize light at the exit pupil of the optical engine. A light ray far away from the relay grating is reflected back to the optical engine, causing a ghost image. For blue light, because a wavelength of the blue light is short and a diffraction angle is small, that is, a total internal reflection step is small, more light cannot be normally propagated to the relay grating. Therefore, in this application, the second wavelength range emitting unit 212 (for example, a light emitting unit for emitting blue light) may be placed close to a relay region of the optical waveguide, so that overall light efficiency can be improved.

FIG. 11 is a three-dimensional diagram of an optical engine according to an implementation of this application. The implementation shown in FIG. 11 is obtained by swapping positions of the second wavelength range emitting unit 212 and the first wavelength range emitting unit 211 on a basis of the implementation shown in FIG. 10A. As shown in FIG. 11, the first wavelength range emitting unit 211 is located on the bottom side of the light combining unit 22, and the second wavelength range emitting unit 212 is located on a front side of the light combining unit 22. In an implementation, the first optical splitting film 225 is a blue-reflective and red-green-transmissible film layer. All blue light rays emitted by the second wavelength range emitting unit 212 are transmitted to the first optical splitting film 225, and the first optical splitting film 225 reflects the blue light ray, so that after being reflected, the blue light ray is emitted out of the light exit surface S4 along the direction of the optical axis 23P, and enters the optical imaging unit 23. The second optical splitting film 226 is a red-reflective and blue-green-transmissible film layer. All red light rays emitted by the first wavelength range emitting unit 211 are transmitted to the second optical splitting film 226, and the second optical splitting film 226 reflects the red light ray, so that after being reflected, the red light ray is emitted out of the light exit surface S4 along the direction of the optical axis 23P, and enters the optical imaging unit 23.

In the implementation shown in FIG. 11, an extension direction of the first flexible circuit board 214 is close to or the same as the direction of the optical axis 23P. With reference to FIG. 1, FIG. 2, and FIG. 3, when the optical engine 20 is mounted in the near-eye display device, the first flexible circuit board 214 may extend along the mechanical part 100 without folding the first flexible circuit board 214, which helps reduce a size of the entire device.

In the implementation shown in FIG. 11, a position of the non-light-incident surface S5 of the light combining unit 22 is the same as a position of the non-light-incident surface S5 of the implementation shown in FIG. 10A, and they are both located on a top side and a back side (the back side is a side opposite to the first light incident surface S1) of the light combining unit 22. In the implementation shown in FIG. 11, the second wavelength range emitting unit 212 or the first wavelength range emitting unit 211 may be placed at a position close to an outer side surface of the temple, to ensure that no light emitting unit is disposed on a side that is of the near-eye display device and that is close to a human face, thereby reducing a risk of heat perception by a user and improving user experience.

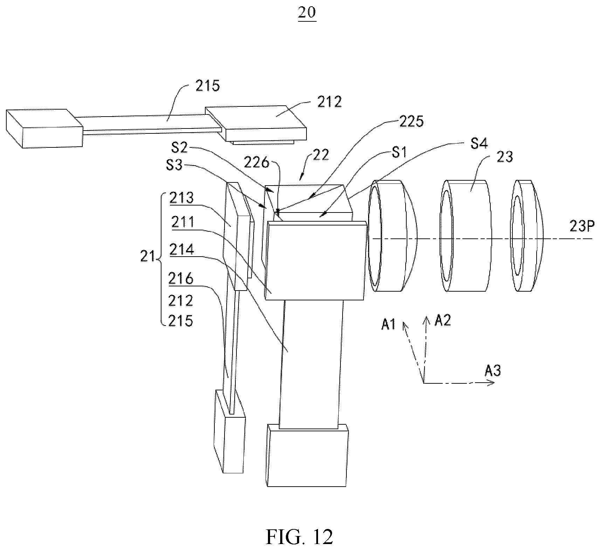

FIG. 12 is a three-dimensional diagram of an optical engine according to an implementation of this application. This implementation is obtained by adjusting the position of the second wavelength range emitting unit 212 and placing the second wavelength range emitting unit 212 on the top side of the light combining unit 22 (in the implementation shown in FIG. 10A, the second wavelength range emitting unit 212 is located on the bottom side of the light combining unit 22) on a basis of the implementation shown in FIG. 10A. As shown in FIG. 12, in order to clearly display a characteristic of the light combining unit, positions of both the second wavelength range emitting unit 212 and the second flexible circuit board 215 are moved upward from the top side of the light combining unit 22. In other words, a state shown in FIG. 12 is a separated state between the second wavelength range emitting unit 212 and the light combining unit 22, and does not mean a position relationship in an assembled state of the optical engine. In the implementation shown in FIG. 12, a position of the second optical splitting film 226 is also adaptively adjusted. In an implementation, the second optical splitting film 226 is a blue-reflective and red-green-transmissible film layer, and the first optical splitting film 225 is a red-reflective and blue-green-transmissible film layer. A specific light splitting principle is the same as that of the implementation shown in FIG. 10A. In the implementation shown in FIG. 12, the second flexible circuit board 215 and the third flexible circuit board 216 do not cross each other, so that the second flexible circuit board 215 and the third flexible circuit board 216 can be arranged in the mechanical part of the near-eye display device more flexibly.

In the implementation shown in FIG. 12, the second light incident surface S2 of the light combining unit 22 is located on the top side of the light combining unit 22, and positions of non-light-incident surfaces of the light combining unit 22 are the bottom side and the back side of the light combining unit 22 (although the bottom side and the back side are not marked, it is easy to understand that the bottom side and the back side are corresponding surfaces on which no light emitting units are disposed). In this implementation, the second wavelength range emitting unit 212 or the first wavelength range emitting unit 211 may be placed at a position close to an outer side surface of the temple, to ensure that no light emitting unit is disposed on a side that is of the near-eye display device and that is close to a human face, thereby reducing a risk of heat perception by a user and improving user experience.

In an implementation, in order to ensure that pictures projected by the first wavelength range emitting unit 211 and the second wavelength range emitting unit 212 are consistent with that projected by the third wavelength range emitting unit 213, AA directions of the first wavelength range emitting unit and the second wavelength range emitting unit need to be aligned with that of the third wavelength range emitting unit, that is, directions of a longer side and a shorter side need to be adjusted. Usually, an AA region is an active area, that is, an effective pixel region, and is in a rectangle shape, including a longer side and a shorter side. As shown in FIG. 12, if a longer side of the third wavelength range emitting unit 213 is in a horizontal direction, and a shorter side is in a vertical direction, a longer side of the first wavelength range emitting unit 211 is parallel to the optical axis, a shorter side of the first wavelength range emitting unit 211 is in a vertical direction, a longer side of the second wavelength range emitting unit 212 is perpendicular to the optical axis, and a shorter side of the second wavelength range emitting unit 212 is parallel to the optical axis. If the longer side and the shorter side of the AA region are equal in length, and quantities of pixels are equal, the first wavelength range emitting unit 211 may also extend the first flexible circuit board 214 along the mechanical part 100.

That pictures projected by the first wavelength range emitting unit 211 and the second wavelength range emitting unit 212 are consistent with an upper picture projected by the third wavelength range emitting unit 213 may be understood as that after the pictures projected by the light emitting units are refracted by the light combining unit, directions of the pictures formed are consistent. As shown in FIG. 12, after passing through the light combining unit, the picture projected by the first wavelength range emitting unit 211 is consistent with the upper picture projected by the third wavelength range emitting unit 213. Similarly, after passing through the light combining unit, the picture projected by the second wavelength range emitting unit 212 is also consistent with the upper picture projected by the third wavelength range emitting unit 213.

The light combining unit provided in this application and the light emitting unit may be flexibly configured. For example, the light combining unit shown in FIG. 6 is used in the three specific implementations provided in FIG. 10A, FIG. 11, and FIG. 12, and different configuration solutions may be formed by adjusting the positions of the first wavelength range emitting unit and the second wavelength range emitting unit. This application merely schematically lists the three specific implementations. A specific application process is not limited to the three specific configuration solutions, and there may be more configuration solutions.

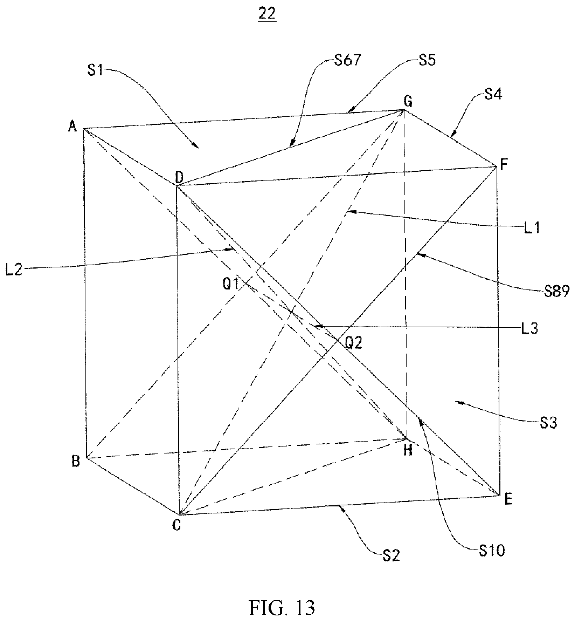

FIG. 13 is a three-dimensional diagram of a light combining unit 22 according to an implementation of this application. As shown in FIG. 13, the light combining unit 22 may be of a hexahedron structure. In this application, A, B, C, D, E, F, G and H are used to represent eight vertices of the light combining unit 22. An outer surface of the light combining unit 22 includes six outer surfaces of a hexahedron structure. In an implementation, four of the six outer surfaces are a first light incident surface S1, a second light incident surface S2, a third light incident surface S3, and a light exit surface S4, and the other two outer surfaces are non-light-incident surfaces S5. One of the non-light-incident surfaces S5 is adjacent to the light exit surface S4, the other non-light-incident surface S5 and the light exit surface S4 are disposed opposite to each other. In an implementation, as shown in FIG. 13, four vertices of the first light incident surface S1 are A, D, F, and G, that is, the first light incident surface S1 is a top side surface of the hexahedron structure shown in FIG. 13. Four vertices of the second light incident surface S2 are B, C, E, and H, that is, the second light incident surface S2 is a bottom side surface of the hexahedron structure shown in FIG. 13. Four vertices of the third light incident surface S3 are C, D, F, and E, that is, the third light incident surface is a front side surface of the hexahedron structure shown in FIG. 13. Four vertices of the light exit surface S4 are E, F, G, and H, that is, the light exit surface S4 is a right side surface of the hexahedron structure shown in FIG. 13. Four vertices of one of the non-light-incident surfaces S5 (the non-light-incident surface disposed adjacent to the light exit surface S4) are A, B, H, and G. Four vertices of the other non-light-incident surface S5 are A, B, C, and D. In this application, a specific position of each light incident surface is not limited, provided that the three light incident surfaces correspond to light emitting units in different colors and it can be ensured that light rays that are incident from the three light incident surfaces to the light combining unit can be combined into one mixed light beam in the light combining unit and emitted from the light exit surface S4.

The implementation shown in FIG. 13 is obtained through further cutting along a diagonal plane on a basis of the implementation shown in FIG. 6. In the implementation shown in FIG. 6, the hexahedron structure is separately cut along the first diagonal plane S67 and the second diagonal plane S89 to form four independent prism units. In the implementation shown in FIG. 13, the hexahedron structure is separately cut along the first diagonal plane S67, the second diagonal plane S89, and a third diagonal plane S10 to form eight prism structures. An intersection line L1 between the first diagonal plane S67 and the second diagonal plane S89 is a body diagonal of the hexahedron structure, and two vertices of the intersection line L1 are C and G. An intersection line L2 between the first diagonal plane S67 and the third diagonal plane S10 is a body diagonal of the hexahedron structure, and two vertices of the intersection line L2 are D and H. An intersection line L3 between the second diagonal plane S89 and the third diagonal plane S10 is a center line of the hexahedron structure, and two vertices of the intersection line L3 are Q1 and Q2. A length of the intersection line L3 is equal to an edge length of the hexahedron structure. In this implementation, the hexahedron structure is a cube, and all edge lengths of the hexahedron structure are equal.

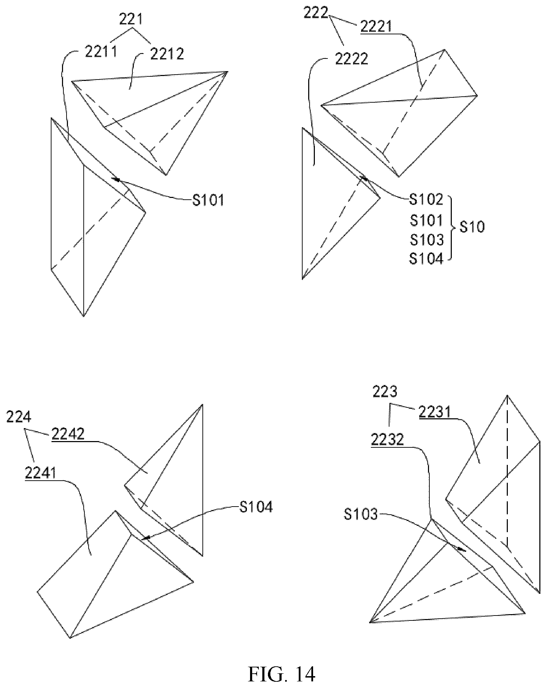

FIG. 14 is a three-dimensional exploded diagram of the light combining unit shown in FIG. 13. With reference to FIG. 13 and FIG. 14, in this implementation, the hexahedron structure is further cut along the third diagonal plane S10 on a basis of the implementation shown in FIG. 6, so that the first prism unit 221 is divided into a first sub-prism 2211 and a second sub-prism 2212, the second prism unit 222 is divided into a third sub-prism 2221 and a fourth sub-prism 2222, the third prism unit 223 is divided into a fifth sub-prism 2231 and a sixth sub-prism 2232, and the fourth prism unit 224 is divided into a seventh sub-prism 2241 and an eighth sub-prism 2242. As shown in FIG. 14, an interconnection position between the first sub-prism 2211 and the second sub-prism 2212 is a first sub-surface S101. The first sub-surface S101 is a quadrilateral, and both the first sub-prism 2211 and the second sub-prism 2212 are pentahedron prisms. An interconnection position between the third sub-prism 2221 and the fourth sub-prism 2222 is a second sub-surface S102, the second sub-surface S102 is triangular, the third sub-prism 2221 is a pentahedron prism, and the fourth sub-prism 2222 is a tetrahedron prism. An interconnection position between the fifth sub-prism 2231 and the sixth sub-prism 2232 is a third sub-surface S103. The third sub-surface S103 is a quadrilateral, and both the fifth sub-prism 2231 and the sixth sub-prism 2232 are pentahedron prisms. An interconnection position between the seventh sub-prism 2241 and the eighth sub-prism 2242 is a fourth sub-surface S104, the fourth sub-surface S1042 is triangular, the seventh sub-prism 2241 is a pentahedron prism, and the eighth sub-prism 2242 is a tetrahedron prism. The first sub-surface S101, the second sub-surface S102, the third sub-surface S103, and the fourth sub-surface S104 form the third diagonal plane S10 of the hexahedron structure.

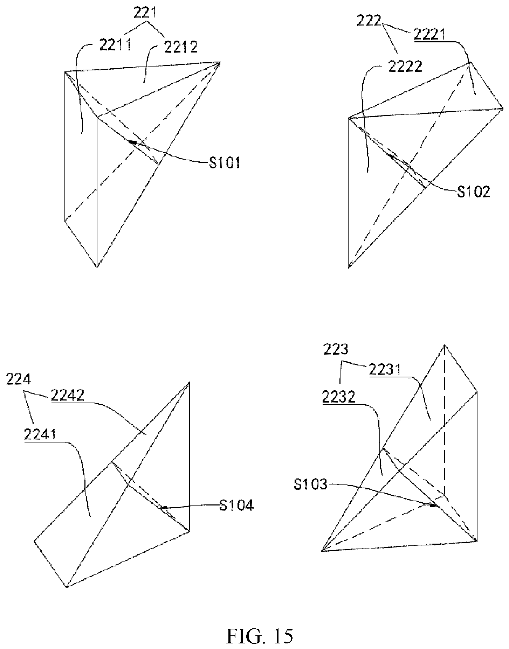

FIG. 15 is a three-dimensional exploded diagram of the light combining unit 22 shown in FIG. 13 in a state. A state shown in FIG. 15 is obtained by displaying each of the first prism unit 221, the second prism unit 222, the third prism unit 223, and the fourth prism unit 224 as a whole on a basis of the state shown in FIG. 14. That is, the first sub-prism 2211 and the second sub-prism 2212 are interconnected, the third sub-prism 2221 and the fourth sub-prism 2222 are interconnected, the fifth sub-prism 2231 and the sixth sub-prism 2232 are interconnected, and the seventh sub-prism 2241 and the eighth sub-prism 2242 are interconnected. It can be found through comparison between FIG. 15 and FIG. 7 that an overall shape of the first prism unit 221, an overall shape of the second prism unit 222, an overall shape of the third prism unit 223, and an overall shape of the fourth prism unit 224 in the light combining unit shown in FIG. 15 are all the same as those in FIG. 7 in terms of corresponding characteristics.

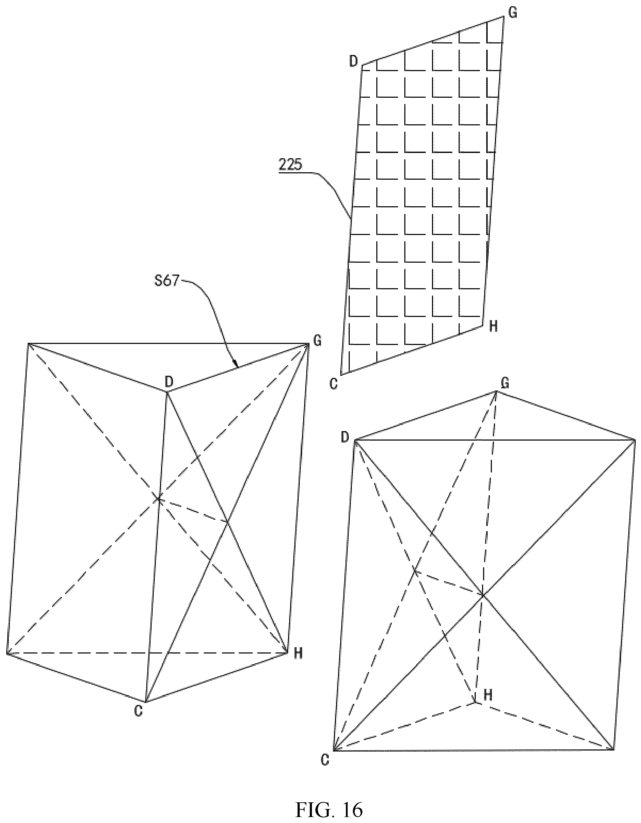

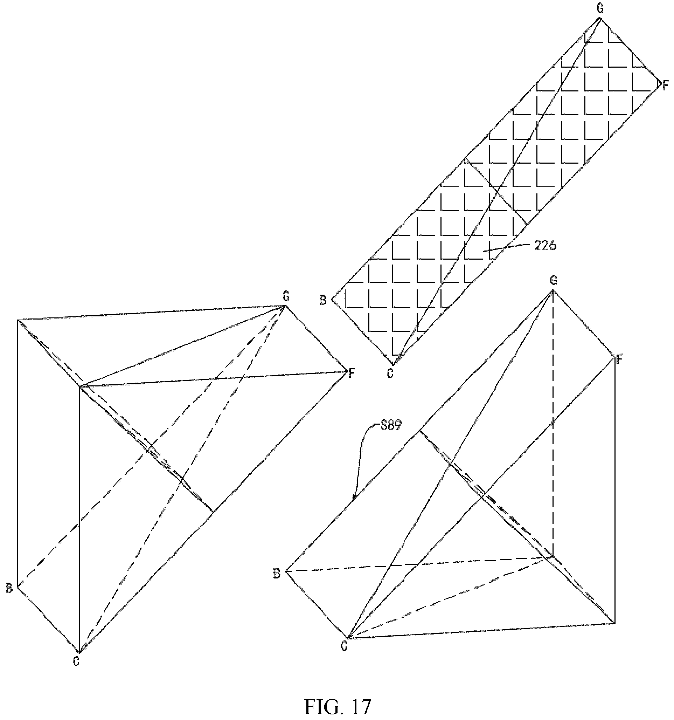

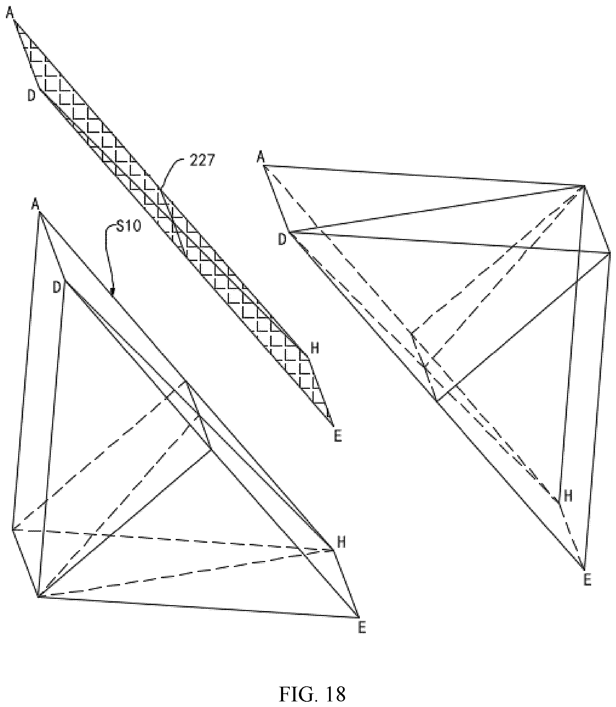

In an implementation, the light combining unit 22 shown in FIG. 13 includes three optical splitting films: a first optical splitting film 225, a second optical splitting film 226, and a third optical splitting film 227. Refer to FIG. 16, FIG. 17, and FIG. 18. The three figures respectively indicate positions of the three optical splitting films. In order to clearly express a relationship between optical splitting films and prisms of the light combining unit, in FIG. 16, FIG. 17, and FIG. 18, the first optical splitting film 225, the second optical splitting film 226, and the third optical splitting film 227 are separated from the light combining unit 22 for separate display. The three optical splitting films are all of a rectangular structure, and specific positions of the optical splitting films in the light combining unit may be determined by using numbers of four vertices in a rectangle. Specifically, as shown in FIG. 16, the first optical splitting film 225 is located on the first diagonal plane S67, and an area of the first optical splitting film 225 may be equal to an area of the first diagonal plane S67 (as shown in FIG. 16). In another implementation, an area of the first optical splitting film 225 may be less than an area of the first diagonal plane S67. It may be understood that a shape of the first optical splitting film 225 may also be different from a shape of the first diagonal plane S67. As shown in FIG. 17, the second optical splitting film 226 is located at the second diagonal plane S89, and an area of the second optical splitting film 226 may be equal to an area of the second diagonal plane S89. As shown in FIG. 18, the third optical splitting film 227 is located at the third diagonal plane S10, and an area of the third optical splitting film 227 may be equal to an area of the third diagonal plane S10.

The third optical splitting film 227, the first optical splitting film 225, and the second optical splitting film 226 are respectively configured to reflect light rays in different wavelength ranges. In an implementation, the first optical splitting film 225 is configured to reflect light in a third wavelength range, and transmit light in a first wavelength range and light in a second wavelength range. For example, the first optical splitting film 225 is a green-reflective and red-blue-transmissible film layer. The second optical splitting film 226 reflects light in the second wavelength range and transmits light in the first wavelength range and light in the third wavelength range.

For example, the second optical splitting film 226 is a blue-reflective and red-green-transmissible film layer. The third optical splitting film 227 reflects light in the first wavelength range and transmits light in the second wavelength range and light in the third wavelength range. For example, the third optical splitting film 227 is a red-reflective and blue-green-transmissible film layer.

In an implementation, the second optical splitting film 226 and the third optical splitting film 227 each include four sub-films. As shown in FIG. 17 and FIG. 18, two of the four sub-films are triangular, and the other two are trapezoidal. The first optical splitting film 225 is of an integrated structure and is rectangular. This solution defines specific structures of the second optical splitting film 226 and the third optical splitting film 227, and a solution in which the first optical splitting film 225 is of an integrated structure. The optical splitting film designed in this solution is used in the light combining unit including eight prisms. Because the first optical splitting film may be of an integrated structure, the first optical splitting film has advantages of a simple structure and convenient assembly.

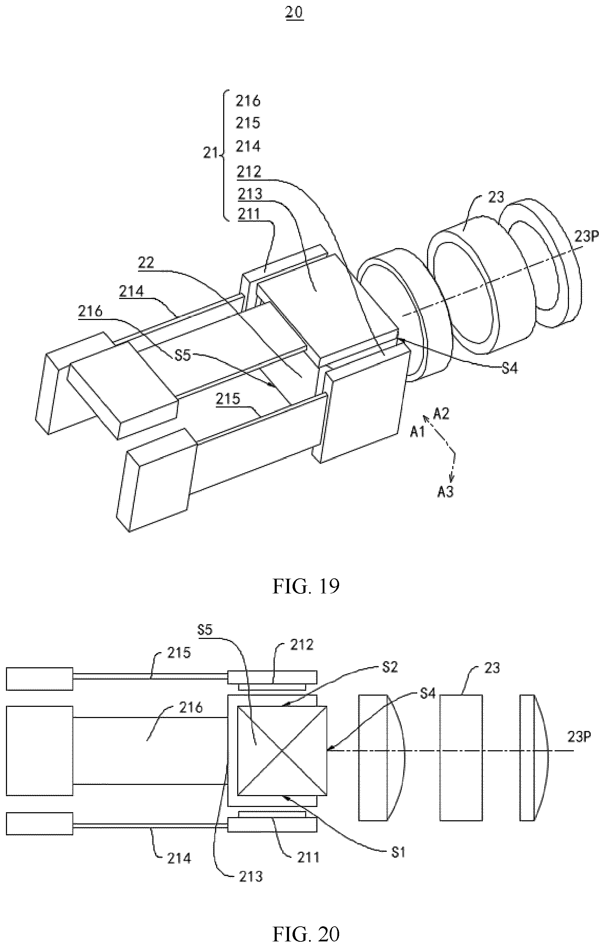

FIG. 19 is a three-dimensional diagram of an optical engine 20 according to an implementation of this application. FIG. 19 schematically shows a specific position relationship between the light combining unit shown in FIG. 13 and a light emitting unit in the optical engine 20. As shown in FIG. 19, the light emitting unit 21 includes a first wavelength range emitting unit 211, a second wavelength range emitting unit 212, a third wavelength range emitting unit 213, a first flexible circuit board 214, a second flexible circuit board 215, and a third flexible circuit board 216. The first wavelength range emitting unit 211 and the second wavelength range emitting unit 212 are disposed opposite to each other on two opposite sides of the light combining unit 22, and the third wavelength range emitting unit 213 is located between the first wavelength range emitting unit 211 and the second wavelength range emitting unit 212.

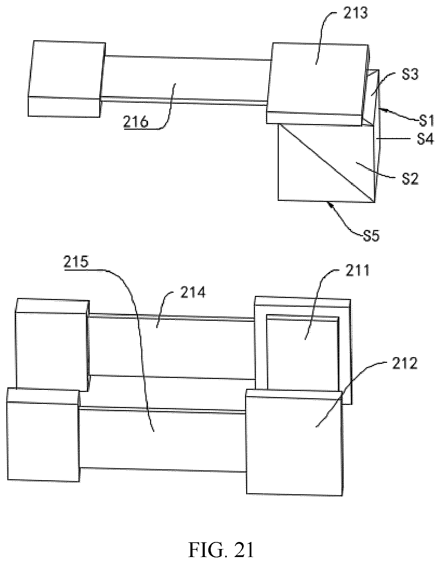

FIG. 20 is a planar diagram of the optical engine shown in FIG. 19 in a direction. FIG. 21 is an exploded diagram of a light combining unit and a light emitting unit in the optical engine shown in FIG. 19. With reference to FIG. 19, FIG. 20, and FIG. 21, a position relationship between the light combining unit 22 and the light emitting unit 21 can be clearly expressed. A light-emitting surface of the first wavelength range emitting unit 211 exactly faces a first light incident surface S1 of the hexahedron structure of the light combining unit 22, a light-emitting surface of the second wavelength range emitting unit 212 exactly faces a second light incident surface S2 of the hexahedron structure of the light combining unit 22, and a light-emitting surface of the third wavelength range emitting unit 213 exactly faces a third light incident surface S3 of the hexahedron structure of the light combining unit 22. The first light incident surface S1 is parallel to the second light incident surface S2, and the third light incident surface S3 is perpendicular to the first light incident surface S1. As shown in FIG. 19, a normal direction A1 of the light-emitting surface of the first wavelength range emitting unit 211, a normal direction A3 of the light-emitting surface of the third wavelength range emitting unit 213, and a normal direction A2 of the light-emitting surface of the second wavelength range emitting unit 213 are all perpendicular to the optical axis 23P of the optical imaging unit 23 of the optical engine. The normal direction A1 of the light-emitting surface of the first wavelength range emitting unit 211 is the same as the normal direction A2 of the light-emitting surface of the second wavelength range emitting unit 213, and the normal direction A3 of the light-emitting surface of the third wavelength range emitting unit 213 is perpendicular to the normal direction A1 of the light-emitting surface of the first wavelength range emitting unit 211.

Extension directions of the first flexible circuit board 214, the second flexible circuit board 215, and the third flexible circuit board 216 in the optical engine 20 provided in the implementation shown in FIG. 19 are close to or the same as the direction of the optical axis 23P. With reference to FIG. 1, FIG. 2, and FIG. 3, when the optical engine 20 is mounted in the near-eye display device, the second flexible circuit board 215 may extend along the mechanical part 100 without folding the second flexible circuit board 215, which helps reduce a size of the entire device.

When the optical engine 20 provided in the implementation shown in FIG. 19 is mounted on the temple of the mechanical part, the temple includes an inner side surface and an outer side surface. The inner side surface of the temple is a part that is of the near-eye display device and that is close to a human face in the worn state, and the outer side surface is a part that is of the near-eye display device and that is away from the human face in the worn state. In an implementation, in this application, the third wavelength range emitting unit 213 is disposed close to the outer side surface of the temple, and a non-light-incident surface S5 (which is specifically the non-light-incident surface S5 disposed opposite to the third light incident surface S3, as shown in FIG. 21) on the light combining unit 22 is close to the inner side surface of the temple. In this way, no light emitting unit is disposed on a side that is of the near-eye display device and that is close to a human face, so that a risk of heat perception by a user can be reduced, thereby improving user experience.

In an implementation, when the optical engine 20 provided in the implementation shown in FIG. 19 is mounted on the temple of the mechanical part, the light exit side of the optical engine 20 is an optical waveguide on a lens of the near-eye display device. During arrangement of specific positions of structures of parts of the optical engine 20, the second wavelength range emitting unit 212 may be located on the bottom side of the light combining unit 22, and the first wavelength range emitting unit 211 may be located on the top side of the light combining unit 22. The second wavelength range emitting unit 212 is located on the bottom side of the light combining unit 22, so that blue light energy at an exit pupil of the optical engine is weak at the top and strong at the bottom. A specific architecture of the optical engine 20 is used in conjunction with a structure of the optical waveguide, so that the optical waveguide can use a relatively strong part of blue light, thereby improving light efficiency. Specifically, the second wavelength range emitting unit 212 is placed close to a relay region (that is, a relay grating) of the optical waveguide. Therefore, this solution can improve light efficiency of the near-eye display device.

FIG. 19 to FIG. 21 merely schematically illustrate a solution between a light emitting unit and a light combining unit. For the light combining unit shown in FIG. 13, the light combining unit 13 includes eight prism structures that are independent of each other, and is formed through further cutting along the third diagonal plane on a basis of the four prisms shown in FIG. 6. Therefore, all possible flexible arrangement solutions of the position relationship between the light combining unit shown in FIG. 6 and the light emitting unit in the optical engine are applicable to the light combining unit shown in FIG. 13. That is, arrangement solutions of the light combining unit and the light emitting unit in the optical engine shown in FIG. 10A, FIG. 11, and FIG. 12 are also applicable to the light combining unit shown in FIG. 13, requiring adjustment only to properties of optical splitting films based on a specific arrangement solution.

In an implementation, the light combining unit 22 provided in this application is of a cube structure as a whole. Due to design of the cube structure, optical distances of light sources (to be specific, a first wavelength range emitting unit 211, a second wavelength range emitting unit 212, and a third wavelength range emitting unit 213) of different colors in the light emitting unit from a light incident surface to a light exit surface can keep consistent, that is, transmission paths of a red light ray emitted by the first wavelength range emitting unit, a blue light ray emitted by the second wavelength range emitting unit, and a green light ray emitted by the third wavelength range emitting unit in the light combining unit have a same length, and the transmission path of light is an optical distance. A same optical distance helps ensure definition of imaging of the optical engine. If an optical distance of light of a particular color is inconsistent with that of light of another color, an image projected by the optical engine is not clear enough, and the image is blurry.

In an implementation, an area of a light incident surface of the light combining unit 22 is greater than an area of a light-emitting surface of a corresponding light emitting unit. In this way, it can be ensured that more light rays emitted by the light emitting unit enter the light combining unit, thereby improving light ray transmission efficiency. In an implementation, an area of a light incident surface of the optical imaging unit is greater than an area of a light exit surface of the light combining unit. In this way, it can be ensured that more light rays emitted by the light emitting unit enter the light combining unit, thereby improving light ray transmission efficiency. In a specific implementation, the optical imaging unit may be a mirror group, that is, includes one or more lenses. An emission direction of the mixed light beam may be an optical axis direction of the optical imaging unit.

In an implementation, the light combining unit provided in this application may be obtained through cutting first, that is, cutting along a diagonal plane based on a hexahedron-shaped optical structure. For the light combining unit 22 shown in FIG. 6, cutting at positions of the first diagonal plane and the second diagonal plane is needed. For the light combining unit 22 shown in FIG. 13, cutting at positions of the first diagonal plane, the second diagonal plane, and the third diagonal plane is needed. After the cutting, each separate prism structure is processed. For example, the optical splitting film is disposed, through chemical deposition, coating, or electroplating, at a position on which the optical splitting film needs to be disposed. Then, the prism structures are interconnected and bonded to form an integrated structure.

Solution 2: Optical component (an in-coupling grating reflects zero-order light rays out of an optical engine)

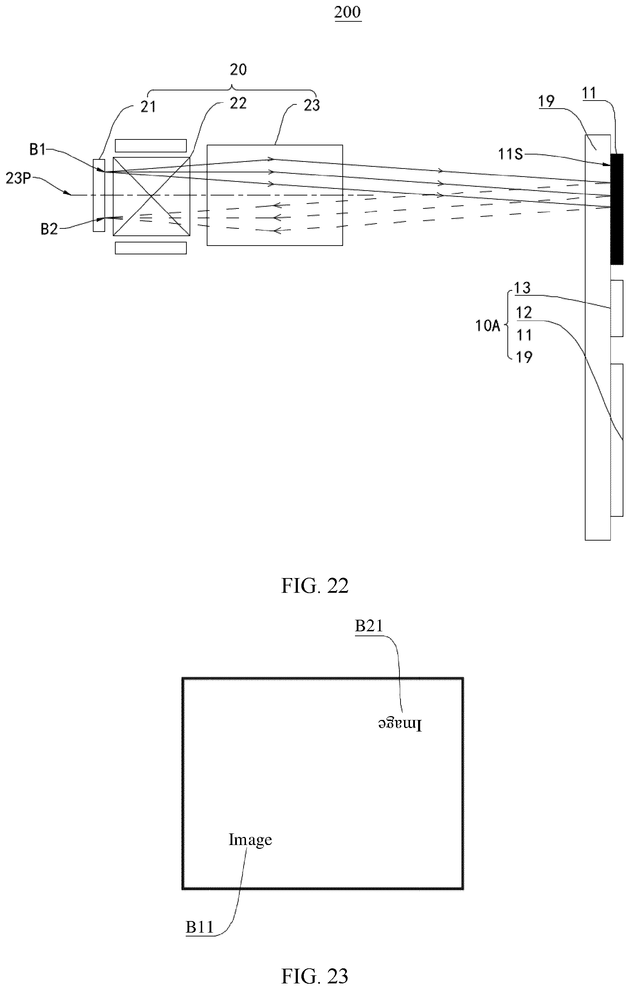

FIG. 22 is a diagram of an optical component 200 according to an implementation of this application. Refer to FIG. 22. In an implementation, the optical component 200 provided in this application includes an optical engine 20 and an optical waveguide 10A. The optical engine 20 includes a light emitting unit 21, a light combining unit 22, and an optical imaging unit 23. The optical waveguide 10A is located on a light exit side of the optical engine 20. The optical waveguide 10A includes a waveguide substrate 19, an in-coupling grating 11, a relay grating 13, and an out-coupling grating 12. The in-coupling grating 11, the relay grating 13, and the out-coupling grating 12 are all formed on a surface of the waveguide substrate 19. The in-coupling grating 11 exactly faces a light exit surface of the optical engine 20. Light rays emitted by the light emitting unit 21 of the optical engine 20 are combined by the light combining unit 22 to form a mixed light beam, and the mixed light beam passes through the optical imaging unit 23 and is then projected onto the in-coupling grating 11. In this implementation, an in-coupling surface 11S that is of the in-coupling grating 11 and that is formed on the waveguide substrate 19 is basically planar in shape, and the in-coupling surface 11S is approximately perpendicular to an optical axis 23P of the optical engine 20. It may be understood that the in-coupling surface 11S may be perpendicular to the optical axis 23P of the optical engine 20, or an included angle between the in-coupling surface 11S and the optical axis 23P of the optical engine 20 is within a small range. For example, the included angle between the in-coupling surface 11S and the optical axis 23P of the optical engine 20 is less than a half of a field of view of the optical engine 20, that is, $\frac{FOV}{2}$ .

As shown in FIG. 22, after passing through the light combining unit 22 and the optical imaging unit 23, light rays emitted by a first position B1 in the light emitting unit 21 are modulated into parallel light in a direction. After the light ray is modulated by the in-coupling grating 11, 20% to 30% of energy enters the waveguide substrate 19. A light ray entering the waveguide substrate 19 undergoes total internal reflection in the waveguide substrate 19, then is transmitted to the out-coupling grating 12 through the relay grating 13, and is coupled to a human eye through the out-coupling grating 12 to form a virtual image B11 (as shown in FIG. 23). 40% of energy of the parallel light projected by the optical engine onto the in-coupling grating 11 is directly reflected (a light ray represented by a dashed line), which means zero-order reflection. Because the in-coupling surface 11S of the in-coupling grating 11 is perpendicular to the optical axis 23P or the included angle between them is within a small range, consequently light rays reflected by the in-coupling grating 11 enter the optical engine 20. After passing through the optical imaging unit 23 and the light combining unit 22, this part of light rays entering the optical engine 20 are focused on a second position B2 of the light emitting unit 21. Because a metal backplate and a glass cover on a screen of the light emitting unit 21 have high reflectivity, the light ray focused on the second position B2 returns along an original path, is coupled to the in-coupling grating 11 for modulation, and finally enters the waveguide substrate 19. After total internal reflection is performed in the waveguide substrate 19, the light ray is coupled to the human eye by the out-coupling grating 12 to form a ghost image B21 (as shown in FIG. 23).

FIG. 23 is a diagram of a ghost image problem generated by the optical component shown in FIG. 22. In an implementation, as shown in FIG. 23, it may be learned through analysis based on an optical path that a ghost image B21 and an original image (a virtual image B11) form a 180° rotational symmetry relationship.

To resolve the ghost image problem shown in FIG. 23, this application provides a new structure of an optical waveguide. Due to design of a light incident position of the optical waveguide, a light ray reflected at a position of the in-coupling grating is deflected out of the optical engine, that is, a direction of the light ray reflected at the position of the in-coupling grating is outside an optical effective region of the optical engine, and does not return to the optical engine. In an implementation, the optical waveguide includes a waveguide substrate and an in-coupling grating, the waveguide substrate includes an oblique surface, and the oblique surface is located at a position at which the in-coupling grating and the waveguide substrate are combined, or is located at a light incident side of a position at which the in-coupling grating and the waveguide substrate are combined. The in-coupling grating is configured to receive light of the optical engine, the oblique surface faces the optical engine, the optical engine has an optical axis, a direction perpendicular to the optical axis is a first direction, and an included angle between the oblique surface and the first direction is greater than or equal to a half of a field of view of the optical engine, so that an edge light ray of the field of view of the optical engine that is reflected by the in-coupling grating is capable of being deflected out of the optical engine. In this way, the optical component can obtain high image display efficiency, and a ghost image problem is resolved.

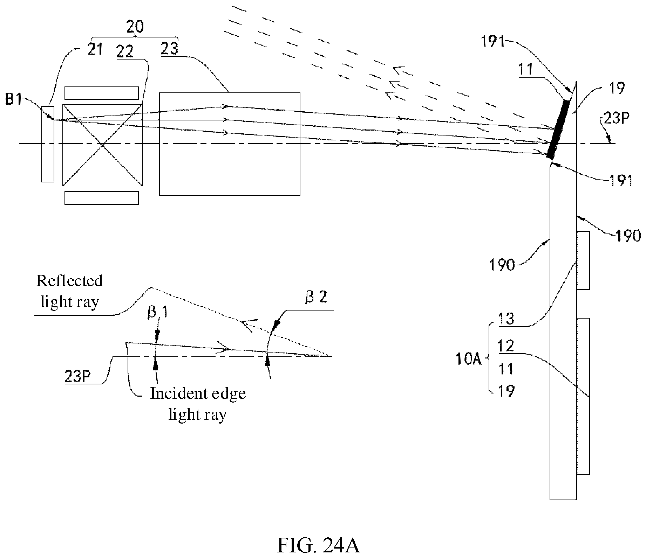

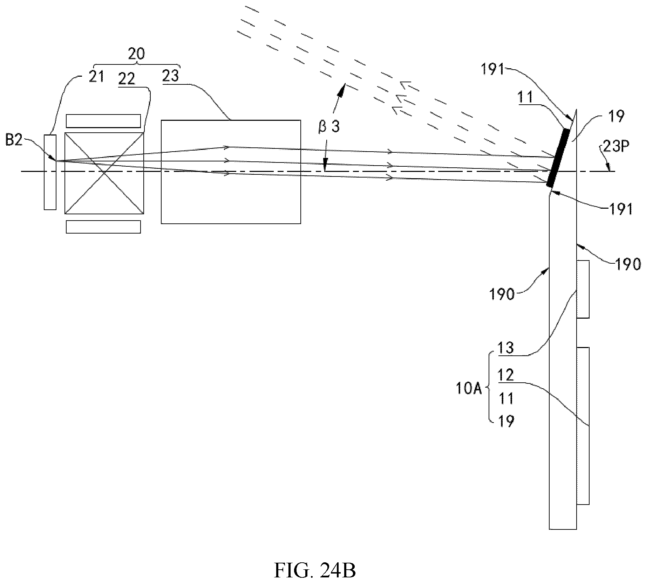

FIG. 24A and FIG. 24B are diagrams of an optical component according to an implementation of this application, where FIG. 24A and FIG. 24B are respectively diagrams of light rays emitted at a position B1 and a position B2 on a light emitting unit and reflected by an in-coupling grating.

In an implementation, as shown in FIG. 24A and FIG. 24B, the optical component includes an optical engine 20 and an optical waveguide 10A, and the optical waveguide 10A includes a waveguide substrate 19, an in-coupling grating 11, a relay grating 13, and an out-coupling grating 12. In an implementation, the in-coupling grating 11, the relay grating 13, and the out-coupling grating 12 are formed on a surface of the waveguide substrate 19. In an implementation, the waveguide substrate 19 is made of a high-refractive waveguide substrate material, and a refractive index of the waveguide substrate 19 may be greater than or equal to 1.6. In an implementation, a material of the waveguide substrate 19 is TiO2, silicon nitride, gallium nitride, a high-refractive resin material, or the like. An optical signal can be transmitted through total internal reflection in the waveguide substrate 19.

The waveguide substrate 19 is of a flat-plate-shaped architecture as a whole. Most of an area of an outer surface of the waveguide substrate 19 is a main flat surface 190, the main flat surface 190 is planar in shape, and the main flat surface 190 is perpendicular to an optical axis 23P of the optical engine 20 or an included angle between them is within a small range. It may be understood that a small included angle is allowed to be formed between the main flat surface 190 and the optical axis 23P due to factors such as a fabrication process error or an assembly tolerance. The relay grating 13 and the out-coupling grating 12 are formed on the main flat surface 190. As shown in FIG. 24A and FIG. 24B, both a surface that is of the waveguide substrate 19 and that faces a side of the optical engine 20 and is perpendicular to the optical axis 23P and a surface that is away from the side of the optical engine 20 and is perpendicular to the optical axis 23P are main flat surfaces 190. The waveguide substrate 19 includes an oblique surface 191, and the oblique surface 191 is located at a position at which the in-coupling grating 11 and the waveguide substrate 19 are combined. In this implementation, the waveguide substrate 19 is of an integrally formed structure, and the oblique surface 191 is a structure formed by removing a part of material from the waveguide substrate 19. In an implementation, the oblique surface 191 is formed on a surface that is on the waveguide substrate 19 and that faces the optical engine 20. This solution defines a specific forming manner of the oblique surface. A part of material is removed from the waveguide substrate to form the oblique surface, to help ensure stability of a refractive index at a position of the oblique surface. That is, in a process of forming the oblique surface, it is not easy to change a refractive index of the waveguide substrate, thereby ensuring diffraction efficiency of the in-coupling grating, ensuring that a coupled-in light ray does not generate unnecessary deflection, and ensuring authenticity of a formed virtual image without distortion.

In an implementation, a process of fabricating the oblique surface 191 is as follows: First, a flat-plate-shaped waveguide substrate is provided, where two surfaces of the waveguide substrate are planar in shape. A part of material is removed through cutting at a position near an edge of one of the planes to form an oblique surface, and then surface processing, for example, polishing, is performed on the oblique surface.

In an implementation, as shown in FIG. 24A, the two main flat surfaces 190 of the waveguide substrate 19 are a first main flat surface and a second main flat surface respectively, the first main flat surface and the second main flat surface are disposed opposite to each other, and both the first main flat surface and the second main flat surface may be perpendicular to the optical axis 23P of the optical engine 20. One end of the oblique surface 191 is connected to the first main flat surface of the waveguide substrate 19, and the other end of the oblique surface 191 is connected to the second main flat surface of the waveguide substrate 19. In this implementation, a sharp-angle structure is formed between the oblique surface 191 and the main flat surface 190 that is away from the optical engine 20. In another implementation, the oblique surface 191 and the main flat surface 190 that is away from the optical engine 20 may alternatively be connected by using a side plane or an arc surface.

For ease of description, in FIG. 24A, a position relationship between an incident edge light ray, the optical axis 23P, and a reflected light ray and angle numbers are schematically shown below the optical engine 20. In the implementation shown in FIG. 24A, the in-coupling grating 11 is formed on the oblique surface 191. In an implementation, the in-coupling grating 11 is a diffraction grating, for example, a surface relief grating (Surface Relief Grating) manufactured by using a photoetching technology, or a volume holographic grating (Volume Holographic Grating) manufactured based on a holographic interference technology. The in-coupling grating 11 is configured to receive a mixed light beam transmitted by the optical engine 20, and modulate the mixed light beam. At a position of the in-coupling grating 11, a part of the light beam enters the waveguide substrate 19 through the in-coupling grating, and a part of the light beam is reflected by the in-coupling grating.

FIG. 24A is a diagram in which an edge light ray of a FOV of the optical engine 20, namely, a light ray that is incident from the position B1 of the light emitting unit 21 to the in-coupling grating 11, is reflected by the in-coupling grating 11 to form a reflected light ray. Specifically, a light ray emitted at the first position B1 of the light emitting unit 21 of the optical engine 20 enters the optical imaging unit 23 after passing through the light combining unit 22, and after the light ray is modulated by the optical imaging unit 23, an incident edge light ray of a field of view of the optical engine 20 is formed, and is projected onto the in-coupling grating 11. The in-coupling grating 11 modulates the incident light, and 20% to 30% of energy enters the waveguide substrate 19. A light ray entering the waveguide substrate 19 undergoes total internal reflection in the waveguide substrate 19, then is transmitted to the out-coupling grating 12 through the relay grating 13, and is coupled to the human eye through the out-coupling grating 12 to form a virtual image. 40% of energy of parallel light projected by the optical engine 20 onto the in-coupling grating 11 is directly reflected (a light ray represented by a dashed line), which means zero-order reflection. An included angle between the incident edge light ray of the field of view of the optical engine 20 incident on the in-coupling grating 11 and the optical axis 23P is a first angle $\beta 1$, an included angle between a light ray reflected by the in-coupling grating 11 (referred to as an in-coupling grating reflected light ray) and the optical axis 23P is a second angle $\beta 2$, and the second angle $\beta 2$ is greater than the first angle $\beta 1$. Because the second angle $\beta 2$ is greater than the first angle $\beta 1$, it can be ensured that the reflected light ray does not enter the optical engine 20.

In an implementation, $\beta 2 > \beta 1 + 0.1°$. In a process of fabricating the optical waveguide or in a process of assembling the optical waveguide to the near-eye display device, a fabrication tolerance or an assembly error is likely to cause an angle error of the included angle between the in-coupling grating reflected light ray and the optical axis and an angle error of the included angle between the incident edge light ray and the optical axis. To compensate for the error, in an implementation of this application, a difference between the second angle $\beta 2$ and the first angle $\beta 1$ is restricted to be at least 0.1°, so that a fabricating yield can be improved.

In this solution, due to arrangement of the oblique surface 191 and the in-coupling grating 11, an oblique state is formed between a specified angle of the in-coupling grating 11 and the main flat surface 190 of the waveguide substrate 19. In this way, a part of light rays incident on the in-coupling grating 11 are reflected, to form an in-coupling grating reflected light ray at an included angle that is the second angle $\beta 2$ relative to the optical axis 23P. The included angle namely, the second angle $\beta 2$, between the in-coupling grating reflected light ray and the optical axis 23P is greater than the included angle (the first angle $\beta 1$) between the incident edge light ray of the field of view of the optical engine 20 incident on the in-coupling grating 11 and the optical axis 23P. In this way, it can be ensured that the light ray reflected by the in-coupling grating 11 is deflected out of the optical engine 20. "Deflected out of the optical engine 20" may be understood as that the in-coupling grating reflected light ray does not enter an optical effective region of the optical engine 20. The in-coupling grating reflected light ray is located outside the optical effective region of the optical engine 20, and therefore is not reflected back to the light emitting unit 21 of the optical engine 20. Therefore, the optical component provided in this implementation does not have a ghost image phenomenon formed when a reflected light ray of the out-coupling grating 11 enters the optical engine 20 and then is reflected again.

In this implementation, the light ray emitted at the first position B1 of the light emitting unit 21, namely, the incident edge light ray, is restricted to be reflected by the in-coupling grating 11 to be deflected out of the optical engine. The incident edge light ray is a light ray at an extreme position of the FOV of the optical engine, and the in-coupling grating 11 is disposed on the oblique surface 191, where the oblique surface 191 and the optical axis 23P are not perpendicular to each other, but form a specific angle. Such design can ensure that light rays emitted at other positions on the light emitting unit 21 all are deflected out of the optical engine.

Refer to FIG. 24B. FIG. 24B schematically shows a reflection path of a light ray emitted at the second position B2 on the light emitting unit 21 and then reflected by the in-coupling grating 11. As shown in FIG. 24B, the light ray emitted at the second position B2 on the light emitting unit 21 enters the optical imaging unit 23 after passing through the light combining unit 22, and after being modulated by the optical imaging unit 23, the light ray is projected onto the in-coupling grating 11, and is reflected at a position of the in-coupling grating 11. An included angle between the reflected light ray and the optical axis 23P is a third angle $\beta3$. The third angle $\beta3$ is greater than the second angle $\beta2$. Therefore, after being reflected by the in-coupling grating 11, the light ray emitted at the second position B2 is deflected out of the optical engine 20.

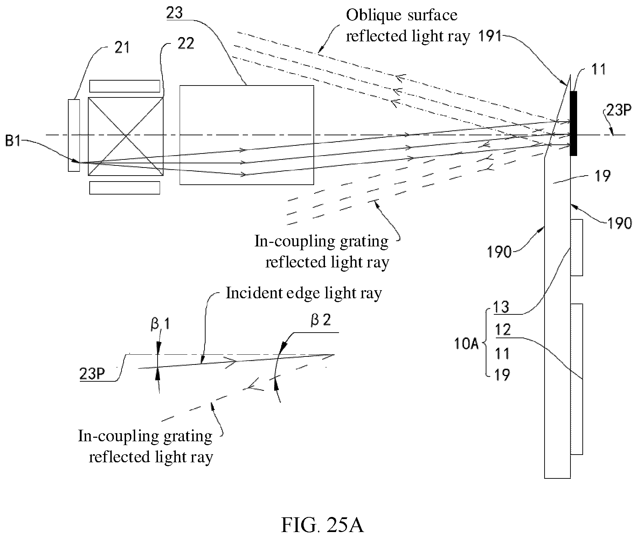

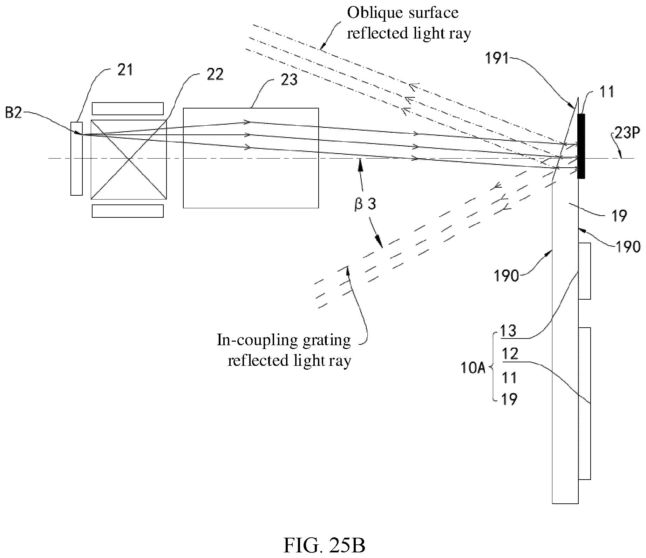

FIG. 25A and FIG. 25B are diagrams of an optical component according to an implementation of this application, where FIG. 25A and FIG. 25B are respectively diagrams of light rays emitted at a position B1 and a position B2 on a light emitting unit and reflected by an in-coupling grating.

A difference of the implementation shown in FIG. 25A from the implementation shown in FIG. 24A lies in that the in-coupling grating 11 is disposed at a different position. As shown in FIG. 25A, in an implementation, the waveguide substrate 19 includes a main flat surface 190, the oblique surface 191 is inclined relative to the main flat surface 190, the in-coupling grating 11 is formed on the main flat surface 190, and in an extension direction of the optical axis 23P, the oblique surface 191 is located between the in-coupling grating 11 and the optical engine 20. An incident edge light ray of the field of view of the optical engine 20 enters an optical waveguide 10A through the oblique surface 191, and is incident on the in-coupling grating 11. When projected onto the oblique surface 191, the incident edge light ray is reflected, to form an oblique surface reflected light ray shown in FIG. 25A. Energy of the oblique surface reflected light ray is weak, for example, is less than 10% of energy that is incident to a position of the in-coupling grating. Even if the oblique surface reflected light ray enters the optical engine, an imaging effect is not affected, and a ghost image cannot be generated. Therefore, whether the oblique surface reflected light ray enters the optical engine is not considered in this application.

The incident edge light ray shown in FIG. 25A enters the optical waveguide 10A at a position of the oblique surface 191, and is projected onto the in-coupling grating 11. Zero-order reflection is formed at the position of the in-coupling grating 11, that is, an in-coupling grating reflected light ray is formed. According to the design of this application, the in-coupling grating reflected light ray can be deflected out of the optical engine 20. Specifically, the in-coupling grating 11 reflects a part of light rays, and the reflected light ray is directly emitted out of the optical waveguide 10A, to form the in-coupling grating reflected light ray. Because the oblique surface 191 is inclined relative to the main flat surface 190 on which the in-coupling grating 11 is located, a light ray that enters the optical waveguide 10A from the oblique surface 191 and then is projected onto the in-coupling grating 11 is refracted at the position of the oblique surface 191. In this way, it can be ensured that an in-coupling grating reflected light ray reflected at the position of the in-coupling grating 11 is deflected out of the optical engine 20. "Deflected out of the optical engine 20" may be understood as that the reflected light ray does not enter an optical effective region of the optical engine. The reflected light ray is located outside the optical effective region of the optical engine, and therefore is not reflected back to the light emitting unit of the optical engine. Therefore, the optical component provided in this implementation does not have a ghost image phenomenon formed when a reflected light ray of the out-coupling grating 11 enters the optical engine 20 and then is reflected again.

In the implementation shown in FIG. 25A, when an edge light ray of the field of view of the optical engine 20 reflected by the in-coupling grating 11 enters the optical waveguide through the oblique surface 191, light ray refraction occurs, so that after the light ray is projected onto the in-coupling grating, the in-coupling grating reflected light ray deflected out of the optical engine can be formed. Specifically, an included angle between the incident edge light ray of the field of view of the optical engine 20 projected onto the oblique surface 191 and the optical axis 23P of the optical engine 20 is a first angle $\beta1$, an included angle between the in-coupling grating reflected light ray reflected at the in-coupling grating 11 and the optical axis 23P of the optical engine 20 is a second angle $\beta2$, and the second angle $\beta2$ is greater than the second angle $\beta1$. In an implementation, $\beta2 > \beta1 + 0.1°$.

In the implementation shown in FIG. 25A, the second angle β2 is restricted to be greater than the first angle β1, so that a light ray emitted at a first position B1 of the light emitting unit 21, namely, an incident edge light ray, is reflected by the in-coupling grating 11 to be deflected out of the optical engine. The incident edge light is a light at an extreme position of the FOV of the optical engine, and the in-coupling grating 11 is disposed on a side that is of the oblique surface 191 and that is away from the optical engine, where the oblique surface 191 and the optical axis 23P are not perpendicular to each other, but form a specific angle to refract the incident edge light. Such design can ensure that light rays emitted at other positions on the light emitting unit 21, after being reflected by the in-coupling grating 11, all are deflected out of the optical engine.

Refer to FIG. 25B. FIG. 25B schematically shows a reflection path of a light ray emitted at a second position B2 on the light emitting unit 21 and then reflected by the in-coupling grating 11. As shown in FIG. 25B, the light ray emitted at the second position B2 on the light emitting unit 21 enters an optical imaging unit 23 after passing through a light combining unit 22, is modulated by the optical imaging unit 23, is projected onto the oblique surface 191, enters an optical waveguide 10A after being refracted by the oblique surface 191, is projected onto the in-coupling grating 11, and is reflected at a position of the in-coupling grating 11. An included angle between the reflected light ray and the optical axis 23P is a third angle β3. The third angle β3 is greater than the second angle β2. Therefore, the light ray emitted at the second position B2, after being reflected by the in-coupling grating 11, is deflected out of the optical engine 20.

In the implementations shown in FIG. 25A and FIG. 25B, because the in-coupling grating 11 is formed on the main flat surface 190, and the main flat surface 190 is an overall planar outer surface of the waveguide substrate 19, a fabrication process of the in-coupling grating 11 has an advantage of easy fabrication, and there are advantages in both design and process steps. However, in the implementations shown in FIG. 24A and FIG. 24B, the in-coupling grating 11 is fabricated on the oblique surface 191, and although a fabrication process is challenging, an optical path between the in-coupling grating 11 and the optical engine 20 is simpler than that in the implementations shown in FIG. 25A and FIG. 25B, and it is easy to control optical transmission efficiency.

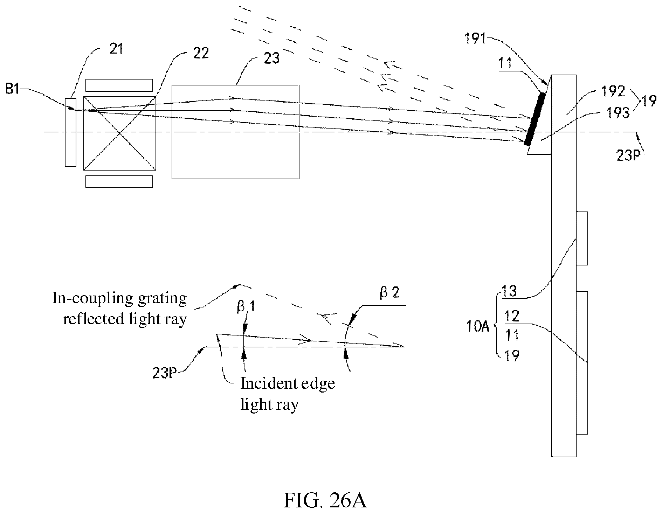

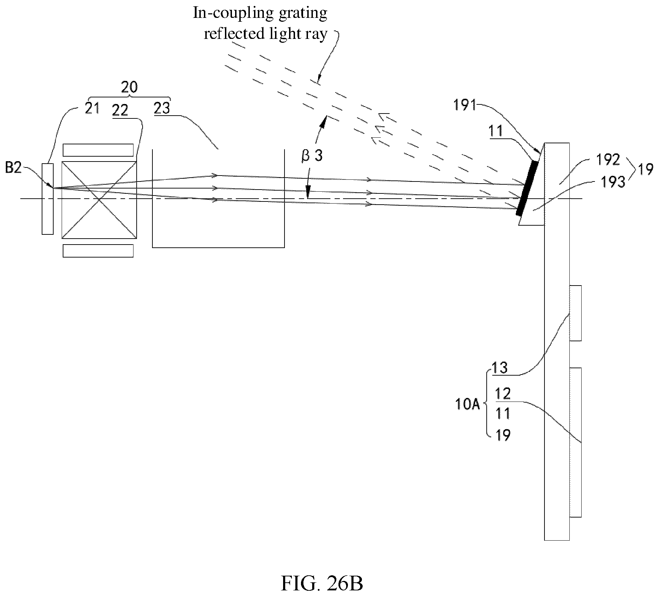

FIG. 26A and FIG. 26B are diagrams of an optical component according to an implementation of this application, where FIG. 26A and FIG. 26B are respectively diagrams of light rays emitted at a position B1 and a position B2 on a light emitting unit and reflected by an in-coupling grating.

As shown in FIG. 26A, in this implementation, the optical component includes an optical engine 20 and an optical waveguide 10A, and the optical waveguide 10A includes a waveguide substrate 19, an in-coupling grating 11, a relay grating 13, and an out-coupling grating 12. The waveguide substrate 19 includes a waveguide body structure 192 and an additional structure 193. The additional structure 193 is fastened to a surface that is of the waveguide body structure 192 and that faces the optical engine 20, an oblique surface 191 is formed on the additional structure 192, and the oblique surface 191 is located on a surface that is of the additional structure 193 and that is away from the waveguide body structure 192. In an implementation, the waveguide body structure 192 is of a flat-plate-like structure. As shown in FIG. 26A, a cross section of the waveguide body structure 192 is rectangular. In this solution, the additional structure 193 is added on the waveguide substrate, and the oblique surface is formed by using the additional structure. This solution has an advantage of protecting structural integrity of the waveguide substrate. The structural integrity of the waveguide substrate helps ensure life of the waveguide substrate. A waveguide substrate with no partial structure cut off has better strength and stability. An optical waveguide with good structure stability has stable optical transmission efficiency.

The additional structure 193 may be a triangular pyramid structure. As shown in FIG. 26A, a cross section of the additional structure 193 is triangular. In an implementation, a material of the waveguide body structure 192 is the same as a material of the additional structure 193. In an implementation, a refractive index of the waveguide body structure 192 is the same as a refractive index of the additional structure 193. For example, both the material of the waveguide body structure 192 and the material of the additional structure 193 are high-refractive substrate materials, and the high-refractive substrate material may be but is not limited to: TiO2, silicon nitride, gallium nitride, a high-refractive resin material, and the like. The material of the waveguide body structure 192 and the material of the additional structure 193 are designed to be the same, so as to ensure consistency of transmission that is of a light ray incident to the waveguide substrate 19 and that is in the additional structure 193 and the waveguide body structure 192. This avoids that diffraction efficiency is affected by light ray refraction or a required angle of incident light cannot be obtained due to different refractive indexes. Therefore, in this application, the refractive index and the material of the additional structure 193 are restricted to be the same as those of the waveguide substrate 19, to ensure optical performance of the optical waveguide 10A. As defined in this application, the refractive indexes being the same may be understood as being completely the same, or having a relatively small tolerance, or may be understood as being approximately the same, provided that an angle of incident light is within a design requirement range.

In an implementation, the waveguide body structure 192 and the additional structure 193 may be bonded by using an optical adhesive. The optical adhesive has a high refractive index. For example, a refractive index of the optical adhesive is the same as the refractive index of the waveguide body structure and the refractive index of the additional structure. A surface on which the waveguide body structure 192 and the additional structure 193 are combined may be polished, and then bonded for fastening. In this implementation, the oblique surface 191 on the additional structure 193 needs to be polished, to improve transmittance of light.

In an implementation, the waveguide body structure 192 and the additional structure 193 may alternatively be combined in an intermolecular bonding manner. In the intermolecular bonding manner, introduction of another medium such as an adhesive is avoided, to better ensure refractive index matching between the waveguide body structure 192 and the additional structure 193.

In the implementation shown in FIG. 26A, the in-coupling grating 11 is formed on the oblique surface 191, a light ray that is incident from the in-coupling grating 11 enters the waveguide body structure 192 after passing through the additional structure 193, and an included angle between a light ray reflected by the in-coupling grating 11 (that is, an in-coupling grating reflected light ray) and an optical axis 23P is a second angle $\beta2$, an included angle between an incident edge light ray of a field of view of the optical engine 20 that is incident on the in-coupling grating 11 and the optical axis 23P is a first angle $\beta1$, and the second angle $\beta2$ is greater than the first angle $\beta1$. In an implementation, $\beta2 > \beta1 + 0.1°$. This solution defines a solution of a specific position of the in-coupling grating in a solution in which the additional structure and the waveguide substrate are combined. In this solution, the in-coupling grating is disposed on the oblique surface. In this way, an optical path of incident light of the in-coupling grating is simple, and it is easy to control energy of the incident light, helping improve light efficiency.

A working principle of the implementation shown in FIG. 26A is the same as a working principle of the implementation shown in FIG. 24A. In the implementation shown in FIG. 26A, the light ray emitted at the first position B1 of the light emitting unit 21, namely, the incident edge light ray, is restricted to be reflected by the in-coupling grating 11 to be deflected out of the optical engine. The incident edge light ray is a light ray at an extreme position of the FOV of the optical engine, and the in-coupling grating 11 is disposed on the oblique surface 191, where the oblique surface 191 and the optical axis 23P are not perpendicular to each other, but form a specific angle. Such design can ensure that light rays emitted at other positions on the light emitting unit 21 all are deflected out of the optical engine.

Refer to FIG. 26B. FIG. 26B schematically shows a reflection path of a light ray emitted at the second position B2 on the light emitting unit 21 and then reflected by the in-coupling grating 11. As shown in FIG. 26B, the light ray emitted at the second position B2 on the light emitting unit 21 enters the optical imaging unit 23 after passing through the light combining unit 22, and after being modulated by the optical imaging unit 23, the light ray is projected onto the in-coupling grating 11, and is reflected at a position of the in-coupling grating 11. An included angle between the reflected light ray and the optical axis 23P is a third angle $\beta3$. The third angle $\beta3$ is greater than the second angle $\beta2$. Therefore, the light ray emitted at the second position B2, after being reflected by the in-coupling grating 11 (that is, the in-coupling grating reflected light ray), is deflected out of the optical engine 20.

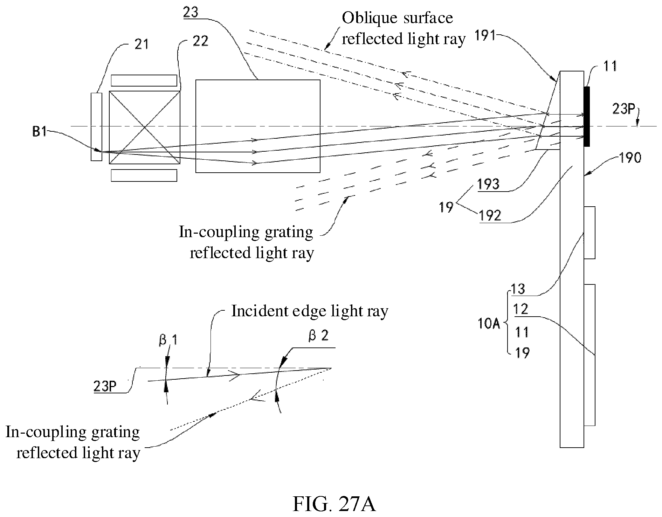

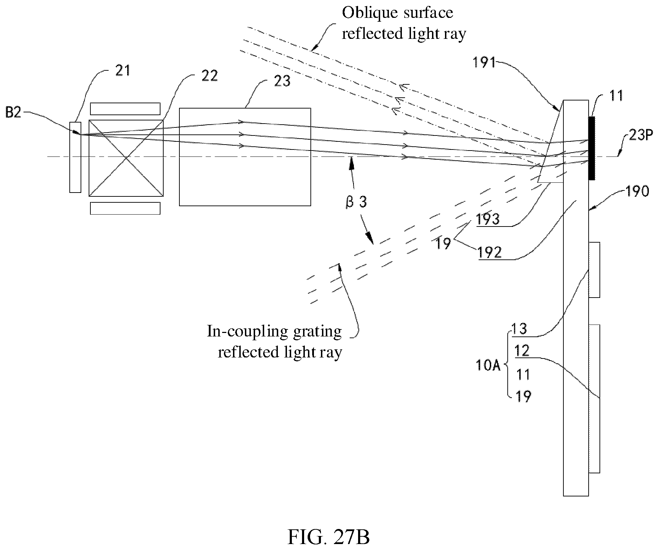

FIG. 27A and FIG. 27B are diagrams of an optical component according to an implementation of this application, where FIG. 27A and FIG. 27B are respectively diagrams of light rays emitted at a position B1 and a position B2 on a light emitting unit and reflected by an in-coupling grating.

A difference of the implementation shown in FIG. 27A from the implementation shown in FIG. 26A lies in that the in-coupling grating 11 is disposed at a different position. As shown in FIG. 27A, in an implementation, the waveguide body structure 192 includes a main flat surface 190, the oblique surface 191 on the additional structure 193 is inclined relative to the main flat surface 190, the in-coupling grating 11 is formed on the main flat surface 190, and in an extension direction of the optical axis 23P, the oblique surface 191 is located between the in-coupling grating 11 and the optical engine 20. An edge light ray of a field of view of the optical engine 20 enters the additional structure 193 and the waveguide body structure 192 through the oblique surface 191 and is incident on the in-coupling grating 11. The edge light ray of the field of view of the optical engine 20 that is reflected by the in-coupling grating 11 forms zero-order reflection, that is, an in-coupling grating reflected light ray. The in-coupling grating reflected light ray is directly emitted out of the optical waveguide 10A, and is deflected out of the optical engine 20. "Deflected out of the optical engine 20" may be understood as that the reflected light ray does not enter an optical effective region of the optical engine. The in-coupling grating reflected light ray is located outside the optical effective region of the optical engine, and therefore is not reflected back to the light emitting unit of the optical engine. Therefore, the optical component provided in this implementation does not have a ghost image phenomenon formed when a reflected light ray of the out-coupling grating 11 enters the optical engine 20 and then is reflected again.

In this implementation, an included angle between the in-coupling grating reflected light ray reflected by the in-coupling grating 11 and the optical axis 23P is a second angle $\beta2$, an included angle between an incident edge light ray of a field of view of the optical engine 20 that is incident on the oblique surface 191 and the optical axis 23P is a first angle $\beta1$, and the second angle $\beta2$ is greater than the first angle $\beta1$. In an implementation, $\beta2 > \beta1 + 0.1°$.

When projected onto the oblique surface 191, the incident edge light ray is reflected at a position of the oblique surface 191, which is referred to as an oblique surface reflected light ray. Energy of the oblique surface reflected light ray is weak, for example, is less than 10% of energy that is incident to a position of the in-coupling grating. Even if the oblique surface reflected light ray enters the optical engine, an imaging effect is not affected, and a ghost image cannot be generated. Therefore, whether the oblique surface reflected light ray enters the optical engine is not considered in this application.

The implementation shown in FIG. 27A has a similar principle to the implementation shown in FIG. 25A. The second angle β2 is restricted to be greater than the first angle β1, so that a light ray emitted at a first position B1 of the light emitting unit 21, namely, an incident edge light, is reflected by the in-coupling grating 11 to be deflected out of the optical engine. The incident edge light ray is a light at an extreme position of the FOV of the optical engine, and the in-coupling grating 11 is disposed on a side that is of the oblique surface 191 and that is away from the optical engine, where the oblique surface 191 and the optical axis 23P are not perpendicular to each other, but form a specific angle to refract the incident edge light ray. Such design can ensure that light rays emitted at other positions on the light emitting unit 21, after being reflected by the in-coupling grating 11, all are deflected out of the optical engine.

Refer to FIG. 27B. FIG. 27B schematically shows a reflection path of a light ray emitted at the second position B2 on the light emitting unit 21 and then reflected by the in-coupling grating 11. As shown in FIG. 27B, the light ray emitted at the second position B2 on the light emitting unit 21 enters an optical imaging unit 23 after passing through a light combining unit 22, is modulated by the optical imaging unit 23, is projected onto the oblique surface 191, enters an optical waveguide 10A after being refracted by the oblique surface 191, is projected onto the in-coupling grating 11, and is reflected at a position of the in-coupling grating 11. An included angle between the reflected light ray and the optical axis 23P is a third angle β3. The third angle β3 is greater than the second angle β2. Therefore, the light ray emitted at the second position B2, after being reflected by the in-coupling grating 11, is deflected out of the optical engine 20.

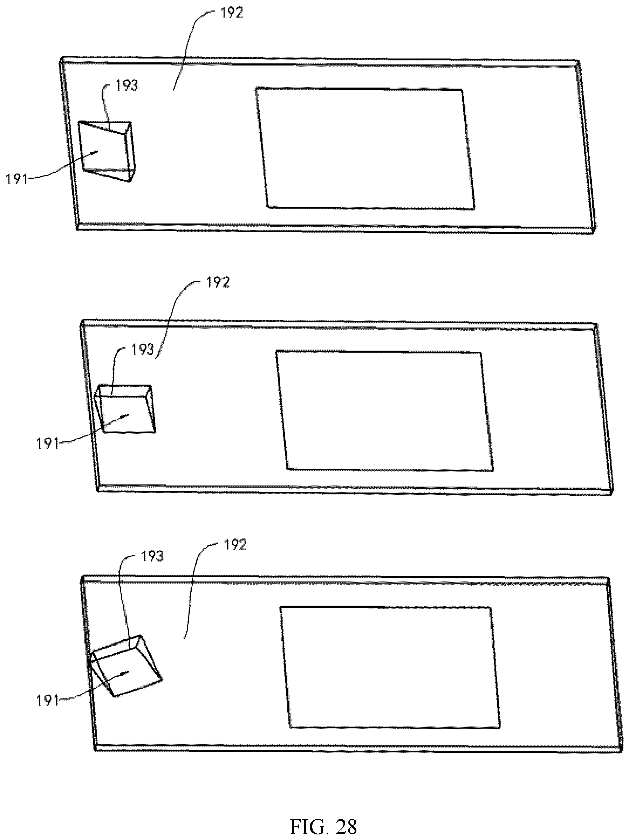

For the implementations shown in FIG. 26A and FIG. 27A, a position relationship between the additional structure 193 and the waveguide body structure 192 may have a plurality of different forms. As shown in FIG. 28, FIG. 28 schematically illustrates three position relationships between the additional structure 193 and the waveguide body structure 192. It may be understood that an inclined direction of the oblique surface 191 on the additional structure 93 relative to the waveguide body structure 192 is adjustable, and different inclined directions of the oblique surface 191 may correspond to different definitions of the field of view of the optical engine. For example, the field of view of the optical engine may be a horizontal field of view or a vertical field of view.

A direction perpendicular to an extension direction of the optical axis 23P of the optical engine 20 is a reference direction. Therefore, in the optical component provided in this application, an included angle between the oblique surface on the waveguide substrate and the reference direction is greater than or equal to a half of the horizontal field of view or a half of the vertical field of view of the optical engine. In an implementation, the optical axis of the optical engine is a central axis of an optical effective region of the optical engine. It may be understood that the optical engine may be a non-off-axis optical system, and the central axis of the optical effective region is the optical axis, which provides convenience for design of the optical engine. In another implementation, the optical engine may alternatively be an off-axis optical system.

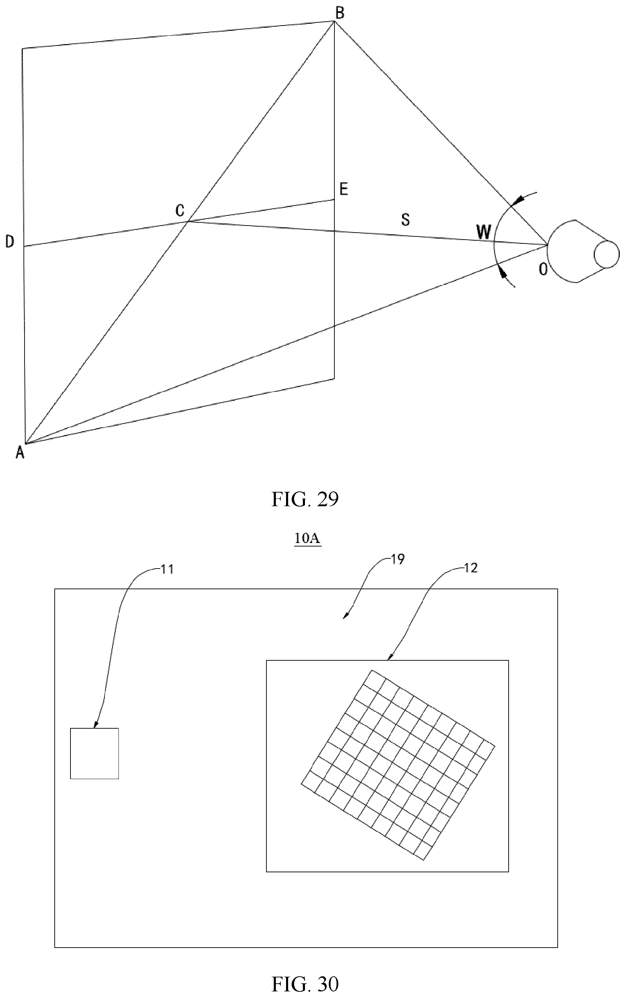

FIG. 29 schematically illustrates a parameter of a field of view of an optical engine. In a specific implementation, a definition and a calculation rule of the field of view (FOV) of the optical engine are as follows: As shown in FIG. 29, a square region whose diagonal is AB is an entire image display region, and a position of a point O is a position of the human eye. In this case, a size of a FOV corresponding to the square region observed by the human eye is 2*tan (AC/S).

For example, based on the implementations shown in FIG. 25A and FIG. 27A, if a FOV of a displayed picture is 30 degrees and a ratio is 4:3, a horizontal FOV and a vertical FOV are 24 degrees and 18 degrees respectively. In an implementation, a direction perpendicular to the optical axis 23P is a reference direction, and an included angle between the oblique surface 191 and the reference direction is greater than or equal to 12 degrees.

With reference to FIG. 25A, FIG. 27A, and FIG. 29, in an implementation, an edge FOV of the optical engine corresponds to a point E in FIG. 29. It is assumed that in this case, a half of the FOV in a horizontal direction is β1, an included angle between the oblique surface 191 and the reference direction is greater than or equal to β2, a refractive index of a medium around the waveguide substrate 19 is n1, and a refractive index of the waveguide substrate 19 is n2. In this case, according to the refraction law, the following formula exists:

$$n_1 \sin(\beta_1 + \beta_2) = n_2 \sin(\beta_2)$$

The following can be obtained:

$$\beta_2 = \arctan\left(\frac{n_1 \sin(\beta_1)}{n_2 - n_1 \cos(\beta_1)}\right)$$

Therefore, the included angle between the oblique surface 191 and the reference direction needs to be greater than or equal to this value.

Assuming that n1 is 1 and n2 is 1.9, it may be obtained through calculation that the included angle between the oblique surface 191 and the reference direction is greater than or equal to 12.7°.

Solution 3: Out-coupling grating architecture including a one-dimensional grating and a two-dimensional grating

In an implementation, this application provides an optical waveguide. The optical waveguide may be a diffractive optical waveguide. The diffractive optical waveguide has advantages such as lightness and thinness, compactness, and high brightness. Use of such an optical waveguide in a near-eye display device can promote advantages of lightweight and ease of wearing of the near-eye display device. For the optical waveguide, in a design process of the optical waveguide, how to improve optical transmission efficiency, ensure uniformity of image light, and reduce processing and fabrication difficulty is a research and development direction in the industry.

FIG. 30 is a diagram of an optical waveguide according to an implementation of this application. Refer to FIG. 30. In an implementation, an optical waveguide 10A includes a waveguide substrate 19 and an in-coupling grating 11 and an out-coupling grating 12 that are formed on the waveguide substrate 19. The in-coupling grating 11 is configured to be disposed opposite to an optical engine, and is configured to receive a light beam transmitted by the optical engine, and couple the light beam into the waveguide substrate 19. Total internal reflection propagation of the light beam is performed in the waveguide substrate 19, and the light beam is coupled out by the out-coupling grating 12, so that a human eye sees an image. In an implementation, the out-coupling grating 12 mainly has two functions: first, performing pupil expansion, so that light rays can cover a larger area; and second, coupling light rays, so that the light rays enter the human eye.

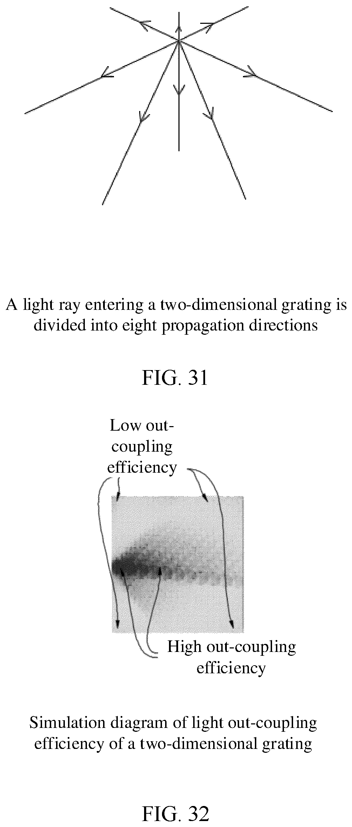

In an implementation, the out-coupling grating 12 is a two-dimensional grating structure. In this solution, the out-coupling grating 12 has two periodicity directions. In a propagation process of light rays in the out-coupling grating 12, one beam of light can be divided by the out-coupling grating 12 into eight propagation directions (as shown in FIG. 31, where FIG. 31 is a diagram in which a two-dimensional grating divides light into eight propagation directions). It may be understood that light in the eight propagation directions is not all coupled out, and light rays in some directions cannot be coupled out and are therefore wasted. FIG. 32 is a diagram of light out-coupling efficiency of the optical waveguide shown in FIG. 31. FIG. 32 is a diagram of light ray out-coupling efficiency, where a region with a deep color is a region with high out-coupling efficiency, and a region with a light color is a region with low out-coupling efficiency. It can be learned from the diagram of light out-coupling efficiency shown in FIG. 32 that out-coupling efficiency of a middle-left region in the square region is the highest, light out-coupling efficiency of a middle region of the square region gradually becomes weak from left to right, and light out-coupling efficiency of four corners of the square region is the lowest.

Because all regions of the out-coupling grating 12 in the optical waveguide 10A shown in FIG. 30 are of a two-dimensional grating architecture, one beam of light passing through the out-coupling grating generates eight propagation directions, and many light rays do not enter the human eye and are directly wasted, resulting in energy waste. In addition, light rays with different FOVs are modulated by the two-dimensional grating different times before entering the human eye. As a result, energy entering the human eye is different, that is, light uniformity of an image seen by the human eye is inconsistent.

To resolve a problem of energy waste and uneven light rays, an implementation of this application provides a structure of an out-coupling grating. The out-coupling grating includes a first region and a second region, the first region includes a first sub-region and a second sub-region, types of gratings in both the first sub-region and the second sub-region are one-dimensional gratings, types of gratings in the second region are two-dimensional gratings, a connection line between a center of the second region and a center of the in-coupling grating is referred to as a central axis, and the first sub-region and the second sub-region are distributed on two sides of the central axis. In this application, the one-dimensional gratings in the first region make most energy of light rays be transmitted to the second region, so that light propagation efficiency can be improved, light uniformity can be improved, fabrication difficulty can be reduced, and costs can be reduced. Specific descriptions are as follows:

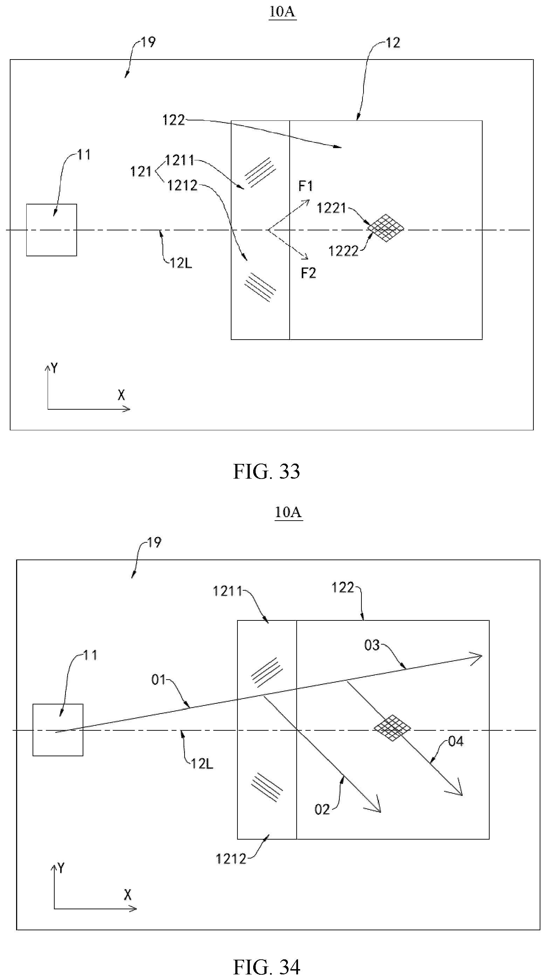

In an implementation, with reference to FIG. 33, the waveguide substrate 19 of the optical waveguide 10A may be a wafer or an imprint adhesive with a high refractive index. The in-coupling grating 11 and the out-coupling grating 12 are formed on a surface of the waveguide substrate 19. The in-coupling grating 11 is located in a light incident region of the optical waveguide 10A, and the in-coupling grating 12 is located in a light exit region of the optical waveguide 10A. In this implementation, the out-coupling grating 12 includes a first region 121 and a second region 122. The in-coupling grating 11 and the out-coupling grating 12 are arranged along a first direction X. In the first direction, the first region 121 is located on a light incident side of the second region 122, and the first region 121 is located between the in-coupling grating 11 and the second region 122. The first region 121 includes a first sub-region 1211 and a second sub-region 1212. The first sub-region 1211 and the second sub-region 1212 are arranged along a second direction Y. A direction of a connection line between a center of the first sub-region 1211 and a center of the second sub-region 1212 is the second direction Y, and the second direction Y intersects with the first direction X. In a specific implementation, the first direction X and the second direction Y are perpendicular to each other or nearly perpendicular to each other. Types of gratings in both the first sub-region 1211 and the second sub-region 1212 are one-dimensional gratings, and types of gratings in the second region 122 are two-dimensional gratings. In FIG. 33, in the first sub-region 1211 and the second sub-region 1212, a pattern formed by parallel lines is schematically used to represent one-dimensional gratings, and in the second region 122, a grid pattern is used to represent a two-dimensional grating. FIG. 33 merely schematically represents one-dimensional gratings and a two-dimensional grating, and does not limit parameters such as specific structures, specific position distribution, and specific sizes and areas of the one-dimensional gratings and the two-dimensional grating. A connection line between a center of the in-coupling grating 11 and a center of the second region 122 is referred to as a central axis 12L. In the implementation shown in FIG. 33, an extension direction of the central axis 12L is the first direction X. The first sub-region 1211 and the second sub-region 1212 are distributed on two sides of the central axis 12L. Specifically, the first sub-region 1211 is located on one side of the central axis 12L, and the second sub-region 1212 is located on the other side of the central axis 12L. In this implementation, the central axis 12L is also a central axis of the out-coupling grating 12, and the out-coupling grating 12 may be a symmetric distribution architecture using the central axis 12L as a symmetric center. The first sub-region 1211 and the second sub-region 1212 are mirror-symmetrically distributed by using the central axis 12L as a center. This solution restricts a relationship between the first sub-region and second sub-region and the central axis, and uses mirror-symmetric design, so that energy of light in the second region of the out-coupling grating is more balanced.

FIG. 34 is a diagram in which a beam of light rays is used as an example to indicate that the out-coupling grating 12 can improve light propagation efficiency and light uniformity by using one-dimensional gratings in the first region. Refer to FIG. 34. When a first light beam 01 entering the optical waveguide from the in-coupling grating 11 is transmitted to the first region 121 of the out-coupling grating 12, because the types of gratings in the first region 121 are one-dimensional gratings, in the first region 121, the first light beam 01 is divided into two parts (that is, a first-part light beam 02 and a second-part light beam 03). The first-part light beam 02 is propagated downward and enters the second region 122, the second-part light beam 03 continues to be propagated forward and enters the second region 122, the second-part light beam 03 entering the second region 122 is also propagated downward under the action of the two-dimensional grating in the second region 122, to form a third-part light beam 04 covering the second region 122. The first region 121 is disposed as one-dimensional gratings, and the first region 121 has a function of pupil expansion, and can further restrict a light ray propagation direction, improving energy utilization. A light ray modulated by the first region 121 has only two directions, and light rays in the two directions can enter the second region 122. According to the out-coupling grating 12 provided in this application, a larger area of light rays can enter the human eye, or the human eye can observe an image in a larger area.

In the implementation shown in FIG. 30, a light beam is transmitted to the out-coupling grating. Because the out-coupling grating is a two-dimensional grating, the light beam is divided into light in eight directions, and most of the light in the eight directions cannot be coupled out, resulting in waste. Apparently, in the optical waveguide 10A provided in the implementation shown in FIG. 33, when the first light beam 01 is propagated to a position of the first region 121, because types of gratings in the first region 121 are one-dimensional gratings, the first light beam 01 is divided into light in two directions, that is, the first-part light beam 02 and the second-part light beam 03. The light in the two directions finally enters the second region 122. Therefore, the implementation shown in FIG. 33 can improve light propagation efficiency.

In an implementation, with reference to FIG. 33, dashed lines with arrows in FIG. 33 represent a first gate line direction F1 and a second gate line direction F2, a gate line extension direction of the one-dimensional grating in the first sub-region 1211 is the first gate line direction F1, and a gate line extension direction of the one-dimensional grating in the second sub-region 1212 is the second gate line direction F2. The two-dimensional grating in the second region 122 includes a first gate line 1221 and a second gate line 1222 that are disposed to intersect each other. An extension direction of the first gate line 1221 is the first gate line direction F1, and an extension direction of the second gate line 1222 is the second gate line direction F2. Alternatively, an extension direction of the first gate line 1221 is approximately the same as the first gate line direction F1, and an extension direction of the second gate line 1222 is approximately the same as the second gate line direction F2. "Approximately the same as" can be understood as: An included angle between the extension direction of the first gate line 1221 and the first gate line direction F1 may be within a small allowed included angle range. When the included angle is 0, the two directions are same directions or are parallel. In this application, the extension direction of the first gate line 1221 is approximately the same as the first gate line direction F1, and the extension direction of the second gate line 1222 is approximately the same as the second gate line direction F2, so that image information transmitted by the optical waveguide is authentic, without image distortion, thereby ensuring an image display effect.

In an implementation, an included angle between the first gate line direction F1 and the second gate line direction F2 is 60 degrees. In this solution, the included angle between the first gate line direction F1 and the second gate line direction F2 is 60 degrees, to restrict a light ray propagation direction, so that the light ray propagation direction matches a gate line direction of the two-dimensional grating in the second region 122. In this way, it can be ensured that more light rays are coupled out, and high light efficiency can be obtained.

In an implementation, a distribution period of the one-dimensional grating in the first sub-region 1211 is the same as a distribution period of the first gate line 1221. A distribution period of the one-dimensional grating in the second sub-region 1212 is the same as a distribution period of the second gate line 1222. For example, distribution periods of one-dimensional gratings in both the first sub-region 1211 and the second sub-region 1212 may be 300 nm. In this solution, the period of the one-dimensional grating in the first sub-region is restricted to be the same as the period of the first gate line in the second region, and the period of the one-dimensional grating in the second sub-region is restricted to be the same as the period of the second gate line in the second region, to ensure that a coupled-out image is distortionless and adverse phenomena such as distortion of the image are not caused, and to ensure an image display effect.

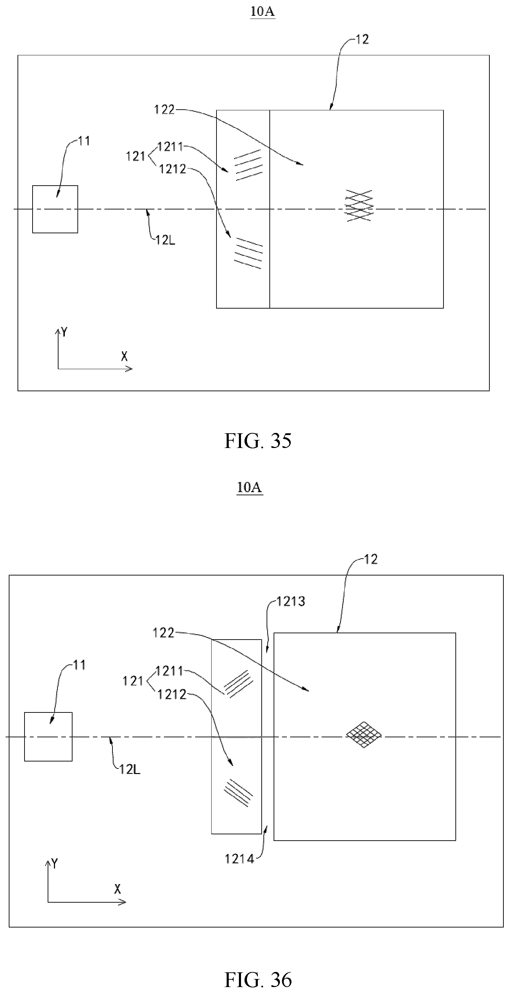

With reference to FIG. 33 and FIG. 35, in an implementation, if the gate line direction and a period of the two-dimensional grating in the second region 122 change, gate line directions and periods of one-dimensional gratings in the first sub-region 1211 and the second sub-region 1212 of the first region 121 also need to be correspondingly changed.

In the implementation shown in FIG. 33, the first sub-region 1211 is in contact with the second sub-region 1212, which may also be understood as: There is no gap between the first sub-region 1211 and the second sub-region 1212, or there is no other structural characteristic that is between the first sub-region 1211 and the second sub-region 1212 and that does not belong to the first region. The first sub-region 1211 is in contact with the second region 122, and the second sub-region 1212 is in contact with the second region 122, which may also be understood as: There is no gap between the first sub-region 1211 and the second region 122 and no gap between the second sub-region 1212 and the second region 122, and there is no other structure that does not belong to the out-coupling grating 12. In the implementation shown in FIG. 33, areas of the first sub-region 1211 and the second sub-region 1212 are equal. In another implementation, areas of the first sub-region 1211 and the second sub-region 1212 may alternatively be not equal, and specific sizes and forms of the first sub-region 1211 and the second sub-region 1212 may be adjusted according to a specific requirement. In the implementation shown in FIG. 33, in the second direction, the first region 121 and the second region 122 have a same size, and in the first direction, a size of the second region 122 is greater than a size of the first region 121. It may also be understood that the area of the second region 122 is greater than the area of the first region 121.

Refer to FIG. 36. In an implementation, the first region 121 and the second region 122 may alternatively be not in contact with each other, that is, there is a spacing region between the first region 121 and the second region 122, and there is no grating structure in the spacing region. Specifically, a first spacing region 1213 is formed between the first sub-region 1211 and the second region 122, and there is no grating structure in the first spacing region 1213. A second spacing region 1214 is formed between the second sub-region 1212 and the second region 122, and there is no grating structure in the second spacing region 1214. In an implementation, the first spacing region 1213 and the second spacing region 1214 are connected. Arrangement of the first spacing region 1213 and the second spacing region 1214 helps ensure that a fabrication yield and efficiency are improved in a process of fabricating the out-coupling grating 12. Because the first region 121 is one-dimensional gratings only, and a part that is in the second region 122 and that is close to the first region is the two-dimensional grating, if the first region 121 is in contact with the second region 122, and no spacing region is disposed, a boundary of each part needs to be precisely controlled in a fabrication process, to avoid overlapping between an edge of the first region 121 and an edge of the second region 122. Therefore, in this solution, arrangement of the first spacing region 1213 and the second spacing region 1214 can reduce fabrication costs.

In a specific implementation, an extension size of the first spacing region 1213 in the first direction X is less than or equal to 4 mm. An extension size of the second spacing region 1214 in the first direction X is less than or equal to 4 mm. This solution defines the sizes of the first spacing region and the second spacing region in the first direction, to help ensure light ray utilization and intensity of a coupled-out light ray.

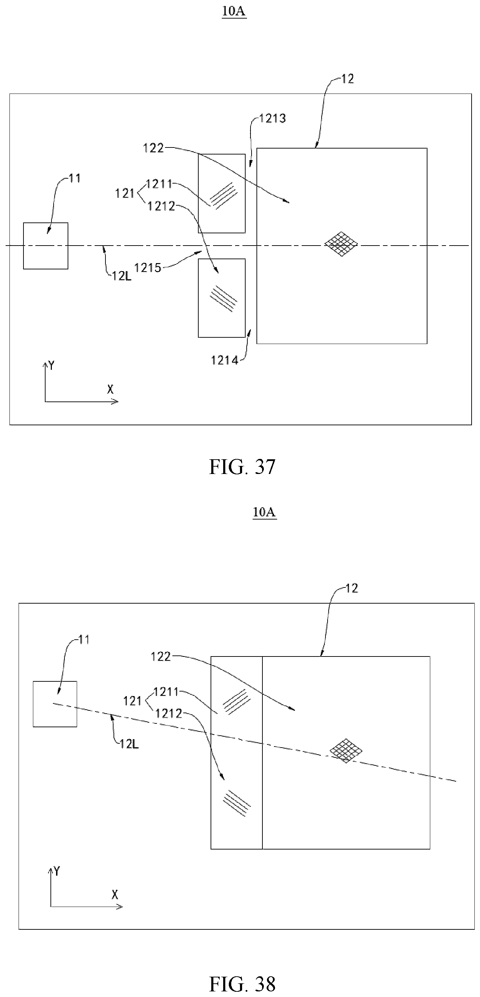

Refer to FIG. 37. A third spacing region 1215 is formed between the first sub-region 1211 and the second sub-region 1212, and there is no grating structure in the third spacing region 1215. Because types of gratings in both the first sub-region 1211 and the second sub-region 1212 are one-dimensional gratings, if the first sub-region 1211 is in contact with the second sub-region 1212, boundaries of the first sub-region 1211 and the second sub-region 1212 need to be precisely controlled in a fabrication process, to ensure that the boundaries of the first sub-region 1211 and the second sub-region 1212 do not overlap. If the two boundaries overlap, a two-dimensional grating is formed in an overlapping part, and the two-dimensional grating divides a light ray into eight different directions, resulting in light ray waste and an energy loss. Therefore, in this solution, the first sub-region 1211 and the second sub-region 1212 are separated, so that edges of the first sub-region 1211 and the second sub-region 1212 are not in contact with each other, to reduce fabrication costs and ensure a fabricating yield. An extension size of the third spacing region 1215 in the second direction Y is less than or equal to a maximum radial size of the in-coupling grating. In this solution, the third spacing region is disposed between the first sub-region and the second sub-region, to help simplify a process of fabricating the one-dimensional grating in the first sub-region and the one-dimensional grating in the second sub-region. Grating structures at adjacent positions of the two sub-regions do not need to be accurately controlled, and it can be ensured that one-dimensional gratings in the two regions are fabricated more easily, provided that the third spacing region is reserved. This reduces fabrication costs and research and development costs. In this solution, a relationship between the third spacing region and the maximum radial size of the in-coupling grating is restricted, so that a light ray transmitted by the in-coupling grating to the third spacing region can still be transmitted to the second region through the one-dimensional grating structures in the first sub-region and the second sub-region, to avoid waste of more light energy.

In the implementation shown in FIG. 33, center positions of the in-coupling grating 11 and the out-coupling grating 12 exactly face each other, and both the in-coupling grating 11 and the out-coupling grating 12 are symmetrically distributed in the second direction Y by using the central axis 12L as a center. It may be understood that, in different application scenarios, positions of the in-coupling grating 11 and the out-coupling grating 12 may be adjusted. After the in-coupling grating 11 moves relative to the position of the out-coupling grating 12, the central axis 12L changes accordingly. In an implementation, the optical waveguide 10A provided in this application is used in a near-eye display device, namely, AR glasses. In the near-eye display device, the optical waveguide 10A needs to be combined with a lens. It may also be understood that the optical waveguide 10A needs to be mounted on the lens or integrated with the lens. In this application scenario, the in-coupling grating 12 is usually located near an edge of the lens or in a corner of the lens.

Refer to FIG. 38. In this implementation, in the first direction X, at least a part of the in-coupling grating 11 exactly faces the first sub-region 1211 in the out-coupling grating 12. An included angle is formed between the extension direction of the central axis 12L and the first direction X. A boundary line between the first sub-region 1211 and the second sub-region 1212 in the first region 121 is located on the central axis 12L, and the first sub-region 1211 and the second sub-region 1212 in the first region 121 have different contour shapes and different areas. In this implementation, a direction of a connection line between a central position of the first sub-region 1211 in the first direction X and a central position of the second sub-region in the first direction X is the second direction Y An included angle less than 90 degrees is formed between the first direction Y and the central axis 12L. In this implementation, a position of the in-coupling grating 11 is adjusted, so that specific structural forms of the first sub-region 1211 and the second sub-region 1212 in the first region 121 change. However, the first sub-region 1211 and the second sub-region 1212 can still restrict a light beam propagation direction and improve light propagation efficiency. An optical principle of the first sub-region 1211 and the second sub-region 1212 is the same as that shown in FIG. 34.

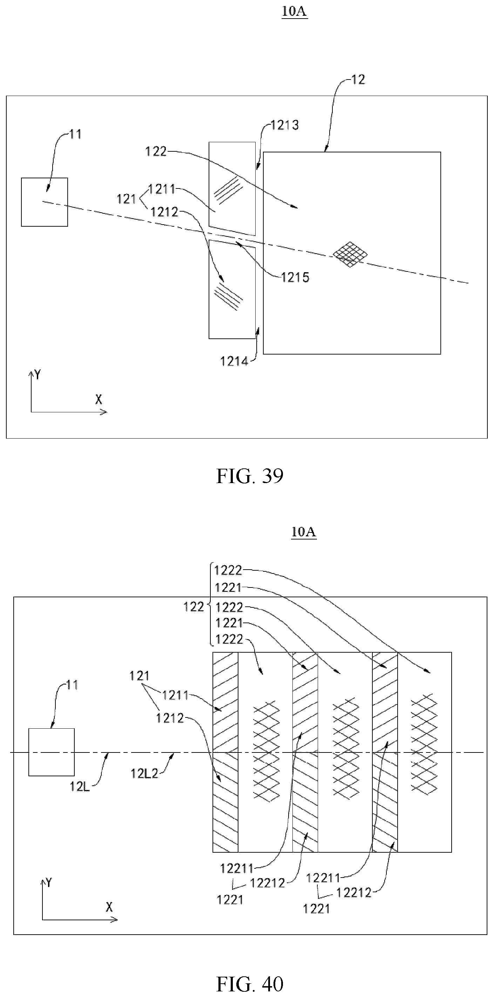

Refer to FIG. 39. An implementation shown in FIG. 39 is based on the implementation shown in FIG. 38. A first spacing region 1213 is disposed between the first sub-region 1211 and the second region 122, a second spacing region 1214 is disposed between the second sub-region 1212 and the second region 122, and a third spacing region 1215 is disposed between the first sub-region 1211 and the second sub-region 1212. Specific sizes and areas of the first sub-region 1211 and the second sub-region 1212 are also correspondingly adjusted. The first sub-region 1211 protrudes from a top edge of the second region 122 in the second direction Y, and the second sub-region 1212 is recessed relative to a bottom edge of the second region 122 in the second direction Y. It may be understood that, in another implementation, the out-coupling grating 12 may include only one or two of the first spacing region 1213, the second spacing region 1214, and the third spacing region 1215. Benefits brought by arrangement of the spacing regions are the same as those of corresponding parts in the implementations shown in FIG. 36 and FIG. 37, and details are not described again.

Refer to FIG. 40. The second region 122 in the out-coupling grating 12 includes N two-dimensional regions 1222 and N-1 one-dimensional regions 1221, where N ≥ 2. The N-1 one-dimensional regions 1221 each are located between two adjacent two-dimensional regions 1222, and one of the two-dimensional regions 1222 is adjacent to or close to the first region 121. That the two-dimensional region 1222 is adjacent to the first region 121 may be understood as follows: The two-dimensional region 1222 is in contact with the first region 121, and there is no spacing between the two-dimensional region 1222 and the first region 121. That the two-dimensional region 1222 is close to the first region 121 may be understood as follows: The two-dimensional region 1222 and the second region 121 are not in contact, and there is a spacing between the two-dimensional region 1222 and the second region 121. A type of a grating in the one-dimensional region 1221 is a one-dimensional grating, and a type of a grating in the two-dimensional region 1222 is a two-dimensional grating. In this application, the two-dimensional grating and the one-dimensional grating are disposed in the second region 122, and the one-dimensional grating is disposed between two-dimensional gratings, to help adjust and control intensity of a coupled-out light ray, so that uniformity of an entire picture is better. Specifically, in the second region 122, light ray intensity of a part close to the first region 121 is greater than light ray intensity of a part away from the first region 121. The one-dimensional region 1221 is disposed between adjacent two-dimensional regions 1222. The one-dimensional grating in the one-dimensional region 1221 can reduce light intensity at a position of the one-dimensional region 1221. In addition, the one-dimensional grating in the one-dimensional region 1221 can restrict a light ray propagation direction, so that light rays are propagated in a centralized manner to a two-dimensional region on a light exit side (the right side of the one-dimensional region shown in FIG. 40) of the one-dimensional region. In this way, light intensity of the two-dimensional region can be supplemented. Therefore, overall, intensity uniformity of coupled-out light rays in the second region 122 can be ensured.

In the implementation shown in FIG. 40, the second region 122 includes three two-dimensional regions 1222 and two one-dimensional regions 1221. Each one-dimensional region 1221 includes a third sub-region 12211 and a fourth sub-region 12212, and the third sub-region 12211 and the fourth sub-region 12212 are arranged along the second direction Y and distributed on two sides of the central axis 12L. A gate line direction of a part of a grating in the two-dimensional region 1222 is the same as a gate line direction of a grating in the third sub-region 12211, and a gate line direction of a part of a grating in the two-dimensional region 1222 is the same as a gate line direction of a grating in the fourth sub-region 12212.

Refer to FIG. 40. In an implementation, the extension direction of the central axis 12L is the first direction X, and the in-coupling grating 11 exactly faces a central position of the out-coupling grating 12. In this implementation, the third sub-region 12211 and the fourth sub-region 12212 may have a same area, and are distributed on two sides of the central axis 12L in a mirror manner.

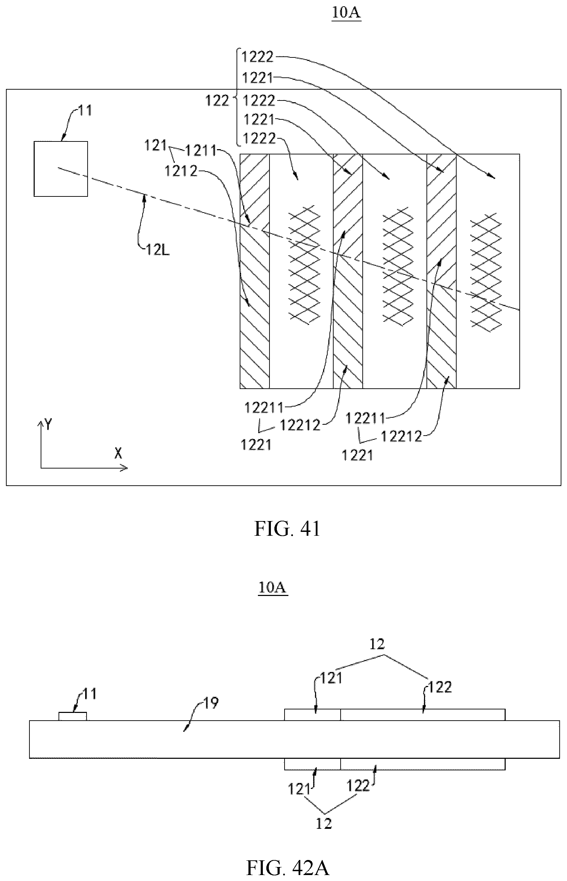

Refer to FIG. 41. In an implementation, the out-coupling grating 11 exactly faces a corner position of the out-coupling grating 12, the extension direction of the central axis 12L is inclined relative to the first direction X, and an included angle is formed between the central axis 12L and the first direction X. In this implementation, the third sub-region 12211 and the fourth sub-region 12212 may have different areas.

Refer to FIG. 42A. In an implementation, the out-coupling grating 12 is disposed on both a top surface and a bottom surface of the waveguide substrate 19 in the optical waveguide 10A provided in this application, and a specific architecture of the out-coupling grating 12 may be the out-coupling grating described in any one of the implementations in FIG. 33 to FIG. 41. In a thickness direction of the waveguide substrate 19, a first region 121 of the out-coupling grating 12 located on the top surface of the waveguide substrate 19 exactly faces a first region 121 of the out-coupling grating 12 located on the bottom surface of the waveguide substrate 19, and a second region 122 of the out-coupling grating 12 located on the top surface of the waveguide substrate 19 exactly faces a second region 122 of the out-coupling grating 12 located on the bottom surface of the waveguide substrate 19. In this solution, the out-coupling grating is disposed on both the top surface and the bottom surface of the waveguide substrate 19, and the out-coupling grating restricts the light propagation direction by using the first region, so that light propagation efficiency can be improved more effectively, and light uniformity can be improved.

In another implementation, the out-coupling grating 12 of the optical waveguide 10A may alternatively be disposed only on a single surface of the waveguide substrate 19. For example, in the implementation shown in FIG. 42A, the out-coupling grating is not disposed on the bottom surface of the waveguide substrate 19, and the out-coupling grating is disposed only on the top surface of the waveguide substrate 19.

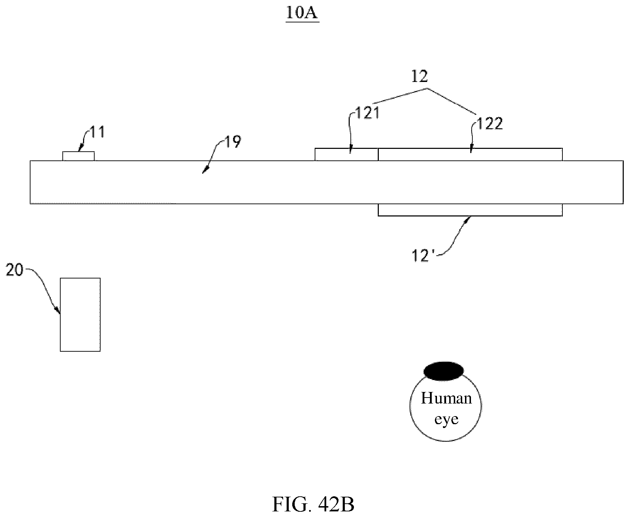

In another implementation, with reference to FIG. 42B, the out-coupling grating 12 described in any one of the implementations in FIG. 33 to FIG. 41 is disposed on the top surface of the waveguide substrate 19, another type of out-coupling grating 12' is disposed on the bottom surface of the waveguide substrate 19, and the another type of out-coupling grating 12' exactly faces the second region 122 in the out-coupling grating 12 described in any one of the implementations in FIG. 33 to FIG. 41.

Solution 4: Out-coupling grating with sparse apertures

A near-eye display device (for example, AR glasses) provided in this application allows a user to simultaneously observe a real scene around and virtual information by using an optical fusion device. In a specific implementation, the near-eye display device performs this function by using a waveguide structure. As shown in FIG. 42A, an optical waveguide 10A provided in an implementation of this application includes an in-coupling grating 11 and an out-coupling grating 12. The in-coupling grating 11 is configured to inject a light ray of each field of view generated by the optical engine 20 into the optical waveguide 10A, where the light ray is propagated in the optical waveguide 10A. The out-coupling grating 12 couples the light ray out of the optical waveguide 10A, so that the light ray enters a human eye for imaging, to generate virtual image information. In addition, the optical waveguide 10A in the near-eye display device allows a surrounding scene to pass through the optical waveguide and enter the human eye for imaging, so that a user can simultaneously observe a real scene and virtual image information.

When the optical waveguide 10A provided in a specific implementation of this application is used as an AR display solution, there is a vergence-accommodation conflict (VAC) problem, that is, a conflict between a single-eye focus position and a binocular parallax position. A mechanism of generating a vergence-accommodation conflict (VAC) phenomenon is as follows: An optical waveguide generally can generate only one virtual image position, and the human eye needs to focus on the virtual image position to see a clear image. A vertical distance between the human eye and the virtual image position is a virtual image distance L1. In addition, to generate stereoscopic vision, a parallax is generated by using a binocular parallax, and the parallax L2 is related to displayed content. When L1 is not equal to L2, a VAC problem occurs, affecting use experience.

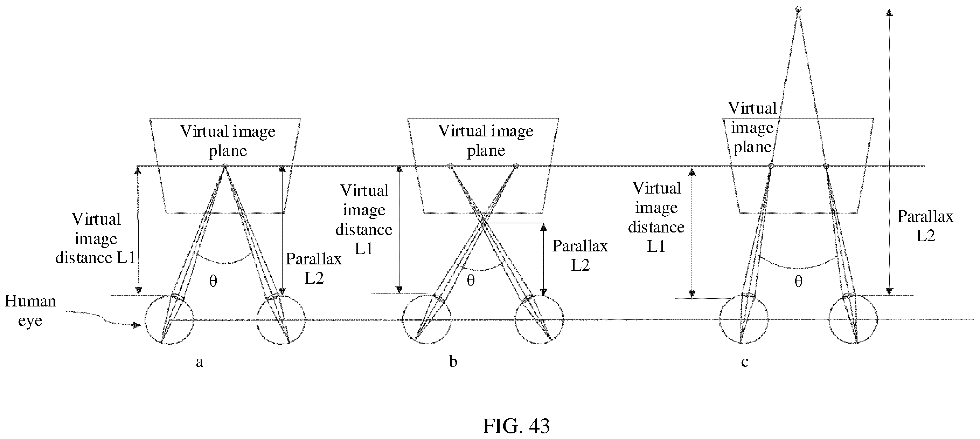

FIG. 43 is a diagram of three different configurations of a virtual image distance and a parallax corresponding to a virtual image on a virtual image plane generated by an optical waveguide according to this application. Refer to FIG. 43. In diagram a (the leftmost diagram) in FIG. 43, a virtual image distance L1 is equal to a parallax L2. In this case, a distance perceived by the human eye is consistent with a focusing distance of the human eye, and a user does not feel uncomfortable. In diagram b (the middle diagram) in FIG. 43, a virtual image is located at a far virtual image distance L1, and the human eye needs to relax in order to focus on a far place to see the virtual image clearly. However, a generated parallax L2 (determined by a parallax angle θ of two virtual images relative to the human eye) is near, and the parallax angle θ of the virtual images is large. A user may perceive that the virtual image is near, and in this case, a VAC problem occurs, which makes the user feel uncomfortable. In diagram c (the rightmost diagram) in FIG. 43, a virtual image is located at a near virtual image distance L1, and the human eye needs to focus on a near position to clearly see the virtual image. However, a generated parallax L2 is far, and a parallax angle θ of the virtual image is small. This is also contradictory to a common eye use habit of a user, causing a VAC problem.

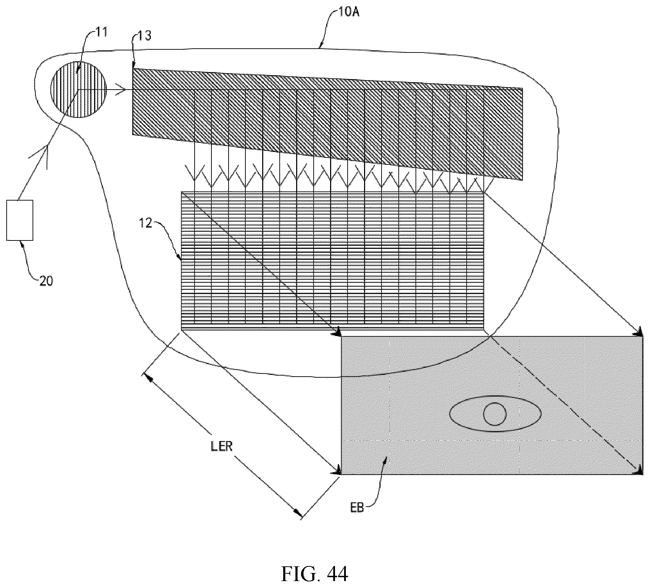

Refer to FIG. 44. In a near-eye display device provided in an implementation, emergent light of an optical engine 20 enters an optical waveguide 10A through an in-coupling grating 11, undergoes total internal reflection propagation in the optical waveguide 10A, is refracted by a relay grating 13, and is emitted to a human eye by an out-coupling grating 12. In a process in which a light ray is coupled out by the out-coupling grating 12, because the out-coupling grating 12 is a grating structure that continuously extends and has a large area, a coupled-out light ray is a light beam with a wide aperture. When the out-coupling grating 12 couples the light ray to a pupil of a human eye, the entire pupil is fully filled. The coupled-out light ray forms an eye movement space (EyeBox) EB of a specific size at a position of the human eye, and a distance between the pupil and the out-coupling grating is an eye relief (Eye Relief) LER. As shown in FIG. 44, in an implementation, an outer contour of the out-coupling grating 12 is rectangular, an eye movement space ER projected by the coupled-out light ray is also rectangular, an area of the eye movement space ER is far greater than that of the eye, and the pupil of the human eye is fully filled with the coupled-out light ray.

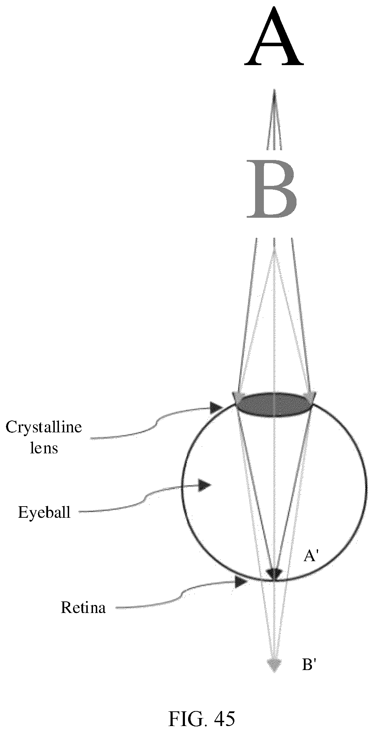

For the optical waveguide shown in FIG. 44, the light ray emitted from the out-coupling grating enters the human eye and is imaged on a retina, and the pupil is fully filled with a light beam. A pupil size of the human eye is generally 2 mm to 4 mm in a bright environment. Therefore, when the human eye correctly focuses, a clear image is formed on the retina. For a defocused object, the object cannot be focused on the retina after passing through the pupil, but a dispersive spot is formed. FIG. 45 is a principle diagram of an optical path for forming a VAC phenomenon through wide beam imaging. Refer to FIG. 45. When a human eye focuses on a depth A, A is correctly focused on a retina after passing through a pupil of the human eye, to form an image A'. In this case, however, an object point of a depth B closer to the human eye is imaged at a rear position B' of the retina after passing through the pupil of the human eye. In this case, a dispersive spot of a specific size is formed on the retina, and the object point of the depth B cannot be clearly imaged by the human eye.

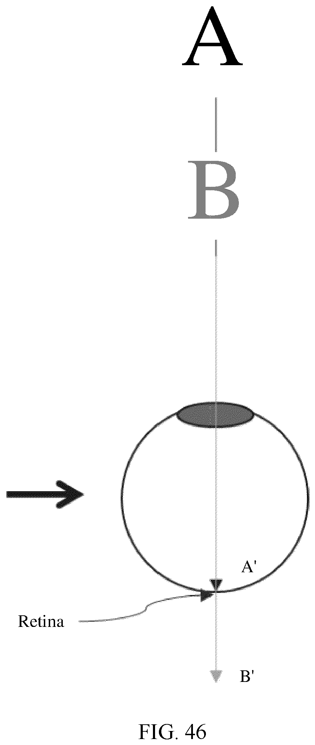

An implementation of this application provides an out-coupling grating. Light rays coupled out by the out-coupling grating is a fine light beam array. It may be understood that a size of each light beam is small, and there may be only one light beam entering a pupil, so that the light beam does not fully fill the pupil. In an implementation, a size range of the light beam is less than or equal to 1.5 mm. FIG. 46 is a principle diagram of an optical path for resolving a VAC problem through fine light beam imaging. When a fine light beam enters a human eye for imaging, a depth of field becomes large. Therefore, regardless of where a user is focusing, the user can clearly see virtual images when observing the virtual images with different parallaxes, without paying attention to where a virtual image distance of the virtual image is actually located, thereby resolving a problem that a virtual image distance of an optical waveguide is a fixed value, and eliminating a VAC problem. Refer to FIG. 46. When a human eye focuses on a depth A, a fine light beam emitted by an object point at A is exactly focused on a retina through the human eye, to form a clear object point A'. In this case, a fine light beam emitted by an object point at a depth B closer to the human eye passes through a pupil, and does not fully fill the pupil either. After the fine light beam passes through the human eye, a dispersive spot is formed on the retina due to defocus. However, because an aperture size of the fine light beam is small, a size of the formed dispersive spot is also small, and the human eye may still clearly see an image at the depth B.

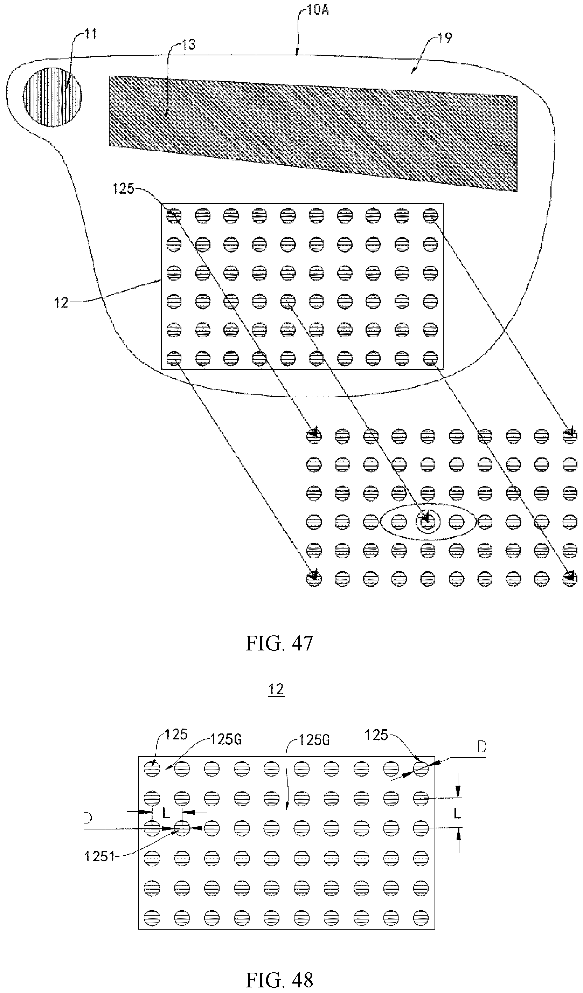

FIG. 47 is a diagram of an optical waveguide according to an implementation of this application. Refer to FIG. 47. In this implementation, an optical waveguide 10A includes a waveguide substrate 19, an in-coupling grating 11, a relay grating 13, and an out-coupling grating 12. The relay grating 13 is located between the in-coupling grating 11 and the out-coupling grating 12. The in-coupling grating 11 receives a light ray projected by an optical engine, and couples the light ray into the waveguide substrate 19, and the light ray undergoes total internal reflection propagation in the waveguide substrate 19. When the light ray is propagated to the relay grating 13, after being refracted by the relay grating 13, the light ray is projected onto a position of the out-coupling grating 12. The out-coupling grating 12 couples the light ray out and projects the light ray onto a human eye to form a virtual image. In this implementation, the out-coupling grating 12 includes a plurality of sub-gratings 125, and the plurality of sub-gratings 125 are arranged at intervals. The plurality of sub-gratings 125 are arranged in an array of multiple rows and multiple columns, and the array arrangement has a same row distance and a same column distance, that is, a distance between any two adjacently disposed sub-gratings 125 is equal. In the implementation shown in FIG. 47, an array arrangement architecture including the plurality of sub-gratings 125 includes 60 sub-gratings 125, which are arranged in 6 rows and 10 columns. Outer contours of all sub-gratings 15 are the same, for example, outer contours of all sub-gratings 125 are circular. In another implementation, the out-coupling grating 12 may include sub-gratings 125 of different sizes, or the out-coupling grating 12 may include sub-gratings 125 of different shapes, and an outer contour shape of the sub-grating 125 may be but is not limited to a circle, a triangle, a square, or a hexagon. An overall outer contour of the out-coupling grating 12 shown in FIG. 47 is rectangular. It may be understood that in another implementation, the out-coupling grating 12 may be designed with an outer contour of a different shape according to a specific design requirement.

A core difference of the implementation shown in FIG. 47 from the implementation shown in FIG. 44 lies in that the out-coupling grating 12 is no longer a continuous grating whole structure, but is divided into a plurality of sub-gratings 125. Each sub-grating 125 has a function of coupling a light ray out and projecting the light ray onto a human eye. However, the light ray projected by each sub-grating 125 is a fine light beam. When the fine light beam is projected onto a human eye, the fine light beam cannot fully fill a pupil due to its small size, where a size of the fine light beam may be 0.5 mm to 1.5 mm.

FIG. 48 is a diagram of the out-coupling grating of the optical waveguide shown in FIG. 47. Refer to FIG. 48. Specifically, a maximum radial size D of each sub-grating 125 is less than or equal to 1.5 mm. A distance between two adjacent sub-gratings 125 is L, 3 mm ≤ L ≤ 5 mm, and the distance between the two adjacent sub-gratings 125 means a distance between centers of the two adjacent sub-gratings 125. In an implementation, one of the sub-gratings 125 is a first sub-grating 1251, and a separating region 125G is disposed between the first sub-grating 1251 and another sub-grating 125 adjacent to the first sub-grating 1251. In FIG. 48, regions outside the sub-gratings 125 (that is, all regions that do not belong to the sub-gratings and that are in the out-coupling grating 12 are a separating region) are the separating region 125G. There is no grating structure in the separating region 125G, and the separating region 125G cannot couple a light beam out. A maximum radial size D of the first sub-grating 1251 is less than or equal to 1.5 mm. It may be understood that, in an implementation, all the sub-gratings 125 may be first sub-gratings 1251 of a same size and form. In an implementation, in all the sub-gratings 125, a size and a form of another sub-grating may be different from those of the first sub-grating 1251, but a maximum radial size D of the another sub-grating is less than or equal to 1.5 mm, to ensure that all the sub-gratings 125 project fine light beams.

In an implementation, a radial size of the first sub-grating 1251 is D, and 0.5 mm ≤ D ≤ 1 mm. In this solution, the radial size of the first sub-grating 1251 is restricted to be greater than or equal to 0.5 mm, to ensure that the first sub-grating 1251 can have an out-coupling grating function, that is, can couple a light ray in the optical waveguide into a human eye. In this solution, the radial size of the first sub-grating 1251 is restricted to be less than or equal to 1 mm, to ensure that a light ray projected by the first sub-grating 1251 is a fine beam, and even when a pupil size becomes small due to an environmental factor, a light beam projected by the first sub-grating 1251 onto a pupil is still a fine light beam and cannot fully fill the pupil.

For an environment of an outdoor bright place, a pupil of the human eye becomes small due to impact of the environment; therefore, in an implementation, a radial size range of each of the sub-gratings 125 is small, and is specifically: 0.25 mm ≤ D ≤ 0.75 mm.

For a dark indoor environment, because a pupil of the human eye becomes large due to impact of the environment; therefore, an implementation, a radial size range of each of the sub-gratings 125 is large, and is specifically: 0.75 mm ≤ D ≤ 1.5 mm.

In a specific implementation, a value range of the distance between the two adjacent sub-gratings 125 is: 3.5 mm ≤ L ≤ 4.5 mm. The range of the distance between the two adjacent sub-gratings 125 defined in this implementation may meet a plurality of application environments and different application scenarios. This ensures that a light ray coupled out by the sub-grating 125 is a fine light beam.

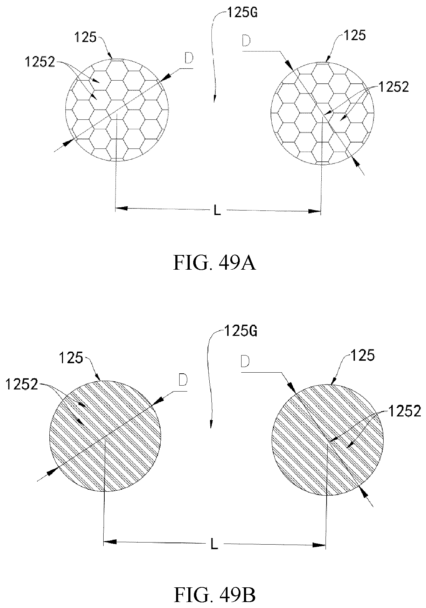

FIG. 49A and FIG. 49B each show specific structural forms of two sub-gratings 125 according to an implementation of this application. Refer to FIG. 49A. In an implementation, there is a two-dimensional grating architecture in the sub-grating 125, each sub-grating 125 includes grating microstructures 1252 arranged based on a preset period, and the preset period may be 200 nm to 500 nm. A specific shape of the grating microstructure 1252 may be, but is not limited to, a hexagon, a parallelogram, a triangle, a trapezoid, or the like. In the sub-grating 125, due to arrangement of the grating microstructure 1252, the sub-grating 125 can couple a light ray in the optical waveguide out and project the light ray onto a human eye. A region between two sub-gratings 125 is a separating region 125G, and there is no grating structure in the separating region 125G. Therefore, no light ray is coupled out at a position of the separating region 125G. Therefore, in this application, a size of the sub-grating 1252 and a size of the separating region 125G are restricted, so that it can be ensured that a light beam coupled out by the sub-grating 125 is a fine light beam, and it can be ensured that only one light beam enters a pupil of a human eye for imaging at a same moment. It can be determined, with reference to the imaging principle shown in FIG. 46, that this solution can solve a VAC problem. The size of the separating region 125G may be understood as a difference between a distance between two adjacent sub-gratings 125 and a diameter of one sub-grating.

A difference of the implementation shown in FIG. 49B from the implementation shown in FIG. 49A lies in that a type of a grating in the sub-grating 125 is different. In the implementation shown in FIG. 49B, there is a one-dimensional grating architecture in the sub-grating 125. Similarly, the sub-grating 125 has grating microstructures 1252 that are periodically arranged.

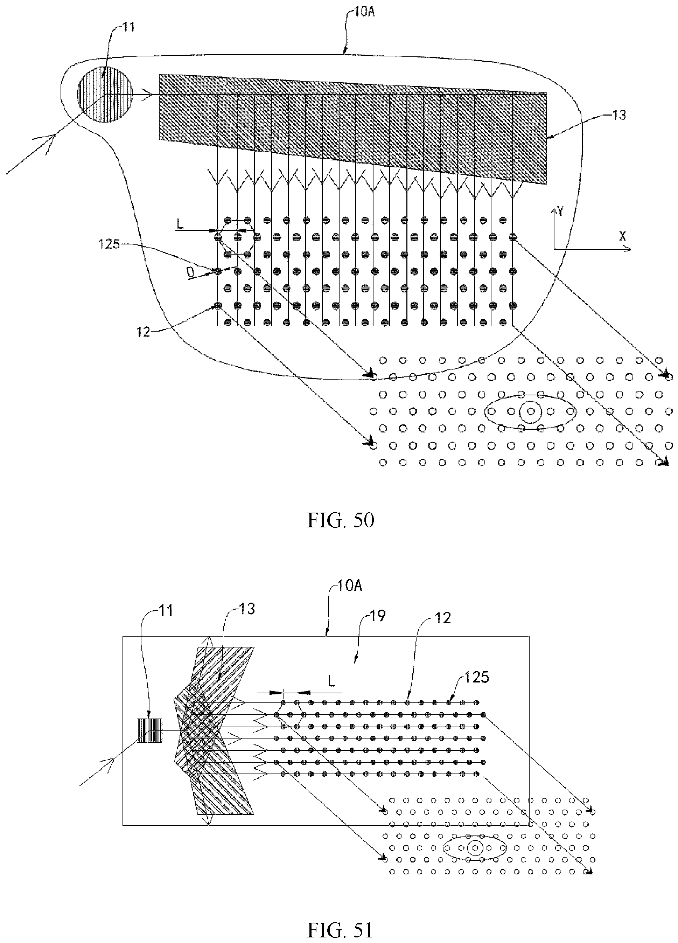

FIG. 50 is a diagram of an optical waveguide according to an implementation of this application. A difference of the implementation shown in FIG. 50 from the implementation shown in FIG. 47 lies in that an arrangement manner of sub-gratings 125 in the out-coupling structure 12 is different. In this implementation, the plurality of sub-gratings 125 are arranged in multiple rows, an arrangement direction of sub-gratings 125 in each row is a first direction X, odd-numbered rows and even-numbered rows in the multiple rows of the sub-gratings 125 are disposed in a staggered manner, a second direction Y is perpendicular to the first direction X, and in the second direction Y, the sub-grating 125 in the odd-numbered row exactly faces the separating region 125G between two adjacent sub-gratings 125 in the even-numbered row. As shown in FIG. 50, the sub-gratings 15 in the out-coupling grating 12 are arranged in seven rows, the first, third, fifth, and seventh rows are odd rows, and the second, fourth, and sixth rows are even rows. In the second direction Y, a sub-grating 125 on the odd row exactly faces a separating region 125G between two adjacent sub-gratings 125 on the even row. Any one sub-grating 125 on an odd row and two adjacent sub-gratings 125 on an even row form an equilateral triangle. In an array architecture of the sub-gratings 125, the sub-gratings 125 are arranged in a multi-regular-hexagon architecture, and this solution is also referred to as a honeycomb-like array arrangement solution. Compared with the orthogonal array arrangement solution of the sub-grating 125 provided in the implementation shown in FIG. 47, this implementation provides the honeycomb-like array arrangement solution, which has the following benefits: In this solution, it can be ensured that a relative distance between fine light beams at a position of an eye movement space is a constant value, while in the orthogonal array arrangement solution, a distance between fine light beams in a diagonal direction is slightly greater than those in a horizontal direction and a vertical direction. In this solution, when the human eye moves in the eye movement space, for example, when the eye rotates or glasses slide, different fine light beams entering a pupil of the human eye change. Because a relative distance between fine gratings in a honeycomb-like arrangement manner is constant, even if the human eye moves relative to the eye movement space, it can be ensured that energy of light beams entering the human eye is equal. Therefore, an image change is more smooth, and use experience of the near-eye display device can be improved.

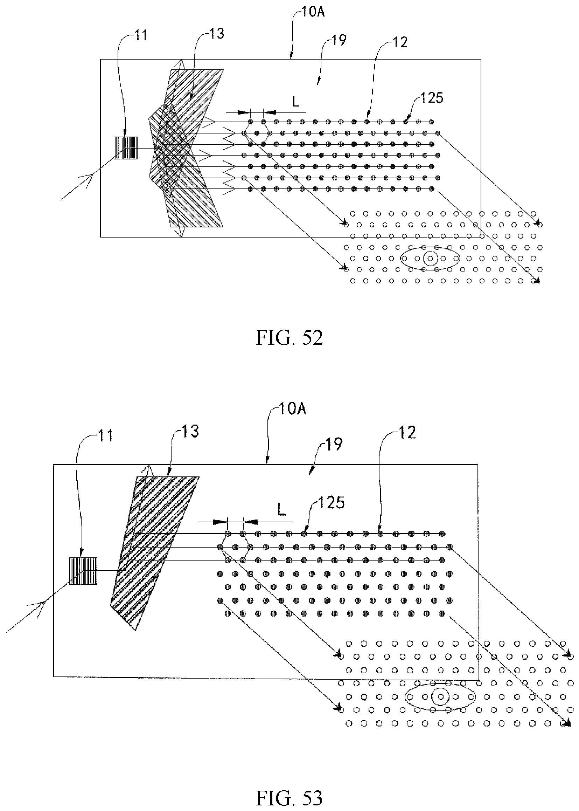

In an implementation, for a specific position of the out-coupling grating on the optical waveguide, the plurality of sub-gratings 125 may be coplanar, that is, the plurality of sub-gratings are disposed on a same surface of the waveguide substrate. In an implementation, with reference to FIG. 51, FIG. 52, and FIG. 53, where FIG. 51 shows an optical waveguide 10A according to an implementation, grating structures are disposed on both a front surface and a back surface of a waveguide substrate 19, that is, in-coupling gratings 11, relay gratings 13, and out-coupling gratings 12 are in pairs disposed on the front surface and the back surface of the waveguide substrate 19. FIG. 51 draws grating structures on the front surface and the back surface of the waveguide substrate 19, FIG. 52 draws only a grating structure on the front surface of the waveguide substrate 19, and FIG. 53 draws only a grating structure on the back surface of the waveguide substrate 19. In a thickness direction of the waveguide substrate 19, sub-gratings 125 of the out-coupling grating 12 located on the front surface of the waveguide substrate 19 and sub-gratings 125 of the out-coupling grating 12 located on the back surface of the waveguide substrate 19 are disposed in one-to-one correspondence. Therefore, the sub-gratings 125 on the front surface and the back surface shown in FIG. 51 are in an overlapping relationship.

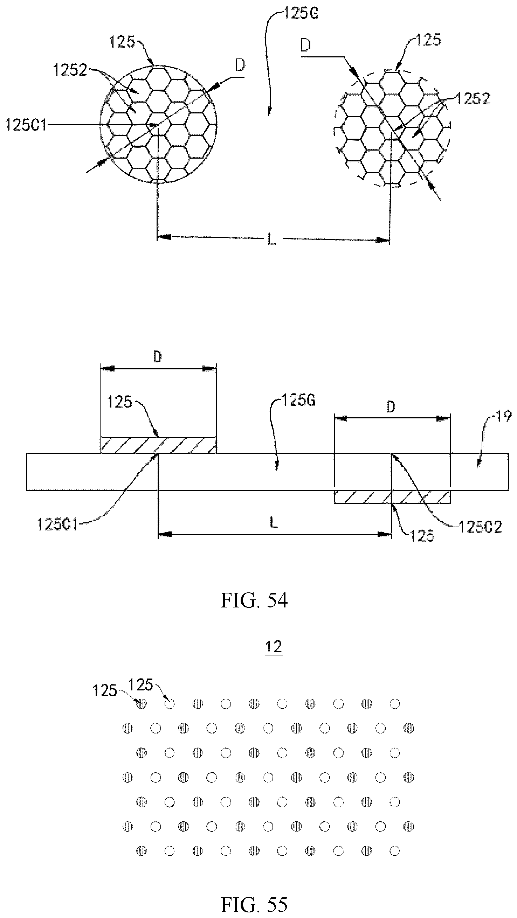

Refer to FIG. 54. In an implementation, one of the two adjacent sub-gratings 125 is located on a front surface of a waveguide substrate 19 of an optical waveguide, and the other of the two adjacent sub-gratings 125 is located on a back surface of the waveguide substrate 19. A center of the sub-grating 125 located on the front surface of the waveguide substrate 19 is a center 1 125C1, a vertical projection of a center of the sub-grating located on the back surface of the waveguide substrate onto the front surface of the waveguide substrate is a center 2 125C2, and a distance L between the two adjacent sub-gratings 125 is a distance between the center 1 125C1 and the center 2 125C2.

Refer to FIG. 55. In an implementation, sub-gratings 125 in the out-coupling grating 12 are distributed on different surfaces of the waveguide substrate 19. In FIG. 55, a sub-grating 125 marked with section lines in a circle is located on the front surface of the waveguide substrate 19, and a sub-grating 125 marked with a blank circle (no section lines are shown) is located on the back surface of the waveguide substrate 19.

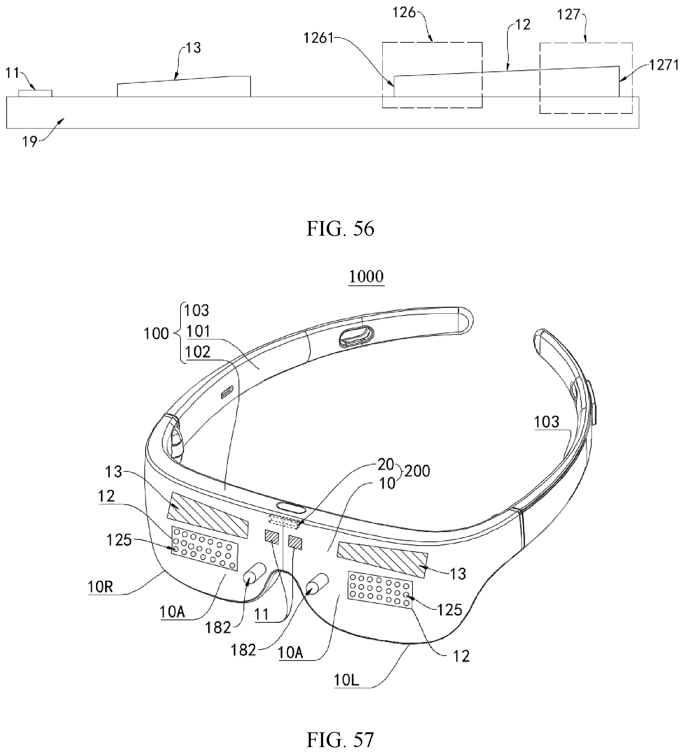

In an implementation, the relay grating and/or the out-coupling grating may use a region division design or a gradient design. For example, a grating height of a region that is of the relay grating and that is close to the in-coupling grating is low, and a grating height of a region that is of the relay grating and that is away from the in-coupling grating is high; and a grating height of a region that is of the out-coupling grating and that is close to the relay grating is low, and a grating height of a region that is of the out-coupling grating and that is away from the relay grating is high. Refer to FIG. 56. An in-coupling grating 11, a relay grating 13, and an out-coupling grating 12 are disposed on a surface of a waveguide substrate 19, a top surface (a surface away from the waveguide substrate 19) of the relay grating 13 extends as an oblique surface, a left side of the relay grating 13 is close to the in-coupling grating 11, and a right side of the relay grating 13 is close to the out-coupling grating 12. A grating height on the left side of the relay grating is low, and a grating height on the right side is high, and from the left side to the right side of the relay grating 13, a grating height of the relay grating 13 may be in a gradient increase trend. The out-coupling grating 12 includes a first sub-grating region 126 and a second sub-grating region 127, a distance between the first sub-grating region 126 and the relay grating 12 is less than a distance between the second sub-grating region 127 and the relay grating 13, and a height of a sub-grating in the first sub-grating region 126 is less than a height of a sub-grating in the second sub-grating region 127. The out-coupling grating 12 includes a first edge 1261 and a second edge 1271, the first edge 1261 is an edge that is of the out-coupling grating 12 and that close to the relay grating 13, and the second edge 1271 is an edge that is of the out-coupling grating 12 and that is away from the relay grating 13. In a direction from the first edge 1261 to the second edge 1271, heights of the sub-gratings in the out-coupling grating 12 exhibit a gradual increase trend. The region division or gradient design of the out-coupling grating provided in this solution helps adjust diffraction efficiency, and improve light uniformity.

In an implementation, grating microstructures in each sub-grating have a same height or have a same form. In the optical waveguide, the in-coupling grating, the out-coupling grating, and the relay grating may have different grating shapes.

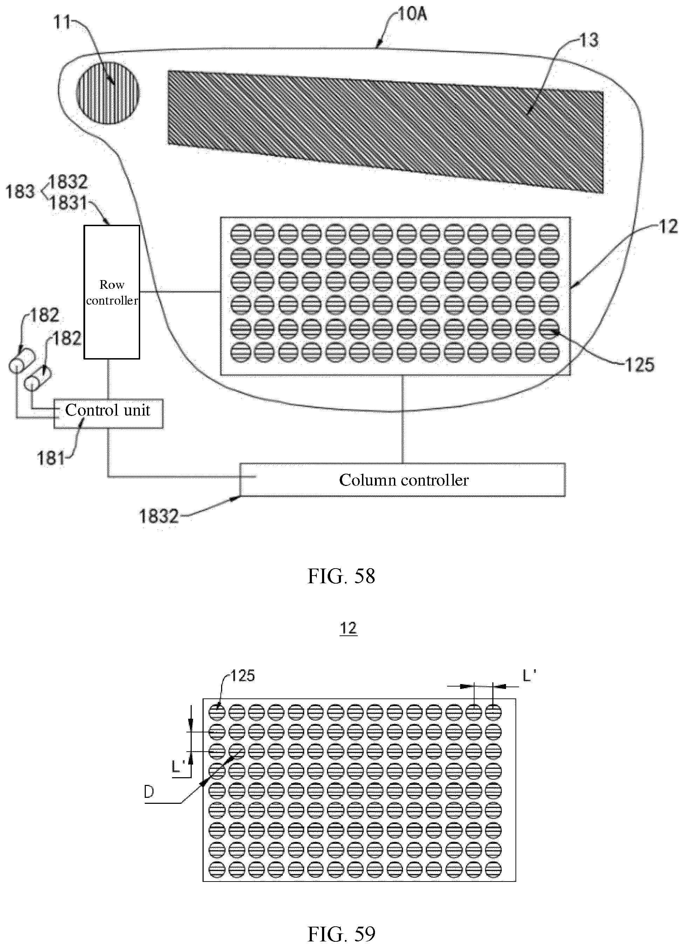

In an implementation, with reference to FIG. 57 and FIG. 58, FIG. 58 is a diagram of a control architecture between a control unit and an out-coupling grating in a near-eye display device shown in FIG. 57. A near-eye display device 1000 provided in this application includes an optical engine 20, an optical waveguide 10A, a control unit 181, a pupil detection member 182, and a grating adjustment member 183. The optical engine 20 is configured to project a light ray onto the optical waveguide 10A. The optical waveguide 10A includes an in-coupling grating 11, a relay grating 13, and an out-coupling grating 12. The in-coupling grating 11 receives the light ray projected by the optical engine 20, and couples the light ray into the optical waveguide 10A, where the light ray undergoes total internal reflection propagation in the optical waveguide 10A. The relay grating 13 is configured to refract the light ray, so that the light ray is projected onto the out-coupling grating 12. In this implementation, the out-coupling grating 12 includes a plurality of sub-gratings 125 arranged in an array. It may be understood that an arrangement manner of the plurality of sub-gratings 125 may be, but is not limited to, an array arrangement of multiple rows and multiple columns (similar to the arrangement manner of the plurality of sub-gratings in the implementation shown in FIG. 47) and a honeycomb-like array arrangement (similar to the arrangement manner of the plurality of sub-gratings in the implementation shown in FIG. 50).

FIG. 59 shows a specific architecture of an out-coupling grating 12 in the implementations shown in FIG. 57 and FIG. 58. Refer to FIG. 59. A maximum radial size D of each sub-grating 125 is less than or equal to 1.5 mm, a distance between two adjacent sub-gratings is L', $D \leq L' \leq$ 4 mm, and L' represents a distance between centers of the two adjacent sub-gratings 125. Array arrangement of the sub-gratings 125 disposed in this solution is dense, and the distance between adjacent sub-gratings 125 may be zero, that is, the sub-gratings may be arranged in a manner of being in contact with each other one by one. A gap may alternatively be provided between adjacent sub-gratings 125. In this solution, an arrangement solution in which the distance between two adjacent sub-gratings is L' is used, and a part of the sub-gratings are turned on by using the grating adjustment member 182, so that in a sub-grating array in the working state, a range of the distance L between the centers of adjacent sub-gratings in the working state is: 3 mm $\leq$ L $\leq$ 5 mm.

In an implementation, the pupil detection member 182 is configured to detect a pupil size. Specifically, there are two pupil detection members 182, which are respectively disposed on a left lens 10L and a right lens 10R of the near-eye display device 1000. The pupil detection member 182 is disposed close to the out-coupling grating 12, so that the pupil detection member 182 can detect the pupil size more accurately. The control unit 181 is configured to receive a signal of the pupil detection member 182. The control unit 181 is further configured to drive the grating adjustment member 183. The grating adjustment member 183 includes a row controller 1831 and a column controller 1832. The row controller 1831 is configured to control a region corresponding to each row of sub-gratings 125 to be on or off, and the column controller 1832 is configured to control a region corresponding to each column of sub-gratings 125 to be on or off. The grating adjustment member 183 is configured to control a part of rows or a part of columns of the out-coupling grating 12 to be on or off, so that a part of sub-gratings enter a working state, and it can be ensured that a range of a distance L between adjacent sub-gratings in the working state is: 3 mm $\leq$ L $\leq$ 5 mm. In this way, the sub-grating emits a fine light beam, and there is one fine light beam entering a pupil, thereby resolving a VAC problem.

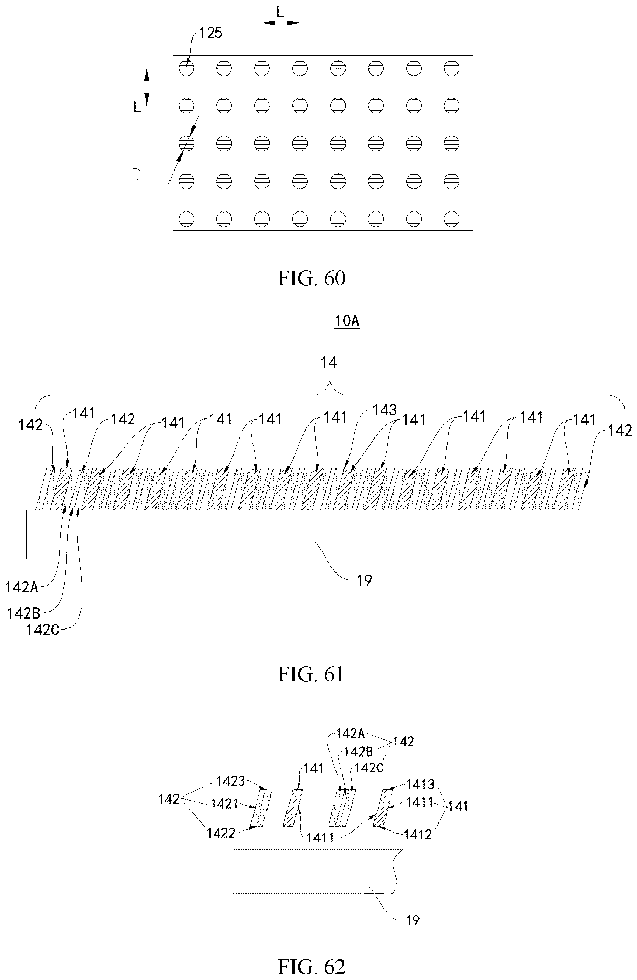

Refer to FIG. 60. FIG. 60 schematically shows distribution of sub-gratings 125 in a working state. An architecture of an out-coupling grating 12 displayed in FIG. 60 is as follows: A part of rows and a part of columns of sub-gratings are turned off by using a row controller and a column controller of a grating adjustment member, the part of rows and the part of columns of sub-gratings that are turned off are not displayed in the figure, and the displayed sub-gratings 125, namely, sub-gratings 125 in the working state, are in an on state. For the sub-gratings 125 in the working state, a distance between adjacent sub-gratings 125 in each row is L; and a distance between adjacent sub-gratings 125 in each column is L. In this solution, a switchable optical element is used, and the sub-grating is controlled to be on or off, so that the sub-gratings in the working state can respond to pupils of different sizes. For example, when a pupil size changes, the distance between the sub-gratings in the working state can be adjusted by using the grating adjustment member, thereby improving image display efficiency. In this solution, a virtual image distance does not need to be switched based on actual content, and system power consumption can be reduced.

Solution 5: Coated grating with a gradient refractive index

According to an optical waveguide provided in a specific implementation of this application, a light ray of each field of view generated by an optical engine is injected into the optical waveguide by using an in-coupling grating, and the light ray undergoes total internal reflection in the optical waveguide, is coupled out of the optical waveguide by an out-coupling grating, and enters a human eye for imaging. In addition, the optical waveguide allows a surrounding scene to pass through the optical waveguide and enter the human eye for imaging, so that a user can simultaneously observe a real scene and virtual information (image information). The optical waveguide provided in this application may be used in a vehicle-mounted HUD, head-mounted augmented reality glasses, and the like.

In an implementation, the in-coupling grating couples a light ray into the optical waveguide by using a diffraction effect, and the out-coupling grating may couple the light ray out of the optical waveguide also by using the diffraction effect. Therefore, how to improve in-coupling efficiency and coupling-out efficiency to improve optical utilization of an optical waveguide is a research direction in the industry.

In an implementation, diffraction efficiency and optical utilization can be improved by changing a refractive index of a grating. For example, a larger average refractive index and a higher refractive index modulation of a volume holographic grating are obtained by adjusting a formula of a holographic material, to obtain a volume holographic grating with different-refractive-index distribution. However, obtaining a desired average refractive index and refractive index modulation by changing the holographic material cannot achieve a desired effect. This is mainly due to a limitation in a characteristic of the holographic material. Specifically, the holographic material is usually made up of polymer monomers and inert polymers. These materials have a low refractive index (1.45 to 1.65), resulting in a low average refractive index of the materials. In addition, because the polymer monomer and the inert polymer are not completely separated in a process of light aggregation, a refractive index modulation of a grating structure made of a volume holographic material is also low (less than 0.15). Therefore, a volume holographic grating cannot obtain a desired average refractive index and a desired refractive index modulation.

In an implementation, this application provides an optical waveguide. A grating structure of the optical waveguide is designed. Specifically, a structure of one period of the grating structure is designed as a layer structure that is disposed in a stacked manner in a vector direction of the grating structure and that has different refractive indexes. A refractive index of the grating structure changes through the design of different refractive indexes in one period of the grating structure, to improve diffraction efficiency and optical utilization of the optical waveguide.

Refer to FIG. 61. In an implementation, an optical waveguide 10A includes a waveguide substrate 19 and a grating structure 14 formed on the waveguide substrate 19. FIG. 61 schematically shows a specific position relationship between the waveguide substrate 19 and the grating structure 14 and structural components, and does not represent a specific structural form of the optical waveguide 10A. In the implementation shown in FIG. 61, the grating structure 14 protrudes from a surface of the waveguide substrate 19, the waveguide substrate 19 is in a flat-plate shape, and the surface of the waveguide substrate 19 may be planar in shape. The grating structure 14 may be an in-coupling grating, or may be an out-coupling grating or a relay grating. A light ray is coupled into the optical waveguide 10A through the grating structure 14, and can undergo total internal reflection in the waveguide substrate 19. The waveguide substrate 19 is a material with a high refractive index. For example, a refractive index of the waveguide substrate 19 is 1.38 to 2.6. A material of the waveguide substrate 19 may include a metal oxide. The material of the waveguide substrate 19 may be any one of MgF2, TiO2, silicon nitride, gallium nitride, or a high-refractive resin material. The material of the waveguide substrate 19 may alternatively be a mixed material, and the mixed material includes a mixture of two or more of the foregoing materials. The waveguide substrate 19 may be of a single-layer structure, or the waveguide substrate 19 may be of a multi-layer structure, for example, a composite layer structure including different materials in all layers.

The grating structure 14 includes a plurality of core structures 141 and a film structure 142. A refractive index of the film structure 142 is different from a refractive index of the core structure 141, and the plurality of core structures 141 are sequentially arranged at intervals in a vector direction of the grating structure 14. The vector direction of the grating structure in FIG. 61 is a direction from left to right. There is a preset distance between adjacent core structures 141, and the film structure 142 is disposed within the preset distance range. In the vector direction of the grating structure 14, both sides of the core structure 141 are used for arrangement of the film structure 142. As shown in FIG. 61, a left side of a leftmost core structure 141 has the film structure 142, and a right side of a rightmost core structure 141 also has the film structure 142. In another implementation, the film structure 142 may be disposed only between adjacent core structures 141, that is, no film structure is disposed on the left side of the leftmost core structure 141 and no film structure is disposed on the right side of the rightmost core structure 142.

In the implementation shown in FIG. 61, a region between adjacent core structures 141 is filled with the film structure 142. In other words, there is no gap (or spacing, where no air exists inside the grating structure 14) in the region between the adjacent core structures 141. In this implementation, the grating structure 14 is a seamless structure continuously extending along the vector direction of the grating structure 14. Due to such as structure design, there is no air inside the grating structure 14, which helps ensure diffraction efficiency of the grating structure 14, and also helps ensure that the grating structure 14 is not affected by environmental factors. For example, dust, moisture, and the like in the air affect a function and life of the grating structure 14.

FIG. 62 is an exploded diagram of a part of the grating structure 14 and a part of the waveguide substrate 19 in FIG. 61, where the core structure 141 is separated from the film structure 142, to facilitate illustration of detailed structural characteristics of the core structure 141 and the film structure 142. With reference to FIG. 61 and FIG. 62, each core structure 141 includes a connection end 1412, a free end 1413, and a side surface 1411, the connection end 1412 is connected to the waveguide substrate 19, and the free end 1413 and the connection end 1412 are disposed opposite to each other in a height direction of the core structure 141. The height direction of the core structure 141 may be understood as a direction perpendicular to the surface of the waveguide substrate 19. The side surface 1411 is connected between the connection end 1412 and the free end 1412. The film structure 142 includes a film body 1421, a first end part 1422, and a second end part 1423, and the film body 1421 wraps the side surface 1411 of the core structure 141. It may also be understood that the film body 1421 is attached to the side surface 1411, and the film body 1421 and the side surface 1411 are in contact with each other and combined together. The first end part 1422 and the second end part 1423 are respectively located at two ends of the film body 1421, and the first end part 1422 is connected to the waveguide substrate 19. In an implementation, an end face of the second end part 1423 and an end face of the free end 1413 of the core structure 141 are coplanar, and the free ends 1411 of all the core structures 141 and the second end part 1423 of the film structure 142 jointly form an end face 143 of the grating structure 14.

In this solution, diffraction efficiency and optical utilization are improved by using different refractive indexes of the core structure 141 and the film structure 142 of the grating structure 14. The free end 1411 of the core structure 141 and the second end part 1423 of the film structure 142 jointly form the end face of the grating structure 14, so that diffraction efficiency of the grating structure 14 is better. The grating structure 14 has the core structure and the film structure with different refractive indexes only in the vector direction of the grating structure 14. In a height direction of the grating structure 14, because both the free end 1411 of the core structure 141 and the second end part 1423 of the film structure 142 are in an exposed state at a position of the end face of the grating structure 14, that is, the exterior of the core structure 141 in the grating height direction is not wrapped by the film structure 142, diffraction efficiency of the grating structure 14 can be ensured. If the free end of the core structure is wrapped by the film structure, a part that is of the film structure and that wraps the free end of the core structure generates a diffraction effect in the height direction of the grating structure. However, because diffraction in the height direction of the grating structure has a direction different from the vector direction of the grating structure, diffraction in the vector direction of the grating structure is negatively affected, that is, diffraction efficiency of the grating structure is reduced.

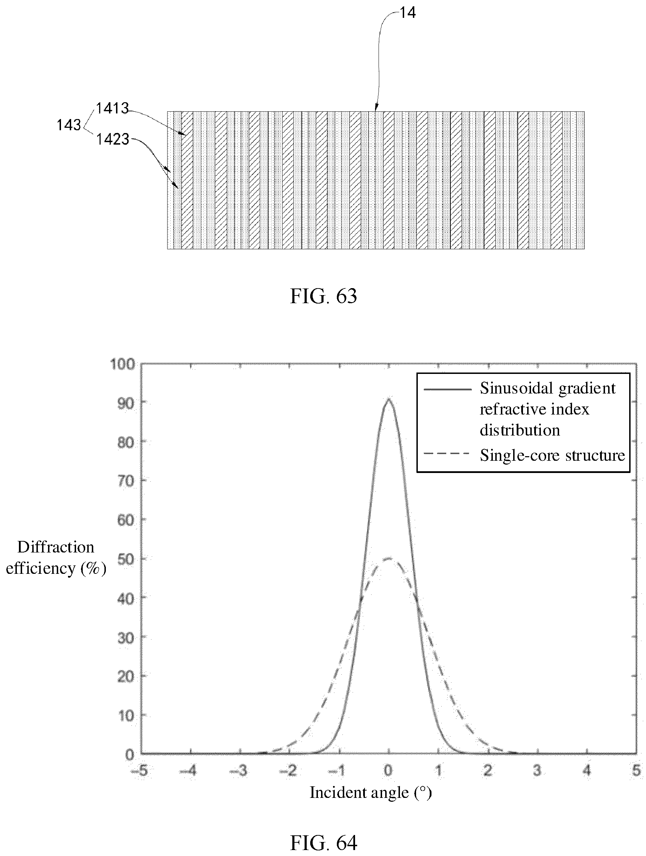

FIG. 63 is a diagram of an end face 143 of a grating structure 14. Refer to FIG. 63. The end face 143 of the grating structure 14 is a stripe-shaped architecture including an end face of a free end 1413 of a core structure 141 and an end face of a second end part 1423 of a film structure 142 that are alternately arranged. With reference to FIG. 61 and FIG. 63, the end face 143 of the grating structure 14 is of a planar architecture.

In an implementation, between adjacent core structures, the film structure includes at least three film layers, the at least three film layers are disposed in a stacked manner between the side surfaces of the adjacent core structures, the at least three film layers have different refractive indexes, and along the vector direction of the grating structure, refractive indexes of the at least three film layers exhibit a gradient trend of sine distribution.

As shown in FIG. 61 and FIG. 62, there are three layers of film structures 142 between adjacent core structures 141. Specifically, the three layers of film structures 142 are respectively a first film layer 142A, a second film layer 142B, and a third film layer 142C. The first film layer 142A, the second film layer 142B, and the third film layer 142C are disposed in a stacked manner between side surfaces 1411 of adjacent core structures 141 in the vector direction of the grating structure 14. The first film layer 142A and the third film layer 142C are respectively combined with side surfaces 1411 of adjacent core structure 141. Both the first film layer 142A and the third film layer 142C are in direct contact with the side surfaces 1411 of the core structures 141. The second film layer 142B is located between the first film layer 142A and the third film layer 142C.

The first film layer 142A, the second film layer 142B, and the third film layer 142C have different refractive indexes. The vector direction of the grating structure 14 may be understood as a direction in which a side surface 1411 of one of two adjacent core structures 141 faces a side surface 1411 of the other core structure 141. That the refractive index of the first film layer 142A, the refractive index of the second film layer 142B, and the refractive index of the third film layer 142C exhibit sine distribution may be understood as follows: A change trend of the three refractive indexes may be a change from large to small and then to large, or may be a change from small to large and then to small. There is a refractive index difference between the core structure 141 and the film structure 142, and there is also a refractive index difference between adjacent film layers inside the film structure 142.

In an implementation, both a refractive index of the first film layer 142A and a refractive index of the third film layer 142C are greater than a refractive index of the second film layer 142B, and the refractive index of the first film layer 142A may be equal to the refractive index of the third film layer 142C. In this implementation, a refractive index of the core structure 141 is greater than the refractive index of the first film layer 142A, and greater than the refractive index of the third film layer 142C. In this implementation, a refractive index range of each part structure may be but is not limited to the following description: A refractive index range of the core structure 141 may be 1.38 to 2.6, a refractive index range of the first film layer 142A and the third film layer 142C may be 1.38 to 2.6, and a refractive index range of the second film layer 142B may be 1.0 to 2.6.

In another implementation, both a refractive index of the first film layer 142A and a refractive index of the third film layer 142C are less than a refractive index of the second film layer 142B, and the refractive index of the first film layer 142A may be equal to the refractive index of the third film layer 142C. In this implementation, a refractive index of the core structure 141 is less than the refractive index of the first film layer 142A, and less than the refractive index of the third film layer 142C. In this implementation, a refractive index range of each part structure may be but is not limited to the following description: A refractive index range of the core structure 141 may be 1.0 to 2.6, a refractive index range of the first film layer 142A and the third film layer 142C may be 1.38 to 2.6, and a refractive index range of the second film layer 142B may be 1.38 to 2.6.

FIG. 64 is a diagram of curves showing a correspondence between an incident angle and diffraction efficiency for comparison between a grating structure with sinusoidal gradient refractive index distribution and a grating structure with a single-core structure. The grating structure with a single-core structure means design in which a refractive index of the grating structure is homogeneous, and in one period of the grating structure, there is only one single core structure, and a refractive index of the core structure is a fixed value. The grating structure with sinusoidal gradient refractive index distribution means that one period of the grating structure includes a core structure and a film structure, and refractive indexes of the core structure and the film structure are different, so that sinusoidal gradient refractive index distribution is generated. Refer to FIG. 64. It can be learned that, at a required incident angle (as shown in FIG. 64, an incident angle is near 0 degrees, and may be set to another incident angle as required), a grating with sinusoidal gradient refractive indexes may have higher diffraction efficiency and narrower full width at half maximum. This can meet a modulation requirement for incident efficiency at a specific angle, thereby improving light efficiency of an entire system.

In an implementation, between the adjacent core structures, the at least three film layers have different thicknesses, a film layer with a largest thickness is adjacent to the core structure, and a thickness of the core structure is greater than that of the film layer with the largest thickness. In the implementation shown in FIG. 61, the first film layer 142A and the third film layer 142C have a same thickness, and may be fabricated on side surfaces of core structures 141 by using a same coating process. From a fabrication perspective, this has advantages of easy implementation and working time reduction. The thickness of the second film layer 142B is not equal to that of the first film layer 142A, and in the specific implementation shown in FIG. 61, the thickness of the second film layer 142B is less than that of the first film layer 142A.

In an implementation, the thickness of the core structure 141 may alternatively be less than that of a film layer with a smallest thickness in the film structure 142, and the film layer with the smallest thickness is adjacent to the core structure 141. The thickness of the second film layer 142B may alternatively be greater than that of the first film layer 142A.

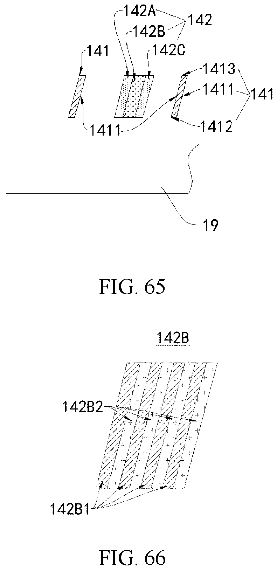

FIG. 65 is an exploded diagram of a part of a grating structure and a part of a waveguide substrate of an optical waveguide according to an implementation of this application. Refer to FIG. 65. The thickness of the core structure 141 is less than that of the first film layer 142A, and is also less than that of the third film layer 142C, the thickness of the first film layer 142A may be equal to that of the third film layer 142C, and the second film layer 142B is a layer with the largest thickness in the film structure 142.

A thickness of the film structure 142 that is of the grating structure 14 provided in this application and that covers the side surface 1411 of the core structure 141 may range from several angstroms to several nanometers. A film structure 142 between a core structure 141 and its adjacent core structure 141 forms one grating period.

Refer to FIG. 61. In one period between adjacent core structures 141, there are an odd number of layers of the film structure 142. For example, a quantity of layers of the film structure 142 is three, five, or seven. One layer located in the middle is a middle layer, and the remaining layers may be symmetrically distributed on two sides of the middle layer. For example, the first film layer 142A and the third film layer 142C are symmetrically distributed on two sides of the second film layer 142B. The symmetric distribution herein may be understood as symmetry in terms of physical sizes and symmetry in terms refractive indexes. Symmetric arrangement in terms of physical sizes helps achieve an advantage of low fabrication difficulty and ease of ensuring a yield rate, and symmetry in terms of refractive indexes helps achieve accurate control on diffraction efficiency and a corresponding incident angle.

In an implementation, a part of the film structure 142 between adjacent core structures 141 is of a seamless structure. It may be understood that a space between adjacent core structures 141 is filled with the film structure 142, and no gap is left. As shown in FIG. 61, the first film layer 142A and the third film layer 142C are attached to side surfaces 1411 of core structures 141, and two sides of the second film layer 142B are respectively directly connected to the first film layer 142A and the third film layer 142C.

The core structure 141 in the grating structure 14 provided in this application may be a blazed grating or a slanted grating. Refractive indexes of any positions in the core structure 141 are the same, and the core structure 141 may be fabricated on the waveguide substrate 19 by using a nano-imprinting process or an etching process. The film structure 142 is formed by using a coating process. Specifically, a multi-layer film structure may be fabricated by using two or more coating processes. For example, in the implementation shown in FIG. 61, two coating processes are used in total, the first film layer 142A and the third film layer 142C are fabricated by using a 1 st first coating process, and the second film layer 142B is fabricated by using 2nd coating process. The film structure 142 may alternatively be made by using another process such as atomic layer deposition (ALD), dip coating, or spin-coating.

In an implementation, one film layer in the film structure 142 is divided into two types of sub-films with different refractive indexes: a first sub-film and a second sub-film, to obtain a target refractive index solution. Refer to FIG. 66. A process of fabricating the second film layer 142B is used as an example. A target refractive index of the second film layer 142 is N. However, it is difficult to directly fabricate a film layer to obtain a film layer with an accurate refractive index of N in terms of processes. Factors that affect fabrication may include material selection, film layer thickness control, and the like. In an implementation, the second film layer 142B includes multiple layers of first sub-films 142B1 and multiple layers of second sub-films 142B2 that are alternately arranged in one-to-one correspondence, a refractive index of the first sub-film 142B1 is N1, a refractive index of the second sub-film 142B2 is N2, a refractive index of the second film layer 142B that includes the multiple layers of first sub-films 142B1 and the multiple layers of second sub-films 142B2 is N, and N1 < N < N2. The first sub-film 142B1 and the second sub-film 142B2 may be made of different materials, and may also have different thicknesses. The first sub-film 142B1 and the second sub-film 142B2 may be implemented by using a same fabrication process. Fabrication processes of the two film layers are simple and easy to implement, and refractive indexes of the two film layers are easy to control. The refractive index N of the finally obtained second film layer 142B can meet a design requirement.

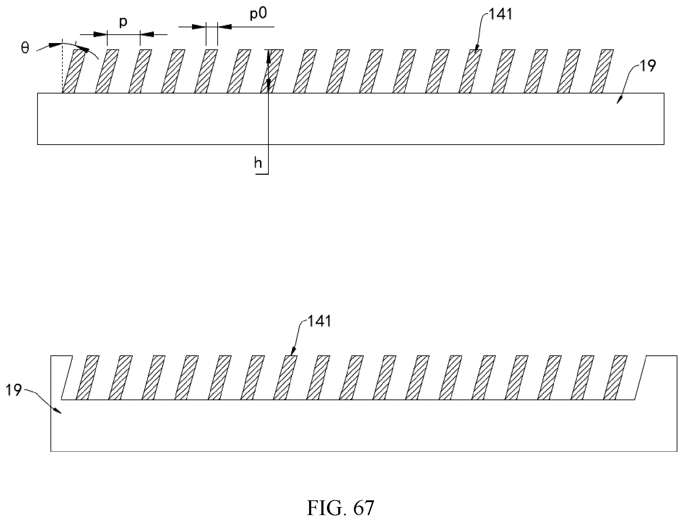

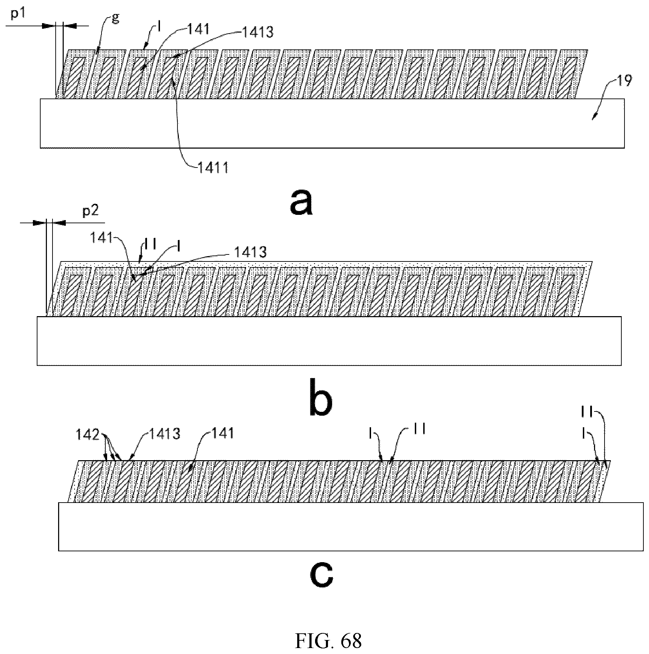

A method for fabricating the optical waveguide 10A shown in FIG. 61 is specifically described as follows with reference to FIG. 67 and FIG. 68.

Refer to FIG. 67. A core structure 141 is fabricated on a waveguide substrate 19. In an implementation, as shown in the upper part of FIG. 67, the core structure 141 protrudes from a surface of the waveguide substrate 19. In another implementation, as shown in the lower part of FIG. 67, the core structure 141 is embedded in the waveguide substrate 19, that is, the core structure 141 is formed in a concave part of the waveguide substrate 19. The core structure 141 may be fabricated on the waveguide substrate 19 by using an etching process. An obtained refractive index range of the core structure 141 fabricated by using the etching process may be 1.38 to 2.6. For example, when a material of the core structure 141 is MgF2, a refractive index of the core structure 141 may be 1.38; or when a material of the core structure 141 is TiO2, a refractive index of the core structure 141 may be 2.6. Alternatively, the core structure 141 may be fabricated on the waveguide substrate 19 by using a nano-imprinting technology, and an obtained refractive index range of a grating core layer may be approximately 1.4 to 2.6.

As shown in FIG. 67, in a specific implementation, a grating period p of a grating structure 14 ranges from 200 nm to 800 nm, a grating height h ranges from 5 nm to 3000 nm, and a grating tilt angle $\theta$ ranges from about 0° to 60°. In a typical embodiment, the period p is equal to 400 nm, the grating height h is 600 nm, the grating tilt angle $\theta$ is 55°, and a width p0 of the grating core layer is 130 nm.

Refer to FIG. 68. FIG. 68 includes diagram a, diagram b, and diagram c from top to bottom. The three diagrams are used to represent three steps of completing fabrication of the grating structure on a basis of the structure shown in FIG. 67.

As shown in diagram a in FIG. 68, after the core structure 141 is fabricated, the film structure is fabricated by using a coating process. First, a film layer I is fabricated on a surface of the core structure 141, where the film layer I wraps a periphery of the core structure 141. The core structure 141 is disposed on the waveguide substrate 19. In this state, both a side surface 1411 and a free end 1413 of the core structure 141 are covered by the film layer I. A thickness p1 of the film layer I may be 70 nm. In a region between adjacent core structures 141, a gap g is formed between film layers I. A refractive index of the film layer I may be 1.38 to 2.6.

As shown in diagram b in FIG. 68, after the film layer I is fabricated, a film layer II is fabricated. A method for fabricating the film layer II may be the same as a method for fabricating the film layer I, for example, the two film layers are fabricated by using the coating process. The film layer II completely covers the film layer I, and the gap g formed by the film layer I is also filled with the film layer II. After the film layer II is fabricated, in a height direction of the grating structure, the film layer I and the film layer II are sequentially stacked above the free end 1413 of the core structure 141. A refractive index of the film layer II may be 1.38 to 2.6. A thickness p2 of the film layer I may be 65 nm.

As shown in diagram c in FIG. 68, after the film layer II is fabricated, a film structure on the surface of the grating structure is polished to be flat by using a process such as chemical mechanical polishing (CMP), so that the free end 1413 of the core structure 141 is exposed. After a process of polishing, the film structure 142 forms a state in which the core structure 141 is not completely wrapped. The film structure 142 forms a film body and a first end part and a second end part that are respectively located at two ends of the film body. The second end part and the free end 1413 of the core structure 141 are coplanar, and the free ends of all the core structures and the second end part of the film structure jointly form an end face of the grating structure.

In an implementation, when the refractive index of the core structure is 1.9, the refractive index of the film layer I in the film structure is 2.1, and the refractive index of the film layer II is 2.3, an average refractive index n=2.1 and a refractive index modulation $\Delta n = 0.4$ may be obtained. The grating structure obtained in this solution has an advantage of high diffraction efficiency.

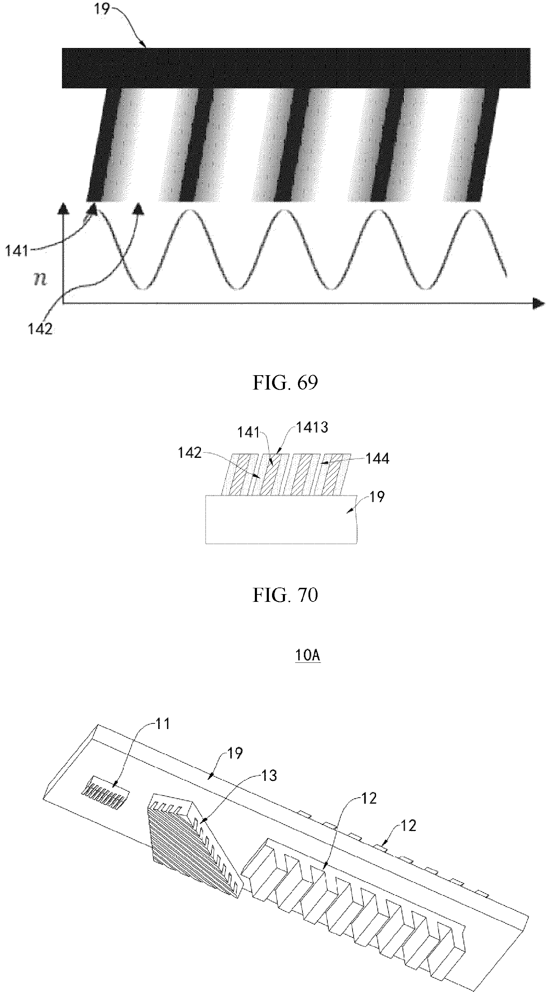

Refer to FIG. 69. In an implementation, a film structure 142 having a film layer with a gradient refractive index may be coated on a basis of the core structure 141, so that good angle and wavelength selection characteristic can be obtained. An SRG grating structure (that is, the core structure 141) with a high refractive index is obtained on the waveguide substrate 19 by using an etching process or a nano-imprinting process. A refractive index of the SRG grating structure (that is, the core structure 141) may reach 2.0 or even higher. For example, when TiO2 is used as the waveguide substrate 19, a highest refractive index of the SRG grating (that is, the core structure 141) obtained by using the etching process may reach 2.6. Then, the film structure 142 is formed by using a multi-layer coating process, where a refractive index may gradually change. A thickness of each coating layer may be several angstroms to several nanometers, and a lowest refractive index may be an air layer. In this case, $\Delta n$ may reach a maximum of 1.6. When the core structure 141 has a high refractive index (for example, a refractive index range is from 1.38 to 2.6), there is a film structure 142 including multiple layers of materials between two core structures 141, and refractive index distribution of the film structure 142 is sine change distribution, as shown by a sine curve in FIG. 69: The refractive index gradually decreases and then gradually increases. A lowest refractive index of the film structure 142 with a gradient refractive index may reach 1.38, and a highest refractive index may reach 2.6. When the core structure 141 has a low refractive index (for example, a refractive index range is from 1.38 to 2.6), a refractive index change distribution between two core structures 141 is still sine distribution, and the refractive index gradually increases and then gradually decreases. This solution can obtain the following benefits: An average refractive index and a refractive index modulation of the grating can be greatly improved, the average refractive index may reach 2.0 or higher, and $\Delta n$ may reach 1.0 or higher, so that a parameter range can be expanded, to provide a proper optimization space for subsequent optical waveguide design.

Similarly, in another implementation, if the core structure 141 is fabricated by using a low-refractive material, and then the film structure 142 is processed by using a high-refractive material, a similar grating structure whose refractive index change distribution is still sinusoidal distribution can be obtained.

Refer to FIG. 70. In an implementation, there is a film gap 144 in a middle position of a film structure 142 between adjacent core structures 141. The gap 144 may be air, and a refractive index of air is 1. In this implementation, a refractive index of the core structure 141 is greater than a refractive index of the film structure 142, and a refractive index of the film structure 142 is greater than 1.38. In this way, between adjacent core structures 141, refractive indexes of the grating structure exhibit a gradient trend of sine distribution. In this implementation, the film structure 142 may be formed on a surface of the core structure 141 through one-time coating.

FIG. 71 is a three-dimensional diagram of an optical waveguide according to an implementation of this application, and schematically shows a grating structure disposed on a surface of a waveguide substrate 19. FIG. 71 merely schematically shows that an out-coupling grating 11, a relay grating 13, and an out-coupling grating 12 are disposed on the waveguide substrate 19, and does not limit specific structures and position relationships of the out-coupling grating 11, the relay grating 13, and the out-coupling grating 12, and a connection relationship, a position relationship, and the like between the three gratings and the waveguide substrate 19. In the implementation shown in FIG. 71, out-coupling gratings 12 are distributed on two sides of the waveguide substrate 19, that is, the out-coupling gratings 12 are disposed on both a top surface and a bottom surface of the waveguide substrate 19. A grating tilt angle of the out-coupling grating 12 located on the top surface of the waveguide substrate 19 may be different from a grating tilt angle of the out-coupling grating 12 located on the bottom surface of the waveguide substrate 19. In this way, the out-coupling grating 12 may diffract light rays in different directions, so that more light rays are coupled out of the waveguide substrate 19, thereby improving diffraction efficiency.

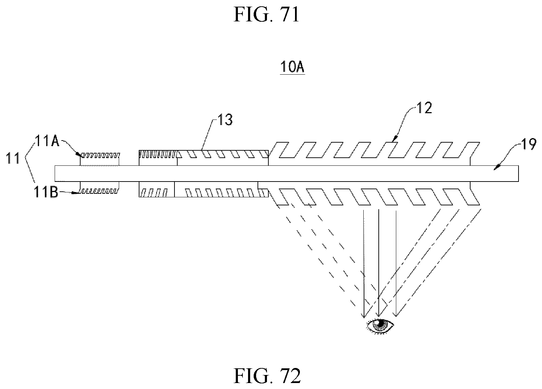

FIG. 72 is a planar diagram of an optical waveguide according to an implementation of this application. Refer to FIG. 72. In an implementation, the in-coupling grating 11 includes a first in-coupling structure 11A and a second in-coupling structure 11B, the first in-coupling structure 11A and the second in-coupling structure 11B are disposed opposite to each other and are respectively located on the top surface and the bottom surface of the waveguide substrate 19, and the first in-coupling structure 11A and the second in-coupling structure 11B have different grating tilt angles. The first in-coupling structure 11A and the second in-coupling structure 11B may diffract light rays in different directions, so that more light rays are coupled into the waveguide substrate 19. That is, the first in-coupling structure 11A and the second in-coupling structure 11B are combined to achieve high diffraction efficiency within a large angle range.

The first in-coupling structure 11A and the second in-coupling structure 11B may be of different grating structures, and may have different grating parameters such as grating heights and grating duty cycles. The first in-coupling structure 11A and the second in-coupling structure 11B may use the grating structure provided in the implementation shown in FIG. 61, FIG. 69, or FIG. 70. The first in-coupling structure 11A and the second in-coupling structure 11B may have different grating core layers (that is, core structures may be different). The first in-coupling structure 11A and the second in-coupling structure 11B may have different film structures (that is, grating coating layers), or may have a same film structure (that is, grating coating layer).

A refractive index of a core structure of the first in-coupling structure 11A may be higher than a refractive index of a core structure of the second in-coupling structure 11B, and a refractive index of a film structure of the first in-coupling structure 11A may be higher than a refractive index of a film structure of the second in-coupling structure 11B. In a specific implementation, the first in-coupling structure 11A has a core structure with a high refractive index (for example, a refractive index range of the core structure is from 1.9 to 2.3), and a film structure of the first in-coupling structure 11A is also made of a material with a high refractive index. For example, a refractive index range of the film structure is from 2.1 to 2.6. The first in-coupling structure 11A can respond to a light ray within an angle range of [-20°, 10°]. The second in-coupling structure 11B uses a core structure with a low refractive index (for example, a refractive index range of the core structure is from 1.5 to 1.9), and a refractive index range of a film structure of the second in-coupling structure 11B is from 1.7 to 2.1. The second in-coupling structure 11B can respond to a light ray within an angle range of [10°, 20°]. The first in-coupling structure 11A and the second in-coupling structure 11B act together, and can respond to a light ray in an incident angle range of [-20°, 20°].

In the implementation shown in FIG. 72, the out-coupling grating 12 also has grating structures distributed on the top surface and the bottom surface of the waveguide substrate 19. In an implementation, both the out-coupling grating 12 and the in-coupling grating 11 use the grating structure provided in the implementation shown in FIG. 61, FIG. 69, or FIG. 70. The out-coupling grating 12 and the in-coupling grating 11 may have different film structures, for example, different materials, different refractive indexes, and different thicknesses.

In one case, in the implementation shown in FIG. 72, a narrow angular bandwidth can be achieved, so that the optical waveguide can meet a specific design requirement. Specifically, for the out-coupling grating 12, when a grating region needs to modulate light only in a specific direction, that is, couple light in the specific direction to the human eye, a narrower angular bandwidth is required in this case. Higher diffraction efficiency can be obtained at a specific angle. As shown in FIG. 72, the human eye sees light rays projected from a left side of the out-coupling grating 12 (three dashed lines on the left side of the out-coupling grating 12 schematically represent light rays projected from the left side of the out-coupling grating 12), and only a part on the left side of the out-coupling grating 12 needs to couple the light rays. Therefore, this part of the out-coupling grating needs to have high diffraction efficiency for this emergent angle. An angular bandwidth of diffraction efficiency required for the part of the grating is narrow. Similarly, for light rays in a middle part (three solid lines in the middle position of the out-coupling grating 12 schematically represent light rays projected from the middle position of the out-coupling grating 12), diffraction efficiency of a middle region of the out-coupling grating also requires a narrow angular bandwidth, to obtain high diffraction efficiency. For light rays on a right side of the out-coupling grating (three dash-dotted lines on the right side of the out-coupling grating 12 represent light rays projected from the middle position of the out-coupling grating 12), a narrow bandwidth is required for light rays coupled out from the right side of the out-coupling grating, to obtain high diffraction efficiency.

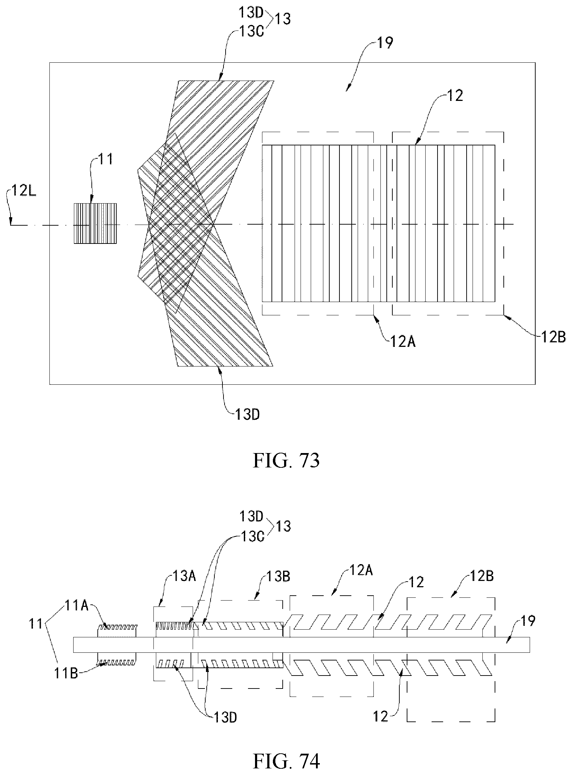

FIG. 73 is a planar diagram of an optical waveguide according to an implementation of this application. In the implementation shown in FIG. 73, a relay grating 13 is located between an in-coupling grating 11 and an out-coupling grating 12, and relay gratings 13 are distributed on a top surface and a bottom surface of the waveguide substrate 19. FIG. 73 shows the relay gratings 13 distributed on the top surface and the bottom surface. The relay grating 13 on the top surface and the relay grating 13 on the bottom surface may have a same structural form and different grating tilt angles, the relay grating 13 on the top surface and the relay grating 13 on the bottom surface may form a symmetric distribution architecture that uses a central axis 12L as a center, and the central axis 12L may be understood as a connection line between a center of the in-coupling grating 11 and a center of the out-coupling grating 12.

As shown in FIG. 73, in an implementation, the out-coupling grating 12 uses the grating structure provided in the implementation shown in FIG. 61, FIG. 69, or FIG. 70. The out-coupling grating 12 includes a first region 12A and a second region 12B, and the first region 12A is closer to the in-coupling grating 11 than the second region 12B. A refractive index difference between a core structure and a film structure of the out-coupling grating 14 in the first region 12A is a first value, a refractive index difference between a core structure and a film structure of the out-coupling grating 12 in the second region 12B is a second value, and the first value is less than the second value. In FIG. 73, rectangular dashed-line boxes are used to represent the first region 12A and the second region 12B. The two rectangular dashed-line boxes in FIG. 73 merely schematically represent a position relationship between the first region 12A and the second region 12B, and do not represent specific structural forms and sizes of outer contours of the first region 12A and the second region 12B. The first region 12A and the second region 12B may be adjacent to each other, that is, boundaries of the first region 12A and the second region 12B are in contact with each other, or are referred to as having a common boundary. The first region 12A and the second region 12B may also be disposed at an interval, like the arrangement shown in FIG. 73, that is, the first region 12A and the second region 12B are separated by using another part of an out-coupling grating.

Refer to FIG. 73 and FIG. 74. In an implementation, the relay grating 13 includes a first relay structure 13C and a second relay structure 13D, the first relay structure 13C and the second relay structure 13D are respectively disposed on a top surface and a bottom surface of the waveguide substrate 19, and the first relay structure 13C and the second relay structure 13D may have different vector directions. The first relay structure 13C and the second relay structure 13D are disposed to have different vector directions, so that more light ray can enter the in-coupling grating 12, thereby improving optical utilization.

In an implementation, for the relay grating 13, film structures at different positions have different coating parameters, and the coating parameters may be but are not limited to a refractive index, a thickness, a density, and the like.

As shown in FIG. 74, in an implementation, the relay grating 13 uses the grating structure provided in the implementation shown in FIG. 61, FIG. 69, or FIG. 70. The relay grating 13 includes a third region 13A and a fourth region 13B, and the third region 13A is closer to the in-coupling grating 11 than the fourth region 13B. A refractive index difference between a core structure and a film structure of the relay grating 13 in the third region 13A is a third value, and a refractive index difference between a core structure and a film structure of the relay grating 13 in the fourth region 13B is a fourth value, and the third value is less than the fourth value. In this implementation, the out-coupling grating 12 may also be an architecture of the out-coupling grating 12 shown in FIG. 73, that is, the out-coupling grating 12 may also include a first region 12A and a second region 12B. A refractive index difference between a core structure and a film structure of the out-coupling grating 14 in the first region 12A is a first value, a refractive index difference between a core structure and a film structure of the out-coupling grating 12 in the second region 12B is a second value, and the first value is less than the second value. In this solution, the refractive index difference (that is, the fourth value) between the core structure and the film structure in the fourth region 13B of the relay grating 13 is less than the first value.

In a specific implementation, in the third region 13A, a refractive index of the core structure of the relay grating 13 is 2.4, a refractive index of the film structure is 1.9, and the third value (that is, the refractive index difference between the core structure and the film structure of the relay grating 13 in the third region 13A) is 0.5. In the fourth region 13B, a refractive index of the core structure of the relay grating 13 is 2.4, a refractive index of the film structure is 1.5, and the fourth value (that is, the refractive index difference between the core structure and the film structure of the relay grating 13 in the fourth region 13B) is 0.9. Grating efficiency in the third region 13A is less than that in the fourth region 13B.

In an implementation, in a vector direction of the relay grating 13, a refractive index difference between the core structure and the film structure exhibits a gradient trend, the refractive index difference gradually increases, and a refractive index of the relay grating also gradually increases.

In summary, in this application, to obtain uniform brightness distribution, diffraction efficiency of the optical waveguide needs to be continuously improved. For example, the diffraction efficiency needs to have an increasing trend in a direction of extending from the in-coupling grating to the out-coupling grating. In order to gradually improve diffraction efficiency, in this application, the refractive index difference may gradually increase, to improve a grating diffraction rate. Increasing the refractive index also helps improve grating diffraction efficiency.

At least a part of the out-coupling grating 11, the relay grating 13, and the out-coupling grating 12 in the implementations shown in FIG. 71, FIG. 72, FIG. 73, and FIG. 74 may include the grating structure provided in the implementations shown in FIG. 61, FIG. 69, or FIG. 70.

An optical waveguide provided in an implementation of this application is used in a near-eye display device as a medium for light ray propagation. The optical waveguide includes a waveguide substrate and an in-coupling grating and an out-coupling grating that are formed on the waveguide substrate. After the in-coupling grating couples a light ray transmitted by an optical engine into the optical waveguide, total internal reflection propagation of the light ray needs to be performed in the waveguide substrate. In order to achieve a large field of view, a refractive index of the waveguide substrate needs to be increased. Therefore, to obtain an image with a good field of view and a good optical effect, the waveguide substrate needs to have a high refractive index. For the waveguide substrate, a larger refractive index indicates a larger weight, but a larger weight affects comfort of wearing the near-eye display device. For design of the optical waveguide, how to reduce a weight is an important research and development direction.

In an implementation, in this application, a medium layer with a low refractive index and grating structures formed on a top surface and a bottom surface of the medium layer jointly form the waveguide substrate, and total internal reflection propagation of a light ray is performed by using the grating structures formed on the top surface and the bottom surface of the medium layer. The grating structure described herein is not an in-coupling grating, an out-coupling grating, or a relay grating. A function of the grating structure is merely to achieve total internal reflection propagation of a light ray in the waveguide substrate. The medium layer with a low refractive index has a lightweight advantage, and an overall weight of the waveguide substrate including the medium layer with a low refractive index and the grating structures formed on the top surface and the bottom surface of the medium layer may be controlled to be within a small range.

Solution 6: Volume holographic grating achieving total internal reflection propagation

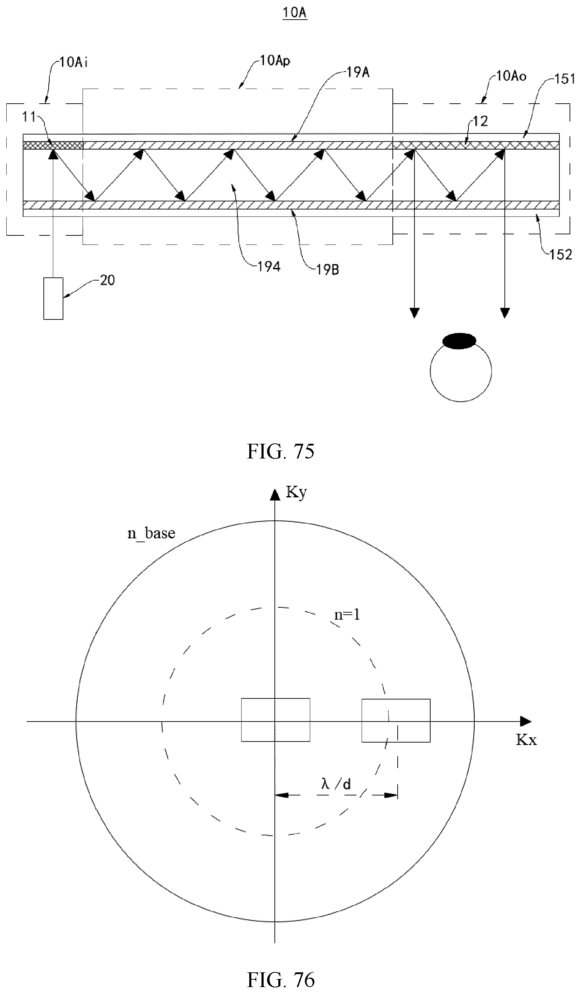

FIG. 75 is a diagram of an optical waveguide according to an implementation of this application. Refer to FIG. 75. An optical waveguide provided in an implementation includes an in-coupling region 10Ai, an out-coupling region 10Ao, and a light propagation region 10Ap. An in-coupling grating 11 is disposed in the in-coupling region 10Ai, and the in-coupling grating 11 is configured to receive an incident light ray transmitted by an optical engine 20. It may be understood that the light ray emitted by the optical engine 20 is incident to the in-coupling grating 11 to form an incident light ray. The incident light ray undergoes total internal reflection in the light propagation region 10Ap after entering the optical waveguide 10A. An out-coupling grating 12 is configured to couple a light ray out, so that the light ray is projected onto a human eye, to form a virtual image.

In the implementation shown in FIG. 75, a waveguide substrate of the optical waveguide 10A is a material with a low refractive index. In the light propagation region 10Ap, the optical waveguide 10A includes a medium layer 194 and a first grating layer 19A and a second grating layer 19B that are located on two sides of the medium layer 194. Specifically, the first grating layer 19A and the second grating layer 19B are respectively formed on a top surface and a bottom surface of the medium layer 194. In this implementation, total internal reflection propagation of a light ray in the light propagation region 10Ap is achieved by using the first grating layer 19A and the second grating layer 19B distributed on the two sides of the medium layer 194, but total internal reflection propagation of the light ray cannot be achieved by using a separate medium layer 194. A refractive index of the medium layer 194 is less than or equal to 1.5. In this solution, a range of the refractive index of the medium layer 194 is restricted, so that it can be ensured that the medium layer 194 has an advantage of low density and a light weight, facilitating lightweight design of the optical waveguide 10A. In this solution, at least one of the first grating layer and the second grating layer is restricted to have different periods, so that at least one of the first grating layer and the second grating layer can transmit ambient light, and can further achieve total internal reflection of a light ray transmitted inside the optical waveguide.

In a specific implementation, a material of the medium layer 194 is a low-refractive material, for example, glass or resin. A thickness of the medium layer 194 may be greater than or equal to 0.1 mm and less than or equal to 1 mm. Specifically, the thickness and the refractive index of the medium layer 194 may be set to match an exit pupil size and a FOV value of an optical engine in a near-eye display device. The medium layer 194 may alternatively be air.

In an implementation, the waveguide substrate in the optical waveguide 10A is entirely formed by the medium layer 194. That is, a part of the waveguide substrate that is in the in-coupling region 10Ai and that is configured to carry the in-coupling grating 11, a part of the waveguide substrate that is in the out-coupling region 10Ao and that is configured to carry the out-coupling grating 12, and a medium layer 194 in the light propagation region 10Ap are of an integrated structure, have a same material and a same refractive index, and may be formed by using a same fabrication process.

In an implementation, a bandwidth of the incident light ray is less than or equal to 5 nm. The incident light ray may be a laser light source. In this implementation, a bandwidth range of the incident light ray is restricted, so that the light ray emitted by the optical engine 20 to the in-coupling grating 11 is a narrow-bandwidth light source, which helps ensure image quality of a virtual image formed by projection of the optical waveguide 10A onto the human eye.

The incident light ray projected by the optical engine 20 onto the in-coupling grating 11 provided in this application is an incident light ray with a narrow wavelength bandwidth. This specifically means that an incident wavelength bandwidth is restricted for a light ray that enters the in-coupling grating from the optical engine, to ensure that little impact is caused on environment observation. It is assumed that the wavelength bandwidth of the incident light ray is 1 nm (532 nm to 533 nm). The first grating layer 19A and the second grating layer 19B are designed for the wavelength, and allow other wavelengths such as 520 nm to normally pass through, without affecting environment observation. However, assuming that the wavelength bandwidth of the incident light ray is wide, for example, is 20 nm (520 nm to 540 nm), ambient light is diffracted when arriving at the first grating layer 19A and the second grating layer 19B. That is, in an external environment, assuming that a white picture is observed, a part of external ambient light in a band of 520 nm to 540 nm is diffracted. Transmittance is less than that of another band, which affects a color ratio, that is, color distortion occurs, affecting observation of the external environment.

For the optical waveguide provided in this application, an incident light ray projected by the optical engine 20 onto the in-coupling grating 11 is separated from an angle of the incident light ray after being diffracted by the in-coupling grating 11, needs to be transmitted in the medium layer 194, and undergoes total internal reflection in the light propagation region 10Ap. For the near-eye display device, in an implementation, a period of the in-coupling grating 11 meets the following condition: $\lambda/d > 2*\sin(FOVx)$, and $\sin(FOVx) + \lambda/d < n\_base*\sin(75°)$, where $\lambda$ is a wavelength of an incident light ray incident to the in-coupling grating, d is the period of the in-coupling grating, and FOVx is a maximum incident angle in a horizontal direction of the incident light ray incident to the in-coupling grating, and n_base represents a refractive index of a waveguide substrate corresponding to the in-coupling grating 11. In the implementation shown in FIG. 75, it may be understood that the waveguide substrate corresponding to the in-coupling grating 11 is a part of the medium layer and a part of the second grating layer that are below the in-coupling grating 11, that is, n_base is a refractive index of the part of the medium layer and the part of the second grating layer that are below the in-coupling grating 11.

FIG. 76 is a diagram of K-space of a grating period of an optical waveguide according to an implementation of this application. Refer to FIG. 76. A dashed circle formed by a refractive index of n= 1 in K-space is an angle range in which propagation in a medium n= 1 can be achieved. Similarly, an angle range in which propagation in the waveguide substrate can be achieved is a solid circle formed by n=n_base. An angle range of light emitted by an optical engine may be described as a block region in a K-space diagram. After being coupled by the in-coupling grating 11, light changes in angle, which means translation of the block in the K-space. A translation distance is related to an incident wavelength and a period of the in-coupling grating, and is equal to $\lambda/d$. After

the translation, angle ranges cannot intersect (if the angle ranges intersect, angular aliasing occurs, and a ghost image is generated), and cannot be outside the circle of n_base (if the angle ranges are outside the circle of n_base, a light ray cannot be propagated in the medium n_base). Therefore, the grating period of the in-coupling grating needs to meet the following condition: $\lambda/d > 2*\sin(FOVx)$, $\sin(FOVx) + \lambda/d < n\_base*\sin(75°)$.

In an implementation, periods of the out-coupling grating and the relay grating (if the optical waveguide includes the relay grating located between the in-coupling grating and the out-coupling grating) on the optical waveguide 10A also need to meet a condition that needs to be met by the grating period of the in-coupling grating.

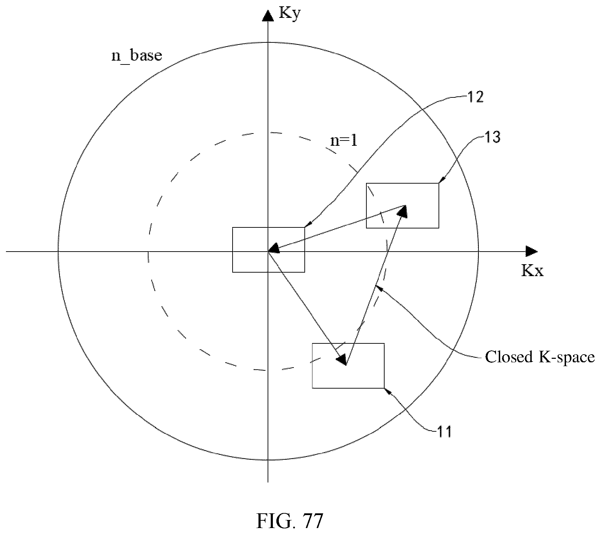

FIG. 77 is a diagram of K-space of a grating period of an optical waveguide according to an implementation of this application. Refer to FIG. 77. Period directions and sizes of an in-coupling grating 11, a relay grating 13, and an out-coupling grating 12 need to form closed K-space. When this condition is met, it can be ensured that a virtual image projected by the optical waveguide is not distorted, that is, authenticity of the image can be ensured, improving an image display effect of the optical waveguide.

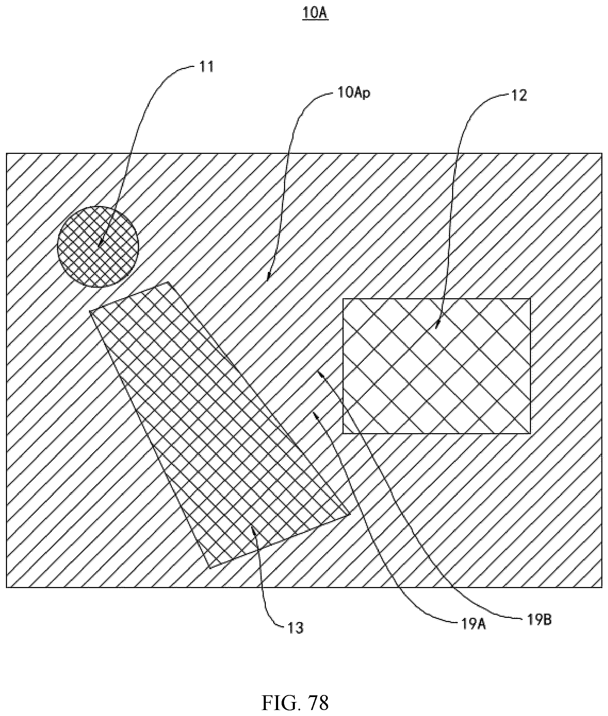

Based on the diagram of the K-space shown in FIG. 77, in an implementation, as shown in FIG. 78, an optical waveguide 10A provided in this application includes an in-coupling grating 11, a relay grating 13, and an out-coupling grating 12. In an optical path transmission direction, the relay grating 13 is located between an in-coupling region 10Ai and an out-coupling region 10Ao, a first grating layer 19A and a second grating layer 19B in a light propagation region 10Ap are located between the in-coupling grating 11 and the out-coupling grating 12, and the first grating layer 19A and the second grating layer 19B in the light propagation region 10Ap surround the relay grating 13. That is, the first grating layer 19A and the second grating layer 19B do not need to be disposed at a position of the relay grating 13. In FIG. 78, section lines outside the in-coupling grating 11, the relay grating 13, and the out-coupling grating 12 represent the first grating layer 19A and the second grating layer 19B, and may also represent the light transmission area 10Ap. In this implementation, the out-coupling grating 12 may be a one-dimensional grating. In the implementation shown in FIG. 78, the in-coupling grating 11, the out-coupling grating 12, and the relay grating 13 may be gratings of different types. Any one of the in-coupling grating 11, the out-coupling grating 12, and the relay grating 13 may be a grating of a same type as the first grating layer 19A and the second grating layer 19B, for example, may be volume holographic grating. The in-coupling grating 11, the out-coupling grating 12, the relay grating 13, the first grating layer 19A, and the second grating layer 19B may all be volume holographic gratings.

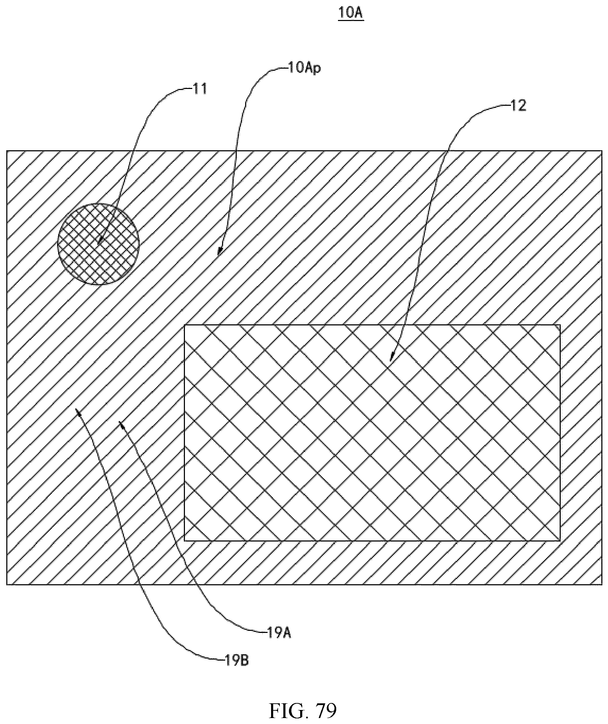

In an implementation, as shown in FIG. 79, the out-coupling grating 12 may be a two-dimensional grating, the light propagation region 10Ap is located between the in-coupling grating 11 and the out-coupling grating 13, and the first grating layer 19A and the second grating layer 19B fill all regions between the in-coupling grating 11 and the out-coupling grating 12. It may be understood that the optical waveguide 10A provided in this implementation does not have a relay grating, a light ray coupled by the in-coupling grating 11 is propagated to the out-coupling grating 12 through total internal reflection of the first grating layer 19A and the second grating layer 19B. In FIG. 79, section lines outside the in-coupling grating 11 and the out-coupling grating 12 represent the first grating layer 19A and the second grating layer 19B, and may also represent the light transmission area 10Ap. In the implementation shown in FIG. 78, the in-coupling grating 11, the out-coupling grating 12, and the relay grating 13 may be gratings of different types. Any one of the in-coupling grating 11 and the out-coupling grating 12 may be a grating of a same type as the first grating layer 19A and the second grating layer 19B, for example, may be volume holographic grating. The in-coupling grating 11, the out-coupling grating 12, the first grating layer 19A, and the second grating layer 19B may all be volume holographic gratings.

In FIG. 78 and FIG. 79, although the first grating layer 19A and the second grating layer 19B are distributed on two sides of a medium layer, because FIG. 78 and FIG. 79 show a position relationship between grating structures, whether the grating structures are located on the top surface or the bottom surface of the medium layer in the thickness direction of the optical waveguide is not distinguished.

After a FOV range of an incident light ray emitted by an optical engine 20 and a grating period of the in-coupling grating 11 are obtained, a propagation angle range of θ1 to θ2 after in-coupling can be obtained. The light ray needs to diffract through the first grating layer 19A and the second grating layer 19B for forward propagation. A corresponding period acting in the first grating layer 19A and the second grating layer 19B for a corresponding angle is $\lambda/(2*n\_base*sin(\theta))$. It is assumed that the FOV range of the incident light ray is -15° to 15°, an incident wavelength length is 532 nm, and a refractive index of the medium layer 194 is n=1.3. According to the foregoing calculation method, a period range of the in-coupling grating 11 is from 533.7 nm to 1.028 μm. Assuming that a period of the in-coupling grating 11 is set to 600 nm, a corresponding diffraction angle is 28.9° to 61.8°, a corresponding period of the first grating layer 19A and the second grating layer 19B is 233.2 nm to 423.4 nm. A larger FOV range of an incident light ray indicates a larger upper limit of a diffraction angle when a period of the in-coupling grating 11 and a refractive index of the medium layer 194 remain unchanged, and indicates a smaller lower limit of a period of the first grating layer 19A and the second grating layer 19B.

In summary, in a specific implementation, a larger FOV range of an incident light ray projected by the optical engine 20 onto the in-coupling grating 11 indicates a larger quantity of periods of at least one of the first grating layer 19A and the second grating layer 19B. In a specific implementation, a larger FOV range of an incident light ray projected by the optical engine 20 onto the in-coupling grating 11 indicates a larger upper limit of a diffraction angle when a period of the in-coupling grating 11 and a refractive index of the medium layer 194 remain unchanged, and indicates a smaller lower limit of a quantity of periods of at least one of the first grating layer 19A and the second grating layer 19B.

When the first grating layer 19A and the second grating layer 19B are volume holographic gratings, a manner of multiplexing volume holographic gratings is used in this application, to achieve total internal reflection propagation of a light ray in the optical waveguide, and further achieve transmission of ambient light. In this case, quantities of grating periods of the first grating layer 19A and the second grating layer 19B depend on required angular resolution. Assuming that the required angular resolution is 18 PPD (pixels per degree) and an incident angle range is from -15° to 15°, the required quantity of grating periods is 18*30=540. High required angular resolution and a larger incident FOV range indicate a larger required quantity of grating periods. Currently, a small FOV is 12°, and a minimum of 18 PPD is required. In this case, the quantity of periods of the first grating layer 19A and the second grating layer 19B is at least greater than 216.

In the implementation shown in FIG. 75, at least one of the first grating layer 19A and the second grating layer 19B has different periods. If the first grating layer 19A and the second grating layer 19B each have a homogeneous period, periods of the first grating layer 19A and the second grating layer 19B are the same, and the two grating layers work at same reflection and diffraction orders, transmittance of ambient light for observation from the outside is low, that is, a user can see a virtual image projected by the out-coupling grating, but cannot clearly see an external environment of the near-eye display device. In this application, at least one of the first grating layer 19A and the second grating layer 19B is restricted to have different periods. Total internal reflection propagation can be performed on incident light at a plurality of fields of view, so that more light ray energy enters the out-coupling grating, to improve diffraction efficiency. Moreover, transmittance of ambient light can be ensured, so that a user can clearly see not only a virtual image projected by the out-coupling grating, but also clearly see an external environment of the near-eye display device.

In an implementation, each of the first grating layer 19A and the second grating layer 19B have different periods. In this solution, each of the first grating layer and the second grating layer is restricted to have different periods, so that light transmission of the optical waveguide can be improved.

Specifically, both the first grating layer 19A and the second grating layer 19B are volume holographic gratings. In this solution, the volume holographic gratings with different periods are multiplexed, so that the light propagation region 10Ap can perform total internal reflection on an incident light ray entering the optical waveguide, and can further achieve good transmittance of ambient light. In addition, compared with another grating type (for example, a blazed grating or a slanted grating), the volume holographic grating has an advantage of lightness and thinness. Therefore, this solution facilitates lightweight design of the optical waveguide 10A.

In an implementation, as shown in FIG. 75, the medium layer 194 is of a flat-plate-like structure, and all grating structures formed on a top surface and a bottom surface of the medium layer 194 may be volume holographic gratings. All the grating structures herein include the in-coupling grating 11, the out-coupling grating 12, the first grating layer 19A, and the second grating layer 19B.

Specifically, the quantity of periods of one of the first grating layer 19A and the second grating layer 19B depends on angular resolution required for the optical waveguide 10A and a value of a FOV of an incident light ray of the optical engine 20. Periodicity is an important characteristic of a grating structure, and different periods correspond to different Bragg angles, that is, different incident angles. Therefore, diffraction efficiency of a grating structure having different periods is higher than diffraction efficiency of a grating structure having only one type of period, and the grating structure having different periods can perform total internal reflection on a light ray in the optical waveguide, and further, can transmit ambient light.

In an implementation, period ranges of the first grating layer 19A and the second grating layer 19B are greater than or equal to 100 nm and less than or equal to 700 nm. Periods of the first grating layer 19A and the second grating layer 19B formed by using the solution of multiplexing the volume holographic grating correspond to incident angles. A grating period range is restricted to be greater than or equal to 100 nm and less than or equal to 700 nm, so that high diffraction efficiency can be obtained on the premise that the incident angle is ensured.

In an implementation, a volume shrinkage range of a material of the first grating layer 19A and a volume shrinkage range of a material of the second grating layer 19B are less than or equal to 0.1%. In this solution, grating structures with small volume shrinkage are used, so that transverse and longitudinal change rates of the first grating layer 19A and the second grating layer 19B can be reduced, thereby reducing changes of a period, a thickness, and a tilt angle, and ensuring that there is no large deviation between designed angles and efficiency and actual angles and efficiency of the first grating layer 19A and of the second grating layer 19B.

In the implementation shown in FIG. 75, the in-coupling grating 11, the first grating structure 195, and the out-coupling grating 12 are located on the top surface of the medium layer 194, and the second grating layer 19B is on the bottom surface of the medium layer 194. Specifically, the second grating layer 19B not only covers the medium layer 194 in the light propagation region 10Ap, but also covers the medium layer in the in-coupling region 10Ai and the out-coupling region 10Ao, so that a surface that is of the optical waveguide 10A and that is on a side of the bottom surface of the medium layer 194 has good flatness. On a side of the top surface of the medium layer 194, a surface that is of the in-coupling grating 11 and that is away from the medium layer, a surface that is of the first grating layer 19A and that is away from the medium layer 194, and a surface that is of the out-coupling grating 12 and that is away from the medium layer 194 may form a coplanar architecture, so that a surface that is of the optical waveguide 10A and that is on the side of the top surface of the medium layer 194 has a good flatness.

In an implementation, the optical waveguide 10A further includes a first protection layer 151 and a second protection layer 152. The first protection layer 151 is located on a side that is of the first grating layer 19A and that is away from the medium layer 194, and the first protection layer 151 covers surfaces of the first grating layer 19A, the in-coupling grating 11, and the out-coupling grating 12. The first protection layer 151 is configured to protect the first grating layer 19A, the in-coupling grating 11, and the out-coupling grating 12, so that the first grating layer 19A, the in-coupling grating 11, and the out-coupling grating 12 are protected from corrosion caused by external dust, air, or moisture. The second protection layer 152 covers a surface of the second grating layer 19B, to protect the second grating layer 19B, so that the second grating layer 19B is protected from corrosion caused by external dust, air, or moisture, thereby helping ensure diffraction efficiency and optical performance of the optical waveguide.

According to the optical waveguide provided in a specific implementation of this application, in the light propagation region 10Ap of the optical waveguide, the first grating layer and the second grating layer are used to perform total internal reflection propagation on a coupled-in image, and transmittance of ambient light of the entire optical waveguide is ensured, to ensure that a human eye can normally observe an external environment. In a specific solution, film thicknesses of the first grating layer and the second grating layer may be greater than 20 $\mu$m. A bandwidth of an incident light ray of a combination of the first grating layer and the second grating layer is less than 5 nm (that is, an incident light ray with a narrow bandwidth), to achieve total internal reflection propagation of a coupled-in light ray. A process of fabricating the first grating layer and the second grating layer may be obtained through multi-time exposure, so that the first grating layer and the second grating layer have a plurality of periods, to achieve total internal reflection propagation of an incident light ray and further improve transmittance of ambient light.

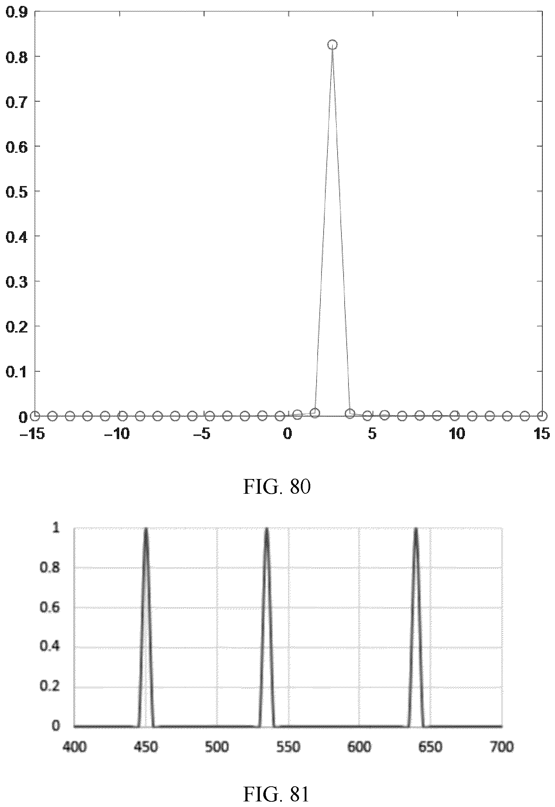

FIG. 80 is a diagram of diffraction efficiency of a single grating. In FIG. 80, a horizontal axis represents an incident angle, and a vertical axis represents diffraction efficiency. It can be learned from FIG. 80 that in this application, a volume holographic grating with high diffraction efficiency within a very small angular range in angle space can be obtained. A multiplexed volume holographic grating is formed by exposing gratings with a plurality of periods in a same layer. FIG. 80 shows diffraction efficiency of a single grating, where the single grating refers to a grating with a specific period. Based on the multiplexed volume holographic grating architecture provided in this application, each period of a grating can perform high-efficiency diffraction for a specific angle.

Reflection and diffraction efficiency at different angles is ensured through calculation and simulation. Specifically, a target function MF = sum((DE_s-1)$^2$ + (DE_p-1)$^2$) + sum(DE_t$^2$) may be used. DE_s and DE_p in the formula respectively represent reflection and diffraction efficiency of s-polarized light and p-polarized light at a target angle that are incident to the first grating layer 19A and the second grating layer 19B, 1 is a required efficiency target value, which means total internal reflection forward propagation, and DE_t is diffraction efficiency of light at another angle arriving at the first grating layer 19A and the second grating layer 19B. Minimization of the objective function is used as an objective of optimizing a grating structure. This objective represents that reflective forward transmission of an image in a waveguide is expected while transmittance of ambient light is ensured.

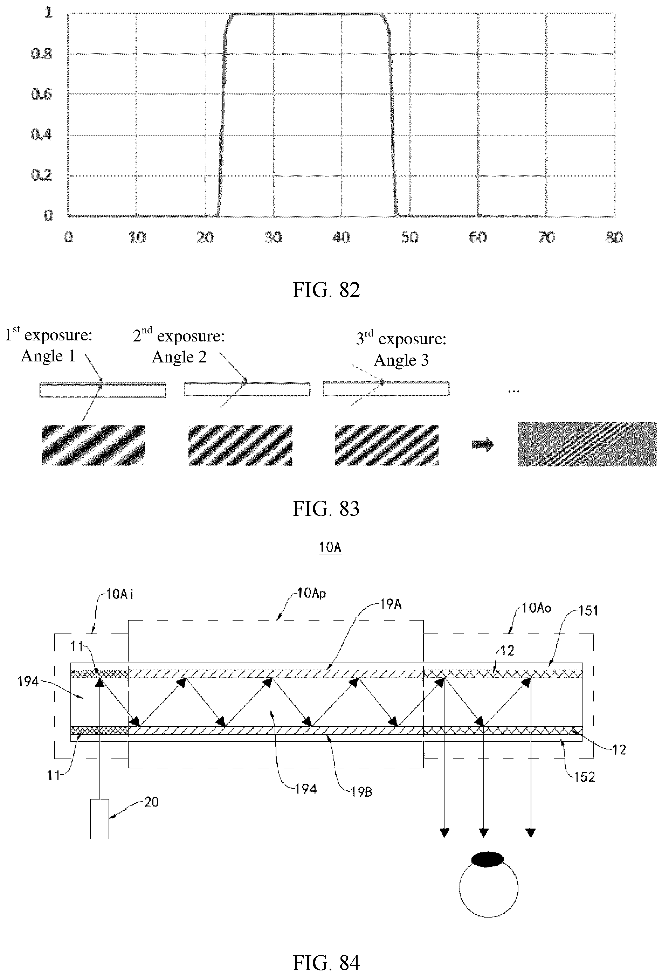

Optimization is performed by using a global optimization algorithm such as a simulated annealing algorithm or a gene algorithm, to obtain specific parameter values of the first grating layer 19A and the second grating layer 19B and an optimized effect. A diffraction angle range (25 to 45) is used as an example, and target optimization effects are shown in FIG. 81 and FIG. 82.

FIG. 81 is a diagram of a wavelength bandwidth. In FIG. 81, a horizontal axis represents an incident wavelength length, and a vertical axis represents diffraction efficiency. It can be learned from FIG. 81 that an optimized multiplexed volume holographic grating has high diffraction efficiency only for a wavelength range of a very narrow bandwidth, and has high-efficiency transmission for other bands, without affecting observation of an external environment.

FIG. 82 is a diagram of an angular bandwidth. In FIG. 82, a horizontal axis represents an incident angle of light incident to the multiplexed volume holographic grating, and a vertical axis represents diffraction efficiency. It can be learned from FIG. 82 that the multiplexed volume holographic grating provided in this application has a high-efficiency diffraction characteristic only within an applied angle range. This also ensures an angle required for total internal reflection propagation while ensuring high-efficiency transmission for another external environment angle.

Three fields of view are used as an example (different fields of view are represented by lines of different colors), and a diagram of exposure is shown in FIG. 83. The first grating layer 19A and the second grating layer 19B on the light propagation region 10Ap need to diffract light arriving at the region and then continue to perform forward propagation in an original direction and angle. Based on multiplexing characteristics of the first grating layer 19A and the second grating layer 19B, a plurality of different gratings need to be exposed for incident light of different fields of view. Exposure angles are a direction in which the incident light comes and a required diffraction direction. A grating formed by exposure in the two directions is for the incident light direction. The first grating layer 19A and the second grating layer 19B formed after multi-time exposure may diffract light of a plurality of fields of view in the waveguide to the required diffraction direction, so that the light is propagated forward to an out-coupling grating after total internal reflection in this region, and is normally coupled out to the human eye.

In a procedure of fabricating the first grating layer 19A and the second grating layer 19B, for a fabrication procedure of the multi-time exposure, refer to FIG. 83. 1$^{st}$ exposure is performed at an angle 1, 2$^{nd}$ exposure is performed at an angle 2, 3$^{rd}$ exposure is performed at an angle 3, and so on. Multi-time exposure can be performed in the process of fabricating the first grating layer 19A and the second grating layer 19B. In a process of the multi-time exposure, exposure angles may sequentially increase. As shown in FIG. 83, Angle 1 < Angle 2 < Angle 3.

Refer to FIG. 84. In an implementation, in the in-coupling region 10Ai, the in-coupling grating 11 is distributed on two sides of the medium layer 194, so that in-coupling efficiency of an incident light ray can be improved. In an implementation, the in-coupling grating 11 located on the top surface of the medium layer 194 and the in-coupling grating 11 located on the bottom surface of the medium layer may have different tilt angles, so that the in-coupling gratings 11 can couple in incident light rays with a larger angle range. In an implementation, in the out-coupling region 10Ao, out-coupling gratings 12 are distributed on two sides of the medium layer 194, so that out-coupling energy of an incident light ray can be improved, and more light rays can be coupled to a human eye, to obtain better image quality. In an implementation, an out-coupling grating 12 located on the top surface of the medium layer 194 and an in-coupling grating 12 located on the bottom surface of the medium layer may have different tilt angles, so that the out-coupling gratings 12 can couple light rays with a larger angle range out.

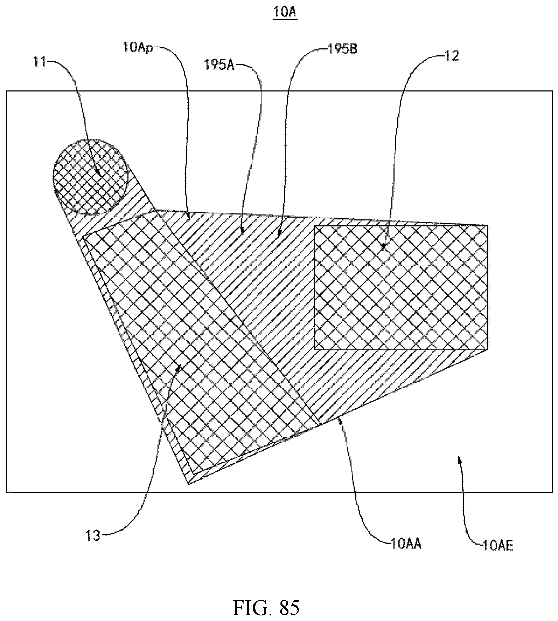

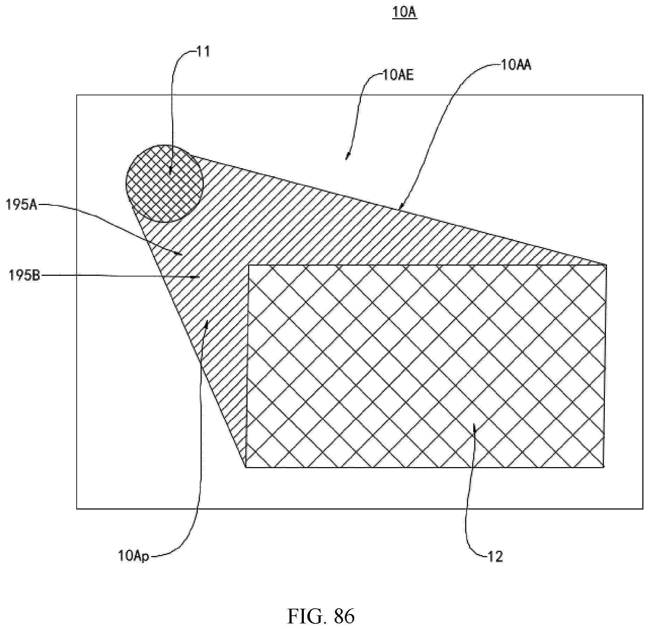

Refer to FIG. 85 and FIG. 86. In an implementation, the optical waveguide 10A includes a functional region 10AA and an edge region 10AE. The functional region 10AA performs functions of diffraction and total internal reflection propagation of incident light rays and light ray coupling of the optical waveguide 10A. The edge region 10AE surrounds the functional region 10AA, the edge region 10AE may transmit ambient light, and the edge region 10AE and the functional region 10AA are assembled together to form a form of a lens of a near-eye display device. The first grating layer and the second grating layer do not need to be configured at a position of the edge region 10AE. According to the optical waveguide provided in this solution, the functional region and the edge region are combined, and the edge region may be made of a light material, which helps achieve lightweight of the optical waveguide.

Specifically, a refractive index of the edge region 10AE is less than a refractive index of the functional region 10AA, or a material of the edge region 10AE is different from a material of the functional region 10AA. The edge region 10AE may be made of a material with a low refractive index or a low-density material, which facilitates overall lightweight design of the near-eye display device.

In the implementation shown in FIG. 85, the functional region 10AA includes the in-coupling grating 11, the relay grating 13, the out-coupling grating 12, and a first grating layer 195 and a second grating layer 196 in the light propagation region 10Ap. In this implementation, a region between the in-coupling grating 11 and the relay grating 13 and a region between the relay grating 13 and the out-coupling grating 12 are the light propagation region 10Ap. In the implementation shown in FIG. 86, the functional region 10AA includes the in-coupling grating 11, the out-coupling grating 12, and a first grating layer 195 and a second grating layer 196 in the light propagation region 10Ap. In this implementation, a region between the in-coupling grating 11 and the out-coupling grating 12 is the light propagation region 10Ap.

The optical waveguide 10A provided in the implementation shown in FIG. 75 may be of an optical waveguide structure with a single-layer single-sided grating, that is, the optical waveguide has only one medium layer, and an in-coupling grating and an out-coupling grating are disposed only on one side of the medium layer. The optical waveguide 10A provided in the implementation shown in FIG. 84 may be of an optical waveguide structure with a single-layer double-sided grating, that is, the optical waveguide has only one medium layer, and in-coupling gratings and out-coupling gratings are disposed only on two sides of the medium layer.

In another implementation, the optical waveguide provided in this application may alternatively be of a multi-layer single-sided architecture or a multi-layer double-sided architecture. "Multi-layer" means that the optical waveguide has two or more medium layers disposed in a stacked manner. "Multi-layer single-sided architecture" means that the optical waveguide has two or more medium layers, and a grating structure is disposed on only one side of each medium layer. "Multi-layer double-sided architecture" means that the optical waveguide has two or more medium layers, and grating structures are disposed on two sides of each medium layer. In another implementation, there may be two layers of the optical waveguide, for example, one layer transmits red light and blue light, and the other layer transmits blue light and green light. In another implementation, a quantity of layers of the optical waveguide may alternatively be three, for example, the three layers respectively transmit red light, blue light, and green light. This solution defines the single-layer architecture or the three-layer architecture of the optical waveguide. In any architecture, the first grating layer and the second grating layer may be used as a medium for total internal reflection propagation of the light propagation region. This solution has an advantage of good flexibility.

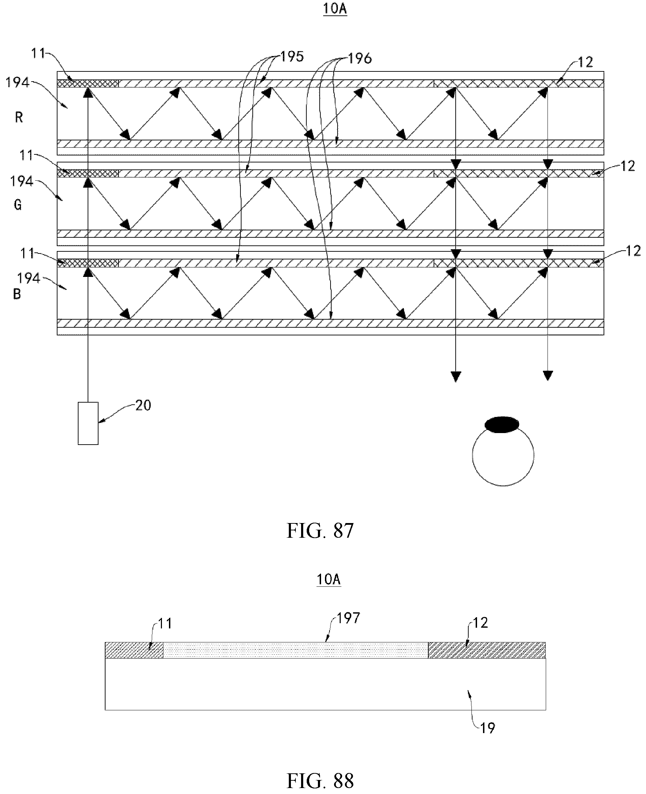

FIG. 87 schematically shows a three-layer single-sided optical waveguide architecture. Refer to FIG. 87. An optical waveguide 10A includes three medium layers 194, and the three medium layers 194 are disposed in a stacked manner. Grating structures disposed on a top surface and a bottom surface of each medium layer 194 are the same. In another implementation, grating structures disposed on top surfaces or bottom surfaces of different medium layers may alternatively be different. In an implementation shown in FIG. 87, an architecture including each medium layer 194, and in-coupling gratings 11, out-coupling gratings 12, a first grating layer 195A, and a second grating layer 195B that are on the top surface and the bottom surface of the medium layer 194 is the same as the optical waveguide architecture shown in FIG. 75. A medium layer 194 and an in-coupling grating 11 at a top layer are configured to couple a red incident light ray R, a medium layer 194 and an in-coupling grating 11 at a middle layer are configured to couple a green incident light ray G, and a medium layer 194 and an in-coupling grating 11 at a bottom layer are configured to couple a blue incident light ray B. All the out-coupling gratings 12 in the three-layer architecture project coupled-out light rays onto the human eye, so that the human eye can see a colorful virtual image.

For the implementation shown in FIG. 87, because a color of a light ray transmitted by each layer of architecture is different, and each layer transmits a light ray of only one color, when the first grating layer 195 and the second grating layer 196 are volume holographic gratings, during fabrication of the first grating layer 195 and the second grating layer 196, a quantity of periods of each layer may be less than the quantity of periods of the first grating layer 195 and the second grating layer 196 in the implementation shown in FIG. 75. Therefore, in this implementation, a quantity of exposure times of the first grating layer 195 and the second grating layer 196 at each layer of architecture can be reduced, reducing process difficulty.

Solution 7: Antireflective layer

An optical waveguide provided in an implementation of this application is a diffractive optical waveguide. An "optical path" is designed for the diffractive optical waveguide by using a diffraction characteristic of a grating, so that light is propagated on a designed path, and light emitted by a micro-projection system (for example, an optical engine in a near-eye display device) is directed into a human eye. The diffraction grating is an optical element having a periodic structure, and is a core part of a diffraction optical waveguide. According to different grating types, diffractive optical waveguides may be further classified into two types: surface relief grating waveguides and volume holographic grating waveguides.

A holographic grating made of a holographic material has many benefits, such as angle selectivity, wavelength selectivity, and high diffraction efficiency. A propagation process of light in a volume holographic grating waveguide is basically the same as that in a surface relief grating waveguide. A difference lies in that a volume holographic grating is formed not through etching but is formed by exposing a light sensing film on a substrate by using alternating light and dark interference fringes generated by two coherent light beams, to form periodic spatial distribution with a refractive index difference at a molecular level.

An augmented reality (AR) technology is a human-computer interaction technology that attracts much attention. A grating structure may be fabricated for an optical waveguide on a lens of a near-eye display device by using a volume holographic material, to obtain high diffraction efficiency. Refer to FIG. 88. An optical waveguide 10A provided in an implementation includes a waveguide substrate 19 and a grating layer 197 formed on a surface of the waveguide substrate 19. The grating layer 197 is a volume holographic material, and the grating layer 197 is used for fabrication of a grating structure, for example, an in-coupling grating 11 and an out-coupling grating 12. The waveguide substrate 19 may be a material with a high refractive index, and is configured to carry the grating layer 197 in a process of fabricating the grating layer 197, and is further configured to perform total internal reflection propagation of a light ray. Specifically, an incident light ray enters the waveguide substrate 19 through the in-coupling grating 11, undergoes total internal reflection propagation in the waveguide substrate 19, and when propagated to the out-coupling grating 12, is coupled by the out-coupling grating 12 to a human eye. The optical waveguide 10A is further configured to transmit ambient light. Through the optical waveguide 10A, a human eye not only needs to see a virtual image coupled out by the out-coupling grating 12, but also needs to see an external environment.

In the volume holographic material, increasing a refractive index difference of different components is key to obtaining a high refractive index modulation. However, according to a "like dissolves like" principle, a high refractive index difference means low material compatibility, and makes it easy for micro-region agglomeration to occur between different components to form large polymer particles, which easily causes light scattering, resulting in low stability and high haze. Haze of the volume holographic material severely affects definition and visual perception of an external view. In the implementation shown in FIG. 88, the grating layer 197 is a volume holographic material and covers the surface of the waveguide substrate 19, positions of the in-coupling grating 11 and the out-coupling grating 12 are grating structures made of the volume holographic material, and other regions of the grating layer 197 than the in-coupling grating 11 and the out-coupling grating 12 are covered by the volume holographic material on the waveguide substrate. Therefore, this part of the volume holographic material and the volume holographic material at the positions of the in-coupling grating 11 and the out-coupling grating 12 are both likely to cause a problem of high haze.

An implementation of this application provides an optical waveguide structure, to reduce haze of a volume holographic material by changing an internal structure or an arrangement manner of internal components of the volume holographic material.

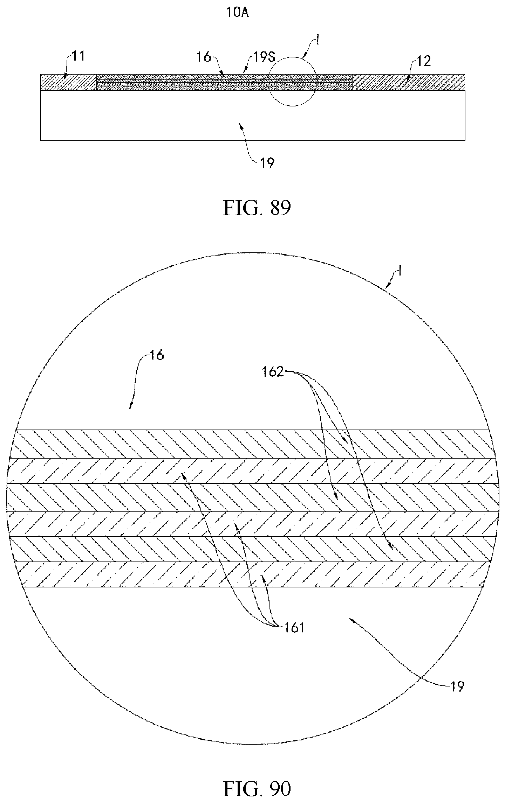

Refer to FIG. 89. An optical waveguide 10A provided in an implementation includes a waveguide substrate 19 and an antireflective layer 16, the antireflective layer 16 is formed on a surface of the waveguide substrate 19, and the antireflective layer 16 includes a volume holographic material. Specifically, the antireflective layer 16 is at least a part of a grating layer 197. The grating layer 197 is a layer structure disposed on the surface of the waveguide substrate 19 and used to fabricate a grating structure (for example, an in-coupling grating 11 and an out-coupling grating 12). A material of the grating layer 197 is the volume holographic material. It may be understood that a grating structure (for example, the in-coupling grating 11 and the out-coupling grating 12) formed on the waveguide substrate 19 is a volume holographic grating. In the implementation shown in FIG. 89, the antireflective layer 16 is located between the in-coupling grating 11 and the out-coupling grating 12. The antireflective layer 16 has no function of diffracting light rays, but only a function of transmitting light rays. In addition, an internal structure of the antireflective layer 16 can be used to resolve a problem that micro-region agglomeration occurs between different components inside the antireflective layer 16 to form large polymer particles, which easily causes light scattering, resulting in low stability and high haze.

FIG. 90 is an enlarged diagram of part I in FIG. 89. A solution for disposing an internal structure of the antireflective layer 16 may be clearly seen from FIG. 90. As shown in FIG. 90, the antireflective layer 16 includes a high refractive index phase region 161 and a low refractive index phase region 162 that have different refractive indexes. The high refractive index phase region 161 and the low refractive index phase region 162 are disposed on the surface of the waveguide substrate 19 in a stacked manner, and the high refractive index phase region 161 and the low refractive index phase region 162 are different regions that are separated from each other. A refractive index range of the high refractive index phase region 161 is from 1.5 to 2.0, a refractive index range of the low refractive index phase region 162 is from 1.1 to 1.5, and a component in the high refractive index phase region 161 is different from a component in the low refractive index phase region 162. Different components may be understood as different material types. Micro-region agglomeration does not occur between materials of a same component, and large polymer particles cannot be formed, so that the optical waveguide can have low haze, thereby improving light transmission of the optical waveguide.

In this solution, the internal structure of the antireflective layer 16 forms the high refractive index phase region 161 and the low refractive index phase region 162 that are alternately distributed, and components in the high refractive index phase region 161 and the low refractive index phase region 162 are different. It may be understood that materials of a same component in the antireflective layer 16 are aggregated in one phase region. For example, a component in the high refractive index phase region 161 is polymers and nanoparticles, and a component in the low refractive index phase region 162 are polymers formed by monomers, that is, sub-polymers. In this way, a macromolecular compound and a sub-macromolecular compound are separated, instead of being mixed together, and it is not easy to form micro-region agglomeration.

In an implementation, as shown in FIG. 90, there are a plurality of high refractive index phase regions 161, there are also a plurality of low refractive index phase regions 162, and the plurality of high refractive index phase regions and the plurality of low refractive index phase regions are alternately distributed in a direction perpendicular to the surface of the waveguide substrate 19. The alternate distribution may be understood as an arrangement manner of ABABAB. The low refractive index phase region 162 is disposed between adjacent high refractive index phase regions 161 in a stacked manner, or the high refractive index phase region 162 is disposed between adjacent low refractive index phase regions 161 in a stacked manner. In the implementation shown in FIG. 90, there are three high refractive index phase regions 161 and three low refractive index phase regions 162. On the surface of the waveguide substrate 19, the three high refractive index phase regions 161 are respectively located at a $1^{st}$ layer, a $3^{rd}$ third layer, and the $5^{th}$ layer, and the three low refractive index phase regions 162 are respectively located at a $2^{nd}$ layer, a $4^{th}$ layer, and a $6^{th}$ layer.

In another implementation, there may be one high refractive index phase region 161 and one low refractive index phase region 162. The high refractive index phase region 161 is disposed between the low refractive index phase region 162 and the waveguide substrate 19 in a stacked manner, or the low refractive index phase region 162 is disposed between the high refractive index phase region 161 and the waveguide substrate 19 in a stacked manner. A quantity of the high refractive index phase regions 161 and a quantity of the low refractive index phase regions 162 may be both two, four, or more.

In the optical waveguide provided in this application, a material of the antireflective layer is a volume holographic material. In an implementation, the volume holographic material is mainly a polymer material, and main elements of the polymer material include: one or more or all of C, H, O, N, S, and P.

In an implementation, the volume holographic material further includes nanoparticles, and a diameter of the nanoparticles is 1 nm to 50 nm. In an implementation, at least a part of the nanoparticles are distributed in the high refractive index phase region, and the nanoparticles distributed in the high refractive index phase region are one or more or all of titanium dioxide, zirconia, zinc sulfide, and carbon quantum dots. In an implementation, at least a part of the nanoparticles are distributed in the low refractive index phase region, and the nanoparticles distributed in the low refractive index phase region are one or both of silicon dioxide and magnesium fluoride. A volume fraction content of the nanoparticles is 0 to 60%. In this solution, a volume fraction of the nanoparticles is restricted to control formation and refractive indexes of the high refractive index region and the low refractive index phase region, and resolve a haze problem of the optical waveguide. Specifically, a quantity of nanoparticles cannot be excessively large, and an excessively large quantity of nanoparticles may cause agglomeration of the nanoparticles and increase haze. The quantity of nanoparticles cannot be excessively small, and an excessively small quantity of nanoparticles may reduce a refractive index difference between different phase regions.

The high refractive index phase region and the low refractive index phase region are layer structures that are sequentially alternately distributed in a stacked manner on the surface of the waveguide substrate 19, and a size of the layer structure in a direction perpendicular to the surface of the waveguide substrate is a thickness of the layer structure. In an implementation, a thickness of a layer structure formed by the high refractive index phase region is the same as a thickness of a layer structure formed by the low refractive index phase region. In an implementation, a thickness of a layer structure formed by the high refractive index phase region may alternatively be different from a thickness of a layer structure formed by the low refractive index phase region.

In an implementation, a thickness range of each high refractive index phase region is from 100 nm to 1000 nm. A thickness range of each low refractive index phase region may also be from 100 nm to 1000 nm. For example, a thickness of each high refractive index phase region or a thickness of each low refractive index phase region is 200 nm. In this solution, the thickness range is restricted to control a wavelength range of light that can be transmitted by the antireflective layer, and antireflective films with different thicknesses correspond to different wavelength ranges.

In the implementation shown in FIG. 89, on the surface of the waveguide substrate 19, only a volume holographic material at a position of a non-grating region 19S (a region that is schematically marked between the in-coupling grating 11 and the out-coupling grating 12 in the figure) is an antireflective layer 16, and at positions of the in-coupling grating 11 and the out-coupling grating 12, only a diffraction grating architecture fabricated by using the volume holographic material is used, where there is no antireflective layer architecture. In the implementation shown in FIG. 89, haze at the position of the non-grating region 19S can be reduced, and light uniformity and transmittance of an ambient light ray can be improved.

In another implementation, an antireflective layer structure may also be disposed at a position of the grating structure. In other words, at the position of the grating structure, there is a diffraction grating structure as well as an antireflective layer structure. A grating vector direction and a period of the diffraction grating structure are set to meet diffraction optical performance. For example, a grating vector direction and a period at a position of the in-coupling grating are set to meet coupling of an incident light ray into the waveguide substrate, and a grating vector direction and a period at a position of the out-coupling grating are set to meet coupling of a light ray out to the human eye. If the optical waveguide has a relay grating, there may also be an antireflective layer architecture at a position of the relay grating.

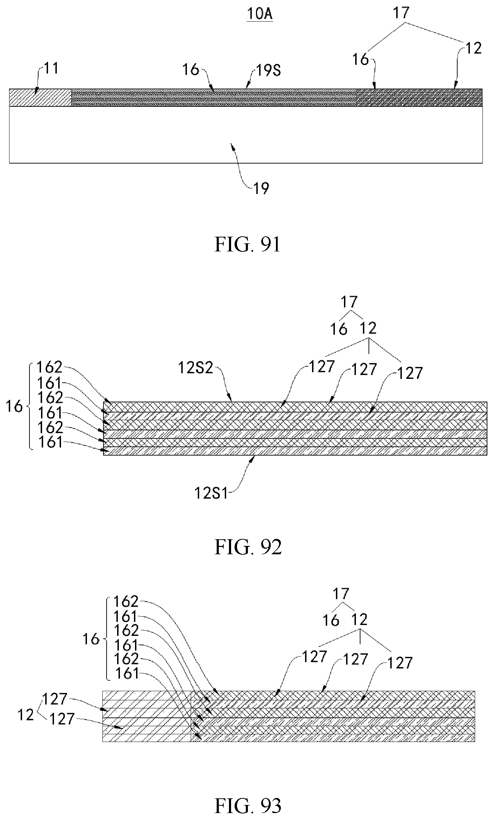

Refer to FIG. 91. In an implementation, the antireflective layer 16 of the optical waveguide 10A is formed at positions of the non-grating region 19S and the out-coupling grating 12. A structure of an antireflective layer in the non-grating region 19S is the same as that of the antireflective layer 16 in the implementation shown in FIG. 89. FIG. 92 is an enlarged diagram of a position of the out-coupling grating 12 in FIG. 91. Refer to FIG. 92. At the position of the out-coupling grating 12, the antireflective layer 16 and the out-coupling grating 12 form a co-location structure 17. The co-location structure 17 includes grating microstructures arranged along a vector direction of the out-coupling grating 12, and the co-location structure 17 further includes a high refractive index phase region 161 and a low refractive index phase region 162 that are alternately distributed in a normal direction of the optical waveguide 10A. In this solution, the antireflective layer 16 is disposed at a position of the out-coupling grating 12, so that transmittance of the out-coupling grating 12 can be improved. The out-coupling grating 12 not only can couple a light ray in the optical waveguide 10A into the human eye, but also can transmit ambient light. The position of the out-coupling grating 12 of the optical waveguide provided in this solution has good transmission.

In the implementation shown in FIG. 92, the antireflective layer 16 is disposed in all regions of the out-coupling grating 12, that is, the antireflective layer 16 and the out-coupling grating 12 have a same outer contour.

Refer to FIG. 91 and FIG. 92. A surface that is of the out-coupling grating 12 and that is connected to the waveguide substrate 19 is an out-coupling bottom surface 12S1 of the out-coupling grating 12, and a surface that is of the out-coupling grating 12 and that is away from the waveguide substrate 19 is an out-coupling top surface 12S2 of the out-coupling grating 12. A part of the antireflective layer 16 that forms, together with the out-coupling grating 12, the co-location structure 17 is formed between the out-coupling bottom surface 12S1 and the out-coupling top surface 12S2. The antireflective layer 16 is fabricated at the position of the out-coupling grating 12 by using a multiplexed holographic technology. This solution defines a specific architecture in which the out-coupling grating and the antireflective layer form the co-location structure. In this solution, no volume holographic material needs to be added to a region other than the out-coupling grating, but instead, the antireflective layer structure is obtained by performing dual-beam exposure based on the out-coupling grating, so that diffraction efficiency of the out-coupling grating can be ensured or not affected as much as possible. If a material is added outside the out-coupling top surface to fabricate the antireflective layer, the added material affects diffraction efficiency of the out-coupling grating.

In another implementation, the antireflective layer 16 may be alternatively disposed only in a part of the out-coupling grating 12. For example, as shown in FIG. 93, a left edge of the antireflective layer 16 is located inside the out-coupling grating 12, and no antireflective layer 16 is disposed a position of a part the out-coupling grating 12 on a left side of the antireflective layer 16. A right edge of the antireflective layer 16 coincides with a right edge of the out-coupling grating 12.

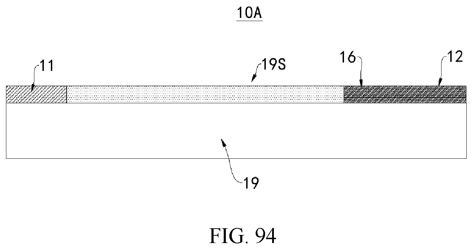

Refer to FIG. 94. In an implementation, the antireflective layer 16 in the optical waveguide 10A is disposed only at a position of the out-coupling grating 12, the antireflective layer 16 and the out-coupling grating 12 form a co-location structure, and no antireflective layer is disposed in the non-grating region 19S. This solution is mainly intended to improve light transmission of ambient light at the position of the out-coupling grating 12. Fabricating the antireflective layer in a small region helps reduce fabrication costs in a solution of obtaining a required optical waveguide.

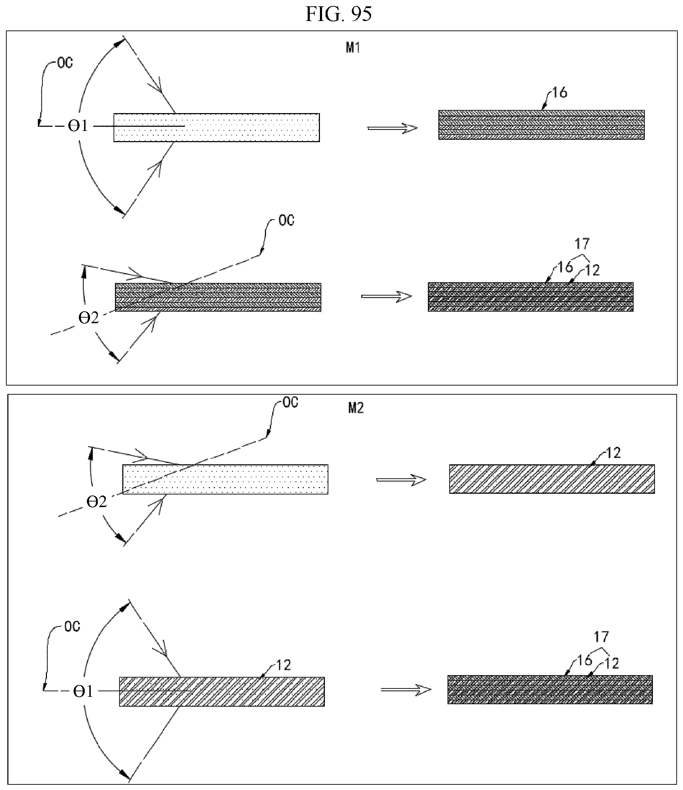

FIG. 95 is a diagram of a specific method for fabricating a co-location structure formed by an antireflective layer and a grating structure. The method includes a first fabrication method M1 and a second fabrication method M2. The diagram in the upper rectangular box in FIG. 95 is the first fabrication method M1, and the diagram in the lower rectangular frame in FIG. 95 is the second fabrication method M2. Refer to FIG. 95. For a solution in which the antireflective layer 16 and a grating structure (for example, the out-coupling grating 12, the in-coupling grating, or the relay grating) form a co-location structure 17, the grating structure (the out-coupling grating 12 is used as an example) is made of a volume holographic material formed on the surface of the waveguide substrate, and the antireflective layer 16 and the grating structure (the out-coupling grating 12 is used as an example) are formed by using a dual-beam exposure process.

An included angle between two light beams in a dual-light-beam exposure process for fabricating the antireflective layer 16 is a first angle $\Theta 1$. Specifically, included angles between two light beams and the antireflective layer 16 is a half of the first angle $\Theta 1$. That is, the two light beams are symmetrically distributed on two sides of the antireflective layer 16, and an angular bisector OC of an included angle formed by the two light beams is parallel to the surface of the waveguide substrate (or a plane on which the antireflective layer is located). A high refractive index phase region and a low refractive index phase region of the antireflective layer that are disposed in a stacked manner with the waveguide substrate is formed by using dual-beam exposure.

An included angle between two light beams in a dual-beam exposure process for fabricating the grating structure is a second angle $\Theta 2$. The out-coupling grating 12 is used as an example. In a process of forming the out-coupling grating 12 through exposure, an included angle is formed between an angular bisector OC of an included angle formed by two light beams in the dual light beams and the surface of the waveguide substrate. In this way, the out-coupling grating 12 having a diffraction function is formed after exposure. It may be understood that, according to different grating types, different types of grating structures may be fabricated by adjusting the included angles between the dual light beams and the surface of the waveguide substrate and adjusting the included angle between the angular bisector OC and the waveguide substrate.

The first angle $\Theta 1$ may be different from the second angle $\Theta 2$.

In the figure shown in FIG. 95, a dual-beam exposure step for fabricating the antireflective layer 16 and a dual-beam exposure step for fabricating the out-coupling grating 12 are separately shown. In a specific fabrication process, a sequence of the two steps may be swapped, that is, the antireflective layer 16 may be first formed through exposure, and then the out-coupling grating 12 is formed through exposure; or the out-coupling grating 12 may be first formed through exposure, and then the antireflective layer 16 is exposed on this basis. In this solution, only an angle of the dual-beam exposure needs to be adjusted, and the co-location structure of the antireflective layer 16 and the grating structure (the out-coupling grating 12 is used as an example) can be implemented in a same region by using one set of devices. This has advantages of a simple fabrication process and low fabrication costs.

This application provides a method for fabricating an optical waveguide, used to fabricate the foregoing optical waveguide having an antireflective layer.

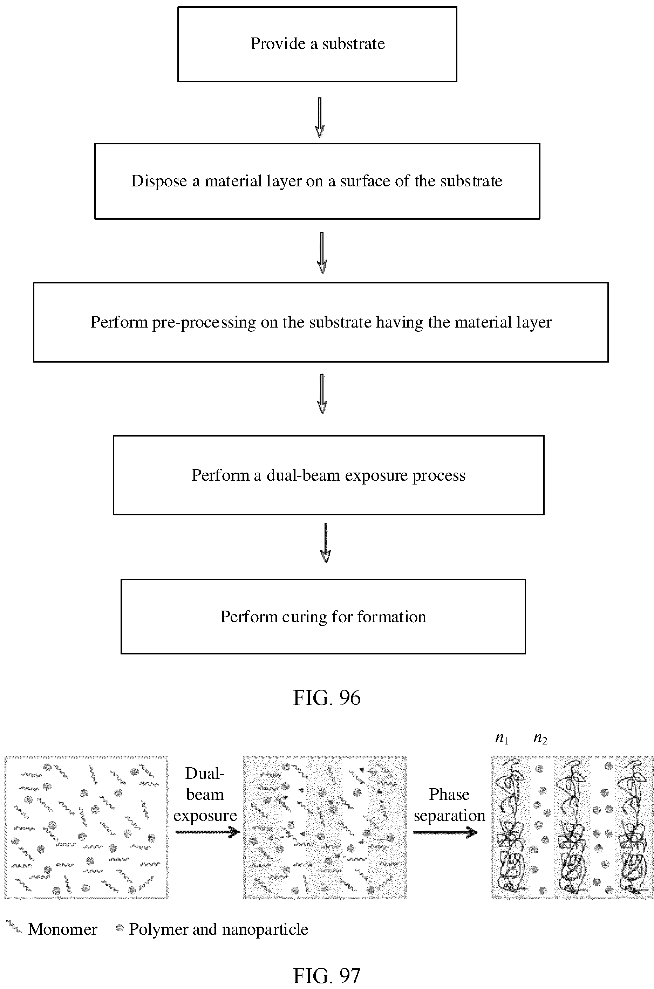

Refer to FIG. 96. In an implementation, the method for fabricating an optical waveguide includes the following steps:

Provide a substrate, where the substrate is a waveguide substrate of an optical waveguide. For example, the substrate may be made of a glass material. In an implementation, a refractive index of the substrate needs to meet a requirement that total internal reflection propagation of a light ray in the substrate can be implemented, and the substrate further needs to have light transmission to transmit ambient light.

Dispose a material layer on a surface of the substrate, where the material layer includes a volume holographic material. The material layer is disposed on the surface of the substrate through coating. For example, the coating includes any one of spin-coating, Czochralski dip coating, spraying, gravure coating, reverse roll coating, knife-over-roll coating, metering rod coating, slot die coating, impregnation, curtain coating, or air knife coating.

Perform pre-processing on the substrate having the material layer. The step of pre-processing includes: performing high-temperature processing at 25°C to 100°C, or low-voltage processing, or light-proof processing, or room-temperature placement processing. Specifically, a material formula of the material layer includes a solvent, and the solvent needs to be removed during pre-processing. Some solvents have a high boiling point, and therefore processing at a low pressure is required. The low pressure may be specifically understood as a pressure less than one atmospheric pressure.

Perform a dual-beam exposure process, so that the material layer forms a structure having a high refractive index phase region and a low refractive index phase region that are alternately distributed.

Perform curing for formation, so that the material layer is modulated into an antireflective layer on the waveguide substrate. The step of performing curing for formation includes: performing high-temperature curing for formation and light curing for formation, where a temperature for the high-temperature curing for formation is 40°C to 150°C, light intensity for the light curing for formation is 0.1 mWcm$^{-2}$ to 5000 mWcm$^{-2}$, a wavelength range for the light curing for formation is 254 nm to 1000 nm, and a type of light for the light curing for formation includes any one of UVA, UVB, UVC, visible light, or infrared light.

In this application, the material layer is coated on the substrate, and the material layer is restricted to be a volume holographic material. The material layer is modulated, by using a dual-beam exposure process, into the antireflective layer having the high refractive index phase region and the low refractive index phase region, to reduce haze of the optical waveguide, and improve light uniformity and light transmittance.

In an implementation, the material layer includes a polymer, a monomer, a photoinitiating system, and a solvent. The polymer is a polymer containing C, H, O, and N with a molecular weight greater than 1000. The monomer includes at least one of acrylate, acrylamide, sulfhydryl-containing compound, an allyl compound, or vinyl compound. The photoinitiating system is used to absorb laser energy and form an active material, so that the active material reacts with the monomer, to convert the monomer into a subpolymer.

In an implementation, the polymer includes at least one of polyether, polyvinyl acetate, polyvinyl acetate-propylene copolymer, polyethylene, polypropylene, polyvinyl chloride, polyethylene terephthalate, polystyrene, polycarbonate, polyurethane, polyester polyol, cellulose acetate, or polyvinyl alcohol.

The acrylate compound includes at least one of polyethylene glycol acrylate, 3-hydroxypropyl acrylate, pentabromophenyl acrylate, ethoxylated trimethylolpropane triacrylate, isooctyl acrylate, sulfur-containing acrylate, benzene-containing acrylate, benzyl-containing acrylate, biphenyl-containing acrylate, or pentaerythritol tetraacrylate, or a corresponding methacrylate analog.

The acrylamide compound includes at least one of methyl alcohol acrylamide, N-benzyl methacrylamide, or N,N-dimethylacrylamide, and the sulfhydryl-containing compound includes at least one of propanethiol, ethylene glycol bis(3-mercaptopropionate), trimethylolpropane tri(3-mercaptopropionate), or tetra(3-mercaptopropionic acid) pentaerythritol ester.

The allyl compound includes at least one of allylurea, allyl ethyl ether, allyl phenyl ether, 1-allylpiperazine, or triallyl isocyanurate.

The vinyl compound includes at least one of N-vinyl carbazole, N-vinyl imidazole, dibromo-N-vinyl carbazole, tribromo-N-vinyl carbazole, tetrabromo-N-vinyl carbazole, or N-vinyl pyrrole.

FIG. 97 is a diagram of changes of components in a process of performing dual-beam exposure on a material layer in a method for fabricating an optical waveguide according to an implementation of this application. Refer to FIG. 97. Before dual-beam exposure is performed on the material layer, as shown in the left picture in FIG. 97, the material layer includes polymers, monomers, and nanoparticles. The polymers and the monomers are randomly arranged, and the nanoparticles are dispersed between the polymers and the monomers. In an implementation, a light source of the dual-beam exposure process includes two expanded coherent laser beams, the two expanded coherent laser beams interfere with each other to form light intensity with sine wave distribution, so as to form high light intensity regions and low light intensity regions on the material layer. Energy absorbed by the photoinitiating system in the high light intensity region is greater than energy absorbed by the photoinitiating system in the low light intensity region, so that the active material in the high light intensity region is more than the active material in the low light intensity region. In this way, the polymer is separated from the subpolymer. As shown in the middle figure in FIG. 97, the polymer and the nanoparticles move in a direction indicated by an arrow. In this way, an architecture with alternate distribution of the high refractive index phase region and the low refractive index phase region is formed. As shown in the right figure in FIG. 97, the polymer is separated from the monomer, and a high refractive index phase region with a refractive index of n1 and a low refractive index phase region with a refractive index of n2 are formed; or a low refractive index phase region with a refractive index of n1 and a high refractive index phase region with a refractive index of n2 are formed.

In an implementation, an included angle between two light beams in the dual-beam exposure process is a first angle, and a range of the first angle is from 10 degrees to 180 degrees. For example, the included angle between the two light beams is 120 degrees. In this solution, the range of the included angle between the two light beams in the dual-beam exposure process is restricted, to obtain an architecture in which the high refractive index phase region and the low refractive index phase region are parallel and disposed in a stacking manner. A vector direction of the antireflective layer may be understood as a stacked direction of the high refractive index phase region and the low refractive index phase region, or may be a direction perpendicular to a surface of the waveguide substrate.

In an implementation, the method for fabricating an optical waveguide further includes: fabricating a grating structure by using the dual-beam exposure process, where the grating structure is formed through exposure by using two light beams whose included angle is a second angle, and the second angle is different from the first angle to form different vector directions. The grating structure and at least a part of the antireflective layer may be located at a same position on the substrate. The grating structure may be an in-coupling grating, an out-coupling grating, or a relay grating of the optical waveguide. A type of the grating structure is a volume holographic grating.

According to the optical waveguide provided in this application, the antireflective layer is fabricated based on the volume holographic material, and a structure of the antireflective layer is made of a material with alternately distributed high and low refractive indexes. The high and low refractive index phase regions are filled by the volume holographic material, a high refractive index component is filled in the high refractive index phase region, and a low refractive index component is filled in the low refractive index phase region. In this application, a refractive index modulation of the volume holographic material can be improved while haze of the volume holographic material is reduced. This improves optical performance of the optical waveguide, and transmittance can be increased to 98% or higher. Because high and low refractive index components in the volume holographic material are separated from each other, and separately form phase regions, mutual contact between the components is avoided, and formation of polymer particles is suppressed. Finally, haze of the volume holographic material is reduced by 50% or higher, and may be reduced to as low as 0.1. In addition, the refractive index modulation of the volume holographic material is as high as 0.2. In the AR field, improvement of the refractive index modulation helps increase a FOV of AR glasses. For a volume holographic material whose refractive index modulation is 0.2, AR glasses with a FOV of up to 40° can be prepared.

In an implementation, an included angle for the dual-beam exposure is 120°, and a quantity of exposure times is 1, so that an antireflective layer structure in which high refractive index phase region and low refractive index phase region are alternately distributed is formed, where a thickness of each high refractive index phase region or each low refractive index phase region is 200 nm. Because the antireflective layer increases only transmittance of a light ray, total internal reflection propagation of a light ray projected by an optical engine onto the optical waveguide is not affected in the optical waveguide. The antireflective layer can reduce haze of the volume holographic material, and improve optical performance of the optical waveguide. A FOV of an incident light ray of the optical waveguide is 40°, light uniformity is 0.3, haze is 0.5%, and a light transmittance range is from 80% to 100%. For example, the transmittance is 95%.

Solution 8: Filling layer protecting a grating structure

An optical waveguide provided in this application is a medium apparatus that guides a light wave to propagate in the optical waveguide. Lightness and thinness of the optical waveguide and a characteristic of high transmission of external light rays are considered as an essential solution for a near-eye display device (for example, augmented reality (AR) glasses). Optical waveguides may be generally classified into two types: geometric optical waveguides and diffractive optical waveguides. A geometric optical waveguide is also referred to as an arrayed optical waveguide, which achieves image output and eyebox enlargement by stacking arrayed reflectors. Diffractive optical waveguides may be classified into surface relief grating waveguides and volume holographic grating waveguides. Optical waveguides with surface relief gratings are widely used in near-eye display devices.

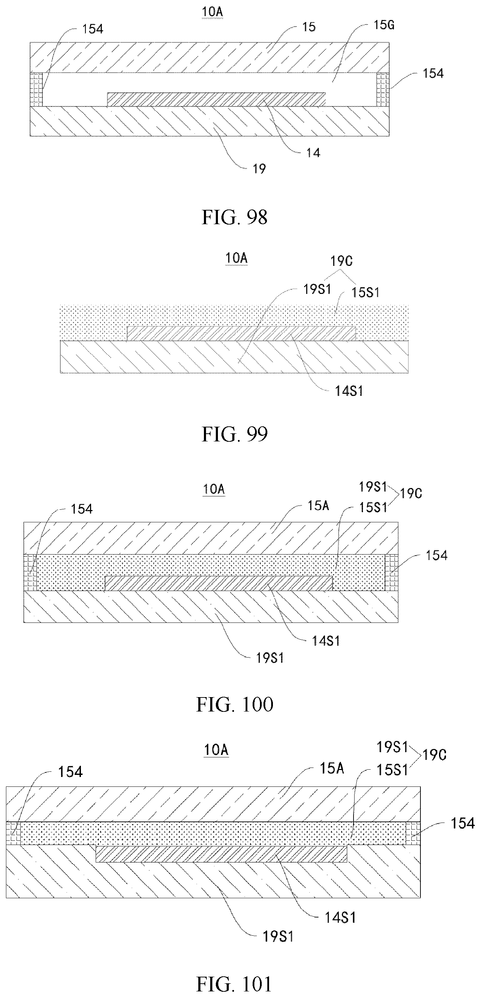

In an implementation, with reference to FIG. 98, an optical waveguide 10A includes a waveguide substrate 19 and a cover plate 15. A grating structure 14 is disposed on the waveguide substrate 19, and the grating structure 14 may be an in-coupling grating, an out-coupling grating, or a relay grating. The cover plate 15 is configured to shield the waveguide substrate 19 and the grating structure 14. The cover plate 15 is an outermost structure of the optical waveguide 10A. For example, the cover plate 15 may be made of a glass material. The waveguide substrate 19 and the cover plate 15 are disposed in a stacked manner, and need to be connected. In this implementation, the waveguide substrate 19 and the cover plate 15 are fastened by using a dispensing structure 154 (an adhesive). A height of the dispensing structure 154 is approximately dozens of microns. There is a gap 15G between the waveguide substrate 19 and the cover plate 15, and air exists in the gap 15G.

Because the gap 15G with dozens of microns is reserved between the waveguide substrate 19 and the cover plate 15, when an external force is applied to the cover plate 15, existence of the gap 15G is likely to cause damage to the waveguide substrate 19 and the grating structure 14. The cover plate 15 and the waveguide substrate 19 are sealed and fastened through dispensing, and therefore air exists in the gap 15G between the waveguide substrate 19 and the cover plate 15. This causes a risk of long-term exposure of the waveguide substrate 19 to water and oxygen. Water and oxygen in the air easily accelerate aging of the waveguide substrate 19 and the grating structure 14. Water vapor in the air is attached to the cover plate 15, and a change of an external temperature difference causes hazing of the cover plate 15, thereby affecting visibility of a human eye.

If the waveguide substrate 19 and the cover plate 15 are sealed through dispensing, there is an internal and external pressure difference between the waveguide substrate 19 and the cover plate 15, and an external environment change (an excessive pressure) causes the cover plate 15 to crack. In a manner of bonding through dispensing, an adhesive is uneven, and the adhesive penetrates into the waveguide substrate 19, affecting a refractive index of the waveguide substrate 19.

In an implementation of this application, a filling layer is disposed around a periphery of a grating structure on the waveguide substrate, and the filling layer is used to protect the grating structure and the waveguide substrate, so as to protect the optical waveguide and improve life and optical performance of the optical waveguide.

In an implementation, with reference to FIG. 99, the optical waveguide 10A includes a first waveguide substrate 19S1, a first grating structure 14S1, and a first filling layer 15S1, the first grating structure 14S1 is formed on a surface of the first waveguide substrate 19S1, the first filling layer 15S1 and the first waveguide substrate 19S1 are disposed in a stacked manner, and the first filling layer 15S1 covers the surface of the first waveguide substrate 19S1. The first filling layer 15S1 and the first waveguide substrate 19S1 jointly form a closed surrounding architecture 19C, and the first grating structure 14S1 is located inside the surrounding architecture 19C, so that the first grating structure 14S1 is isolated from air outside the surrounding architecture 19C. A difference between a refractive index of the first filling layer 15S1 and a refractive index of air is less than or equal to 0.2.

The first waveguide substrate 19S1 may be made of an inorganic material, a high-refractive resin material, or the like. A specific material of the first waveguide substrate 19S1 is not limited in this application. The first waveguide substrate 19S1 may be any material or a combination of materials that can achieve total internal reflection propagation of light.

Specifically, the first filling layer 15S1 is made of a transparent material and has good light transmission. For example, the light transmission may be greater than or equal to 80%. The first filling layer 15S1 may be made of a material with a low refractive index, where the low refractive index means that the refractive index of the first filling layer 15S1 is close to the refractive index of air. For example, a difference between the refractive index of the first filling layer 15S1 and the refractive index of air is less than or equal to 0.2. In this solution, the first filling layer 15S1 is disposed to protect the first waveguide substrate 19S1 and the first grating structure 14S1, so that the first waveguide substrate 19S1 and the first grating structure 14S1 are isolated from outside air, and it can be ensured that the first waveguide substrate 19S1 and the first grating structure 14S1 avoid long-term exposure to water and oxygen environments, resolving problems such as easy aging, corrosion, and hazing of the optical waveguide 10A. The optical waveguide can be further prevented from being damaged by an external impact force. In this implementation provided in this application, service life and optical performance of the optical waveguide 10A can be ensured.

In the implementation shown in FIG. 99, the cover plate may be not disposed outside the first filling layer 15S1. In other words, the first filling layer 15S1 may be used as an outermost structure of the optical waveguide 10A. The first filling layer 15S1 may fully cover the surface of the first waveguide substrate. The first grating structure 14S1 may be a blazed grating, a linear grating, a slanted grating, or a volume holographic grating. The first grating structure 14S1 may be an in-coupling grating, an out-coupling grating, or a relay grating.

Refer to FIG. 100. In an implementation, the optical waveguide 10A includes a first cover plate 15A, a first waveguide substrate 19S1, and a first filling layer 15S1, a first grating structure 14S1 is formed on the first waveguide substrate 19S1, the first filling layer 15S1 is disposed between the first cover plate 15A and the first waveguide substrate 19S1. The first filling layer 15S1 and the first waveguide substrate 19S1 jointly form a closed surrounding architecture 19C, and the first grating structure 14S1 is located inside the surrounding architecture 19C, so that the first grating structure 14S1 is isolated from air outside the surrounding architecture 19C. A difference between a refractive index of the first filling layer 15S1 and a refractive index of air is less than or equal to 0.2. This solution provides an optical waveguide architecture with the first cover plate. The first filling layer is filled between the first cover plate and the first waveguide substrate, so that there is no air gap between the first cover plate and the first waveguide substrate.

The first filling layer provides support for the first cover plate, to prevent the first cover plate from being damaged by external stress.

In this solution, the first cover plate 15A is fastened to the first waveguide substrate 19S1, and a surface that is of the first filling layer 15S1 and that is away from the first waveguide substrate 19S1 is attached to an inner surface of the first cover plate 15A. In comparison with the implementation shown in FIG. 99, in the implementation shown in FIG. 100, a structure of the first cover plate 15A is added. The first filling layer 15S1 in the implementation shown in FIG. 100 may be thin, provided that a gap between the first cover plate 15A and the first waveguide substrate 19S1 is filled. This solution provides a solution for fastening the first cover plate and the first waveguide substrate. A structure for fastening through dispensing is easy to operate. In addition, because the first filling layer already covers most of an area of the first waveguide substrate, an adhesive does not cause destructive impact on optical performance of the first waveguide substrate.

In a specific implementation, the first cover plate 15A is fastened to the first waveguide substrate 19S1 by using a dispensing structure 154, and the dispensing structure 154 is distributed around the first filling layer 1551. In an implementation, the dispensing structure 154 surrounds a periphery of the first filling layer 15S1 to form a closed structure surrounding the first filling layer 15S1, and the dispensing structure 154 forms a sealing structure around the periphery of the first filling layer 15S1. In an implementation, the dispensing structure 154 is a plurality of connection structures that are distributed at intervals and are sequentially arranged around the first filling layer 15S1 at intervals.

In another implementation, the first cover plate 15A may alternatively be fastened to the first waveguide substrate 19S1 in another fastening manner, for example, fastened by using a screw.

In the implementation shown in FIG. 100, a surface of the first waveguide substrate 19S1 is planar in shape, and the first grating structure 14S1 is disposed protruding from the surface of the first waveguide substrate 19S1. The first filling layer 15S1 surrounds a top surface and a side surface of the first grating structure 14S1, and a bottom surface of the first grating structure 14S1 is connected to the first waveguide substrate 19S1.

Refer to FIG. 101. In an implementation, the first grating structure 14S1 may alternatively be embedded in the first waveguide substrate 19S1. A vertical distance between the surface of the first waveguide substrate 19S1 and the first cover plate 15A in the implementation shown in FIG. 101 is less than a vertical distance between the surface of the first waveguide substrate 19S1 and the first cover plate 15A in the implementation shown in FIG. 100. In the implementation shown in FIG. 101, both a bottom surface and a side surface of the first grating structure 14S1 are located inside the first waveguide substrate 19S1, and the first filling layer 15S1 covers a top surface of the first grating structure 14S1 and an outer surface of the first waveguide substrate 19S1. Specifically, based on the implementation shown in FIG. 101, the top surface of the first grating structure 14S1 may be concave relative to the outer surface of the first waveguide substrate 19S1. In this way, a part of the first filling layer 15S1 is located in a groove formed by the first waveguide substrate 19S1.

In comparison with the implementation shown in FIG. 100, in the implementation shown in FIG. 101, because the vertical distance between the first waveguide substrate 19S1 and the first cover plate 15A is smaller, a size of the dispensing structure 154 is also smaller. Therefore, in this implementation, a smaller amount of the adhesive may be used to fasten the first waveguide substrate 19S1 and the first cover plate 15A. Small-size design of the dispensing structure 154 helps mitigate impact of the dispensing structure on the first waveguide substrate 19S1. It may be understood that the adhesive penetrates into the first waveguide substrate 19S1 and affects a refractive index of the first waveguide substrate 19S1.

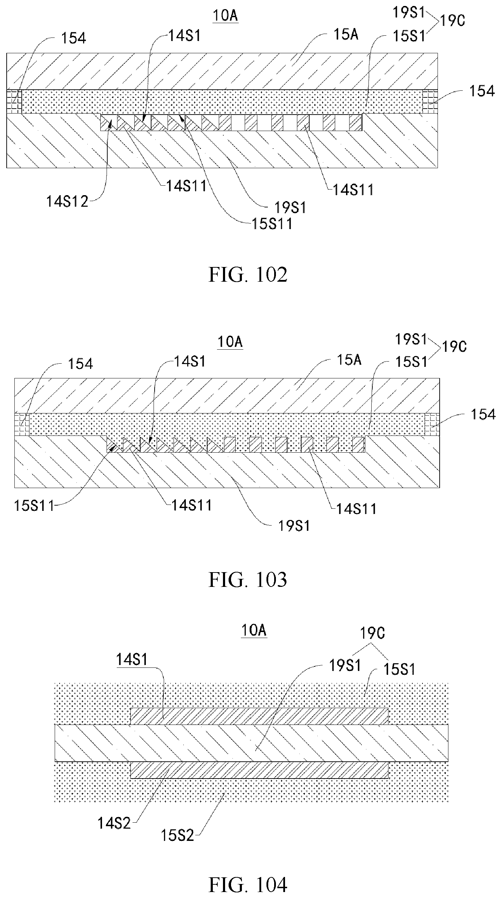

In the implementations shown in FIG. 99 to FIG. 101, arrangement manners of the first grating structure 14S1 on the first waveguide substrate 19S1 and a position relationship between the first grating structure 14S1 and the first filling layer 15S1 are schematically shown, and microstructures in the first grating structure 14S1 are not drawn in detail. FIG. 102 and FIG. 103 schematically illustrate a position relationship between the microstructures in the first grating structure 14S1 and the first filling layer 15S1.

Refer to FIG. 102. The first filling layer 15S1 includes a grating contact surface 15S11, and the grating contact surface 15S11 is planar in shape. The first grating structure 14S1 includes periodically arranged microstructures 14S11, and there are periodically arranged slits 14S12 between the grating contact surface 15S11 and the first grating structure 14S1. The periodically arranged slits 14S12 may be understood as a slit structure formed by the periodically arranged microstructures 14S11 of the first grating structure 14S1. Both the microstructure 14S11 and the slit 14S12 have sizes measured in nanometer units, and are configured to form a diffraction grating architecture. In this solution, slits are allowed between the grating contact surface 15S11 and the surface of the first grating structure 14S1. A fabrication process of the first filling layer 15S1 provided in this solution has a low precision requirement, and is easy to fabricate.

Refer to FIG. 103. The first grating structure 14S1 includes periodically arranged microstructures 14S11. The first filling layer 15S1 includes a grating contact surface 15S11, and the grating contact surface 15S11 has a same structural form as the microstructures 14S11 of the first grating structure, so that the first filling layer 15S1 and the first grating structure 14S1 are in contact without air gaps. The grating contact surface 15S11 of the first filling layer 15S1 is attached to a surface of the microstructures 14S11 of the first grating structure 14S1, that is, a part of the first filling layer 15S1 is filled in slits formed by the periodically arranged microstructures 14S11 of the first grating structure 14S1. In the optical waveguide 10A provided in this implementation, there is no air gap around a periphery of the first grating structure 14S1, and the first grating structure 14S1 is completely in contact with the first filling layer 15S1, to achieve complete isolation from air. In this way, life of the first grating structure 14S1 can be improved.

The implementations shown in FIG. 99 to FIG. 103 may be considered as single-layer single-sided optical waveguide architectures. It may be understood that a grating structure and a filling layer are disposed on one surface of a waveguide substrate, and no grating structure and no filling layer are disposed on the other surface of the waveguide substrate. On a basis of these several implementations, any implementation may be extended to a single-layer double-sided optical waveguide architecture, that is, the optical waveguide has one waveguide substrate, and a grating structure and a filling layer are disposed on both a front surface and a back surface of the waveguide substrate.

An implementation shown in FIG. 104 is a single-layer double-sided optical waveguide architecture constructed based on the implementation shown in FIG. 99. Refer to FIG. 104. A first grating structure 14S1 and a first filling layer 15S1 are disposed on a top surface of a first waveguide substrate 19S1, the first filling layer 15S1 and the first waveguide substrate 19S1 jointly surround the first grating structure 14S1, and the first filling layer 15S1 protects the first waveguide substrate 19S1 and the first grating structure 14S1 on a side of the top surface of the first waveguide substrate 19S1. A second grating structure 14S2 and a second filling layer 15S2 are disposed on a bottom surface of the first waveguide substrate 19S1, the second filling layer 15S2 and the first waveguide substrate 19S1 jointly surround the second grating structure 14S2, and the second filling layer 15S2 protects the first waveguide substrate 19S1 and the second grating structure 14S2 on a side of the bottom surface of the first waveguide substrate 19S1. A difference between a refractive index of the second filling layer and a refractive index of air is less than or equal to 0.2. In this implementation, the first grating structure 14S1 and the second grating structure 14S2 may be of a same grating type or may be of different grating types, and may have a same refractive index, or may have different refractive indexes. The first filling layer 15S1 and the second filling layer 15S2 may be made of a same material or may be made of different materials, and may have a same refractive index or different refractive indexes.

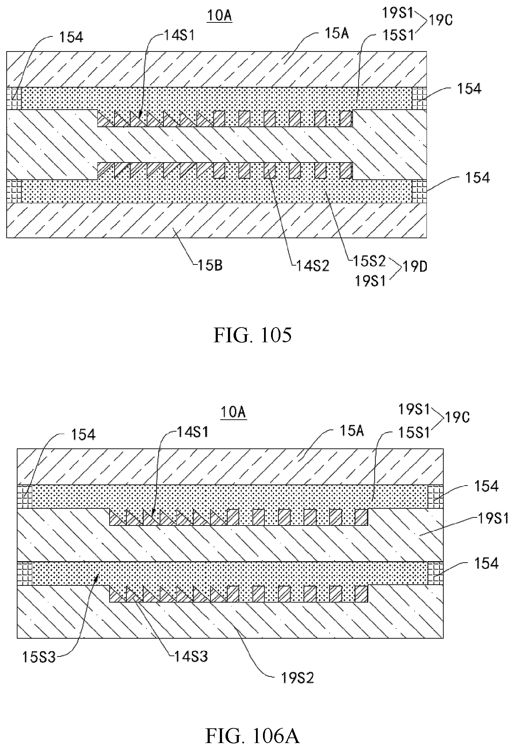

An implementation shown in FIG. 105 is a single-layer double-sided optical waveguide architecture constructed based on the implementation shown in FIG. 103. Refer to FIG. 105. The optical waveguide 10A further includes a second grating structure 14S2, a second filling layer 15S2, and a second cover plate 15B. The first grating structure 14S1, the first filling layer 1551, and the first cover plate 15A are located on a side of a top surface of the first waveguide substrate 19S1. A second grating structure 14S2, a second filling layer 15S2, and a second cover plate 15B are located on a side of a bottom surface of the first waveguide substrate 19S1. The second grating structure 14S2 and the first grating structure 14S1 are distributed on two opposite sides of the first waveguide substrate 19S1, the second filling layer 15S2 and the first waveguide substrate 19S1 are disposed in a stacked manner, and the second filling layer 15S2 and the first optical waveguide substrate 19S1 jointly enclose and surround the second grating structure 14S2. A difference between a refractive index of the second filling layer 15S2 and a refractive index of air is less than or equal to 0.2. The second cover plate 15B is fastened to the first waveguide substrate 19S1, the second filling layer 15S2 is disposed between the second cover plate 15B and the first waveguide substrate 19S1 in a stacked manner, and the second filling layer 15S2 is attached to the second cover plate 15B.

In an implementation, the second cover plate 15B is fastened to the first waveguide substrate 19S1 by using a dispensing structure 154. For a specific arrangement direction of the dispensing structure, refer to the arrangement of the dispensing structure 154 between the first cover plate 15A and the first waveguide substrate 19S1. Details are not described again.

In an implementation, this application further provides a double-layer single-sided optical waveguide architecture. To be specific, the optical waveguide has two layers of waveguide substrates, and a grating structure is disposed on a single side of each layer of waveguide substrate. In an implementation, the entire optical waveguide may have only one cover structure. In an implementation, the entire optical waveguide may not be provided with a cover structure.

In an implementation shown in FIG. 106A, on a basis of the implementation shown in FIG. 103, the optical waveguide 10A further includes a second waveguide substrate 19S2, a third filling layer 15S3, and a third grating structure 14S3. The first waveguide substrate 19S1 and the second waveguide substrate 19S2 are disposed in a stacked manner. The second waveguide substrate 19S2 is located on a side that is of the first waveguide substrate 19S1 and that is away from the first cover plate 15A. The third grating structure 14S3 is formed on a surface of the second waveguide substrate 19S2, and the third grating structure 14S3 is located on a side that is of the second waveguide substrate 19S2 and that faces the first waveguide substrate 19S1. The third filling layer is disposed between the first waveguide substrate 19S1 and the second waveguide substrate 19S2, and the third filling layer 15S3 and the second waveguide substrate 19S2 jointly surround the third grating structure 14S3. The third filling layer 15S3 is configured to protect the third grating structure 14S3. A top side of the third filling layer 15S3 is attached to a bottom surface of the first waveguide substrate 19S1, and a bottom side of the third filling layer 15S3 is attached to a top surface of the second waveguide substrate 19S2. Therefore, the third filling layer 15S3 can cover both the bottom surface of the first waveguide substrate 19S1 and the top surface of the second waveguide substrate 19S2, and can protect the first waveguide substrate 19S1 and the second waveguide substrate 19S2. A difference between a refractive index of the third filling layer 15S3 and the refractive index of air is less than or equal to 0.2.

In an implementation, as shown in FIG. 106A, the second waveguide substrate 19S2 may be fastened to the first waveguide substrate 19S1 by using a dispensing structure 154.

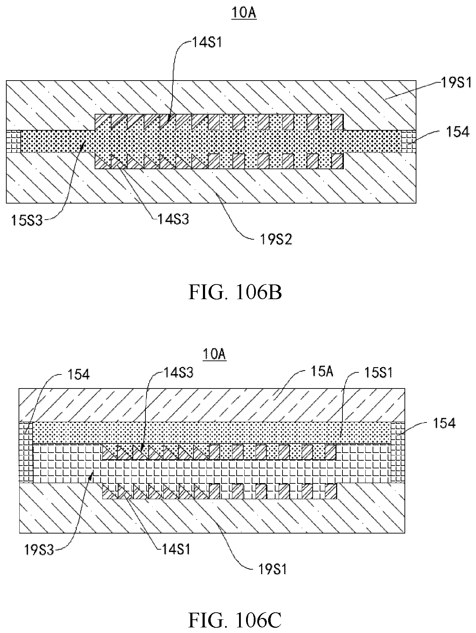

In an implementation shown in FIG. 106B, the optical waveguide 10A includes a first waveguide substrate 19S1 and a second waveguide substrate 19S2, a first grating structure 14S1 is disposed on a bottom surface of the first waveguide substrate 19S1, a third grating structure 14S3 is disposed on a top surface of the second waveguide substrate 19S2, the first waveguide substrate 19S1 and the second waveguide substrate 19S2 are disposed in a stacked manner, and the first grating structure 14S1 and the third grating structure 14S3 are disposed opposite to each other, that is, the bottom surface of the first waveguide substrate 19S1 faces the top surface of the second waveguide substrate 19S2. In this implementation, a filling layer is filled between the first waveguide substrate 19S1 and the second waveguide substrate 19S2 to protect the first grating structure 14S1 and the third grating structure 14S3. As shown in FIG. 106B, the filling layer between the first waveguide substrate 19S1 and the second waveguide substrate 19S2 is a first filling layer 15S1. The first filling layer 15S1 can cover the bottom surface of the first waveguide substrate 19S1, the first grating structure 14S1, the top surface of the second waveguide substrate 19S2, and the third grating structure 14S3. That is, the first filling layer 15S1 and the second waveguide substrate 19S2 jointly form a surrounding architecture surrounding the third grating structure 15S3. The first waveguide substrate 19S1 is fastened to the second waveguide substrate 19S2 by using a dispensing structure 154, and the dispensing structure 154 is located around a periphery of the first filling layer 15S1. A physical property of the first filling layer 15S1 in the optical waveguide 10A provided in this solution may be the same as a physical property of the first filling layer in the optical waveguide shown in FIG. 99. A top surface of the first waveguide substrate 19S1 and a bottom surface of the second waveguide substrate 19S2 in the optical waveguide 10A provided in this implementation may be used as surface layers of the optical waveguide, and no other cover plate structure needs to be disposed, which facilitates design of lightness and thinness of the optical waveguide.

In an implementation, this application further provides an optical waveguide of a double-layer grating architecture. However, the optical waveguide of the double-layer grating architecture has only one optical waveguide substrate. One grating layer is formed on the waveguide substrate, and the other grating layer is formed on a waveguide filling structure. The waveguide filling structure may carry a grating to perform total internal reflection propagation of a light ray, and further, a may protect a grating layer on the waveguide substrate. Refer to FIG. 106C. In an implementation, an optical waveguide 10A includes a first waveguide substrate 19S1, a first grating structure 14S1 is formed on side of a top surface of the first waveguide substrate 19S1, a waveguide filling structure 19S3 is disposed on a side of the top surface of the first waveguide substrate 19S1, and the waveguide filling structure 19S3 may wrap the first grating structure 14S1 and cover the top surface of the first waveguide substrate 19S1. An edge of the waveguide filling structure 19S3 is recessed relative to the first waveguide substrate 19S1, to reserve a position at the edge of the first waveguide substrate 19S1 for dispensing. The waveguide filling structure 19S3 is made of a high refractive index material, and can achieve total internal reflection propagation of a light ray in the waveguide filling structure 19S3. The waveguide filling structure 19S3 and the first waveguide substrate 19S1 may have different refractive indexes. A refractive index difference between the waveguide filling structure 19S3 and the first waveguide substrate 19S1 may be between 0 and 0.5. This solution defines a range of the refractive index difference between the waveguide filling structure and the first waveguide substrate. This range is used for restriction, so that all the layers of grating structures can achieve diffraction efficiency, and both the waveguide filling structure and the first waveguide substrate have a function of total internal reflection of a light ray.

The waveguide filling structure 19S3 is further used for forming a third grating structure 14S3, and the third grating structure 14S3 may be formed, by using an imprinting process, on a side that is of the waveguide filling structure 19S3 and that is away from the first waveguide substrate 19S1. The optical waveguide 10A further includes a first filling layer 1551, and the first filling layer 15S1 covers the waveguide filling structure 19S3 and wraps the third grating structure 14S3. The first filling layer 15S1 and the waveguide filling structure 19S3 jointly form a closed surrounding architecture, the third grating structure 14S3 is located in the surrounding architecture, so that the third grating structure 14S3 is isolated from outside air, where a difference between a refractive index of the first filling layer 15S1 and a refractive index of air is less than or equal to 0.2. The first cover plate 15A is formed on a side that is of the first filling layer 15S1 and that is away from the waveguide filling structure 19S3, and the first cover plate 15A is fastened to the first waveguide substrate 19S1 by using a dispensing structure 154. In the implementation shown in FIG. 106C, a layer of grating structure is constructed by using the waveguide filling structure 19S3. In another implementation, a multi-layer (two or more layers) grating structure may also be constructed by using the waveguide filling structure 19S3. In this solution, a layer of grating structure is constructed by using the waveguide filling structure. In another implementation, multiple layers (two or more layers) of grating structures may alternatively be constructed by using the waveguide filling structure. This solution provides a multi-layer architecture constructed on a basis of a single-layer waveguide substrate by using the waveguide filling structure. The waveguide filling structure and the first filling layer are used to protect the layers of grating structures. An outermost first filling layer is combined with a cover plate, to further provide support and protection for the cover plate.

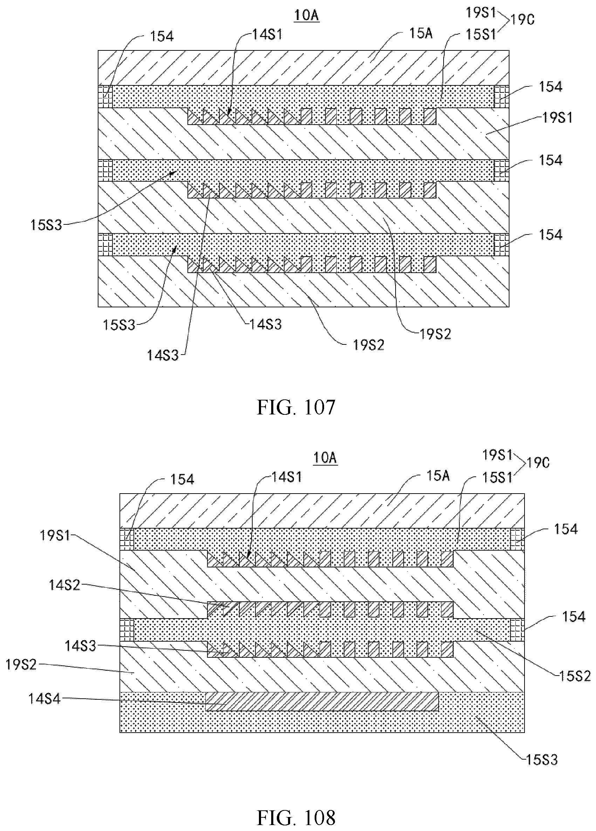

In an implementation, this application further provides a multi-layer single-sided optical waveguide architecture. To be specific, the optical waveguide has three or more layers of waveguide substrates, a grating structure is disposed on a single side of each layer of waveguide substrate, and the entire optical waveguide has only one cover structure. In an implementation shown in FIG. 107, on a basis of the implementation shown in FIG. 103, the optical waveguide 10A further includes at least two second waveguide substrates 19S2 (in the implementation shown in FIG. 107, two second waveguide substrates 19S2 are used as an example for description). A third grating structure 14S3 is disposed on each second waveguide substrate 19S2, the at least two second waveguide substrates 19S2 are disposed in a stacked manner on a side that is of the first waveguide substrate 19S1 and that is away from the first cover plate 15A, third filling layers 15S3 are respectively disposed between the second waveguide substrate 19S2 and the first waveguide substrate 19S1 and between adjacent second waveguide substrates 19S2, the third filling layer 15S3 and the second waveguide substrate 19S2 jointly surround the third grating structure 14S3, and a difference between a refractive index of the third filling layer 15S3 and the refractive index of air is less than or equal to 0.2.

Based on the implementations shown in FIG. 106A and FIG. 107, this application may further provide a multi-layer double-sided optical waveguide architecture. To be specific, grating structures may be disposed on both a top surface and a bottom surface of the first waveguide substrate 19S1 in the implementations shown in FIG. 106A and FIG. 107, and similarly, grating structures may also be disposed on both a top surface and a bottom surface of the second waveguide substrate 19S2. Refer to FIG. 108. In an implementation, an optical waveguide 10A includes a first waveguide substrate 19S1 and a second waveguide substrate 19S2 that are disposed in a stacked manner. A first grating structure 14S1 is disposed on a top surface of the first waveguide substrate 19S1, and a second grating structure 14S2 is disposed on a bottom surface of the first waveguide substrate 19S1. A third grating structure 14S3 is disposed on a top surface of the second waveguide substrate 19S2, and a fourth grating structure 14S4 is disposed on a bottom surface of the second waveguide substrate 19S2. The first cover plate 15A is located on a side of the top surface of the first waveguide substrate 19S1, and a first filling layer 15S1 is disposed between the first cover plate 15A and the first waveguide substrate 19S1. The first filling layer 15S1 and the first waveguide substrate 19S1 jointly surround the first grating structure 14S1. A second filling layer 15S2 is disposed between the second waveguide substrate 19S2 and the first waveguide substrate 19S1, the second filling layer 15S2 and the first waveguide substrate 19S1 jointly surround the second grating structure 14S2, and the second filling layer 15S2 and the second waveguide substrate 19S2 jointly surround the third grating structure 14S3. A third filling layer 15S3 is disposed on a side that is of the second waveguide substrate 19S2 and that is away from the first waveguide substrate 19S1, and the third filling layer 15S3 and the second waveguide substrate 19S2 jointly surround the fourth grating structure 14S4.

In the implementation shown in FIG. 108, a second cover plate may be disposed at the bottom of the third filling layer 15S3.

In the implementation shown in FIG. 108, the first filling layer 15S1, the second filling layer 15S2, and the third filling layer 15S3 all can meet that differences between refractive indexes of these filling layers and a refractive index of air are less than or equal to 0.2. In a specific implementation, the first filling layer 15S1, the second filling layer 15S2, and the third filling layer 15S3 all can meet the following condition: The differences between the refractive indexes of these filling layers and the refractive index of air are less than or equal to 0.1. The refractive index of each filling layer is controlled to be closer to the refractive index of air, so as to improve light transmission of the optical waveguide.

FIG. 99 to FIG. 108 schematically illustrate examples of several specific implementations provided in this application, but this application is not limited to the foregoing specific implementations.

The first filling layer, the second filling layer, and the third filling layer in the foregoing implementation may further have the following restrictions. The following uses the first filling layer as an example for description. The second filling layer and the third filling layer may be made of same materials or have same properties as the first filling layer.

In an implementation, light transmission of the first filling layer is greater than or equal to 80%. This solution defines the light transmission of the first filling layer, so that light transmission of the optical waveguide can be ensured.

In an implementation, a thickness of the first filling layer is less than or equal to 1000 μm. In this solution, the thickness of the first filling layer is restricted to ensure the refractive index and the light transmission of the optical waveguide, so that the optical waveguide has a lightweight advantage.

In an implementation, a thickness of the first filling layer is 1 μm to 1000 μm. In order to ensure lightness and thinness of the optical waveguide, the thickness of the first filling layer may be controlled to be within 100 μm.

In an implementation, a material of the first filling layer includes any one or a combination of an aerogel material, a resin material, an inorganic material, or an organic material. The aerogel material may be a silicon dioxide, a carbide, an oxide, a non-oxide, an organic polymer, or the like.

The silicon dioxide has a refractive index of about 1.5, and is not a desired low-refractive material. Porosity is introduced into the silicon dioxide material to form a silicon dioxide aerogel. Air shares a part of the refractive index. For example, if porosity of silicon dioxide is 50%, a composite refractive index is 1.5*50% + 1*50% = 1.25. The silicon dioxide aerogel may be used as the material of the first filling layer. The silicon dioxide aerogel is a solid-state material, formed by interconnection of nanosilica particles, with a three-dimensional porous network structure having nanometer-scale pores. The pores are fully filled with air. The refractive index is adjusted by adjusting the pores of the silicon dioxide aerogel. Currently, it is possible for an aerogel to include air with a volume proportion of 90% or higher. A pure silicon dioxide aerogel is transparent and colorless, with a refractive index as low as 1.007, which is close to a refractive index of air. In addition, because most of a volume is air, density is very low. In addition, the aerogel has good light transmission and hardness. Currently, it is possible for the aerogel to achieve 95% light transmission and can bear thousands of times of a weight of the aerogel.

In an implementation, the first filling layer has an elastic modulus. It may be understood that the first filling layer is located between the first cover plate and the first waveguide substrate, and close attaching between the first filling layer and the first cover plate and close attaching between the first filling layer and the first waveguide substrate can be ensured by using the elastic modulus of the first filling layer.

A refractive index of the filling layer, for example, the first filling layer, in a specific implementation of this application is close to the refractive index of air, and a difference between the refractive index of the filling layer and the refractive index of air is less than or equal to 0.2. A larger refractive index difference between the filling layer and air indicates a narrower FOV field of view range and a more reduced grating modulation effect. Therefore, the filling layer provided in this application can ensure an optical effect while ensuring that various physical characteristics are close to those of air, and can further provide functions of buffering and excluding water and oxygen.

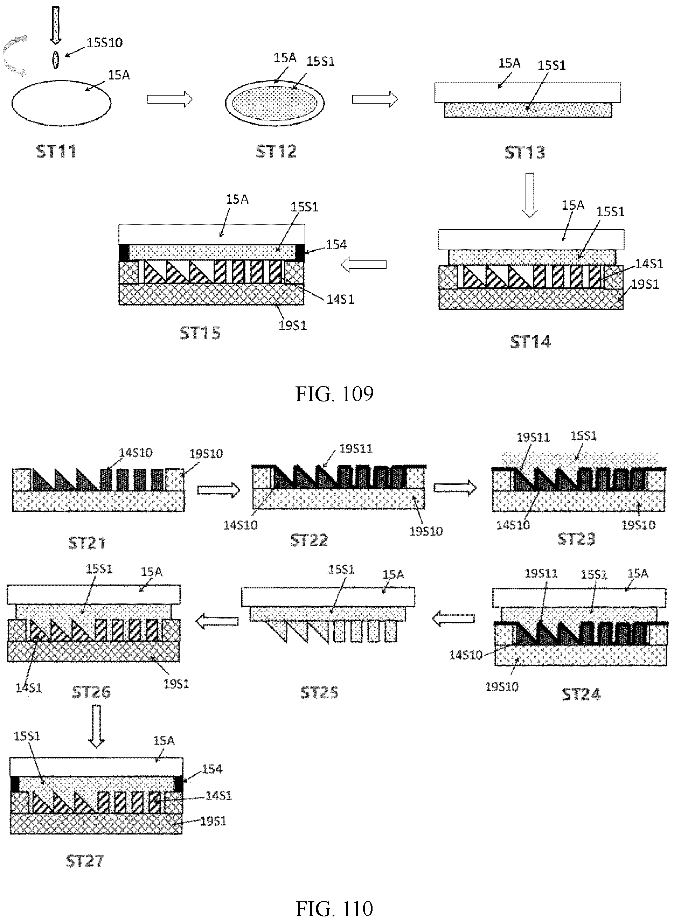

Refer to FIG. 109. In an implementation, this application provides a method for fabricating an optical waveguide, including the following steps.

Step ST11: Provide a first cover plate 15A, and coating a first filling material 15S10 on the first cover plate 15A. Specifically, the first filling material 15S10 may be coated on a surface of the first cover plate 15A through spin-coating or raw material spraying.

Step ST12: Remove a part of the first filling material 15S10 at an edge position of the first cover plate 15A, where a retained part of the first filling material 15S10 forms a first filling layer 15S1.

Step ST13: Perform curing processing, so that the first filling layer 15S1 is cured for formation on the first cover plate 15A, to form the first filling layer 15S1 in a preset form on the first cover plate 15A. The preset form may be understood as that the first filling layer 15S1 has parameters such as a preset thickness and a preset area.

Step ST14: Provide a first waveguide substrate 19S1, where a first grating structure 14S1 is disposed on the first waveguide substrate 19S1, and align the first cover plate 15A and the first waveguide substrate 19S1 so that the first filling layer 15S1 and the first waveguide substrate 19S1 are combined and jointly enclose and surround the first grating structure 14S1.

Step ST15: Fasten the first cover plate 15A to the first waveguide substrate 19S1, so that the first filling layer and the first waveguide substrate jointly form a closed surrounding architecture, the first grating structure is located in the surrounding architecture, and the first grating structure is isolated from outside air, where a difference between a refractive index of the first filling layer and a refractive index of air is less than or equal to 0.2.

Specifically, the first cover plate 15A is fastened to the first waveguide substrate 19S1 by using a dispensing structure 154. Specifically, in a process of fastening the first cover plate 15A to the first waveguide substrate 19S1, a pressure is applied to the first cover plate 15A, so that the first filling layer 15S1 is elastically deformed due to the applied pressure. Because the first filling layer 15S1 has an elastic modulus and stores elastic potential energy, after the first cover plate 15A is fastened to the first waveguide substrate 19S1, under an action of the elastic potential energy of the first filling layer 15S1, the first filling layer 15S1 can be closely attached to the first waveguide substrate 19S1 and the first grating structure 14S1.

Refer to FIG. 110. In an implementation, this application provides a method for fabricating an optical waveguide, including the following steps.

Step ST21: Provide a rigid mother mold 19S10, where the rigid mother mold 19S10 has a grating mold structure 14S10. In selection and fabrication processes of the rigid mother mold 19S10 and the grating mold structure 14S10, specific structural forms and size parameters of a waveguide substrate and a grating structure in an optical waveguide to be fabricated in this application need to be considered. For example, structures and sizes of the rigid mother mold 19S10 and the grating mold structure 14S10 are the same as structures and sizes of a first waveguide substrate and a first grating structure of the optical waveguide to be fabricated subsequently, and alternatively may have a relatively small tolerance range while basic structural forms are ensured.

Step ST22: Perform hydrophobic processing on a surface of the rigid mother mold 19S10 and a surface of the grating mold structure 14S10, to form a hydrophobic film layer 19S11.

Step ST23: Coat a first filling material on the rigid mother mold 19S10, to be specific, coat the first filling material on the hydrophobic film layer 19S11, to form a first filling layer 15S1. Specifically, the hydrophobic film layer 19S11 is a substrate carrying the first filling material. The first filling material may be first coated on a surface of the hydrophobic film layer 19S11, and then a part of the first filling material at an edge is removed, to form the first filling layer 15S1.

Step ST24: Attach the first cover plate 15A to the first filling layer 15S1, so that the first cover plate 15A and the first filling layer 15S1 are combined together.

Step ST25: Perform demolding, so that the first cover plate 15A and the first filling layer 15S1 are separated from the rigid mother mold 19S11. Specifically, in a process from step ST24 to step ST25, due to existence of the hydrophobic film layer 19S11, the first filling layer 15S1 can be separated from the rigid mother mold 19S11, that is, a structure in which the first cover plate 15A and the first filling layer 15S1 are interconnected together is formed.

Step ST26: Provide a first waveguide substrate 19S1, where a first grating structure 14S1 is disposed on the first waveguide substrate 19S1. Align the first cover plate 15A and the first waveguide substrate 19S1 so that the first filling layer 15S1 and the first waveguide substrate 19S1 are combined and jointly enclose and surround the first grating structure 14S1.

Step ST27: Fasten the first cover plate 15A to the first waveguide substrate 19S1, so that the first filling layer and the first waveguide substrate jointly form a closed surrounding architecture, the first grating structure is located in the surrounding architecture, and the first grating structure is isolated from outside air, where a difference between a refractive index of the first filling layer and a refractive index of air is less than or equal to 0.2.

Specifically, the first cover plate 15A is fastened to the first waveguide substrate 19S1 by using a dispensing structure 154. Specifically, in a process of fastening the first cover plate 15A to the first waveguide substrate 19S1, a pressure is applied to the first cover plate 15A, so that the first filling layer 15S1 is elastically deformed due to the applied pressure. Because the first filling layer 15S1 has an elastic modulus and stores elastic potential energy, after the first cover plate 15A is fastened to the first waveguide substrate 19S1, the first filling layer 15S1 can be closely attached to the first waveguide substrate 19S1 and the first grating structure 14S1 under an action of the elastic potential energy of the first filling layer 15S1. In this implementation, the first filling layer 15S1 has periodically arranged microstructures the same as those of the first grating structure, so that a grating contact surface of the first filling layer is attached to a surface of the microstructures of the first grating structure.

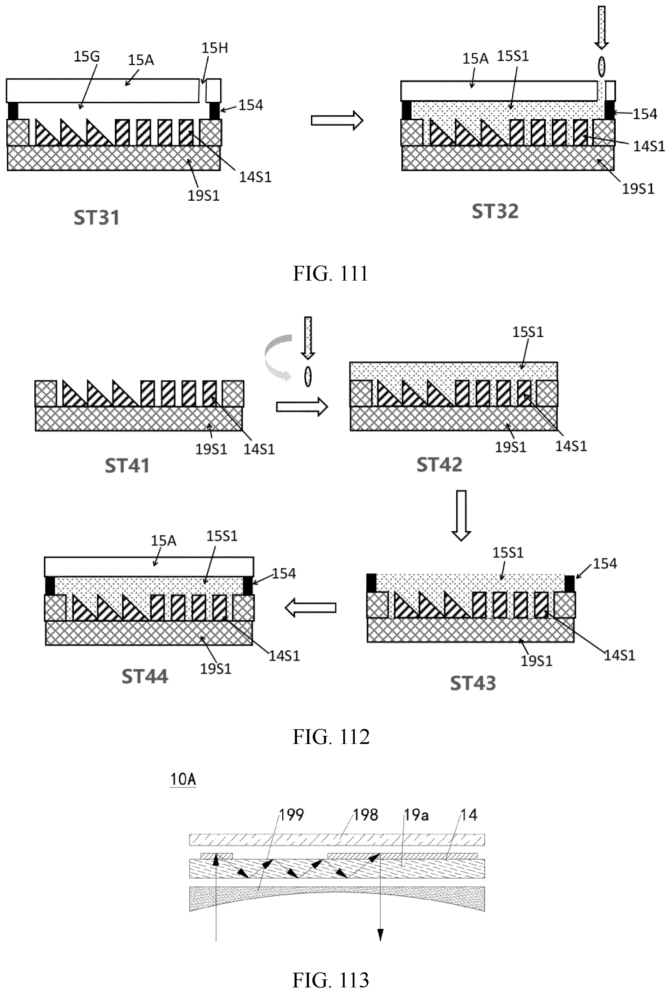

Refer to FIG. 111. In an implementation, this application provides a method for fabricating an optical waveguide, including the following steps.

Provide an optical waveguide intermediate structure, where the optical waveguide intermediate structure includes a first waveguide substrate 19S1, a first grating structure 14S1, and a first cover plate 15A, the first grating structure 14S1 is formed on a surface of the first waveguide substrate 19S1, the first cover plate 15A and the first waveguide substrate 19S1 are disposed in a stacked manner and are fastened, and a gap 15G is formed between the first cover plate 15A and the first waveguide substrate 19S1 and between the first cover plate 15A and the first grating structure 14S1.

Step ST31: Drill a hole on the first cover plate 15A to form an injection hole 15H. Specifically, the injection hole 15H may be disposed at an edge position of the first cover plate 15A, and the injection hole 15H avoids a region that is on the first cover plate 15A and that corresponds to the first grating structure 14S1. That is, there is no intersection between a vertical projection of the first grating structure 14S1 onto the first cover plate 15A and the injection hole 15H, and the vertical projection and the injection hole 15H are isolated from each other. In this way, a position of the injection hole 15H does not affect diffraction efficiency of the first grating structure 14S1.

In an implementation, there is one injection hole 15H, disposed at an edge position of the first cover plate 15A. In another implementation, there are two injection holes 15H, and the two injection holes 15H may be respectively disposed at opposite edge positions of the first cover plate 15A.

In an implementation, the first cover plate 15A is fastened to the first waveguide substrate 19S1 by using a dispensing structure 154, and the position of the injection hole 15H is close to the dispensing structure 154. The injection hole 15H is disposed at a position near the dispensing structure 154, so that the injection hole 15H has relatively little impact on optical performance of the optical waveguide, or does not affect optical performance of the optical waveguide.

Step ST32: Inject a filling material into the gap 15G through the injection hole 15H to form a first filling layer 15S1, where the first filling layer 15S1 and the first waveguide substrate 19S1 jointly form a closed surrounding architecture, and the first grating structure 14S1 is located in the surrounding architecture, so that the first grating structure 14S1 is isolated from outside air, where a difference between a refractive index of the first filling layer 15S1 and a refractive index of air is less than or equal to 0.2.

Specifically, in a process of injecting the filling material into the gap, it may be determined, by controlling a weight or a volume of the injected filling material, whether the gap 15G is fully filled. When there are two injection holes, one of the injection holes may be used for injection of the filling material. When the gap 15G is fully filled, the filling material is ejected from the other injection hole. Therefore, in a design solution of two injection holes, a filling status of the filling material can be determined, and further, gas in the gap 15G can be expelled in a process of injecting the filling material, thereby helping ensure a refractive index and light transmission of the filling material.

After the injection of the first filling layer is completed, a residual filling material on an outer surface of the first cover plate 15A is removed, and then curing processing is performed.

Refer to FIG. 112. In an implementation, this application provides a method for fabricating an optical waveguide, including the following steps.

Step ST41: Provide a first waveguide substrate 19S1, where a first grating structure 14S1 is disposed on the first waveguide substrate 19S1.

Step ST42: Directly coat a filling material on surfaces of the first waveguide substrate 19S1 and the first grating structure 14S1 through spin-coating or spraying, to form a filling layer. Specifically, the filling layer may completely cover the surfaces of the first waveguide substrate 19S1 and the first grating structure 14S1, and then the filling material at an edge position of the first waveguide substrate 19S1 is removed, to form a first filling layer 15S1.

Step ST43: Dispose a dispensing structure 154 around a periphery of the first filling layer 15S1 and on the first waveguide substrate 19S1. In an implementation, a surface that is of the dispensing structure 154 and that is away from the first waveguide substrate 19S1 may be coplanar with a surface that is of the first filling layer 15S1 and that is away from the first waveguide substrate 19S1. In an implementation, alternatively, a surface that is of the dispensing structure 154 and that is away from the first waveguide substrate 19S1 may be lower than a surface that is of the first filling layer 15S1 and that is away from the first waveguide substrate 19S1. That is, the first filling layer 15S1 protrudes from the dispensing structure 154.

Step ST44: Provide a first cover plate 15A, align the first cover plate 15A and the dispensing structure 154, and attach the first cover plate 15A to the dispensing structure 154, so that the first cover plate 15A is fastened to the first waveguide substrate 19S1. In an implementation, after step ST43 is completed, the surface that is of the dispensing structure 154 and that is away from the first waveguide substrate 19S1 may be lower than the surface that is of the first filling layer 15S1 and that is away from the first waveguide substrate 19S1. In a process of fastening the first cover plate 15A to the first waveguide substrate 19S1, the first cover plate 15A applies a pressure to the first filling layer 15S1, so that the first filling layer 15S1 is elastically deformed due to the applied pressure. Because the first filling layer 15S1 has an elastic modulus and stores elastic potential energy, after the first cover plate 15A is fastened to the first waveguide substrate 19S1, the first filling layer 15S1 can be closely attached to the first cover plate 15A under an action of the elastic potential energy of the first filling layer 15S1.

Solution 9: Lightweight substrate of an optical waveguide

As shown in FIG. 113, in an embodiment, the optical waveguide 10A may include a protection layer 198, a grating structure 14, a waveguide layer 19a, and an integrated lens 199. The grating structure 14 is located on a surface of the waveguide layer 19a. The protection layer 198 and the integrated lens 199 are respectively located on two sides of the waveguide layer 19a. The grating structure 14 is configured to diffract and deflect a light ray. The waveguide layer 19a is configured to perform total internal reflection of a light ray. The protection layer 198 and the integrated lens 199 are configured to protect the grating structure 14 and the waveguide layer 19a.

A material of the waveguide layer 19a is a glass material with a high refractive index. For example, a refractive index of the waveguide layer 19a is greater than or equal to 1.6, so that a light ray coupled into the waveguide layer 19a can undergo total internal reflection in the waveguide layer 19a. However, considering that a wafer of glass with a high refractive index glass is large in size (8 inches or 12 inches) during mass production, the waveguide layer 19a cannot be too thin in a processing process. In addition, because a higher refractive index of the glass material indicates higher density of the glass material, the waveguide layer 19a made of the high refractive index glass material has a large weight.

FIG. 113 shows a design solution of an optical waveguide. When the optical waveguide 10A shown in FIG. 113 is included in a near-eye display device, a weight of a single lens (a left lens or a right lens) as a whole (including the protection layer 198, the grating structure 14, the waveguide layer 19a, and the integrated lens 199) exceeds 20 grams. Therefore, the near-eye display device fabricated by using the optical waveguide 10A has a large weight and a large thickness, and is not convenient to be worn for a long time. Therefore, how to reduce a weight and a thickness of a single-side near-eye display device is one of research hot topics in the field of optical waveguides, and lightweight optical waveguides become a research and development direction in the industry.

In an implementation, a waveguide substrate is designed as a composite material in this application, to achieve lightweight of an optical waveguide, and resolve a problem that a near-eye display device is relatively heavy and thick.

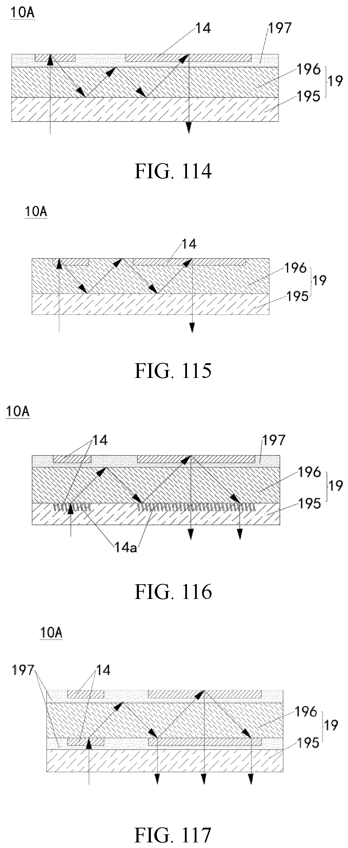

As shown in FIG. 114, in an embodiment, an optical waveguide 10A may include a waveguide substrate 19 and a grating layer 197 that are disposed in a stacked manner, and a grating structure 14 may be formed on the grating layer 197. The waveguide substrate 19 is configured to transmit a light ray, and the grating structure 14 is configured to diffract and deflect a light ray. The waveguide substrate 19 may include a first substrate layer 195 and a second substrate layer 196. A refractive index of the first substrate layer 195 is less than a refractive index of the second substrate layer 196, a difference between the refractive index of the second substrate layer 196 and the refractive index of the first substrate layer 195 is greater than or equal to 0.1, and a thickness of the second substrate layer 196 is 50 micrometers to 300 micrometers. The grating structure 14 is located on a side that is of the second substrate layer 196 and that is away from the first substrate layer 195. In this solution, the waveguide substrate 19 is designed as a composite material formed by stacking the first substrate layer 195 and the second substrate layer 196, and the thickness of the second substrate layer 196 and the refractive index difference between the first substrate layer 195 and the second substrate layer 196 are restricted, so that lightweight of the optical waveguide 10A can be achieved.

In comparison with the solutions shown in FIG. 113 and FIG. 114, in the solution shown in FIG. 113, the waveguide layer 19a is made of a glass material with a high refractive index, and there is a problem of a heavy weight (a weight of a single-side lens of a near-eye display device fabricated by using the solution shown in FIG. 113 exceeds 20 grams). The waveguide substrate 19 of the optical waveguide 10A shown in FIG. 114 includes the first substrate layer 195 and the second substrate layer 196, where the first substrate layer 195 is made of a material with a low refractive index, and the second substrate layer 196 is a film structure formed on the first substrate layer 195 by using a fabrication process. In this way, a weight of the waveguide substrate 19 of the optical waveguide 10A shown in FIG. 114 may be light (a weight of a single-side lens of a near-eye display device fabricated by using the solution shown in FIG. 114 may be less than 20 grams). That is, in comparison with the solution shown in FIG. 113, the optical waveguide 10A in this embodiment has a lighter weight, and can better achieve lightweight of the optical waveguide.

Specifically, the first substrate layer 195 is made of a material with a low refractive index (for example, low-refractive glass), so that the first substrate layer 195 features low density, a light weight, and a small thickness. The first substrate layer 195 does not have performance of total internal reflection of a light ray, and therefore the first substrate layer may be thin and light. The first substrate layer 195 is used as a carrying layer of the second substrate layer 196, and a thickness of the second substrate layer 196 formed on the first substrate layer 195 may be 50 micrometers to 300 micrometers. The second substrate layer 196 features a high refractive index, and can meet a requirement of total internal reflection of a light ray, so that an optical signal can be propagated.

When the first substrate layer 195 and the second substrate layer 196 are combined into an integrated structure, a total thickness of the waveguide substrate 19 may be less than 0.35 mm. Therefore, in the implementation provided in this application, the weight of the waveguide substrate 19 and a thickness of the waveguide substrate 19 can be reduced, and further, a weight of the optical waveguide 10A and a thickness of the optical waveguide 10A can be reduced. Therefore, lightweight of the optical waveguide 10A can be achieved while total internal reflection propagation (optical performance) of a light ray can be achieved in the optical waveguide 10A.

A material of the first substrate layer 195 may be glass, and the refractive index of the first substrate layer 195 may be less than or equal to 1.55. A material of the second substrate layer 196 may be one or a combination of at least two of TiO2, silicon nitride, gallium nitride, and a high-refractive resin material. The refractive index of the second substrate layer 196 may be greater than or equal to 1.65. In this solution, a range of the refractive index of the second substrate layer is restricted, so that the second substrate layer can meet a function of total internal reflection propagation of light.

As shown in FIG. 114, the first substrate layer 195 is configured to carry, in a process of fabricating the second substrate layer 196, a material for forming the second substrate layer 196, where the second substrate layer 196 and the first substrate layer 195 are combined into an integrated structure by using a fabrication process. The fabrication process may be vapor deposition, physical deposition, spin-coating, blade coating, spraying, injection molding, electroplating, or the like, or may be another process method that can be used to directly form the structure. That the second substrate layer 196 and the first substrate layer 195 are combined into an integrated structure may mean that the second substrate layer 196 and the first substrate layer 195 may be directly connected as an integrated structure, and there is no other layer structure between them. In other words, in a process of fabricating the second substrate layer 196, a material of the second substrate layer 196 may be directly disposed on a surface of the first substrate layer 195 by using the foregoing fabrication process. In another implementation, that the second substrate layer 196 and the first substrate layer 195 are combined into an integrated structure may alternatively mean that there is another layer structure between the first substrate layer 195 and the second substrate layer 196. For example, before the second substrate layer 196 is fabricated, a grating layer having a grating structure, for example, an imprint adhesive, may be fabricated on a surface of the first substrate layer 195, and then a material of the second substrate layer 196 is disposed on the grating layer by using the foregoing fabrication process.

In the implementation shown in FIG. 114, the grating layer 197 is formed on a surface that is of the second substrate layer 196 and that is away from the first substrate layer 195. The grating layer 197 may be disposed on the surface of the second substrate layer 196 by using a spin-coating or deposition process, and the grating layer 197 may be, but is not limited to, an imprint adhesive material. A refractive index of the grating layer 197 may be the same as the refractive index of the second substrate layer 196. A refractive index of the grating layer 197 may alternatively be different from the refractive index of the second substrate layer 196. In this application, diffraction efficiency of the optical waveguide 10A can be modulated by modulating the refractive index of the grating layer 197. The grating structure 14 may be formed on the grating layer 197 by using an imprinting process. In an implementation, the grating layer 197 may be made of an imprint adhesive that is the same as the material of the second substrate layer 196, or may be made of an imprint adhesive of another material with a high refractive index. The grating structure 14 may be a slanted grating, a blazed grating, or another grating. A specific structure and type of the grating structure 14 are not limited in this embodiment, and a person skilled in the art can design the grating structure 14 based on an actual situation.

In the implementation shown in FIG. 114, the first substrate layer 195 is not only configured to carry the second substrate layer 196 in a process of fabricating the optical waveguide 10A, but also configured to protect the second substrate layer 196 and the grating structure from corrosion caused by external dust, air, or moisture, thereby ensuring diffraction efficiency of the optical waveguide. Therefore, in the optical waveguide 10A provided in this application, no protection layer needs to be further disposed on a side that is of the first substrate layer 195 and that is away from the second substrate layer 196, thereby facilitating lightweight development of the optical waveguide 10A.

In an embodiment, the grating structure may be formed on the second substrate layer of the waveguide substrate by using an etching process. Specifically, as shown in FIG. 115, different from the optical waveguide 10A shown in FIG. 114, the grating structure 14 is formed, by using the etching process, on the side that is of the second substrate layer 196 and that is away from the first substrate layer 195. The grating structure 14 is formed by using the etching process, so that it can be ensured that the waveguide substrate 19 and the grating structure 14 are combined as one, thereby improving structural stability and reliability of the grating structure 14, ensuring diffraction efficiency of the optical waveguide 10A, and improving optical performance of the optical waveguide 10A.

In an implementation, the grating structure may alternatively be formed between the first substrate layer and the second substrate layer. Alternatively, grating structures may be distributed on two sides of the second substrate layer, that is, the grating structures may be disposed between the second substrate layer and the first substrate layer and on a side that is of the second substrate layer and that is away from the first substrate layer.

Refer to FIG. 116. In an implementation, a part of the grating structure 14 may be formed inside the waveguide substrate 19 by using an etching process. A difference of the implementation shown in FIG. 116 from the optical waveguide 10A shown in FIG. 114 lies in that the grating structure 14 is formed on the surface of the first substrate layer 195 by using the etching process. The second substrate layer 196 is formed on the surface of the first substrate layer 195 by using a fabrication process, and the second substrate layer 196 is combined with the grating structure 14 on the first substrate layer 195. Specifically, a plurality of groove-shaped microstructures 14a are first formed on the surface of the first substrate layer 195 by using the etching process, and then the second substrate layer 196 is disposed on the first substrate layer 195 by using the fabrication process. For example, a material of the second substrate layer 196 is disposed on the first substrate layer 195 through deposition or coating. In this process, the material of the second substrate layer 196 is filled in the plurality of groove-shaped microstructures 14a, so that the second substrate layer 196 and the plurality of groove-shaped microstructures 14a are combined to form the grating structure 14. The grating structure 14 located on the first substrate layer 195 and the grating structure 14 located on the grating layer 197 are arranged on two sides of the second substrate layer 196.

In another implementation, a plurality of groove-shaped microstructures 14a are fabricated on the surface of the first substrate layer 195. Alternatively, a material with a high refractive index may be first filled in the plurality of groove-shaped microstructures 14a to form a grating structure, and then the second substrate layer 196 is fabricated. In other words, the material with a high refractive index in the groove-shaped microstructure 14a may be different from the material of the second substrate layer 196, and two processes are used for fabrication.

In the implementation shown in FIG. 116, the grating structures 14 distributed on the two sides of the second substrate layer 196 are formed by using an imprinting process and an etching process respectively. Specifically, the grating structure between the first substrate layer and the second substrate layer is formed by using the etching process, and the grating structure formed on the side that is of the second substrate layer 196 and that is away from the first substrate layer 195 is fabricated by disposing the grating layer 197 and performing the imprinting process on the grating layer 197. In another embodiment, the grating layer 197 may be formed between the first substrate layer 195 and the second substrate layer 196, and the grating structure 14 is fabricated on the grating layer by using an imprinting technology. The grating structure 14 on the side that is of the second substrate layer 196 and that is away from the first substrate layer 195 is formed by using the etching processing.

The optical waveguide 10A provided in the implementation shown in FIG. 116 is an architecture including a single-layer waveguide substrate 19 and a double-sided grating structure 14. This helps improve diffraction efficiency of the optical waveguide 10A and reduce a weight of the optical waveguide 10A, and further, more variables can be designed for the grating structure 14, to improve imaging uniformity of the optical waveguide 10A.

In addition, in another embodiment, the optical waveguide 10A may have only the grating structure between the first substrate layer 195 and the second substrate layer 196, and no grating structure is disposed on the side that is of the second substrate layer 196 and that is away from the first substrate layer 195. A quantity of grating structures, a fabrication process, and a specific structure are not specifically limited in this embodiment, and a person skilled in the art can specifically design the grating structure 14 based on an actual situation.

Refer to FIG. 117. A difference of the implementation shown in FIG. 117 from the optical waveguide 10A shown in FIG. 114 lies in that the grating structure between the first substrate layer 195 and the second substrate layer 196 is formed by using the imprinting technology on the grating layer 197. Specifically, the grating layer 197 is disposed on the surface of the first substrate layer 195, and the grating structure 14 is imprinted on a surface of the grating layer 197. The second substrate layer 196 is directly formed, by using a fabrication process, on a surface that is of the grating layer 197 and that is away from the first substrate layer 195. Then, another grating layer 197 is disposed on the surface of the second substrate layer 196, and a grating structure 14 is formed on the grating layer 197. FIG. 117 schematically illustrates that both the grating structures 14 on two sides of the second substrate layer 196 are formed on the grating layers 197 by using an imprinting process. A material of the grating layer 197 is not limited in this solution, and the two grating layers 197 may be made of imprint adhesives of a same material, or may be made of imprint adhesives of different materials. The material of the grating layer 197 is not specifically limited in this embodiment, and a person skilled in the art can specifically design the grating structure 14 based on an actual situation.

In the implementations shown in FIG. 114, FIG. 116, and FIG. 117, the optical waveguide 10A includes a grating layer 197. In an implementation, the grating layer 197 may also be made of multiple layers of materials, that is, the grating layer may be a composite material. In an implementation, the material of the grating layer 197 may be a volume holographic material, and a grating structure 14 is formed by using holographic exposure on the grating layer 197, and the formed grating structure 14 may be a volume holographic grating. The grating structure on the grating layer 197 may alternatively be another type of grating structure, or a composite grating (including a plurality of grating types or a plurality of materials, a plurality of different vector directions or periods, and the like).

The optical waveguide 10A provided in the foregoing implementations may be built in a lens of a near-eye display device, and both sides of the optical waveguide 10A are attached to a layer structure of the lens. In this way, no other protection layer needs to be disposed on the side that is of the second substrate layer 196 and that is away from the first substrate layer 195, and the grating structure and the second substrate layer 196 may be wrapped by using a material of the lens, to protect the grating structure and the second substrate layer 196.

The optical waveguide 10A provided in the foregoing implementations may alternatively be located on a surface layer of the lens. For example, the first substrate layer 195 is located on an outermost layer, and the side that is of the second substrate layer 196 and that is away from the first substrate layer 195 is attached to a surface of the lens. In this way, the second substrate layer 196 and the grating structure are disposed between the first substrate layer 195 and the lens, so that the first substrate layer and the lens jointly protect the grating structure and the second substrate layer 196.

The optical waveguide 10A provided in the foregoing implementations is applied to a lens, and because no other protection layer needs to be disposed on the side that is of the second substrate layer 196 and that is away from the first substrate layer 195, when the second substrate layer 196 is combined with the lens, lightweight of the lens can be achieved, thereby improving comfort of wearing the near-eye display device.

In an embodiment, the optical waveguide may further include a filling layer and a protection layer. The filling layer and the protection layer cover the side that is of the second substrate layer and that is away from the first substrate layer, and the filling layer and the protection layer are configured to protect the second substrate layer and the grating structure.

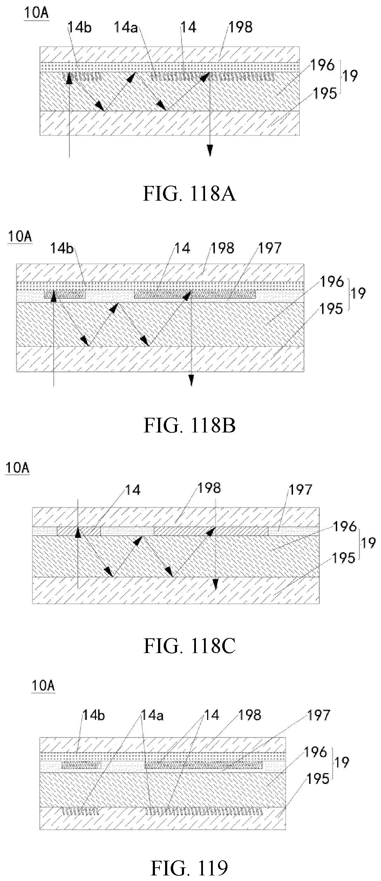

As shown in FIG. 118A, in an implementation, the waveguide substrate 19 includes a first substrate layer 195 and a second substrate layer 196 that are disposed in a stacked manner. Specific designs of the first substrate layer 195 and the second substrate layer 196 may be the same as those in the foregoing implementations, and details are not described again. A grating structure 14 is disposed on a side that is of the second substrate layer 196 and that is away from the first substrate layer 195, and the grating structure 14 is formed on the second substrate layer 196 by using an etching process. Specifically, the second substrate layer 196 is etched to form periodically arranged microstructures 14a with slits. The optical waveguide 10A further includes a filling layer 14b. Specifically, the filling layer 14b is stacked on the side that is of the second substrate layer 196 and that is away from the first substrate layer 195. The filling layer 14b covers the second substrate layer 196 and the microstructures 14a, and fills slits formed by the microstructures 14a. A protection layer 198 is disposed on a side that is of the filling layer 14b and that is away from the second substrate layer. The protection layer 198 may be formed on the side of the second substrate layer 196 through adhesive bonding. The filling layer 14b may not only be configured to protect the second substrate layer 196 and the grating structure 14, but also be configured to prevent the second substrate layer 196 and the grating structure 14 from being in contact with adhesive. If the second substrate layer 196 and the grating structure 14 are in contact with the glue, the adhesive may penetrate into the second substrate layer 196 and the grating structure 14, affecting refractive indexes of the second substrate layer 196 and the grating structure 14, and affecting diffraction efficiency of the optical waveguide. Therefore, this solution can ensure diffraction efficiency of the optical waveguide.

In an implementation, a refractive index of the protection layer 198 may be less than or equal to 1.55. For example, a material of the protection layer 198 may be the same as a material of the first substrate layer 195, or may be another glass material with relatively low refractive index. The protection layer 198 may protect the grating structure 14 on a surface layer of the waveguide substrate 19 from being affected by an external environment. In this embodiment, the first substrate layer 195 and the protection layer 198 may protect the second substrate layer 196 and the grating structure 14 that are located between the first substrate layer 195 and the protection layer 198, so that the second substrate layer 196 and the grating structure 14 are protected from corrosion caused by external dust, air, and moisture, thereby ensuring diffraction efficiency of the optical waveguide 10A.

In an embodiment, design improvement may be made based on the solutions in FIG. 114, FIG. 116, and FIG. 117, to add a protection layer 198 and a filling layer 14b, so as to protect the second substrate layer 196 and the grating structure 14 from damage caused by an external factor.

An implementation shown in FIG. 118B is an architecture in which a protection layer 198 and a filling layer 14b are added based on the solution shown in FIG. 114. As shown in FIG. 118B, a grating layer 197 is disposed on a surface that is of the second substrate layer 196 and that is away from the first substrate layer 195, a grating structure 14 is disposed on the grating layer 197, and the filling layer 14b is located on a side that is of the second substrate layer 196 and that is away from the first substrate layer 195, and is disposed in a stacked manner with the grating layer 197. The filling layer 14b covers the grating layer 197 and the grating structure 14. The protection layer 198 is disposed on a side that is of the filling layer 14b and that is away from the second substrate layer 196.

In the implementation shown in FIG. 118A and the implementation shown in FIG. 118B, a part of the grating structure 14 that is in contact with the filling layer 14b may be a blazed grating, a slanted grating, or the like. The grating structure 14 has microstructures 14a, and the filling layer 14b may be disposed to fill slits between the microstructures 14a, so as to achieve comprehensive protection for the grating structure 14.

In another implementation, alternatively, the filling layer 14b may not be formed between the grating structure 14 and the protection layer 198. The grating layer 197 may be directly covered by using the protection layer 198.

Refer to FIG. 118C. In an implementation, a grating layer 197 formed on a surface that is of the second substrate layer 196 and that is away from the first substrate layer 195 is a volume holographic material, and a grating structure 14 is formed through holographic exposure. In this solution, a surface of the grating structure 14 is planar in shape, and the grating structure 14 has no slit structures. Therefore, no filling layer needs to be disposed in this solution. A protection layer 198 is disposed on a side that is of the grating layer 197 and that is away from the second substrate layer 196, and the grating layer 197 and the grating structure 14 are directly protected by using the protection layer 198.

In this application, the first substrate layer 195 and the protection layer 198 may protect the second substrate layer 196 and the grating structure 14 that are located between the first substrate layer 195 and the protection layer 198, so that the second substrate layer 196 and the grating structure 14 are protected from corrosion caused by external dust, air, and moisture, thereby ensuring diffraction efficiency of the optical waveguide 10A.

FIG. 118A, FIG. 118B, and FIG. 118C are solutions of disposing a filling layer and a protection layer on a basis a solution of an optical waveguide in which a single-layer waveguide substrate has a single-sided grating structure. In another implementation, alternatively, a filling layer and a protection layer may be disposed on a basis of a solution of an optical waveguide in which a single-layer waveguide substrate has a double-sided grating structure.

In an implementation, with reference to FIG. 119, the optical waveguide 10A includes a first substrate layer 195, a second substrate layer 196, a grating layer 197, a filling layer 14b, and a protection layer 198 that are sequentially disposed in a stacked manner. A grating structure 14 is disposed on a surface of the first substrate layer 195, and the grating structure 14 is formed by using an etching process. The grating layer 197 is disposed on a surface of the second substrate layer 196, a grating structure 14 is disposed on the grating layer 197, and this grating structure 14 is formed by using an imprinting process. The filling layer 14b is disposed on a side that is of the grating layer 197 and that is away from the second substrate layer 196, and the protection layer 198 is disposed on a side that is of the filling layer 14b and that is away from the grating layer 197. In this embodiment, the first substrate layer 195 and the protection layer 198 may protect the second substrate layer 196 and the grating structure 14, so that the second substrate layer 196 and the grating structure 14 are protected from corrosion caused by external dust, air, and moisture, thereby ensuring diffraction efficiency of the optical waveguide 10A.

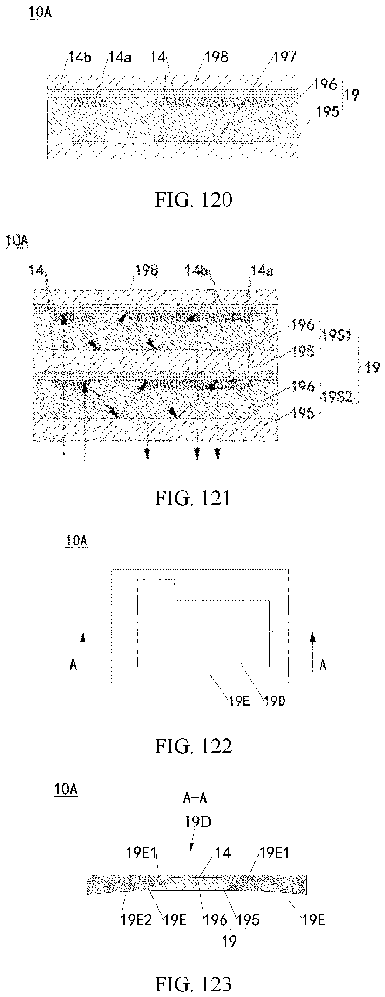

In an implementation, with reference to FIG. 120, the optical waveguide 10A includes a first substrate layer 195, a grating layer 197, a second substrate layer 196, a filling layer 14b, and a protection layer 198 that are sequentially disposed in a stacked manner. The grating layer 197 is disposed on a surface of the first substrate layer 195, a grating structure 14 is disposed on the grating layer 197, and this grating structure 14 is formed by using an imprinting process. The second substrate layer 196 is formed on a surface of the grating layer 197. A grating structure 14 is disposed on a surface of the second substrate layer 196, and this grating structure 14 is formed by using an etching process. The filling layer 14b covers the surface of the second substrate layer 196 and fills the grating structure 14. The protection layer 198 is disposed on a side that is of the filling layer 14b and that is away from the second substrate layer 196. In this embodiment, the first substrate layer 195 and the protection layer 198 may protect the second substrate layer 196 and the grating structure 14 that are located between the first substrate layer 195 and the protection layer 198, so that the second substrate layer 196 and the grating structure 14 are protected from corrosion caused by external dust, air, and moisture, thereby ensuring diffraction efficiency of the optical waveguide 10A.

The optical waveguide 10A shown in FIG. 114 to FIG. 120 may transmit light in different wavelength ranges by using a same waveguide substrate 19, for example, red, green, and blue optical signals, to implement full-color display of the red, green, and blue colors. Such an optical waveguide structure may be referred to as a single-layer optical waveguide.

In another implementation, alternatively, the optical waveguide may transmit light in different wavelength ranges, for example, red, green, and blue color optical signals, by using a plurality of stacked layers of waveguide substrates separately through different paths, or transmit light in different wavelength ranges, for example, red, green, and blue color optical signals, by dividing the light in different wavelength ranges into two groups. For example, the red and green color optical signals may be divided into one group for transmission, and the green and blue color optical signals may be divided into the other group for transmission.

In an implementation, as shown in FIG. 121, the waveguide substrate 19 of the optical waveguide 10A may include a first waveguide substrate 19S1 and a second waveguide substrate 19S2. The first waveguide substrate 19S1 and the second waveguide substrate 19S2 each include a first substrate layer 195 and a second substrate layer 196, the second substrate layer 196 is formed on the first substrate layer 195 by using a fabrication process, and the first substrate layer 195 and the second substrate layer 196 are combined into an integrated structure. In the first waveguide substrate 19S1 and the second waveguide substrate 19S2, a grating structure 14 is etched on a side that is of the second substrate layer 196 that is away from the first substrate layer 195. For specific fabrication processes and position relationships between the first waveguide substrate 19S1, the second waveguide substrate 19S2, and the grating structure, refer to related content in the implementations shown in FIG. 114 and FIG. 115. Details are not described herein again.

As shown in FIG. 121, the first substrate layer 195 of the first waveguide substrate 19S1 is located on a side that is of the second substrate layer 196 of the second waveguide substrate 19S2 and that is away from the first substrate layer 195 of the second waveguide substrate 19S2. There is a filling layer 14b between the first substrate layer 195 of the first waveguide substrate 19S1 and the second substrate layer 196 of the second waveguide substrate 19S2. The filling layer 14b covers a grating structure 14 on the second waveguide substrate 19S2, to protect surfaces of the grating structure 14 and the second substrate layer 196 in the second waveguide substrate 19S2. A protection layer 198 is located on a side that is of the second substrate layer 196 in the first waveguide substrate 19S1 and that is away from the first substrate layer 195. A filling layer 14b is formed between the protection layer 198 and the second substrate layer 196 of the first waveguide substrate 19S1. The filling layer 14b covers the grating structure 14 of the first waveguide substrate 19S1, to protect the grating structure 14 and the second substrate layer 196 in the first waveguide substrate 19S1.

In this embodiment, the first waveguide substrate 19S1 and the second waveguide substrate 19S2 in the waveguide substrate 19 may transmit light of different wavelengths, for example, red, green, and blue optical signals, into two groups. This can improve optical utilization and optical performance of the optical waveguide 10A, and further, can improve a display field of view, brightness uniformity, and color uniformity of the optical waveguide 10A.

It may be understood that the optical waveguide provided in any one of the implementations in FIG. 114 to FIG. 120 may form a layer in the double-layer optical waveguide architecture.

In an embodiment, the optical waveguide may further include a functional region and an edge region. Specifically, as shown in FIG. 122 and FIG. 123, FIG. 122 is a diagram of a structure of an optical waveguide 10A according to this embodiment, and FIG. 123 is a diagram of a cross-sectional structure, cut along A-A, of the optical waveguide 10A shown in FIG. 122.

As shown in FIG. 122 and FIG. 123, the optical waveguide 10A includes a functional region 19D and an edge region 19E. A waveguide substrate 19 and a grating structure 14 are located in the functional region 19D. The waveguide substrate 19 may include a first substrate layer 195 and a second substrate layer 196. The grating structure 14 and the waveguide substrate 19 may be a combination of the grating structure 14 and the waveguide substrate 19 in any one of the embodiments shown in FIG. 114 to FIG. 121, and details are not described herein again.

As shown in FIG. 122 and FIG. 123, the edge region 19E is located around a periphery of the functional region 19D. The waveguide substrate 19 and the grating structure 14 are configured to transmit and display an optical signal. The functional region 19D is configured to carry the grating structure 14 and the waveguide substrate 19. In a lens of a near-eye display device, the functional region 19D may correspond to a pupil of a human eye, and a size of the functional region 19D may be less than an overall size of the lens. The edge region 19E may be a part of the lens located at an outer periphery of the pupil.

As shown in FIG. 123, a waveguide edge body 19E1 is disposed in the edge region 19E. The waveguide edge body 19E1 may be made of a resin material, and a refractive index of the waveguide edge body 19E1 may be 1.55 to 1.75. The waveguide edge body 19E1 has light transmission, and an outside light ray may enter an eye through the waveguide edge body 19E1 of the optical waveguide 10A, thereby expanding a field of view.

As shown in FIG. 123, the waveguide edge body 19E1 located in the edge region 19E is combined with an edge of the waveguide substrate 19 located in the functional region 19D. Density of the waveguide edge body 19E1 may be less than density of the first substrate layer 195. For example, the waveguide substrate 19 and the waveguide edge body 19E1 may be integrally formed, or may be combined through adhesive bonding, or may be combined in another connection manner.

As shown in FIG. 123, an edge surface 19E2 on a near-eye side of the waveguide edge body 19E1 is a curved surface with a specific curvature, and the curved surface may be used to compensate for a visual deviation caused by different refractive indexes of the waveguide edge body 19E1 and the waveguide substrate 19, thereby improving display performance of the optical waveguide 10A.

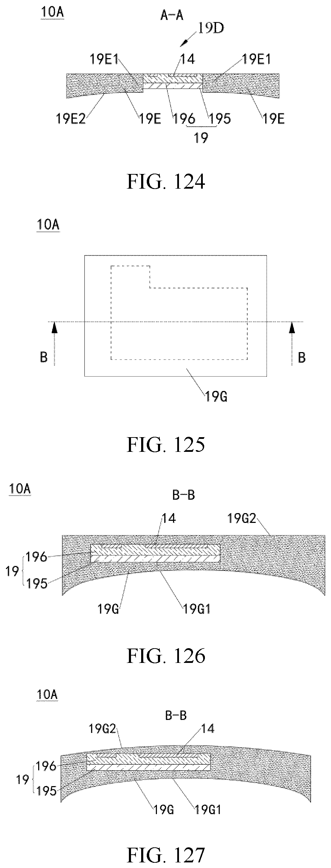

A size parameter, a material, a shape, and a structure of the functional region 16 including the waveguide edge body 19E1 may be adjusted as required, to better compensate for a visual deviation caused by different refractive indexes of the waveguide edge body 19E1 and the waveguide substrate 19. As shown in FIG. 123 and FIG. 124, at edges of the functional region 19D and the edge region 19E, a thickness of the functional region 19D may be equal to that of the edge region 19E, or may be less than that of the edge region 19E. In addition, curvatures of a near-eye surface of the edge region 19E may vary.

In this embodiment, the density of the edge region 19E is less than the density of the first substrate layer 195. Therefore, the edge region 19E located on an outer side of the waveguide substrate 19 can reduce a weight of the optical waveguide 10A, thereby achieving lightweight of the optical waveguide 10A.

In another embodiment, the optical waveguide may further include a wrapping layer. Specifically, as shown in FIG. 125 and FIG. 126, FIG. 125 is a diagram of a structure of another optical waveguide 10A according to an embodiment of this application, and FIG. 126 is a diagram of a cross-sectional structure, cut along B-B, of the optical waveguide 10A shown in FIG. 125.

As shown in FIG. 125 and FIG. 126, the optical waveguide 10A may include a grating structure 14, a waveguide substrate 19, and a wrapping layer 19G. The waveguide substrate 19 may include a first substrate layer 195 and a second substrate layer 196. The grating structure 14 and the waveguide substrate 19 may be wrapped by the wrapping layer 19G. The grating structure 14 and the waveguide substrate 19 may be a combination of the grating structure 14 and the waveguide substrate 19 in any one of the embodiments shown in FIG. 114 to FIG. 121, and details are not described herein again. In a lens of a near-eye display device, the grating structure 14 and the waveguide substrate 19 may correspond to a pupil of the human eye, and sizes of the grating structure 14 and the waveguide substrate 19 are less than an overall size of the lens, and are configured to transmit and display an optical signal. Other regions in the wrapping region 19G than regions corresponding to the grating structure 14 and the waveguide substrate 19 in the edge region 19E may be a part of the lens located on an outer side of the pupil, and are used to carry the grating structure 14 and the waveguide substrate 19.

For example, in this embodiment of this application, the grating structure 14 and the waveguide substrate 19 may be fully wrapped by the wrapping layer 19G. In another embodiment, the grating structure 14 and the waveguide substrate 19 may also be half wrapped by the wrapping layer 19G.

As shown in FIG. 126, the wrapping layer 19G may be made of a resin material, a refractive index of the wrapping layer 19G may be 1.55 to 1.75, and the wrapping layer 19G has light transmission performance. The wrapping layer 19G includes a first surface 19G1 and a second surface 19G2. The first surface 19G1 is an outer surface on a near-eye side of the wrapping layer 19G, and the second surface 19G2 is an outer surface on a far-eye side of the wrapping layer 19G.

As shown in FIG. 126, the first surface 19G1 may be a curved surface, for example, may be a concave surface with different curvatures, or may be a smooth curved surface of another shape. The first surface 19G1 may be formed through 3D printing, casting, or in another possible implementation. The first surface 19G1 not only can compensate for an angle deviation caused by a refractive index difference between the waveguide substrate 19 and the wrapping layer 19G, but also can be used to correct different degrees of myopia.

As shown in FIG. 126, the second surface 19G2 may be a flat surface. In another embodiment, the second surface 19G2 on a side that is of the wrapping layer 19G and that is away from the eye may alternatively be a convex surface with different curvatures, as shown in FIG. 127.

For example, an outer surface of the wrapping layer 19G is not specifically limited in this embodiment, provided that the outer surface of the wrapping layer 19G can correct different degrees of myopia. A person skilled in the art may design the outer surface according to an actual requirement.

In this embodiment, the wrapping layer 19G not only can further reduce a weight of the optical waveguide 10A, but also can correct degrees of myopia by using the curvature of the outer surface, so that the optical waveguide 10A can be integrated with a function of a myopia lens, and therefore is applicable individuals with myopia.

Solution 10: Fabrication of a double-layer optical waveguide by using a nano-imprinting method

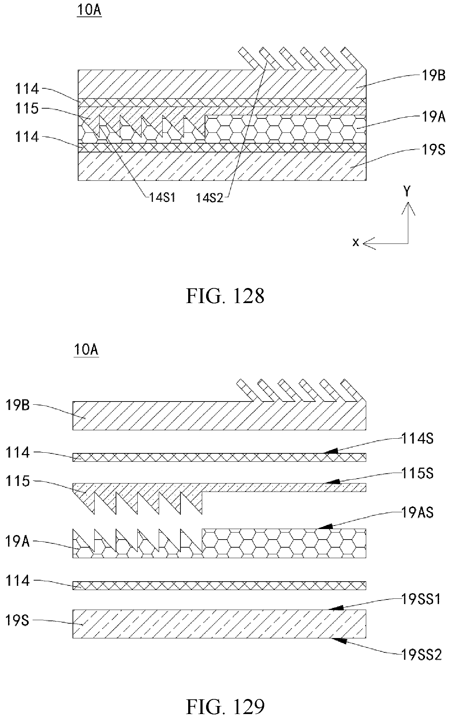

FIG. 128 is a diagram of an optical waveguide 10A according to an implementation of this application. In a possible implementation, the optical waveguide 10A includes a substrate layer 19S, a first grating layer 19A, a second grating layer 19B, and an adhesion enhancement layer 114. The first grating layer 19A and the substrate layer 19S are disposed in a stacked manner. The second grating layer 19B is disposed in a stacked manner on a side that is of the first grating layer 19A and that is away from the substrate layer 19S, and there is an adhesion enhancement layer 114 between the first grating layer 19A and the second grating layer 19B. The first grating layer 19A and the second grating layer 19B are firmly combined by using the adhesion enhancement layer 114. This brings a benefit of ensuring reliability of connection between the first grating layer 19A and the second grating layer 19B to facilitate demolding in a fabrication process of the optical waveguide. This further helps ensure stability of a bonding state between the first grating layer 19A and the second grating layer 19B in a specific application process of the optical waveguide 10A.

In the implementation shown in FIG. 128, the first grating layer 19A has a first grating structure 14S1, the second grating layer 19B has a second grating structure 14S1, and the optical waveguide 10A is a double-layer grating architecture. In an implementation, there is also an adhesion enhancement layer 114 between the substrate layer 19S and the first grating layer 19A. In another implementation, the substrate layer 19S and the first grating layer 19A may alternatively be in direct contact with each other, or another substrate layer is disposed without disposing an adhesion enhancement layer.

Specifically, refer to FIG. 129. FIG. 129 is an exploded diagram of a structure of each layer of an optical waveguide 10A according to an implementation of this application. The substrate layer 19S is flat-plate-like with a flat surface and includes a substrate top surface 19SS1 and a substrate bottom surface 19SS2. A material of the substrate layer 19S may be a material with high transparency, such as glass or resin. It may be understood that, the optical waveguide 10A may be a part of a lens of a near-eye display device, and not only needs to be responsible for displaying image information, but also needs to have transparent light transmission performance, so as to ensure a user can wear an electronic device 1000 without affecting the user's movement.

In an implementation, the first grating layer 19A is disposed on the substrate top surface 19SS1 of the substrate layer 19S, and is disposed in a stacked manner with the substrate layer 19S. A material of the first grating layer 19A may be a polymer, and may be specifically a light-curable, thermal-curable, or chemical-curable material. The first grating layer 19A may be bonded to the substrate layer 19S by using a bonding characteristic of the first grating layer 19A. It may be understood that the first grating layer 19A can use the foregoing material and be covered on the substrate layer 19S when the first grating layer 19A has fluidity or deformability; and after curing, form an adhesive bond with the substrate layer 19S.

In an implementation, a surface that is of the first grating layer 19A and that is away from the substrate layer 19S may be the first top surface 19AS, and the adhesion enhancement layer 114 may be directly formed on the first top surface 19AS of the first grating layer 19A. A material of the adhesion enhancement layer 114 may be a polymer material with high transparency, and has adhesion. It may be understood that, a reason why the adhesion enhancement layer 114 requires high transparency is to ensure light transmission of the optical waveguide 10A, and the adhesion of the adhesion enhancement layer 114 is used to firmly bond the first grating layer 19A and the second grating layer 19B, so as to improve reliability of the optical waveguide 10A.

The second grating layer 19B is disposed in a stacked manner on a side that is of the adhesion enhancement layer 114 and that is away from the first grating layer 19A. A surface that is of the adhesion enhancement layer 114 and that is away from the first grating layer 19A forms an adhesion enhancement top surface 114S, and the second grating layer 19B is disposed on the adhesion enhancement top surface 114S of the adhesion enhancement layer 114. A material of the second grating layer 19B may be the same as or different from the material of the first grating layer 19A. In addition, a manufacturing process of the second grating layer 19B may be the same as that of the first grating layer 19A.

In a possible implementation, with reference to FIG. 128 and FIG. 129, there is also an adhesion enhancement layer 114 between the substrate layer 19S and the first grating layer 19A. Specifically, the adhesion enhancement layer 114 may be disposed in advance on the substrate top surface 19SS1 of the substrate layer 19S, and then the first grating layer 19A is disposed on the adhesion enhancement layer 114. The adhesion enhancement layer 114 between the substrate layer 19S and the first grating layer 19A and the adhesion enhancement layer 114 between the first grating layer 19A and the second grating layer 19B may be made of a same material or different materials. It may be understood that, because the materials of the substrate layer 19S and the second grating layer 19B are not necessarily the same, to ensure that the adhesion enhancement layer 114 can maintain high adhesion between the substrate layer 19S and the first grating layer 19A, the adhesion enhancement layer 114 may use a bonding material suitable for the substrate layer 19S.

In this application, the adhesion enhancement layer 114 is disposed between the first grating layer 19A and the second grating layer 19B, so that the first grating layer 19A is separated from the second grating layer 19B. Therefore, during fabrication of the second grating layer 19B, the first grating layer 19A is not affected by a pressure or an impact force, and a probability of deformation and damage of the first grating layer 19A is reduced. In addition, firmness between the second grating layer 19B and the adhesion enhancement layer 114 can be maintained by utilizing an adhesion characteristic of the adhesion enhancement layer 114 after they are connected, thereby improving reliability of demolding. In addition, the second grating layer 19B may be bonded to the first grating layer 19A by using the adhesion enhancement layer 114, thereby improving connection strength between the first grating layer 19A and the second grating layer 19B, avoiding loosening between the first grating layer 19A and the second grating layer 19B, and facilitating subsequent processing of the optical waveguide 10A.

In a possible implementation, a thickness of the adhesion enhancement layer 114 is 0 nm to 20 nm. It may be understood that, the thickness of the adhesion enhancement layer 114 is controlled to be within the range, so that connection strength between the first grating layer 19A and the substrate layer 19S can be ensured without affecting the overall thickness of the optical waveguide 10A. When the thickness of the adhesion enhancement layer 114 exceeds this range, an excessively large overall thickness of the optical waveguide 10A is likely to be caused, and refraction of a light ray is affected.

In a possible implementation, with reference to FIG. 128 and FIG. 129, there is a medium layer 115 between the first grating layer 19A and the second grating layer 19B. Specifically, the medium layer 115 may be located between the first grating layer 19A and the adhesion enhancement layer 114. Specifically, the medium layer 115 may be disposed on the first top surface 19AS, and a surface that is of the medium layer 115 and that is away from the first grating layer 19A is a medium top surface 115S. The adhesion enhancement layer 114 is formed on the medium top surface 115S. The medium layer 115 may be made of a material with high transmittance in a visible light band, for example, one or more of silicon oxide, silicon nitride, gallium nitride, titanium dioxide, and the like. This is not limited in the present invention. In addition, the medium layer 115 may be fabricated by using a semiconductor manufacturing process, to meet requirements for high mass production and high precision. A fabrication process of the medium layer 115 may include a process such as adhesive coating, exposure, and/or atomic layer deposition, and/or etching, and/or adhesive removal.

In a possible implementation, a refractive index of the medium layer 115 is 1.8 to 2.3. The medium layer 115 has a high refractive index, which can effectively improve optical efficiency and improve a field of view of an electronic device 1000 having the optical waveguide 10A. In another implementation, the refractive index of the medium layer 115 may alternatively be greater than 2.3.

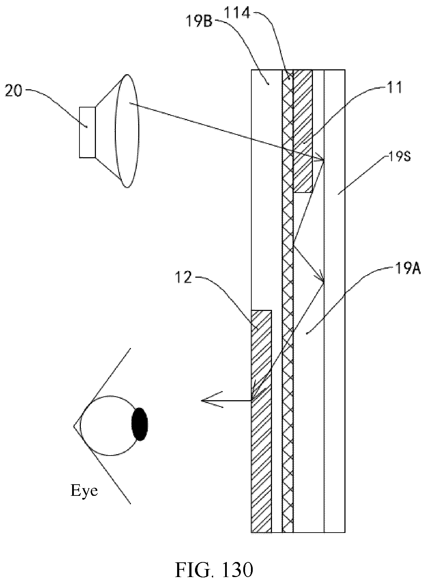

FIG. 130 is a diagram of an optical path of a light ray propagated in the optical waveguide 10A shown in FIG. 129. In a possible implementation, an in-coupling grating 11 is disposed on a side that is of the first grating layer 19A and that faces away from the substrate layer 19S, an out-coupling grating 12 is disposed on a side that is of the second grating layer 19B and that faces away from the first grating layer 19A, and there is a spacing between a vertical projection of the in-coupling grating 11 onto the substrate layer 19S and a vertical projection of the out-coupling grating 12 onto the substrate layer 19S. The in-coupling grating 11 is opposite to an optical engine 20, and an image light ray emitted by the optical engine 20 enters the optical waveguide 10A through the in-coupling grating 11, and is coupled out of the optical waveguide 10A through the out-coupling grating 12. Both the in-coupling grating 11 and the out-coupling grating 12 may be micro-nanostructures on the optical waveguide 10A, and have a diffraction function.

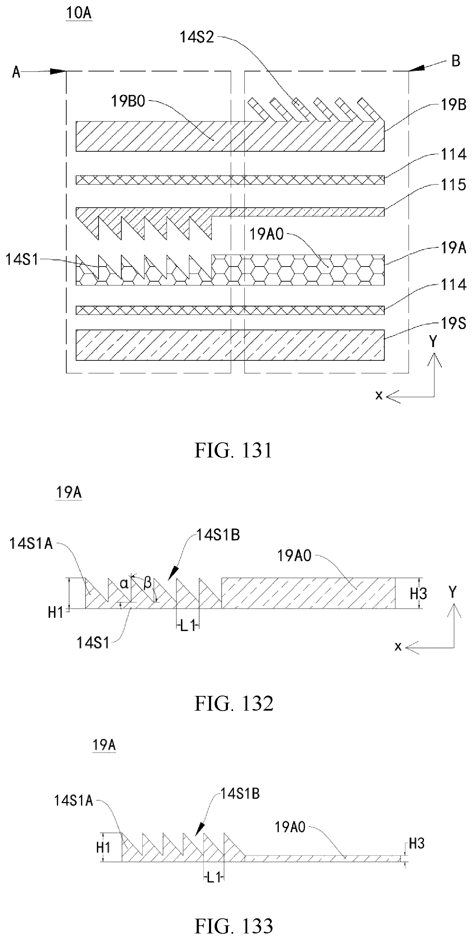

FIG. 131 is a diagram of division of a first region A and a second region B of the optical waveguide 10A shown in FIG. 129. In a possible implementation, the optical waveguide 10A includes a first direction X and a second direction Y. The first direction X may be a length direction of the optical waveguide 10A, and the second direction Y may be a thickness direction of the optical waveguide 10A. Both an optical engine and the user may be located on a same side in the second direction Y. It may be understood that the second direction Y is a thickness direction of the lens of the near-eye display device. The substrate layer 19S, the first grating layer 19A, the medium layer 115, the adhesion enhancement layer 114, and the second grating layer 19B are sequentially disposed in a stacked manner in the second direction Y of the optical waveguide 10A. The optical waveguide 10A may include a first region A and a second region B that are disposed in parallel in the first direction X. Dashed rectangular boxes in FIG. 131 represent the first region A and the second region B. Each of the first grating layer 19A and the second grating layer 19B is at least partially located in the first region A, and are partially located in the second region B. The optical engine may exactly face the first region A, and an eye of the user may exactly face the second region B. In this way, the optical engine may emit an image light ray to the first region A, and the image light ray is coupled into the optical waveguide by a grating structure in the first region A, is propagated to the second region B through total internal reflection propagation in the optical waveguide, and is coupled by a grating structure in the second region B out to a human eye, so as to form a virtual image for the user to view.

In a possible implementation, with reference to FIG. 131, the first grating layer 19A includes a first grating structure 14S1. Specifically, the first grating layer 19A includes a first grating structure 14S1 and a first grating layer body 19A0 that are connected to each other, and the first grating structure 14S1 may be used as an in-coupling grating, and configured to diffract an incident light ray into an optical waveguide. The first grating structure 14S1 is located in the first region A, and the first grating layer body 19A0 is located in the second region B.

Refer to FIG. 132. FIG. 132 is a diagram of a structure of a first grating layer 19A according to an implementation of this application. The first grating structure 14S1 includes a plurality of first grating units 14S1A. In an implementation, the first grating unit 14S1A may be a micro-nanostructure with a triangular cross section, or may be a micro-nanostructure in another form. In a cross-sectional view, the plurality of first grating units 14S1A may be periodically arranged along the first direction X. A first groove 14S1B is formed between two adjacent first grating units 14S1A. The plurality of first grating units 14S1A may have a same height H1, a same width L1, and a same distance. It may be understood that a specific shape and size of the first grating unit 14S1A may be specifically set based on a light ray that needs to be refracted. Therefore, in optical waveguides 10A of different sizes, shapes and sizes of first grating units 14S1A may vary. The first grating layer body 19A0 is located on a right side of the first grating structure 14S1, and a cross section of the first grating layer body 19A0 may be a rectangle. The height H1 of the first grating unit 14S1A may be the same as or different from a height H3 of the first grating layer body 19A0.

FIG. 133 shows an architecture of another first grating layer 19A. In a possible implementation, with reference to FIG. 133, a height H1 of a first grating unit 14S1A is different from a height H3 of a first grating layer body 19A0. The height H3 of the first grating layer body 19A0 may be less than the height H1 of the first grating unit 14S1A. There is a first groove 14S1B between two adjacent first grating units 14S1A. In a possible implementation, the height H1 of the first grating unit 14S1A may be 100 nm to 400 nm, and a width L1 of the first grating unit 14S1A may be 200 nm to 600 nm. In a possible implementation, with reference to FIG. 132, the first grating unit 14S1A may include a blaze angle $\alpha$ and an anti-blaze angle $\beta$, where the blaze angle $\alpha$ is an angle formed by a right slant edge of the first grating unit 14S1A and a horizontal plane in the figure, and the anti-blaze angle $\beta$ is an angle formed by a left slant edge of the first grating unit 14S1A and the horizontal plane in the figure. The blaze angle α may be 20° to 50°, and the anti-blaze angle β may be 70° to 90°.

In a possible implementation, a refractive index of the first grating layer 19A is 1.6 to 1.9, and in a possible implementation, a thickness of the first grating layer 19A is 100 nm to 400 nm. The first grating layer 19A has a high refractive index, which can effectively improve optical efficiency and improve a refractive index of an electronic device 1000 having the optical waveguide 10A. In another implementation, the refractive index of the first grating layer 19A may alternatively be greater than 1.9. In addition, controlling the thickness of the first grating layer 19A to be 100 nm to 400 nm can effectively control an overall thickness of the optical waveguide 10A, thereby implementing lightness and thinning of the electronic device 1000 having the optical waveguide 10A.

In a possible implementation, with reference to FIG. 131, the second grating layer 19B includes a second grating structure 14S2 and a second grating layer body 19B0 that are connected to each other, the first grating structure 14S1 and the second grating structure 14S2 may have different structures, and the first grating structure 14S1 and the second grating structure 14S2 may have different sizes or periods. Specifically, the second grating structure 14S2 may be used as an out-coupling grating, and configured to couple a light ray in the optical waveguide out to the human eye. The second grating structure 14S2 is located in the second region B, and the second grating layer body 19B0 is located in the first region A and the second region B. An orthographic projection of the second grating structure 14S2 onto the substrate layer 19S at least partially overlaps an orthographic projection of the first grating layer body 19A0 onto the substrate layer 19S. An orthographic projection of the second grating layer body 19B0 onto the substrate layer 19S at least partially overlaps an orthographic projection of the first grating structure 14S1 onto the substrate layer 19S.

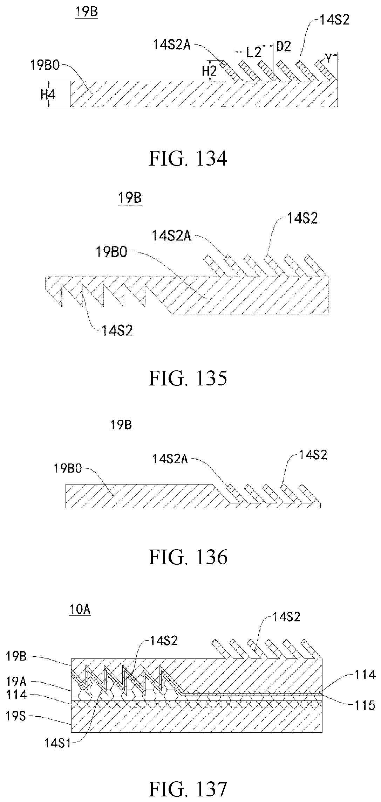

FIG. 134 is a diagram of a structure of a second grating layer 19B according to an implementation of this application. Refer to FIG. 134. The second grating structure 14S2 includes a plurality of second grating units 14S2A. In an implementation, the second grating structure 14S2 is a slanted grating, and the second grating unit 14S2A may be a micro-nanostructure with a quadrilateral cross section. In a cross-sectional view, the plurality of second grating units 14S2A may be periodically arranged along the first direction X of the optical waveguide 10A. The plurality of second grating units 14S2A may have a same height H2, a same width L2, or a same distance D2. Certainly, in another implementation, the cross section shape of the second grating unit 14S2A may alternatively be another shape, or specific sizes of the plurality of second grating units 14S2A are not completely the same. This is not specifically limited.

A part of the second grating layer body 19B0 is located below the second grating structure 14S2, that is, the second grating structure 14S2 is formed on a part of the second grating layer body 19B0. A cross section of the second grating layer body 19B0 may be a rectangle. The second grating layer body 19B0 has a height H4. In a possible implementation, a sum of the height H2 of the second grating unit 14S2A and the height H4 of the second grating layer body 19B0 is a height of the second grating layer 19B, and the height of the second grating layer 19B may be 100 nm to 400 nm. A width L1 of the second grating unit 14S2A may be 200 nm to 600 nm. A tilt angle y of the second grating unit 14S2A may be 20° to 50°.

FIG. 135 is a diagram of a structure of a second grating layer 19B according to an implementation of this application. Refer to FIG. 135. In an implementation, the second grating layer 19B may have a double-sided grating structure, that is, a part of second grating structures 14S2 are distributed on a side of a top surface of the second grating layer body 19B0, and a part of second grating structures 14S2 are distributed on a side of a bottom surface of the second grating layer body 19B0. With reference to FIG. 131 and FIG. 135, in an implementation, the second grating structure 14S2 distributed on the top surface of the second grating layer body 19B0 may be located in the second region B, and the second grating structure 14S2 distributed on the bottom surface of the second grating layer body 19B0 may be located in the first region A. As shown in FIG. 135, in an implementation, the second grating structure 14S2 distributed on the bottom surface of the second grating layer body 19B0 and the second grating structure 14S2 distributed on the top surface of the second grating layer body 19B0 have different structural forms, or have different arrangement periods and vector directions. Design of such different grating architectures can be used to modulate diffraction efficiency of the optical waveguide.

FIG. 136 is a diagram of a structure of a second grating layer 19B according to an implementation of this application. Refer to FIG. 136. In an implementation, an overall thickness of the second grating layer 19B is less than an overall thickness of the second grating layer provided in the implementation shown in FIG. 135. Top surfaces of the plurality of second grating units 14S2A of the second grating structure 14S2 are flush with the top surface of the second grating layer body 19B0. A bottom surface of the second grating layer 19B in which the second grating structure 14S2 is located is coplanar with the bottom surface of the second grating layer body 19B0.

In the optical waveguide shown in FIG. 131, the medium layer 115 is disposed on the first grating layer 19A, the medium layer 115 is used to fill the first groove 14S1B of the first grating structure 14S1, and the medium layer 115 is stacked on the first grating layer 19A to form a flat surface, that is, the medium top surface 115S is planar in shape. The adhesion enhancement layer 114 is formed on the medium top surface 115S, and the second grating layer 19B further needs to be disposed on the adhesion enhancement layer 114. The flat medium top surface 115S constructed by using the medium layer 115 provides a basis for fabricating the adhesion enhancement layer 114 and the second grating layer 19B, and has advantages of easy fabrication and easy control on diffraction efficiency of the optical waveguide.

FIG. 137 is a diagram of an optical waveguide according to an implementation of this application. In an implementation, with reference to FIG. 137, a substrate layer 19S and a first grating layer 19A are connected by using an adhesion enhancement layer 114, and the adhesion enhancement layer is of a flat-plate-shaped architecture. A structural form of the first grating layer 19A is the same as or similar to a structural form of the first grating layer 19A shown in FIG. 133. A medium layer 115 is of a film-like structure. The medium layer 115 covers a surface of the first grating layer 19A, and the medium layer 115 covers a surface of a first grating structure 14S1. It may be understood that the medium layer 115 is a layer structure that is evenly disposed on a surface that is of the first grating layer 19A and that is away from the substrate layer 19S. In this implementation, the medium layer 115 cannot form a flat surface to carry a second grating layer 19B. A form of the medium layer 115 is consistent with a surface form of the first grating layer 19A. In this implementation, there is an adhesion enhancement layer 114 between the second grating layer 19B and the medium layer 115, and a form of the adhesion enhancement layer 114 is consistent with the form of the medium layer 115.

In the implementation shown in FIG. 137, a bottom surface of the second grating layer 19B fits with a structural form of a top surface of the first grating layer 19A, so that the second grating layer 19B is attached to a surface of the adhesion enhancement layer 114. A surface of the second grating layer 19B is consistent with a form of the first grating structure 14S1 on the first grating layer 19A, so that a grating structure is formed on the bottom surface of the second grating layer 19B. It may be understood that, in this implementation, second grating structures 14S2 on the second grating layer 19B are distributed on a top surface and the bottom surface of the second grating layer 19B. A part of second grating structures 14S2 are formed on the top surface of the second grating layer 19B by using a fabrication process, and the other part of second grating structures 14S2 are formed by using structures of the second grating layer 19B and the first grating layer 19A. The optical waveguide provided in the implementation shown in FIG. 137 has an advantage of thinness, and further helps improve diffraction efficiency of the optical waveguide.

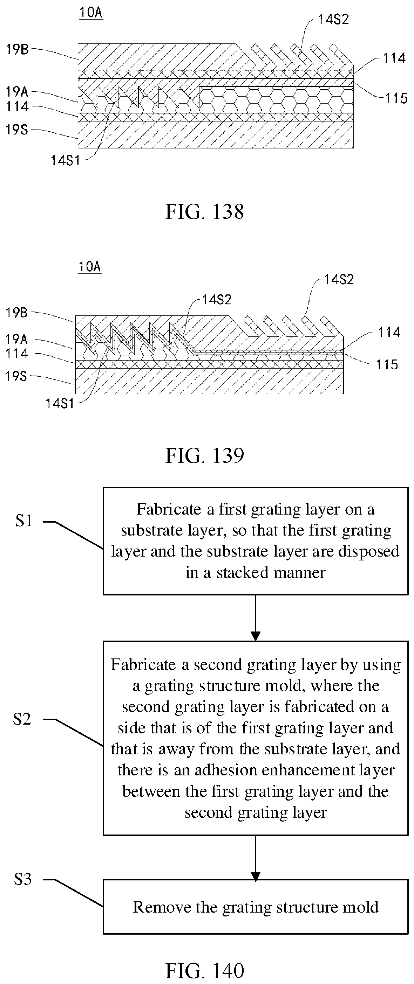

FIG. 138 is a diagram of an optical waveguide according to an implementation of this application. Refer to FIG. 138. In an implementation, a substrate layer 19S and a first grating layer 19A are connected by using an adhesion enhancement layer 114, and the adhesion enhancement layer is of a flat-plate-shaped architecture. A structural form of the first grating layer 19A is the same as or similar to a structural form of the first grating layer 19A shown in FIG. 132. A structural form of a medium layer 115 is the same as or similar to a structural form of the medium layer 115 in FIG. 131. The medium layer 115 is stacked on the first grating layer 19A to form a flat surface, that is, a medium top surface 115S is planar in shape. The adhesion enhancement layer 114 is formed on the medium top surface 115S. The adhesion enhancement layer 114 between a second grating layer 19B and the medium layer 115 is of a flat-plate-shaped structure. In this implementation, a structural form of the second grating layer 19B is the same as or similar to a structural form of the second grating layer 19B shown in FIG. 136.

FIG. 139 is a diagram of an optical waveguide according to an implementation of this application. Refer to FIG. 139. In an implementation, a substrate layer 19S and a first grating layer 19A are connected by using an adhesion enhancement layer 114, and the adhesion enhancement layer is of a flat-plate-shaped architecture. A structural form of the first grating layer 19A is the same as or similar to a structural form of the first grating layer 19A shown in FIG. 133. A structural form of a medium layer 115 is the same as or similar to a structural form of the medium layer 115 in the implementation shown in FIG. 137. That is, the medium layer 115 is film-like and covers a surface of the first grating layer 19A. A structural form of the adhesion enhancement layer 114 between a second grating layer 19B and the medium layer 115 is also the same as or similar to a structural form of the adhesion enhancement layer 114 in the implementation shown in FIG. 137. In this implementation, a structural form of the second grating layer 19B is different from that in the foregoing implementation. A grating structure is also formed on a bottom surface of the second grating layer 19B. Second grating structures 14S2 on the second grating layer 19B are distributed on a top surface and the bottom surface of the second grating layer 19B. A part of second grating structures 14S2 are formed by using structures of the second grating layer 19B and the first grating layer 19A. A part of second grating structures 14S2 are formed on the top surface of the second grating layer 19B by using a fabrication process. As shown in FIG. 139, a top surface of the second grating structure 14S2 distributed on the top surface of the second grating layer 19B is coplanar with the top surface of the second grating layer 19B, that is, the second grating structure 14S2 distributed on the top surface of the second grating layer 19B is a structure embedded in the second grating layer 19B.

This application further provides a method for fabricating an optical waveguide. Refer to FIG. 140. FIG. 140 is a flowchart of a method for fabricating an optical waveguide according to an implementation of this application. The method for fabricating an optical waveguide provided in this application is used to prepare the optical waveguide provided in the foregoing implementations. In an implementation, the method for fabricating an optical waveguide specifically includes steps S1 to S3.

Step S1: Fabricate a first grating layer on a substrate layer.

Step S2: Fabricate a second grating layer by using a grating structure mold, where the second grating layer is fabricated on a side that is of the first grating layer and that is away from the substrate layer, and there is an adhesion enhancement layer between the first grating layer and the second grating layer.

Step S3: Remove the grating structure mold.

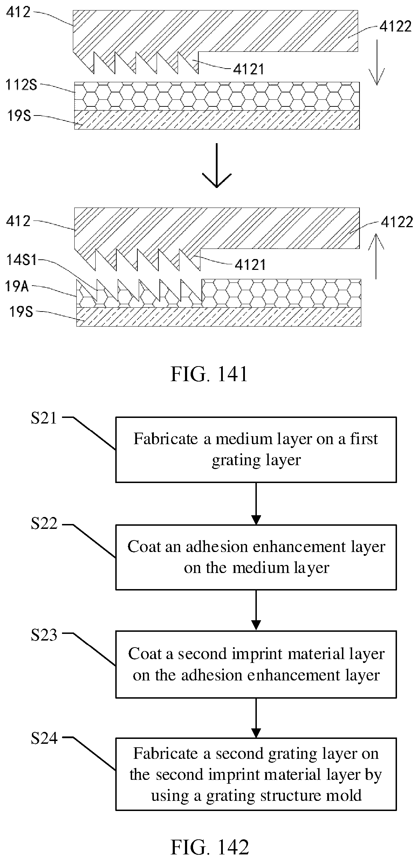

For a specific description of step S1, refer to FIG. 141 for a specific implementation. A first grating layer 19A is fabricated on a substrate layer 19S, so that the first grating layer 19A and the substrate layer 19S are disposed in a stacked manner. The substrate layer 19S may be made of a material with high transparency such as glass or resin, and the substrate layer 19S is configured to carry the first grating layer 19A. The first grating layer 19A may be formed by using a nano-imprinting process.

As shown in FIG. 141, a first imprint material layer 112S is spin-coated on the substrate layer 19S, and the first imprint material layer 112S may be specifically a nano-imprint adhesive. A first grating structure mold 412 is provided, the first grating structure mold 412 is pressed onto the first imprint material layer 112S on a nano-imprinting device by using a nano-imprinting process, then the first imprint material layer 112S is cured, and the first grating layer 19A is obtained after demolding.

Specifically, the first grating structure mold 412 may include two parts: a first mold structure 4121 corresponding to a first grating structure 14S1 and a second mold structure 4122 corresponding to a first grating layer body 19A0. In an implementation, the first mold structure 4121 fits with a structure of the first grating structure 14S1. For example, the first grating structure 14S1 is in a sawtooth shape, and the first mold structure 4121 is in a sawtooth shape complementary to a form of the first grating structure 14S1. The second mold structure 4122 has a same planar shape as the first grating layer body 19A0. In another implementation, the first grating structure mold 412 may have only the first mold structure 4121, that is, the first grating structure 14S1 may be obtained by pressing the first grating structure mold 412 onto the first imprint material layer 112S in a first region A.

In a possible implementation, a manner of curing the first imprint material layer 112S may be light curing, thermal curing, chemical curing, or the like. In a possible implementation, a manner of curing the first imprint material layer 112S is ultraviolet curing, because an ultraviolet curing process is mature and mass production is easy to implement.

In a possible implementation, the first imprint material layer 112S is a nano-imprint adhesive material with a high refractive index, for example, polyorganosiloxane, and a refractive index of the first grating layer 19A is 1.6 to 1.9. A thickness of the first grating layer 19A is 100 nm to 400 nm. It may be understood that the thickness of the first grating layer 19A should be a straight-line distance between a farthest position of the first grating layer 19A from the substrate layer 19S and a nearest position of the substrate layer 19S in a thickness direction Y of the optical waveguide 10A. The refractive index of the first grating layer 19A is designed to be 1.6 to 1.9, so that refraction efficiency of the first grating layer 19A can be effectively improved. In addition, the first grating layer 19A is formed by using a nano-imprinting process, and the process is simple, and is easy to implement for mass production.

Refer to FIG. 128 and FIG. 129. In a possible implementation, before the first grating layer 19A is fabricated on the substrate layer 19S, the method for fabricating an optical waveguide provided in this application may further include: fabricating an adhesion enhancement layer 114 on the substrate layer 19S, where the first grating layer 19A is fabricated on the adhesion enhancement layer 114. The adhesion enhancement layer 114 is 0 nm to 20 nm. It may be understood that, the thickness of the adhesion enhancement layer 114 is controlled to be within the range, so that connection strength between the first grating layer 19A and the substrate layer 19S can be ensured without affecting an overall thickness of the optical waveguide 10A. When the thickness of the adhesion enhancement layer 114 exceeds this range, an excessively large overall thickness of the optical waveguide 10A is likely to be caused, and refraction of a light ray is affected.

A specific description of step S2 (that is, fabricating the second grating layer by using the grating structure mold, where there is an adhesion enhancement layer between the first grating layer and the second grating layer) in the implementation provided in FIG. 140 is as follows.

Refer to FIG. 128 and FIG. 129. In a possible implementation, the adhesion enhancement layer 114 may be fabricated in advance on the first grating layer 19A, and then the second grating layer 19B is fabricated on the adhesion enhancement layer 114.

In a possible implementation, with reference to FIG. 142, FIG. 142 is a flowchart of steps of fabricating the second grating layer 19B by using the grating structure mold in step S2 in the implementation shown in FIG. 140. The step of fabricating the second grating layer 19B by using the grating structure mold specifically includes step S21 to step S24.

Step S21: Fabricate a medium layer on the first grating layer.

Step S22: Coat the adhesion enhancement layer on the medium layer.

Step S23: Coat a second imprint material layer on the adhesion enhancement layer.

Step S24: Fabricate the second grating layer on the second imprint material layer by using the grating structure mold.

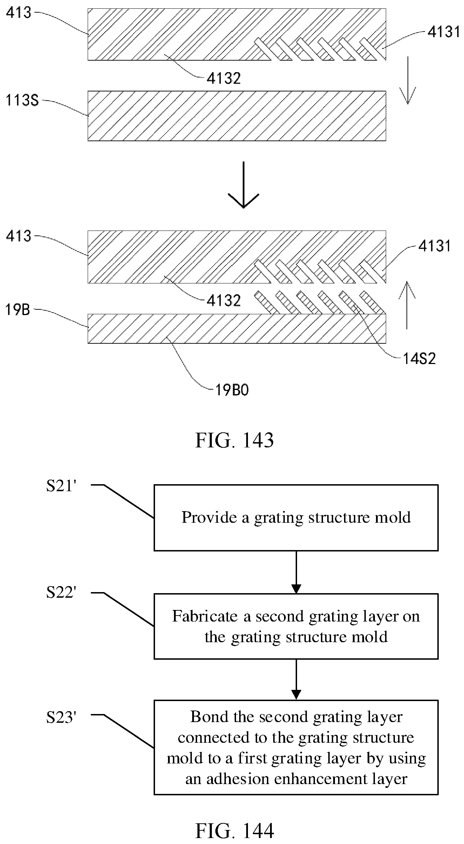

Refer to FIG. 143. A method for fabricating the second grating layer in the implementation provided in FIG. 142 is specifically described with reference to the figure.

An imprint material layer 113S shown in FIG. 143 is the second imprint material layer coated on the adhesion enhancement layer in step S23. The fabrication method shown in FIG. 143 is a specific method (that is, specific description of step S24) for fabricating the second grating layer on a basis of step 23. A second grating structure mold 413 is provided, the second grating structure mold 413 is pressed onto the second imprint material layer 113S on the nano-imprinting device by using a nano-imprinting process, then the second imprint material layer 113 S is cured, and the second grating layer 19B is obtained after demolding

It may be understood that the second grating structure mold 413 may also include two parts: a third mold structure 4131 corresponding to a second grating structure 14S2 and a fourth mold structure 4132 corresponding to a second grating layer body 19B0. The third mold structure 4131 fits with a form of the second grating structure 14S2. Specifically, the second grating structure 1452 is an inclined strip grating structure, and the third mold structure 4131 may be an inclined strip structure complementary to the second grating structure 14S2. The fourth mold structure 4132 may have a same planar shape as the second grating layer body 19B0. In another implementation, the second grating structure mold 413 may have only the third mold structure 4131, that is, the second grating structure 14S2 can be obtained by pressing the second grating structure mold 413 onto the second imprint material layer 113S in a second region B.

In summary, in a specific implementation, the second grating layer 19B may be formed by using a nano-imprinting process. That is, the second grating structure mold 413 is provided, and the second grating layer 19B is obtained by using the second imprint material layer 113S and the second grating structure mold 413 together. A material used by the second grating layer 19B may be the same as or different from a material used by the first grating layer 19A. For example, the material used by the first grating layer 19A may be a thermal-curable material, that is, the first imprint material layer 112S is cured through heating to form the first grating layer 19A. The material used by the second grating layer 19B may be an ultraviolet-curable material, that is, the second imprint material layer 113S is cured through ultraviolet irradiation to form the second grating layer 19B.

In an implementation, a refractive index of the second imprint material layer 113S is 1.6 to 1.9. In a possible implementation, a thickness of the second imprint material layer 113S is 100 nm to 400 nm. The second imprint material layer 113S has a high refractive index, which can effectively improve diffraction efficiency. In another implementation, the refractive index of the second imprint material layer 113S may alternatively be greater than 1.9. In addition, controlling the thickness of the second imprint material layer 113S to be 100 nm to 400 nm can ensure that the thickness of the obtained second grating layer 19B does not exceed a maximum value of the range. In this way, an overall thickness of the optical waveguide 10A can be effectively controlled, to achieve lightness and thinness of the optical waveguide 10A.

In another implementation, in a specific fabrication method of step S2 in the implementation shown in FIG. 140, alternatively, the second grating layer may be first fabricated by using a grating structure mold, then the second grating layer is bonded to the first grating layer by using the adhesion enhancement layer, and then the grating structure mold is removed. In summary, the second grating layer is fabricated in advance on the grating structure mold, steps of fabricating the first grating layer and the second grating layer can be performed simultaneously, and structures of various layers do not need to be fabricated in sequence. After the first grating layer and the second grating layer are separately fabricated, they are bonded by using the adhesion enhancement layer, thereby improving manufacturing efficiency and facilitating large-scale production.

In a possible implementation, with reference to FIG. 144, FIG. 144 is a flowchart of steps of fabricating the second grating layer 19B by using the grating structure mold in step S2 in the implementation shown in FIG. 140 in another implementation. The step of fabricating the second grating layer 19B by using the grating structure mold includes step S21' to step S23'.

Step S21': Provide the grating structure mold. Specifically, the grating structure mold provided in this step may be a second grating structure mold complementary to the second grating layer.

Step S22': Fabricate the second grating layer on the grating structure mold. Specifically, the second imprint material layer is spin-coated on the grating structure mold, and the second imprint material layer may be specifically a nano-imprint adhesive. A material of the first grating layer may be different from or the same as a material of the second grating layer.

Step S23': Bond the second grating layer connected to the grating structure mold to the first grating layer by using the adhesion enhancement layer.

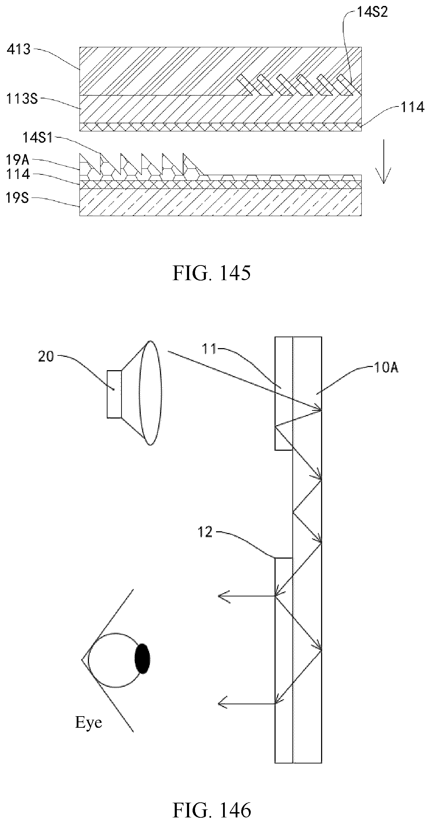

Refer to FIG. 145. A method for fabricating the second grating layer in the implementation provided in FIG. 144 is specifically described with reference to the figure. Specifically, with reference to FIG. 145, a second imprint material layer 113S is coated on a second grating structure mold 413, the second grating structure mold 413 has micro-nanostructures used to form a second grating structure 14S2, and the second imprint material layer 113S is combined with the second grating structure mold 413, so that the second grating structure 14S2 is formed on the second imprint material layer 113S. Before the second imprint material layer 113S is cured, an adhesion enhancement layer 114 may be disposed on a surface that is of the second imprint material layer 113S and that is away from the second grating structure mold 413, then the second imprint material layer 113S together with the second grating structure mold 413 is disposed on the first grating layer 19A, and then the second imprint material layer 113S is cured. The adhesion enhancement layer 114 disposed in this manner may be completely covered on the first grating layer 19A by using a deformable characteristic of the second imprint material layer 113S, thereby improving uniformity of the adhesion enhancement layer 114.

In another implementation, the adhesion enhancement layer 114 may alternatively be disposed on the first grating layer 19A. Then the second imprint material layer 113 S together with the second grating structure mold 413 is disposed on the first grating layer 19A together, and then the second imprint material layer 113S is cured.

It may be understood that, when the second imprint material layer 113S still has a deformability capability, the second imprint material layer 113S can be easily disposed on the first grating layer 19A. In addition, the second imprint material layer 113S is in full contact with a first grating structure 14S1 on the first grating layer 19A, so that a structure complementary to the first grating structure 14S1 may be formed on a surface that is of the second imprint material layer 113S and that faces the first grating layer 19A. After the second imprint material layer 113 S is cured to form the second grating layer 19B, a surface form of the surface that is of the second grating layer 19B and that faces the first grating layer 19A is the same as a surface form of the first grating layer 19A.

In step S3 in the implementation shown in FIG. 140, the step of removing the grating structure mold may be performed after the second grating layer is cured for formation, and is closely connected to the first grating layer by using the adhesion enhancement layer.

Refer to FIG. 137. FIG. 138, and FIG. 139. In this application, the adhesion enhancement layer 114 is disposed between the first grating layer 19A and the second grating layer 19B, so that the first grating layer 19A is separated from the second grating layer 19B. Therefore, during fabrication of the second grating layer 19B, the first grating layer 19A is not affected by a pressure or an impact force, and a probability of deformation and damage of the first grating layer 19A is reduced. In addition, firmness between the second grating layer 19B and the adhesion enhancement layer 114 can be maintained by utilizing an adhesion characteristic of the adhesion enhancement layer 114 after they are connected, thereby improving reliability of demolding. In addition, the second grating layer 19B may be bonded to the first grating layer 19A by using the adhesion enhancement layer 114, thereby improving connection strength between the first grating layer 19A and the second grating layer 19B, avoiding loosening between the first grating layer 19A and the second grating layer 19B, and facilitating subsequent processing of the optical waveguide 10A.

Refer to FIG. 137 and FIG. 139. A medium layer 115 may be fabricated on the first grating layer 19A by using a coating process. A thickness of the medium layer 115 is 0 nm to 50 nm. A specific coating manner may be electron beam evaporation, magnetron sputtering, atomic layer deposition, or the like. It is easier to form the medium layer 115 by using the coating process, so that mass production of a product can be improved. In a possible implementation, the medium layer 115 fabricated by using the coating process may be filled in slits of micro-nanostructures of the first grating structure 14S1. In a possible implementation, a material of the medium layer 115 includes an oxide or a nitride, and may specifically include at least one of silicon oxide, silicon nitride, gallium nitride, and titanium dioxide. In a possible implementation, the material of the medium layer 115 may be titanium dioxide. In a possible implementation, a refractive index of the medium layer 115 is 1.8 to 2.3.

In a possible implementation, the medium layer 115 may alternatively be formed on the first grating layer 19A through applying, and a thickness of the medium layer 115 may be 100 nm to 400 nm.

Refer to FIG. 137. FIG. 138, and FIG. 139. The method for fabricating an optical waveguide provided in this application includes: applying the adhesion enhancement layer 114 on the medium layer 115. A thickness of the adhesion enhancement layer 114 is 0 nm to 20 nm. It may be understood that, the thickness of the adhesion enhancement layer 114 is controlled to be within the range, so that connection strength between the first grating layer 19A and the substrate layer 19S can be ensured without affecting the overall thickness of the optical waveguide 10A. When the thickness of the adhesion enhancement layer 114 exceeds this range, an excessively large overall thickness of the optical waveguide 10A is likely to be caused, and refraction of a light ray is affected. The adhesion enhancement layer 114 is configured to be combined with the second grating layer.

In this application, the medium layer 115 is fabricated on the first grating layer 19A before the adhesion enhancement layer 114 is applied, so that the medium layer 115 can form force protection for the first grating layer 19A, to ensure that the first grating layer 19A is not easily deformed in a process of imprinting the second grating layer 19B. In addition, fabrication of the medium layer 115 on a surface of the first grating layer 19A can further improve a refractive index of a light ray at the first grating layer 19A, thereby achieving excellent optical performance of the optical waveguide 10A.

In a possible implementation, in a process of bonding the second grating layer connected to the grating structure mold to the first grating layer by using the adhesion enhancement layer, the adhesion enhancement layer may be in direct contact with the first grating layer. That is, no medium layer is disposed between the adhesion enhancement layer and the first grating layer, to achieve a thinning effect of the optical waveguide, thereby reducing a thickness of the optical waveguide while a thickness of each layer is unchanged.

Refer to the implementations shown in FIG. 143 and FIG. 145. Before the step of fabricating the second grating layer 19B by using the grating structure mold, the method for fabricating an optical waveguide includes: performing anti-sticking processing on a working surface of the second grating structure mold 413, where in a process of fabricating the second grating layer 19B on the second imprint material layer 113S by using the second grating structure mold 413, the working surface of the second grating structure mold 413 is in contact with the second imprint material layer. Specifically, the working surface of the second grating structure mold 413 may be a surface that is of the second grating structure mold 413 and that is in contact with the second imprint material layer 113S. Anti-sticking processing is performed on the working surface, in order that demolding can be performed more smoothly, the second grating layer 19B is prevented from being adhered to the second grating structure mold 413, and damage to the second grating structure 14S2 is avoided. A specific form of the anti-sticking processing is not specifically limited. For example, the anti-sticking processing may be: performing evaporation or fluoride infiltration processing on the working surface of the second grating structure mold 413, to facilitate demolding. In another implementation, alternatively, an anti-sticking agent such as paraffin or a lubricant may be applied to the working surface.

In a possible implementation, the step of fabricating a medium layer on the first grating layer further includes: performing surface processing on the medium layer by using a chemical-mechanical grinding process. Specifically, surface processing may be performed on a medium top surface of the medium layer, to improve roughness of the surface, thereby improving an adsorption force of a surface of the medium layer, increasing bonding strength between the medium layer and the adhesion enhancement layer, and avoiding detachment of the adhesion enhancement layer.

In a possible implementation, in a process of fabricating the first grating layer on the substrate layer, the first grating layer is formed on the first imprint material layer by using a nano-imprinting process. In this process, a force applied to the first imprint material is a first pressure. In a process of bonding the second grating layer connected to the grating structure mold to the first grating layer by using the adhesion enhancement layer, a force applied to the first grating layer and the second grating layer a second pressure. The second pressure is less than or equal to the first pressure. It may be understood that, both the first grating layer and the second grating layer fabricated by using the nano-imprinting process may have micro-nanostructures. During fabrication of the first grating layer, the substrate layer is below the first grating layer and has no micro-nanostructures. Therefore, in order to ensure formation of the first grating layer, a large first pressure may be used. During fabrication of the second grating layer on the first grating layer, the first grating layer has the first grating structure, and the first grating structure is micro-nanostructures. To prevent the first grating structure from being damaged due to an excessively large imprinting force, the second pressure is restricted to be less than or equal to the first pressure in this application, to protect the first grating structure on the first grating layer in a fabrication process.

Solution 11: Filling protection and anti-reflection structures between a waveguide substrate and a protection layer

In a possible implementation, with reference to FIG. 146, an optical waveguide 10A includes an in-coupling grating 11 and an out-coupling grating 12. Both the in-coupling grating 11 and the out-coupling grating 12 may be micro-nanostructures on the optical waveguide 10A, and have light reflection and light transmission capabilities. The in-coupling grating 11 and the out-coupling grating 12 may be located on a same surface of a lens 10 or respectively located on two opposite surfaces of the lens 10. The in-coupling grating 11 is opposite to an optical engine 20. A light ray emitted by the optical engine 20 is projected onto the in-coupling grating 11. An incident light ray enters the optical waveguide 10A through the in-coupling grating 11, undergoes total internal reflection propagation in the optical waveguide 10A, and is projected onto a human eye by the out-coupling grating 12, so that the human eye can see a virtual image.

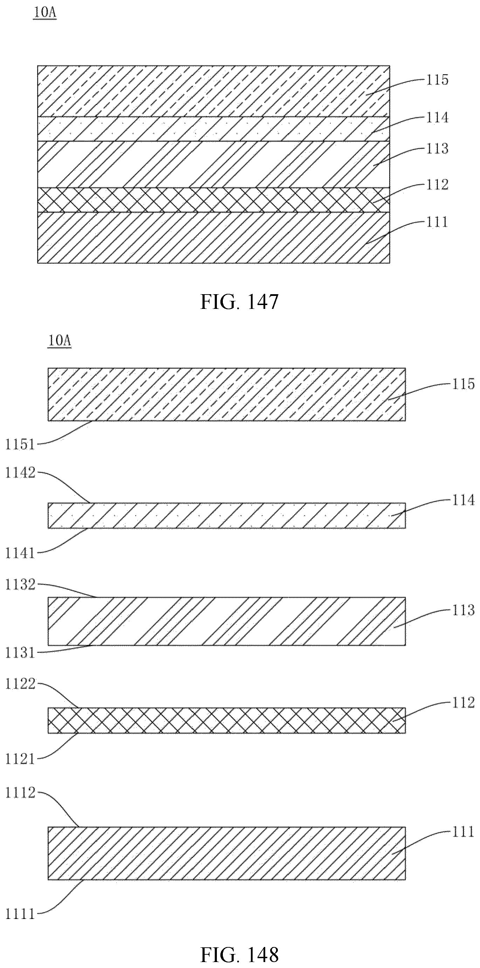

FIG. 147 is a cross-sectional view of an optical waveguide 10A. The optical waveguide 10A includes an optical waveguide body 111, a first anti-reflection layer 112, a filling body layer 113, a second anti-reflection layer 114, and a surface protection layer 115 that are sequentially disposed in a stacked manner, the first anti-reflection layer 112 is located between the optical waveguide body 111 and the filling body layer 113, and a difference between a refractive index of the filling body layer 113 and a refractive index of air is within a first preset range. The second anti-reflection layer 114 is located between the filling body layer 113 and the surface protection layer 115, a refractive index of the second anti-reflection layer 114 exhibits a gradient change trend, a difference between a refractive index of a part that is of the second anti-reflection layer 114 and that is close to the filling body layer 113 and the refractive index of the filling body layer 113 is within a second preset range, and a difference between a refractive index of a part that is of the second anti-reflection layer 114 and that is close to the surface protection layer 115 and a refractive index of the surface protection layer 115 is within a third preset range.

In this application, the filling body layer 113 is disposed between the surface protection layer 115 and the optical waveguide body 111. Because a refractive index of the filling body layer 113 is small, for example, close to that of air, there is a refractive index difference between the filling body layer 113 and the surface protection layer 115, and there is also a refractive index difference between the filling body layer 113 and the optical waveguide body 111. If the first anti-reflection layer 112 and the second anti-reflection layer 114 are not disposed, light ray reflection occurs at a connection position between the filling body layer 113 and the optical waveguide body 111 and at a connection position between the filling body layer 113 and the surface protection layer 115. This reflection affects light transmission of the optical waveguide. Therefore, in this application, the first anti-reflection layer 112 and the second anti-reflection layer 114 are disposed to achieve an overall anti-reflection effect of the optical waveguide.

The first anti-reflection layer 112 may be a single-layer film architecture. In this case, a refractive index of the first anti-reflection layer 112 is related to refractive indexes of media (the filling body layer 113 and the optical waveguide body 111) at an upper interface and a lower interface, and is estimated to be a square root of a product of the two refractive indexes (the refractive index of the filling body layer 113 and the refractive index of the optical waveguide body 111), and a thickness of the first anti-reflection layer 112 is 1/4 of an incident wavelength. Alternatively, the first anti-reflection layer 112 may be a multi-layer film structure. If the first anti-reflection layer is a multi-layer film structure, an equivalent refractive index of the multi-layer film structure is required to be the foregoing value, to achieve a low reflectivity (which is theoretically reduced to 0) at an interface, thereby achieving a function of anti-reflection at the surface.

Specifically, the optical waveguide 10A shown in FIG. 147 and FIG. 148 includes: an optical waveguide body 111, a first anti-reflection layer 112, a filling body layer 113, a second anti-reflection layer 114, and a surface protection layer 115 that are sequentially distributed from bottom to top. FIG. 148 is an exploded diagram of the structure shown in FIG. 147. The optical waveguide body 111 may be an optical waveguide wafer, and includes a first surface 1111 and a second surface 1112 that face away from each other, and the first anti-reflection layer 112 is disposed on the second surface 1112. The optical waveguide body 111 is configured to receive an incident light ray of an optical engine and couple in the incident light ray, so that the incident light ray undergoes total internal reflection propagation in the optical waveguide body 111, and is coupled to the human eye to form a virtual image. Specifically, the optical waveguide body 111 includes an in-coupling grating, an out-coupling grating, and a waveguide substrate. The in-coupling grating is configured to receive an incident light ray sent by the optical engine, couple the incident light ray into the waveguide substrate, and perform total internal reflection propagation in the waveguide substrate. When a light ray propagated in the waveguide substrate encounters the out-coupling grating, the out-coupling grating couples the light ray to the human eye to form a virtual image. Moreover, the optical waveguide body 111 is configured to transmit ambient light.

FIG. 147 and FIG. 148 schematically show a cross-sectional view of the optical waveguide 10A in a thickness direction according to an implementation. It may be understood that an overall area or a shape of an outer contour of the optical waveguide body 111 is not specifically limited. A material for fabricating the optical waveguide body 111 may be silicon, silicon dioxide, or the like. This is not specifically limited. The optical waveguide body 111 may have light transmission. In a possible implementation, a refractive index of the optical waveguide body 111 is 1.9. In another implementation, the refractive index of the optical waveguide body 111 may alternatively be 1.7, 1.8, or 2.0.

In a possible implementation, with reference to FIG. 147 and FIG. 148, the first anti-reflection layer 112 includes a third surface 1121 and a fourth surface 1122 that face away from each other, and the third surface 1121 is in contact with the second surface 1112. The first anti-reflection layer 112 may be made of a transparent material, and a refractive index of a material for fabricating the first anti-reflection layer 112 may be close to the refractive index of air. It may be understood that the refractive index is a ratio of a propagation speed of light in a vacuum to a propagation speed of light in a medium. A higher refractive index of a material indicates a stronger capability of refraction of incident light. However, long-term use of a material with a high refractive index as a lens may cause damage to eyes. Long-term wearing of a material with a high refractive index may result in deterioration of visual quality, causing blurred vision of objects and increased dispersion, and affecting eyesight. Therefore, to ensure safety of a near-eye display device, a material with a low refractive index is used for the first anti-reflection layer 112 in this application. For example, the material for fabricating the first anti-reflection layer 112 is a siloxane polymer. In addition, the refractive index of the first anti-reflection layer 112 may be 1.37. Certainly, in another implementation, the refractive index of the first anti-reflection layer 112 may alternatively be 1.2, 1.3, 1.4, or the like.

In a possible implementation, the material for fabricating the first anti-reflection layer 112 may further have low haze. Haze (haze) is a percentage of intensity of transmitted light that deviates from incident light by more than 2.5 degrees in total transmitted light intensity. A higher haze value indicates a decrease in film luster, transparency, and especially an imaging effect. Therefore, in this application, haze of a material further needs to be considered for selection of the material for fabricating the first anti-reflection layer 112, to improve transparency and an imaging effect of the first anti-reflection layer 112. For example, haze of the first anti-reflection layer 112 may be less than 1%.

In a possible implementation, a process method for fabricating the first anti-reflection layer 112 includes but is not limited to: electron beam evaporation, sputtering, atomic layer deposition (ALD, Atomic Layer Deposition), physical vapor deposition (PVD, Physical Vapor Deposition), chemical vapor deposition (CVD, Chemical Vapor Deposition), and the like.

In a possible implementation, the first anti-reflection layer 112 is formed on a surface of the optical waveguide body 111 through coating. In addition, the thickness of the first anti-reflection layer 112 may be 137.5 nm.

In a possible implementation, with reference to FIG. 147 and FIG. 148, the filling body layer 113 includes a fifth surface 1131 and a sixth surface 1132 that face away from each other, and the fifth surface 1131 is in contact with the fourth surface 1122. The filling body layer 113 may also be made of a transparent material, and has a low refractive index and low haze. In a possible implementation, a difference between the refractive index of the filling body layer 113 and the refractive index of the air is within the first preset range. For example, the first preset range may be 0.1 to 0.4. Because the refractive index of air is 1, the refractive index of the filling body layer 113 may be 1.1 to 1.4. In a possible implementation, the first preset range is a range less than or equal to 0.25. For example, the refractive index of the filling body layer may be within a range of 1.1 to 1.25. The refractive index of the filling body layer is controlled to be within a range less than or equal to 0.25, mainly in order that the refractive index of the filling body layer is close to the refractive index of air to avoid affecting a field of view of the optical waveguide while filling protection is achieved between the optical waveguide body and the surface protection layer to make the optical waveguide body and the surface protection layer relatively fixed.

Haze of the filling body layer 113 may be less than 1%. In a possible implementation, a material for fabricating the filling body layer 113 may also be a siloxane polymer. However, because the siloxane polymer includes a plurality of molecular structure types, a siloxane polymer for fabricating the filling body layer 113 may be the same as or different from that for the first anti-reflection layer 112.

In a possible implementation, with reference to FIG. 147 and FIG. 148, the second anti-reflection layer 114 includes a seventh surface 1141 and an eighth surface 1142 that face away from each other, the surface protection layer 115 includes a ninth surface 1151, the seventh surface 1141 is in contact with the sixth surface 1132, and the eighth surface 1142 is in contact with the ninth surface 1151. The second anti-reflection layer 114 may also be made of a transparent material, and has a low refractive index and low haze. In a possible implementation, the refractive index of the second anti-reflection layer 114 may change in a gradient trend from bottom to top.

In an implementation, a refractive index difference between the seventh surface 1141 of the second anti-reflection layer 114 and the sixth surface 1132 of the filling body layer 113 is within the second preset range. In a possible implementation, the second preset range is a range less than or equal to 0.1. A refractive index difference between the eighth surface 1142 of the second anti-reflection layer 114 and the ninth surface 1151 of the surface protection layer 115 is within the third preset range. In a possible implementation, the third preset range is a range less than or equal to 0.1. In this application, the second preset range and the third preset range are restricted to be less than or equal to 0.1, so that the refractive indexes of the two surfaces of the second anti-reflection layer that face away from each other can be close to refractive indexes of connected layers, to reduce a reflection effect between different layers, thereby achieving an anti-reflection effect by using the second anti-reflection layer, and improving overall optical transmission efficiency of the optical waveguide.

In a possible implementation, the refractive index of the surface protection layer 115 may be 1.4. For example, the surface protection layer 115 is made of a glass material or a resin material. The refractive index of the surface protection layer 115 is not limited in this application. Different surface protection layers may be selected based on specific application environments of the optical waveguide. The refractive index of the surface protection layer 115 also varies with a material, a size, and the like.

In this application, the filling body layer 113 is disposed between the optical waveguide body 111 and the surface protection layer 115, to achieve support and protection for the optical waveguide body 111 and the surface protection layer 115, and prevent optical performance of the optical waveguide body 111 from being affected by an environment factor. Light reflection occurs on adjacent surfaces between the filling body layer 113 and the optical waveguide body 111 and adjacent surfaces between the surface protection layer 115 and the filling body, affecting transmittance of the optical waveguide 10A. Therefore, in this application, the first anti-reflection layer 112 is further disposed between the optical waveguide body 111 and the filling body layer 113, and the second anti-reflection layer 114 is disposed between the filling body layer 113 and the surface protection layer 115, to resolve a light reflection problem. The first anti-reflection layer 112 may be formed on the surface of the optical waveguide body 111 through coating, and total internal reflection of the optical waveguide body 111 is achieved by using a light interference principle. The first anti-reflection layer 112 can mitigate a scattering and absorption problem at an interface of the optical waveguide, and improve an anti-reflection and antireflective effect at the interface. In a solution in which the second anti-reflection layer 114 has a gradient refractive index, a gradient changing refractive index design is formed between the surface protection layer 115 and the filling body layer 113, to resolve a problem of light reflection between the surface protection layer 115 and the filling body layer 113, and improve light transmission of the optical waveguide 10A. Because a grating structure (including an in-coupling grating, an out-coupling grating, and a relay grating) configured to transmit a light ray is formed on the surface of the optical waveguide body 111, for example, a type of the grating structure may be a relief grating, the filling body layer 113 disposed between the optical waveguide body 111 and the surface protection layer 115 can protect the grating structure from scratches, improve service life of the optical waveguide body 111, and ensure diffraction efficiency.

In a possible implementation, the first preset range is a range less than or equal to 0.25. For example, the refractive index of the filling body layer 113 may be within a range of 1.1 to 1.25. Therefore, the first preset range should be a range less than or equal to 0.25. The refractive index of the filling body layer 113 is controlled to be within the foregoing range, mainly in order that the refractive index of the filling body layer 113 is close to the refractive index of air to avoid affecting a field of view of the optical waveguide 10A while filling protection is achieved between the optical waveguide body 111 and the surface protection layer 115 to make the optical waveguide body 111 and the surface protection layer 115 relatively fixed.

In a possible implementation, the refractive index of the second anti-reflection layer 114 may gradually change within a range of 1.1 to 1.4. For example, when the refractive index of the filling body layer 113 is 1.1, a refractive index of the seventh surface 1141 may also be 1.1 or approximate 1.1; or when the refractive index of the filling body layer 113 is 1.25, a refractive index of the seventh surface 1141 may also be 1.25 or approximate 1.25. In a possible implementation, the refractive index of the surface protection layer 115 is 1.4, and a refractive index of the eighth surface 1142 may be 1.4 or approximate 1.4. Both the second preset range and the third preset range are ranges less than or equal to 0.1. In a specific implementation of this application, the refractive indexes of the two surfaces of the second anti-reflection layer 114 that face away from each other can be close to refractive indexes of connected layers, to reduce a reflection effect between different layers can be reduced, thereby achieving an anti-reflection effect by using the second anti-reflection layer 114, and improving overall optical transmission efficiency of the optical waveguide 10A.

In a possible implementation, a difference between the refractive index of the filling body layer 113 and the refractive index of air is between 0.1 and 0.25. In a possible implementation, a thickness of the filling body layer 113 is 30 $\mu$m to 50 $\mu$m. Specifically, the refractive index and the thickness of the filling body layer 113 are controlled, to avoid an excessively large refractive index of the filling body layer 113, thereby helping control an overall refractive index of the optical waveguide 10A to be within a proper range, and avoiding visual impairment of a user. In this solution, the thickness of the filling body layer 113 is restricted, so that support for the optical waveguide body 111 can be effectively achieved, and the optical waveguide 10A is prevented from being excessively thick or excessively thin.

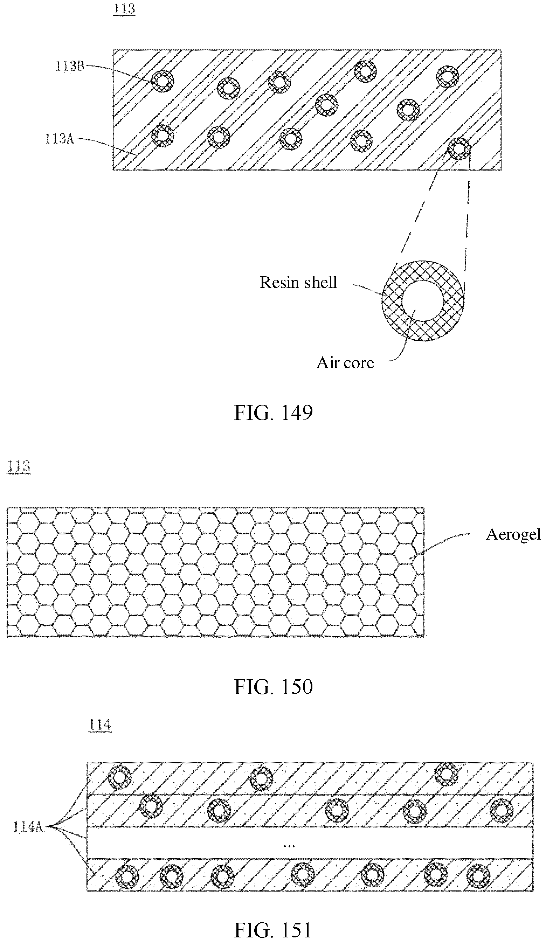

In a possible implementation, with reference to FIG. 149, the filling body layer 113 includes a substrate 113A and a refraction medium 113B, and the refraction medium 113B is dispersed in the substrate 113A. A specific material of the substrate 113A may be a siloxane polymer. A specific form of the refraction medium 113B is not limited. The refraction medium 113B may be particulate microspheres, or may be a hollow region formed in the filling body layer. For example, the refraction medium 113B may be a particle material, and a refractive index of the refraction medium 113B may be different from the refractive index of the substrate 113A. The refraction medium dispersed in the substrate 113A may be used to adjust the refractive index of the filling body layer 113, for example, to implement that the refractive index of the filling body layer 113 is close to the refractive index of air. It may be understood that a material of the substrate 113A and the material of the first anti-reflection layer 112 may be the same, and both use a siloxane polymer with a refractive index of 1.37. However, in order that the refractive index of the filling body layer 113 is different from the refractive index of the first anti-reflection layer 112, the refractive index of the filling body layer 113 may be reduced by adding the refraction medium 113B with a lower refractive index.

In a possible implementation, with reference to FIG. 149, the refraction medium 113B is resin particles. A reason why the resin particles are used as the refraction medium 113B is that the resin particles have good light transmission and light transmission for visible light is high. Therefore, adding the resin particles to the substrate 113A does not affect light transmission of the filling body layer 113. In addition, using the resin particles as the refraction medium 113B further facilitates stability of a structure of the filling body layer 113. Because chemical properties of the resin particles are similar to those of the siloxane polymer, after the filling body layer 113 is fabricated and formed, the substrate 113A and the refraction medium 113B are not easily separated, and the substrate 113A and the refraction medium 113B have better adhesion and are easy to package.

In a possible implementation, a refractive index of the resin particles is 1. The resin particles with a low refractive index may be selected as the refraction medium 113B, and then a content and distribution of the resin particles in the substrate 113A may be adjusted, to control the refractive index of the filling body layer 113.

In a possible implementation, a particle size of the resin particle is 0.1 $\mu$m to 100 $\mu$m. An appearance of the resin particles may be spherical in shape and formed by using a spray granulation method Controlling the particle size of the resin particle to be within the foregoing range facilitates formation of the filling body layer 113. In addition, difficulty in manufacturing the resin particles is low, making industrial production easy. When the particle size of the resin particle is less than the foregoing range, a size of the resin particle is excessively small, and the manufacturing difficulty is increased; or when the particle size of the resin particle is greater than the foregoing range, a size of the resin particle is excessively large, which is not conducive to formation of the filling body layer 113.

In a possible implementation, with reference to FIG. 149, the resin particle is of an internal hollow structure. Specifically, the resin particle may be of a core-shell structure, a shell of the resin particle is made of a resin material, and a core may be air. A purpose of this design is to make the refractive index of the resin particles closer to the air. Certainly, in another implementation, the resin particle may alternatively be of a solid core-shell structure. For example, a shell of the resin particle is formed by using a resin material, and a core of the resin particle may be another material whose refractive index is close to that of air to provide support.

In a possible implementation, the refractive index of the substrate 113A is 1.4. Specifically, the refractive index of the substrate 113A may be about 1.4. As described in the foregoing implementation, the material of the substrate 113A may be a same siloxane polymer as the material of the first anti-reflection layer 112. A reason for using the siloxane polymer the same as the material of the first anti-reflection layer 112 is that the filling body layer 113 that uses the same material as the substrate 113A is more easily bonded to the first anti-reflection layer 112, so that a layer separation phenomenon caused by different materials can be avoided. In addition, steps of replacing a material may be further reduced, and the same material is easy to obtain, which facilitates industrial production and cost reduction.

In a possible implementation, with reference to FIG. 150, the filling body layer 113 is an aerogel. Specifically, the aerogel is a nano-scale porous solid-state material formed by replacing a liquid phase in a gel with a gas phase through drying by using a sol-gel method, and density of the aerogel is extremely low. Due to a formation manner and a porous characteristic of the aerogel, it is easier to control a refractive index range of the filling body layer 113 when the aerogel is used as the filling body layer 113. The filling body layer 113 is a porous solid-state material similar to the aerogel, so that it can be ensured that the refractive index of the filling body layer 113 is close to that of air, and further, the filling body layer 113 has a support function. The filling body layer 113 between the surface protection layer 115 and the optical waveguide body 111 can provide a good buffer and support for the surface protection layer 115, to protect the surface protection layer 115, and prevent the surface protection layer 115 from being damaged by an external force. In a possible implementation, the filling body layer 113 may be an aerogel fabricated by using a silicon source such as orthosilicate or methyltrimethoxysilane. The aerogel is used as the filling body layer 113, so that the step of mixing the substrate 113A and the refraction medium 113B can be eliminated, to simplify a preparation process, and further, manufacturing costs of the filling body layer 113 can be reduced.

In a possible implementation, the refractive index of the second anti-reflection layer 114 is 1.1 to 1.4. In a possible implementation, a thickness of the second anti-reflection layer 114 is 1 μm to 2 μm. Specifically, the refractive index and the thickness of the second anti-reflection layer 114 are controlled, to avoid an excessively large refractive index of the second anti-reflection layer 114, thereby helping control an overall refractive index of the optical waveguide 10A to be within a proper range, and avoiding visual impairment of a user.

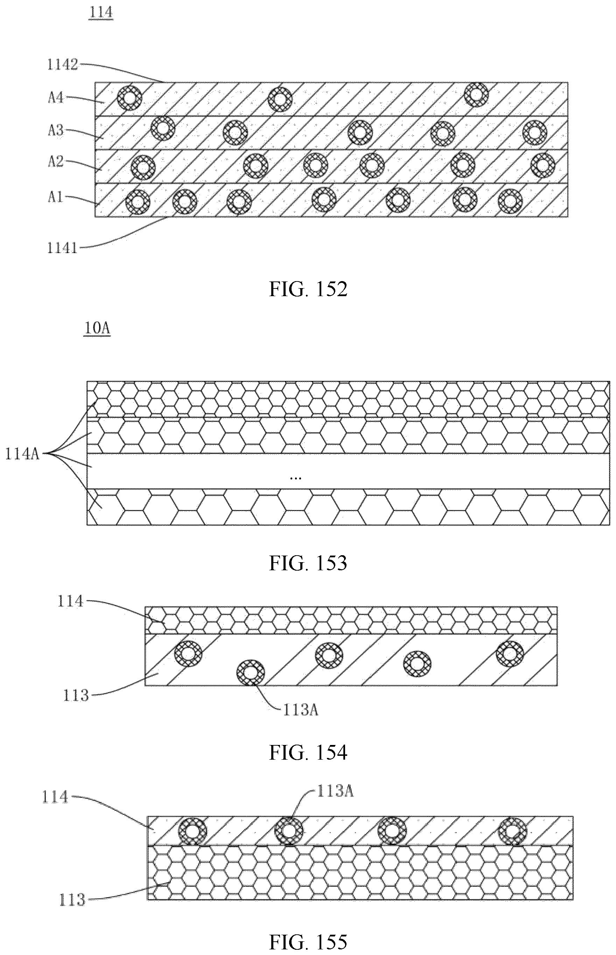

FIG. 151 is a diagram of a cross-sectional structure of a second anti-reflection layer 114 in a possible implementation. The second anti-reflection layer 114 includes a plurality of second anti-reflection sublayers 114A disposed in a stacked manner, and a difference between refractive indexes of any two adjacent second anti-reflection sublayers 114A is within a preset range. For example, FIG. 152 is a diagram of a structure having four second anti-reflection sublayers 114A. In a direction from the seventh surface 1141 to the eighth surface 1142, the second anti-reflection sublayer 114 may sequentially include a second anti-reflection sublayer A1, a second anti-reflection sublayer A2, a second anti-reflection sublayer A3, and a second anti-reflection sublayer A4. In addition, a surface that is of the second anti-reflection sublayer A1 and that faces the filling body layer 113 is the seventh surface 1141, and a surface that is of the second anti-reflection sublayer A4 and that faces the surface protection layer 115 is the eighth surface 1142. The difference between the refractive indexes of any two adjacent second anti-reflection sublayers 114A is within the preset range (for example, 0.1 or 0.05). The preset range may be determined according to a specific design requirement of the second anti-reflection layer 114. For example, a difference between a refractive index of the second anti-reflection sublayer A1 and a refractive index of the second anti-reflection sublayer A2 is 0.1, the refractive index of the second anti-reflection sublayer A1 may be 1.1, and the refractive index of the second anti-reflection sublayer A2 may be 1.2. Certainly, in another implementation, other values may be used. That is, it may be understood that refractive indexes of the second anti-reflection sublayers 114A are different from each other. In another implementation, there may be more or fewer second anti-reflection sublayers 114A. This is not specifically limited.

In a possible implementation, in a direction from the optical waveguide body 111 to the surface protection layer 115, refractive indexes of the plurality of second anti-reflection sublayers 114A increase along a gradient. For example, a refractive index of the second anti-reflection sublayer A1 may be 1.1, a refractive index of the second anti-reflection sublayer A2 may be 1.2, a refractive index of the second anti-reflection sublayer A3 may be 1.3, and a refractive index of the second anti-reflection sublayer A4 may be 1.4. Therefore, a difference between refractive indexes of any two adjacent layers of second anti-reflection sublayer 114A may be 0.1. In another implementation, a difference between refractive indexes of any two adjacent layers of second anti-reflection sublayer 114A may be 0.2 or 0.05. This is not specifically limited.

FIG. 153 is a diagram of a cross-sectional structure of a second anti-reflection sublayer 114 in a possible implementation. The second anti-reflection sublayers 114A are all prepared by using an aerogel. In addition, as shown in the figure, porosity in each layer may be different from that in another layer. It may be understood that the hexagon in the figure is merely used to illustrate a pore, and is not an actual shape of a pore.

Designing the second anti-reflection layer 114 as a plurality of second anti-reflection sublayers 114A helps prepare the second anti-reflection layer 114 step by step for a plurality of times, and improve formation precision of the second anti-reflection layer 114. In addition, refractive indexes of the second anti-reflection sublayers 114A are not completely the same, which helps gradually reduce reflection of a light ray by using a plurality of different refractive indexes.

In a possible implementation, the second anti-reflection layer 114 and the filling body layer 113 are made of a same material but have different density. Specifically, a material for fabricating the second anti-reflection layer 114 may be a mixture of the siloxane polymer and the refraction medium 113B in the foregoing implementation. Therefore, the material of the second anti-reflection layer 114 may be the same as the material of the filling body layer 113. However, in order to design different refractive indexes of the second anti-reflection layer 114 and the filling body layer 113, proportions of the siloxane polymer and the refraction medium 113B are different, and consequently, the second anti-reflection layer 114 and the filling body layer 113 have different density. In another implementation, the second anti-reflection layer 114 may alternatively be an aerogel. The second anti-reflection sublayers 114A with different refractive indexes can be fabricated by adjusting pore density in the aerogel.

In a possible implementation, the second anti-reflection layer 114 and the filling body layer 113 are formed by using a same fabrication process.

In a possible implementation, with reference to FIG. 154, the filling body layer 113 may be made of the resin particles and the siloxane polymer in the foregoing implementation, and the second anti-reflection layer 114 may be made of the aerogel in the foregoing implementation. Certainly, with reference to FIG. 155, in another implementation, the filling body layer 113 may be made from the aerogel in the foregoing implementation, and the second anti-reflection layer 114 may be made of the resin particles and the siloxane polymer in the foregoing implementation. It may be understood that this application provides two different types of film layer structures: a film layer structure having a substrate 113A and a refraction medium 113B, and an aerogel film layer structure. The filling body layer 113 and the second anti-reflection layer 114 may be formed by using any one of the two film layer structures, or may be formed by using a combination of the two film layer structures.

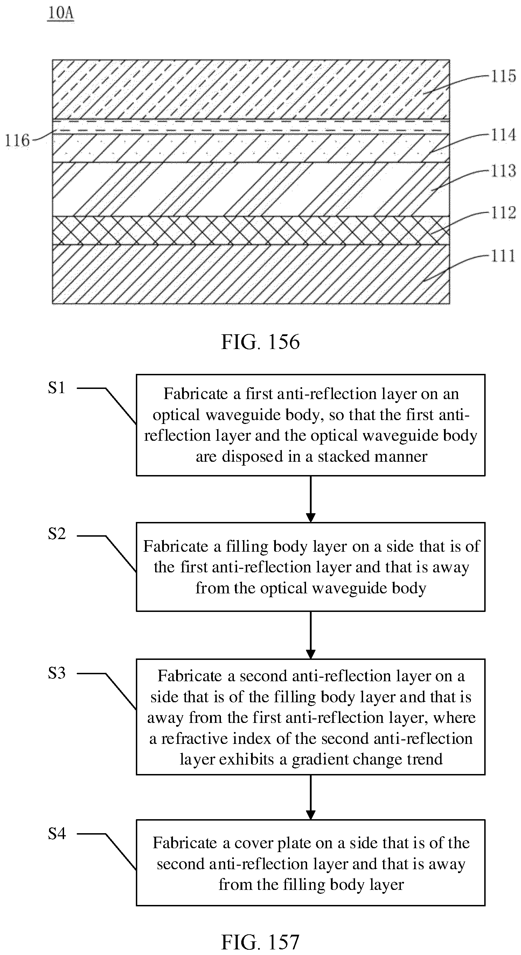

In a possible implementation, with reference to FIG. 156, an adhesion enhancement layer 116 within a thickness of 50 nm may be fabricated between the second anti-reflection layer and the surface protection layer, to increase packaging strength between them.

This application further provides a method for preparing an optical waveguide 10A. Refer to FIG. 157. FIG. 157 is a flowchart of a method for preparing an optical waveguide 10A according to an implementation of this application. Specifically, the optical waveguide 10A provided in the foregoing implementations is prepared. The preparation method specifically includes steps S1 to S3.

Step S1: Fabricate a first anti-reflection layer on an optical waveguide body, so that the first anti-reflection layer and the optical waveguide body are disposed in a stacked manner.

Specifically, the optical waveguide body is provided, and the first anti-reflection layer is fabricated on the optical waveguide body. The first anti-reflection layer should be made of the siloxane polymer in the foregoing implementation. The first anti-reflection layer may be fabricated and formed by using an electron beam evaporation process and/or a sputtering and/or ALD process and/or a PVD process and/or a CVD process. In addition, the first anti-reflection layer may have a refractive index of 1.37 and a thickness of 137.5 nm.

In a possible implementation, the first anti-reflection layer may be fabricated and formed a plurality of times. For example, the first anti-reflection layer may be a multi-layer structure, and a plurality of anti-reflection sublayers may be separately fabricated by using one or more of the foregoing processes, and the plurality of anti-reflection sublayers jointly form the first anti-reflection layer. In addition, refractive indexes of all the anti-reflection sublayers may be the same, and may be 1.37, to ensure that refractive indexes at all positions of the first anti-reflection sublayers are the same. However, thicknesses of the plurality of anti-reflection sublayers may be the same or may not be completely the same. This is because the first anti-reflection layer may be fabricated a plurality of times, so that a thickness of the first anti-reflection layer may be accurate. Therefore, a thickness of each anti-reflection sublayer may be determined based on a sum of thicknesses of previous anti-reflection sublayers. An advantage of multi-time fabrication and formation is that the thickness of the first anti-reflection layer can be accurately controlled, and further, first anti-reflection layers with different thickness specifications may be fabricated in this manner and used in optical waveguides having different specification requirements.

Step S2: Fabricate a filling body layer on a side that is of the first anti-reflection layer and that is away from the optical waveguide body.

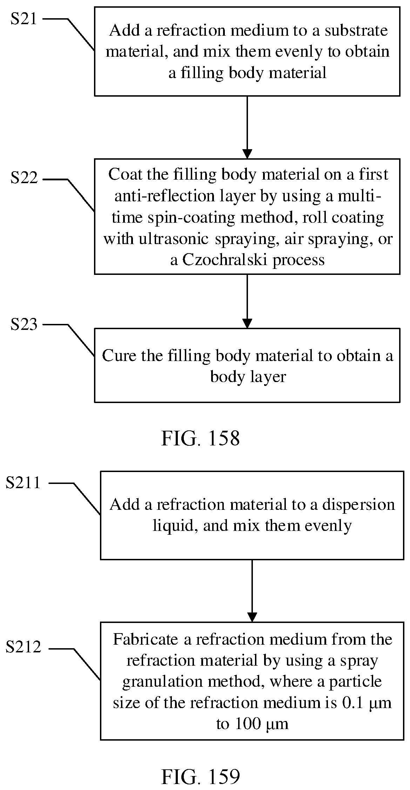

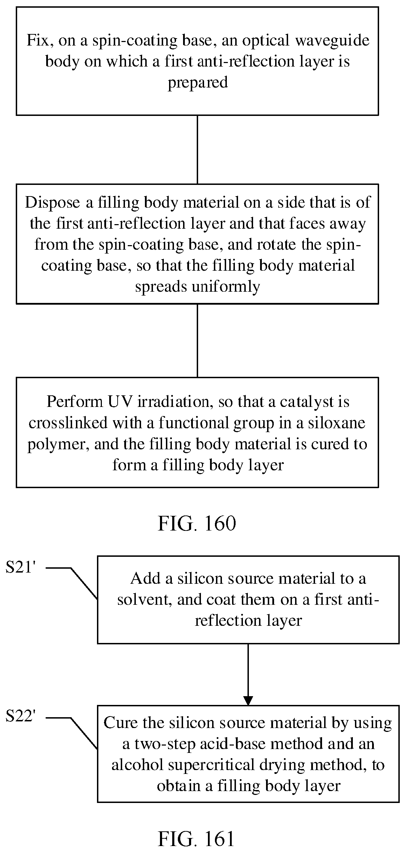

Specifically, with reference to FIG. 158 and FIG. 160, step S2 may include steps S21 to S23, and details are as follows.

Step S21: Add a refraction medium to a substrate material, and mix them evenly to obtain a filling body material. The substrate material may be the foregoing siloxane polymer with a refractive index of 1.4. The refraction medium is added to a siloxane polymer solution. A filling body material with a refractive index in a range of 1-1 to 1.25 is obtained by adjusting a ratio of the refraction medium to the substrate material.

In a possible implementation, the substrate material may alternatively be a siloxane polymer with a refractive index of 1.5 or a siloxane polymer with a refractive index of 1.3. The siloxane polymer is selected due to its good light transmission and low costs. In addition, the substrate material of the filling body layer is the same as or similar to that of the first anti-reflection layer, which better facilitates fabrication and formation. Certainly, in another implementation, another material may be selected as the substrate material. This is not specifically limited. It may be understood that, in this application, the substrate material and the refraction medium are used for fabricating the filling body layer because a material with a large refractive index range may be provided by adjusting the ratio. In a manner of fabrication by using a homogeneous material, in order to meet a requirement of a large refractive index range, a plurality of homogeneous materials with different refractive indexes need to be provided, and costs are relatively high. In comparison with the manner of fabrication by using a homogeneous material, in a manner of fabrication through adjustment, few raw material types are required, and costs can be reduced.

In a possible implementation, the substrate material and the refraction medium may be fully mixed by using a high-shear mixer or a three-roll mill. The foregoing mixing manner is already a relatively mature technology, and is easy to industrialize.

Step S22: Coat the filling body material on the first anti-reflection layer by using a multi-time spin-coating method, roll coating with ultrasonic spraying, air spraying, or a Czochralski process. A coating thickness of the filling body material may be 30 $\mu$m to 50 $\mu$m.

Step S23: Cure the filling body material to obtain the filling body layer.

Specifically, with reference to FIG. 160, the optical waveguide body on which the first anti-reflection layer is prepared may be fixed on a spin-coating base, where the spin-coating base is a flat metal or polytetrachloroethylene disk whose surface has many vacuum holes to secure a silicon wafer. The filling body material is disposed on a side that is of the first anti-reflection layer and that faces away from the spin-coating base, and then the optical waveguide body and the first anti-reflection layer are rotated by rotating the spin-coating base, to obtain a layer of uniformly spread filling body material. Then, in step S23, a catalyst may be crosslinked with a functional group in the siloxane polymer through UV irradiation, so that the filling body material is cured to form a uniform filling body layer. Certainly, in another implementation, a curing manner in step S23 may alternatively be thermal curing or chemical curing. It may be understood that an objective of step S23 is to cure the filling body material to form a complete solid film structure, and therefore a specific curing manner is not limited.

In a possible implementation, with reference to FIG. 159 and FIG. 160, the step of adding a refraction medium to a substrate material may further include: fabricating the refraction medium. Details are as follows:

Step S211: Add a refraction material to a dispersion liquid, and mix them evenly. Specifically, the refraction material may be a water-soluble resin, and the dispersion liquid may be pure water. The water-soluble resin can dissolve in pure water through thorough stirring. An advantage of selecting the water-soluble resin is that obtaining processes and use methods of this material are relatively mature, and costs for obtaining this material are low. In addition, the water-soluble resin uses water as a solvent, causing no chemical pollution, and provides better environmental protection.

Step S212: Fabricate the refraction medium from the refraction material by using a spray granulation method, where a particle size of the refraction medium is 0.1 $\mu$m to 100 $\mu$m. Specifically, in the spray granulation method, a material that needs to be dried is dispersed into fine mist-like particles by using a mechanical function of a spray dryer, and most moisture is removed instantaneously upon contact between the particles and hot air, so that solid substances in the material are dried into powder. Compared with common drying, spray drying has a further function of granulation, can reduce a size of a finished product, and a shape is relatively regular. In a possible implementation, a spray drying temperature may be 100°C to 130°C, and a spraying speed is 10 mL/min to 30 mL/min. A boiling point of the dispersive liquid provided in the foregoing implementation is 100°C. Therefore, in order to fully remove the dispersive liquid to obtain the refraction medium, a temperature of the drying sprayer may be set to be greater than 100°C and not greater than 130°C. When the drying temperature is lower than the lower limit of the range, the drying temperature is insufficient, consequently the dispersive liquid is not completely removed, a large quantity of liquid drops appear in a drying cavity, and a purpose of drying cannot be achieved. When the drying temperature is higher than the upper limit of this range, the refraction medium may be melted due to overheating.

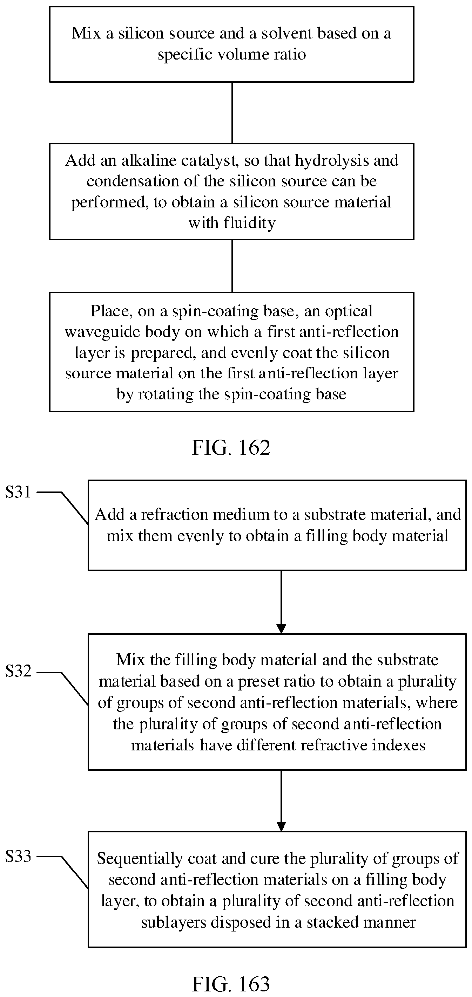

In a possible implementation, with reference to FIG. 161 and FIG. 162, the filling body layer may alternatively be an aerogel. Therefore, the fabricating a filling body layer on a side that is of the first anti-reflection layer and that is away from the optical waveguide body may include the following steps.

Step S21': Add a silicon source material to a solvent, and coat them on the first anti-reflection layer. Specifically, the silicon source material may be a precursor solution of the aerogel. Refer to FIG. 162. A specific preparation manner may be: mixing the silicon source and the solvent based on a specific volume ratio, where the volume ratio of the silicon source to the solvent may be set according to a refractive index requirement. This is not limited in this application. Then, an alkaline catalyst is added, so that hydrolysis and condensation of the silicon source can be performed, to obtain a silicon source material with fluidity. Then, the optical waveguide body on which the first anti-reflection layer is prepared is placed on the spin-coating base, and the silicon source material is evenly coated on the first anti-reflection layer by rotating the spin-coating base, to wait for a next step. The silicon source includes one or more of orthosilicate, methyltrimethoxysilane, and the like, and the solvent includes one or more of methanol, ethanol, and water.

Step S22': Cure the silicon source material by using a two-step acid-base method and an alcohol supercritical drying method, to obtain the filling body layer. Specifically, after the silicon source material is coated on the first anti-reflection layer, the silicon source material may be cured by using a supercritical drying method, to obtain the filling body layer formed by an aerogel.

A purpose of the foregoing steps is to use an aerogel as the filling body layer, and fabricate, on the first anti-reflection layer by using a supercritical drying method and utilizing a pore-adjustable characteristic of the aerogel, an aerogel that meets a refractive index requirement. In comparison with the substrate and the refraction medium in the foregoing implementation, steps of fabricating the aerogel are simple, and material costs are low.

Refer to FIG. 157. The preparation method provided in this application further includes step S3: Fabricate a second anti-reflection layer on a side that is of the filling body layer and that is away from the first anti-reflection layer, where a refractive index of the second anti-reflection layer exhibits a gradient change trend.

Specifically, the fabricating a second anti-reflection layer may include: fabricating, on the side that is of the filling body layer and that is away from the first anti-reflection layer, a plurality of second anti-reflection sublayers disposed in a stacked manner, where in a direction from the optical waveguide body to the surface protection layer, refractive indexes of the plurality of second anti-reflection sublayers increase along a gradient. The plurality of second anti-reflection sublayers may be fabricated one by one in a step-by-step fabrication manner, and raw material properties of the second anti-reflection sublayer may be adjusted to obtain the second anti-reflection sublayers with different refractive indexes.

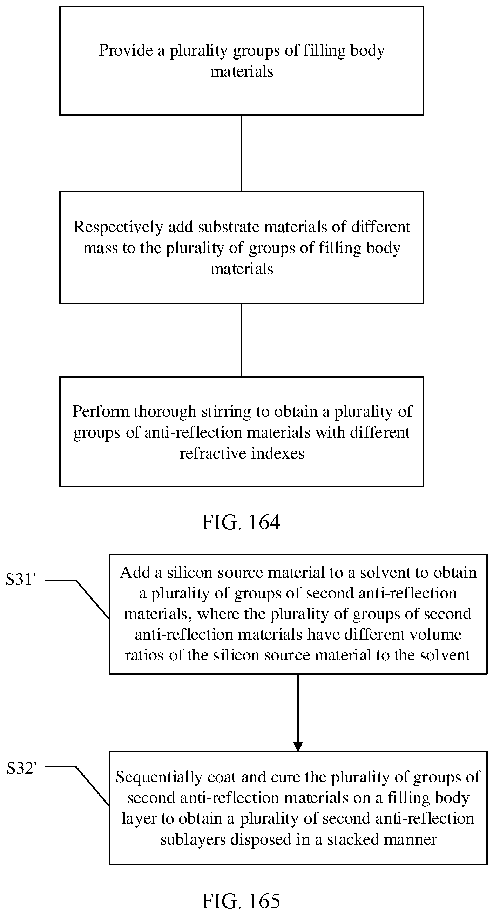

In a possible implementation, with reference to FIG. 163 and FIG. 164, the step of fabricating, on the side that is of the filling body layer and that is away from the first anti-reflection layer, a plurality of second anti-reflection sublayers disposed in a stacked manner includes:

Step S31: Add a refraction medium to a substrate material, and mix them evenly to obtain a filling body material. For a specific implementation of this step, refer to step S21.

Step S32: Mix the filling body material and the substrate material based on a preset ratio to obtain a plurality of groups of second anti-reflection materials, where the plurality of groups of second anti-reflection materials have different refractive indexes. Specifically, on a basis of the foregoing step, the substrate material may be added to the filling body material. An implementation of this step is similar to dilution. The second anti-reflection materials with different refractive indexes may be obtained by adding substrate materials of different proportions. For example, with reference to FIG. 164, a plurality of groups of filling body materials are provided, then substrate materials of different mass are respectively added to the plurality of groups of filling body materials, and a plurality of groups of anti-reflection materials with different refractive indexes are obtained after thorough stirring. A refractive index of the filling body material may be in a range of 1.1 to 1.25. Then, a refractive index of a material mixed with the substrate material may be increased by adding the substrate material whose refractive index is 1.4. In this way, the second anti-reflection material with the refractive index in the range of 1.1 to 1.4 may be obtained.

Step S33: Sequentially coat and cure the plurality of groups of second anti-reflection materials on the filling body layer, to obtain the plurality of second anti-reflection sublayers disposed in a stacked manner. This step may be achieved by using a multi-time spin-coating method. For details, refer to step S22, that is, the second anti-reflection material is spread on the spin-coating base through spin-coating for film formation. A plurality of second anti-reflection materials with a plurality of refractive indexes are fabricated by using the foregoing step, and the plurality of second anti-reflection sublayers disposed in a stacked manner can be obtained in ascending order of refractive indexes by using multi-time spin-coating and curing. In addition, thicknesses of all the second anti-reflection sublayers may be the same or different. In a possible implementation, a total thickness of the second anti-reflection layer should be 1 $\mu$m to 2 $\mu$m. Therefore, the thickness of the second anti-reflection sublayer may be 0.3 $\mu$m, 0.5 $\mu$m, or 0.8 $\mu$m.

A characteristic of fabricating the second anti-reflection sublayer by using the method provided in the foregoing steps S31 to S33 is that the filling body material provided in the foregoing implementation, supplemented with different proportions of substrate materials, may be utilized to obtain a plurality of second anti-reflection materials with different refractive indexes. An advantage is that preparation of the second anti-reflection sublayer can be continued by using an existing material of the filling body layer without adding a new ingredient, and without changing a process and a production line. This is applicable to mass production and costs are controllable.

In a possible implementation, with reference to FIG. 165, the second anti-reflection sublayer may alternatively be an aerogel, and the step of fabricating, on the side that is of the filling body layer and that is away from the first anti-reflection layer, a plurality of second anti-reflection sublayers disposed in a stacked manner may include:

> Step S31': Add a silicon source material to a solvent to obtain a plurality of groups of second anti-reflection materials, where the plurality of groups of second anti-reflection materials have different volume ratios of the silicon source material to the solvent. For a specific implementation of this step, refer to step S21'.
> Step S32': Sequentially coat and cure the plurality of groups of second anti-reflection materials on the filling body layer, to obtain the plurality of second anti-reflection sublayers disposed in a stacked manner. For a specific implementation of this step, refer to step S22'. A plurality of second anti-reflection materials with a plurality of refractive indexes are fabricated by using the foregoing step, and the plurality of second anti-reflection sublayers disposed in a stacked manner can be obtained in ascending order of refractive indexes by using multi-time supercritical drying. In addition, thicknesses of all the second anti-reflection sublayers may be the same or different.

A characteristic of fabricating the second anti-reflection sublayer by using the method provided in the foregoing steps is that the filling body material provided in the foregoing implementation, supplemented with different proportions of silicon source materials, may be utilized to fabricate an aerogel with a plurality of porosities by using second anti-reflection materials with different concentration ratios. An advantage is that preparation of the second anti-reflection sublayer can be continued by using an existing material of the filling body layer without adding a new ingredient, and without changing a process and a production line. This is applicable to mass production and costs are controllable.

Refer to FIG. 156 and FIG. 157. The preparation method provided in this application further includes step S4: fabricating a surface protection layer on a side that is of the second anti-reflection layer and that is away from the filling body layer. Specifically, an adhesion enhancement layer within a thickness of 50 nm may be fabricated between the second anti-reflection layer and the surface protection layer, to increase packaging strength between them.

Solution 12: Flexible optical waveguide and fabrication method

A waveguide substrate of an optical waveguide provided in an implementation of this application is a rigid plate. For example, in a process of fabricating the waveguide substrate, a high-refractive waveguide material is disposed on a rigid glass base plate to form the waveguide substrate. The glass base plate is a rigid plate, and an optical waveguide formed by using the glass base plate as a carrier is likewise a rigid plate. Accordingly, a grating structure formed on the waveguide substrate is also a rigid plate. An optical waveguide in a shape of a rigid plate is not flexible and cannot be bent.

When an optical waveguide is used in a near-eye display device, for example, AR glasses, incident light of an optical engine needs to be projected onto a human eye to form a virtual image, and further, a function of transmitting ambient light is required for a lens structure of the near-eye display device. In many cases, the lens, such as a lens used for correcting myopia, needs to have a curved surface form. For the optical waveguide in the shape of a rigid plate, in a process of combining with a lens having a curved surface, because of a rigid characteristic of the optical waveguide, the optical waveguide cannot be bent, and cannot match a shape of the curved surface of the lens, and a thickness of the lens needs to be large enough for the lens to be combined with and connected to the optical waveguide in the shape of a rigid plate. Such design may cause the lens to be thick and heavy, and form an obstacle in design of a light and thin lens.

A specific implementation of this application provides an optical waveguide and a method for fabricating the optical waveguide. The optical waveguide is flexible, can be freely bent, and can match lenses of different curved surface forms, which facilitates design of lightness and thinness of the lens.

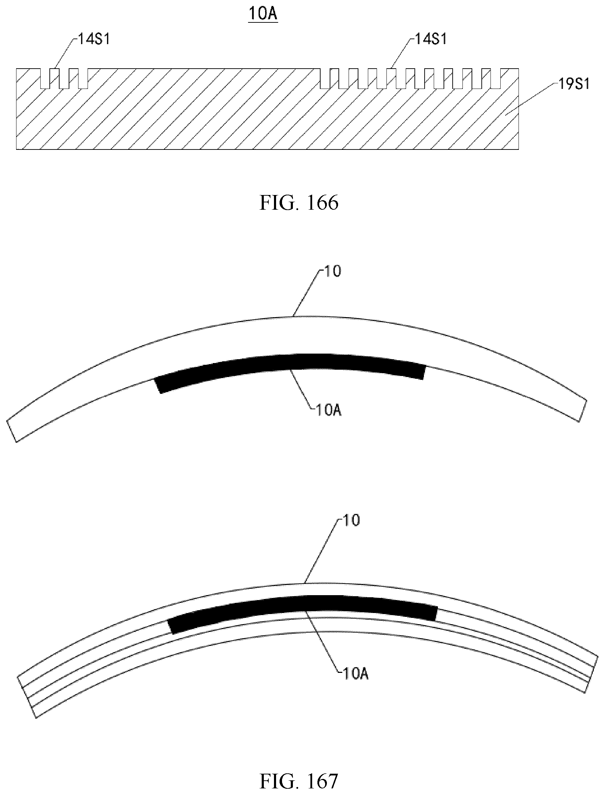

In an implementation, with reference to FIG. 166, an optical waveguide 10A provided in this application has a deformable characteristic, so that the optical waveguide 10A can adapt to different-curvature lenses of a near-eye display device. The optical waveguide 10A includes a first waveguide substrate 19S1 and a first grating structure 14S1 formed on a surface of the first waveguide substrate 19S1. The first waveguide substrate 19S1 is used for total internal reflection of an optical path, and the first grating structure 14S1 may be used for diffraction of light. For example, the first grating structure 1451 may be an in-coupling grating or an out-coupling grating. An incident light ray projected by an optical engine is coupled into the first waveguide substrate 19S1 by the in-coupling grating, and the incident light ray enters the first waveguide substrate 19S1 and then undergoes total internal reflection propagation in the first waveguide substrate 19S1. When propagated to a position of the out-coupling grating, the light ray is coupled out by the out-coupling grating to a human eye, to form a virtual image. In this implementation, both the first waveguide substrate 19S1 and the first grating structure 14S1 are flexible, and it may be understood that all structures in the optical waveguide 10S are flexible, so that the optical waveguide 10S may be freely bent to match different-curvature lenses, thereby achieving lightness and thinness of the lens and contributing to lightweight of the near-eye display device.

FIG. 166 is a diagram of an optical waveguide 10A in a flattened state. In a state in which the optical waveguide 10A is not combined with a lens, the optical waveguide 10A is flexible and can be freely bent. Refer to FIG. 166 and FIG. 167. The optical waveguide 10A may be combined with a curved lens 10, or the optical waveguide 10A may be combined with a curved surface part of a lens 10. The upper figure in FIG. 167 shows that the optical waveguide 10A is attached to a surface layer of the lens 10. In a process of attaching the optical waveguide 10A to the lens 10, the first grating structure 14S1 may be located between the first waveguide substrate 19S1 and the lens 10, or the first grating structure 14S1 may be located on a side that is of the first waveguide substrate 19S1 and that is away from the lens 10. The lower figure in FIG. 167 shows that the optical waveguide 10A is attached to a middle layer of the lens 10, that is, the lens 10 has at least two layers of structures, and the optical waveguide 10A is sandwiched between two adjacent layers. In this way, the lens 10 has a protection function for the optical waveguide 10A, without a need to dispose a protection layer for the optical waveguide 10A.

In an implementation, a refractive index of the first waveguide substrate 19S1 is greater than or equal to 1.6, and a thickness of the first waveguide substrate 19S1 is less than 300 $\mu$m. In this solution, the refractive index and the thickness of the first waveguide substrate 19S1 are restricted, so that arrangement of the first waveguide substrate 19S1 can meet total internal reflection propagation of light in the first waveguide substrate, and thin design is ensured on a basis of good optical performance. The thickness of the first waveguide substrate 19S1 is set to be within 300 $\mu$m, and a material of the first waveguide substrate 19S1 is restricted, so that flexibility performance can be improved. Specifically, the material of the first waveguide substrate 19S1 is flexible glass or a flexible optical resin material.

The flexible glass is glass whose thickness is less than 1 mm, and belongs to a category of ultra-thin glass. The flexible glass may be soda-lime glass, high-aluminum glass, or low-alkali glass. The flexible glass is a very flexible material that can be bent, and an outer layer of the flexible glass is a laminated plastic. With the laminated plastic, the flexible glass can be easily bent.

The flexible optical resin material may be a polymer organic compound, for example, poly(allyl diglycol carbonate) (CR-39), polymethyl methacrylate (PMMA), or polycarbonate (PC). Use of the flexible optical resin material has benefits of: a light weight, where a weight of an optical waveguide fabricated by using the flexible optical resin material may be a half of a weight of an optical waveguide fabricated by using a glass material; and strong impact resistance, where impact resistance of the optical waveguide fabricated by using the flexible optical resin material is 10 times higher than that of the glass material. In addition, use of the flexible optical resin material further has benefits of good chemical stability, light transmission, and the like.

The first grating structure 14S1 may be a surface relief grating (SRG), or a volume holographic grating (VHG). A type of the first grating structure 14S1 may be a blazed grating, a slanted grating, or the like.

In the implementation shown in FIG. 166, the first grating structure 14S1 is integrally formed in the first waveguide substrate 19S1. For example, the first grating structure 14S1 is formed on the surface of the first waveguide substrate 19S1 by using an etching process. In the optical waveguide 10A provided in this implementation, the first grating structure 14S1 is directly fabricated on the first waveguide substrate 19S1, without a need to additionally dispose a material layer for grating fabrication. The first grating structure 14S1 and the first waveguide substrate 19S1 are of an integrated structure, structural stability is better, diffraction efficiency is easy to modulate, and optical performance is easy to maintain.

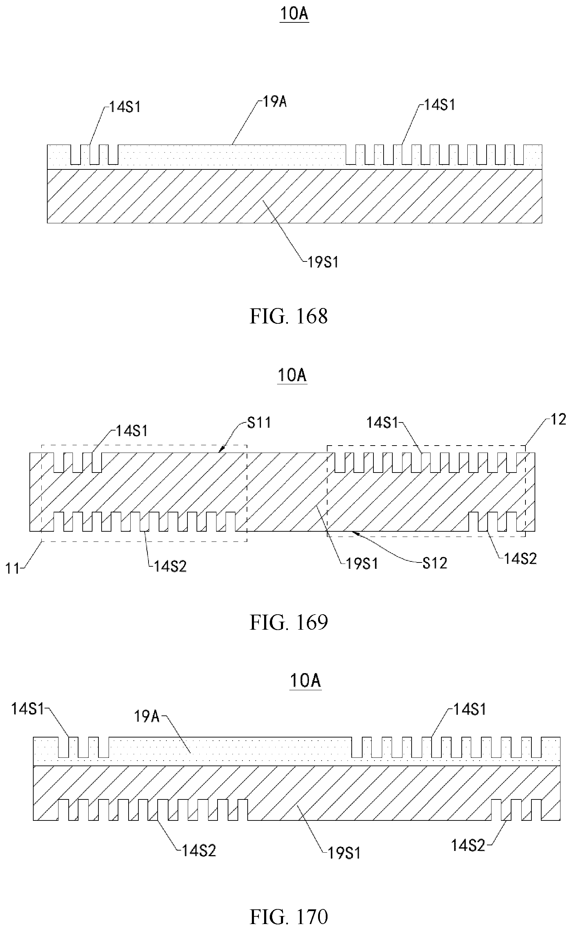

Refer to FIG. 168. In an implementation, the first grating structure 14S1 is formed on a first grating layer 19A, the first grating layer 19A and the first waveguide substrate 19S1 are disposed in a stacked manner, both the first waveguide substrate 19S1 and the first grating layer 19A are flexible, and a material of the first grating layer 19A is an imprint adhesive. In this implementation, the first grating structure 14S1 may be fabricated and formed by using a nano-imprinting process. A thickness of the first grating layer 19A may be greater than or equal to 0.2 $\mu$m and less than or equal to 1.2 $\mu$m, and a refractive index of the first grating layer 19A is greater than or equal to 1.6. The refractive index of the first grating layer 19A may be different from the refractive index of the first waveguide substrate 19S1. In this solution, diffraction efficiency may be modulated by setting different refractive indexes.

Both the implementation shown in FIG. 166 and the implementation shown in FIG. 168 are a single-layer single-sided optical waveguide architecture. To be specific, the optical waveguide includes only one layer of waveguide substrate (that is, the first waveguide substrate 19S1) and one layer of grating structure (that is, the first grating structure 14S1). In an implementation, this application further provides a single-layer double-sided optical waveguide architecture. To be specific, an optical waveguide includes only one layer of waveguide substrate and two layers of grating structures. It may be understood that grating structures are disposed on both sides of the first waveguide substrate.

Refer to FIG. 169. In an implementation, a first waveguide substrate 19S1 includes a top surface S11 and a bottom surface S12, a first grating structure 14S1 is formed on a side of the top surface S11 of the first waveguide substrate 19S1, the optical waveguide 10A further includes a second grating structure 14S2, and the second grating structure 14S2 is formed on a side of the bottom surface S12 of the first waveguide substrate 19S1. In an implementation, the first grating structure 14S1 and the second grating structure 14S2 may be of a same structure. For example, both the first grating structure 14S1 and the second grating structure 14S2 are surface relief gratings (SRGs) of one model. In an implementation, the first grating structure 14S1 and the second grating structure 14S2 may be of different structures. For example, the first grating structure 14S1 is a blazed grating, and the second grating structure 14S2 is a slanted grating. Specific grating types and grating structures of the first grating structure 14S1 and the second grating structure 14S2 are not limited in this application. Refractive indexes of the first grating structure 14S1 and the second grating structure 14S2 may be the same or may be different.

In an implementation, both the first grating structure 14S1 and the second grating structure 14S2 include in-coupling gratings. In other words, in this solution, the in-coupling gratings are distributed on the top surface S11 and the bottom surface S12 of the first waveguide substrate 19S1, so that an in-coupling range and diffraction efficiency of an incident light ray of the optical waveguide 10A can be improved, and a large FOV of the incident light ray can be obtained.

In an implementation, both the first grating structure 14S1 and the second grating structure 14S2 include out-coupling gratings, and a refractive index of a part of the out-coupling grating included in the first grating structure 14S1 may be different from a refractive index of a part of the out-coupling grating included in the second grating structure 14S2. Through adjustment of refractive indexes and appearances (which may be understood as parameters such as structural forms, periods, and vector directions of the gratings) of the out-coupling gratings on the top surface S11 and the bottom surface S12 of the first waveguide substrate 19S1, light ray out-coupling efficiency of the optical waveguide 10A may be modulated, and properties such as a bandwidth of a light ray coupled out by the optical waveguide 10A may be modulated.

As shown in FIG. 169, in a specific implementation, parts of grating structures in two rectangular dashed-line boxes are respectively an in-coupling grating 11 and an out-coupling grating 12. In a region in which the in-coupling grating 11 is located, an area of the second grating structure 14S2 is greater than an area of the first grating structure 14S1, a part that is of the second grating structure 14S2 and that is away from the out-coupling grating 12 overlaps the first grating structure 14S1, and there is no grating structure on a top surface S11 corresponding to a part that is of the second grating structure 14S2 and that is close to the out-coupling grating 12. In a region in which the out-coupling grating 12 is located, an area of the first grating structure 14S1 is greater than an area of the second grating structure 14S2, a part that is of the first grating structure 14S1 and that is away from the in-coupling grating 11 overlaps the second grating structure 14S2, and there is no grating structure on a bottom layer corresponding to a part that is of the first grating structure 14S1 and that is close to the in-coupling grating 11. Such a grating configuration architecture can achieve good diffraction efficiency in limited space, and help ensure uniformity of light rays. In another implementation, neither an area relationship nor an overlapping relationship between the first grating structure 14S1 and the second grating structure 14S2 is limited in this application. Areas, structural forms, and position settings of the first grating structure 14S1 and the second grating structure 14S2 may be determined according to a specific design requirement.

In the implementation shown in FIG. 169, each of the first grating structure 14S1 and the second grating structure 14S2 is integrally formed on the first waveguide substrate 19S1. For example, through etching, the first grating structure 14S1 is formed on the top surface of the first waveguide substrate 19S1 through etching and the second grating structure 14S2 is formed on the bottom surface of the first waveguide substrate 19S2.

Refer to FIG. 170. In an implementation, the optical waveguide 10A includes a first waveguide substrate 19S1 and a first grating layer 19A that are disposed in a stacked manner, and the first grating layer 19A may be formed on a surface of the first waveguide substrate 19S1 through spin-coating. A first grating structure 14S1 is formed on the first grating layer 19A by using an imprinting technology, and a second grating structure 14S2 is integrally formed on the first waveguide substrate 19S1. For example, the second grating structure 14S2 is formed on a bottom surface of the first waveguide substrate 19S2 through etching.

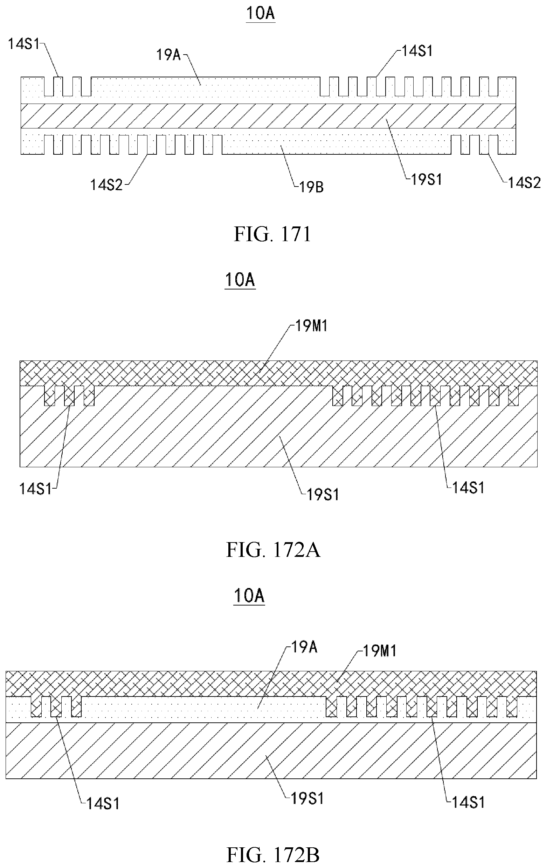

Refer to FIG. 171. In an implementation, the optical waveguide 10A includes a first grating layer 19A, a first waveguide substrate 19S1, and a second grating layer 19B that are sequentially disposed in a stacked manner. The first grating layer 19A and the second grating layer 19B may be formed on a surface of the first waveguide substrate 19S1 through spin-coating. A first grating structure 14S1 is formed on the first grating layer 19A by using an imprinting technology, and a second grating structure 14S2 is formed on the second grating layer 19B by using the imprinting technology. Both the first grating layer 19A and the second grating layer 19B may be made of imprint adhesive materials. In an implementation, materials of the first grating layer 19A and the second grating layer 19B may be different, the first grating layer 19A and the second grating layer 19B may have different refractive indexes, and the refractive indexes of the first grating layer 19A and the second grating layer 19B may be different from a refractive index of the first waveguide substrate 19S1. Such arrangement architecture can be used to modulate diffraction efficiency of an optical waveguide, and different grating shapes can be separately imprinted, and subsequently, another structure such as a film-coated grating may be added on any single side to form an asymmetric structure.

Refer to FIG. 172A and FIG. 172B. In an implementation, on a basis of the implementation shown in FIG. 166 and the implementation shown in FIG. 168, the optical waveguide 10A further includes a first modulation layer 19M1, the first modulation layer 19M1 and the first waveguide substrate 19S1 are disposed in a stacked manner, and a part of the first modulation layer 19M1 is filled in the first grating structure 14S1. A difference between a refractive index of the first modulation layer 19M1 and a refractive index of the first grating structure 14S1 is greater than or equal to 0.1. In this solution, the first modulation layer 19M1 is additionally disposed on a surface on which a grating of the optical waveguide 10A is located. The first modulation layer 19M1 covers the first grating structure 14S1, and the first modulation layer 19M1 is configured to protect the first grating structure 14S1. In addition, the first modulation layer 19M1 can modulate diffraction efficiency of the optical waveguide 10A, so that diffraction efficiency of the optical waveguide 10A can meet a requirement of a use scenario, allowing the optical waveguide 10A to be applied to more scenarios.

In an implementation, the first modulation layer 19M1 may be made of a low-refractive adhesive or a coating structure, and the first modulation layer 19M1 may be formed, by using a spin-coating process or an electroplating process, on a surface that is of the first waveguide substrate 19S1 and that has the first grating structure 14S1, or may be formed on a surface of the first grating layer 19A.

In an implementation, a thickness of the first modulation layer is 0.2 $\mu$m to 1.2 $\mu$m.

In an implementation, the refractive index of the first modulation layer 19M1 is less than the refractive index of the first grating structure 14S1. Specifically, the refractive index of the first modulation layer 19M1 may be less than or equal to 1.6. This solution is mainly used to adjust diffraction efficiency of the first grating structure 14S1. Because there is a refractive index difference (the refractive index difference is greater than or equal to 0.1) between the first modulation layer 19M1 and the first grating structure 14S1, diffraction efficiency changes. In order to ensure the refractive index difference between the first modulation layer 19M1 and the first grating structure 14S1, the refractive index of the first modulation layer 19M1 may be restricted to be within a range less than or equal to 1.6.

In an implementation, the refractive index of the first modulation layer 19M1 is greater than the refractive index of the first grating structure 14S1. Specifically, the refractive index of the first modulation layer 19M1 is greater than or equal to 1.9. This solution is mainly used to adjust diffraction efficiency of the first grating structure 14S1. Because there is a refractive index difference (the refractive index difference is greater than or equal to 0.1) between the first modulation layer 19M1 and the first grating structure 14S1, diffraction efficiency changes. In order to ensure the refractive index difference between the first modulation layer 19M1 and the first grating structure 14S1, the refractive index of the first modulation layer 19M1 may be restricted to be within a range greater than or equal to 1.9.

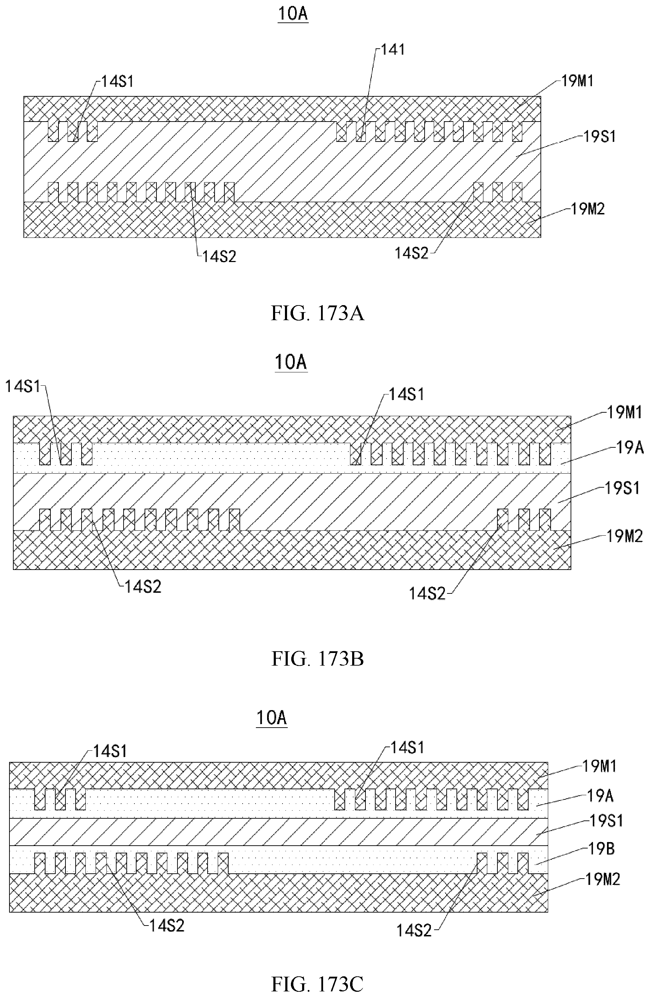

Refer to FIG. 173A, FIG. 173B, and FIG. 173C. In an implementation, on a basis of the implementation shown in FIG. 169, the implementation shown in FIG. 170, and the implementation shown in FIG. 171, the optical waveguide 10A further includes a first modulation layer 19M1 and a second modulation layer 19M2. As shown in FIG. 173A, the first modulation layer 19M1 is disposed on the top surface of the first waveguide substrate 19S1 and covers the first grating structure 14S1, and the second modulation layer 19M2 is disposed on the bottom surface of the first waveguide substrate 19S1 and covers the second grating structure 14S2. As shown in FIG. 173B, the first modulation layer 19M1 is disposed on the first grating layer 19A and covers the first grating structure 14S1, and the second modulation layer 19M2 is disposed on the bottom surface of the first waveguide substrate 19S1 and covers the second grating structure 14S2. As shown in FIG. 173C, the first modulation layer 19M1 is disposed on the first grating layer 19A and covers the first grating structure 14S1, and the second modulation layer 19M2 is disposed on the second grating layer 19B and covers the second grating structure 14S2.

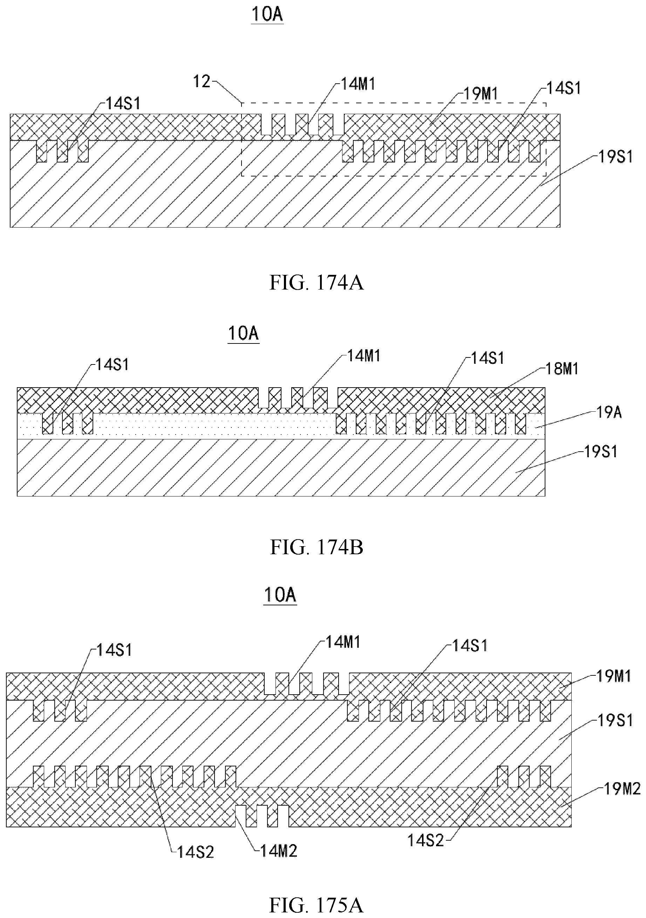

Refer to FIG. 174A and FIG. 174B. In an implementation, a first auxiliary grating structure 14M1 is disposed on a surface that is of the first modulation layer 19M1 and that is away from the first grating structure 14S1, and the first auxiliary grating structure 14M1 is configured to modulate a light ray.

In an implementation, the first auxiliary grating structure 14M1 and a part of the first grating structure 14S1 jointly form an out-coupling grating of the optical waveguide 10A, as shown in FIG. 174A, where a grating structure in the rectangular dashed box represents the out-coupling grating 12. This solution may be understood as follows: The out-coupling grating 12 is disposed in layers, a part of the out-coupling grating 12 is the first grating structure 14S1, and a part of the out-coupling grating 12 is the first auxiliary grating structure 14M1. Refractive indexes of the two parts of the out-coupling grating 12 are different, and diffraction efficiency of the out-coupling grating 12 can be modulated. In a specific implementation, in a region in which the out-coupling grating 12 is located, the refractive index of the first auxiliary grating structure 14M1 is less than the refractive index of the first grating structure 14S1, and the first auxiliary grating structure 14M1 is located on a side that is of the first grating structure 14S1 and that is close to the in-coupling grating, that is, located on a light incident side of the first grating structure 14S1. In this design, the out-coupling grating 12 can couple uniform light rays out. In another implementation, in a region in which the out-coupling grating 12 is located, the refractive index of the first auxiliary grating structure 14M1 is greater than the refractive index of the first grating structure 14S1, and diffraction efficiency of the optical waveguide can be improved by using the first auxiliary grating structure 14M1. The first auxiliary grating structure 14M1 may be an in-coupling grating, a relay grating, or an out-coupling grating.

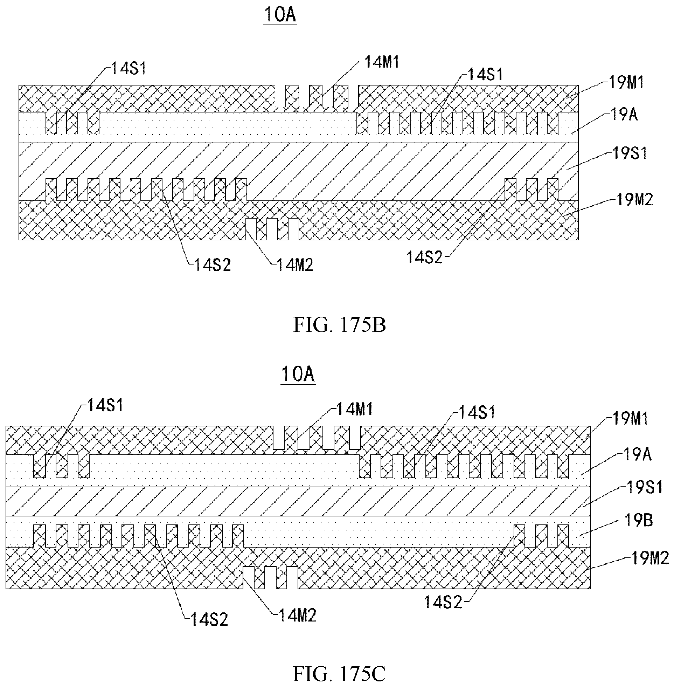

Refer to FIG. 175A, FIG. 175B, and FIG. 175C. In an implementation, on a basis of the implementations shown in FIG. 173A, FIG. 173B, and FIG. 173C, the optical waveguide 10A further includes a second auxiliary grating structure 14M2 disposed on the second modulation layer.

Refer to FIG. 175A. The optical waveguide 10A includes the second modulation layer 19M2, the first waveguide substrate 19S1, and the first modulation layer 19M1 that are sequentially disposed in a stacked manner, the first grating structure 14S1 is disposed between the first modulation layer 19M1 and the first waveguide substrate 19S1, and the second grating structure 14S2 is disposed between the second modulation layer 19M2 and the first waveguide substrate 19S1. The first auxiliary grating structure 14M1 is disposed on a surface that is of the first modulation layer 19M1 and that is away from the first waveguide substrate 19S1, and the second auxiliary grating structure 14M2 is disposed on a surface that is of the second modulation layer 19M2 and that is away from the first waveguide substrate 19S1. The first auxiliary grating structure 14M1 and the second auxiliary grating structure 14M2 may be symmetrically distributed on two sides of the first waveguide substrate 19S1, and the first auxiliary grating structure 14M1 and the second auxiliary grating structure 14M2 may have parameters such as a same structure, a same refractive index, and a same vector direction. In another implementation, the first auxiliary grating structure 14M1 and the second auxiliary grating structure 14M2 may have different refractive indexes, or have different vector directions, or have different structural forms.

Refer to FIG. 175B. The optical waveguide 10A includes the second modulation layer 19M2, the first waveguide substrate 19S1, the first grating layer 19A, and the first modulation layer 19M1 that are sequentially disposed in a stacked manner. The first grating structure 14S1 is disposed on the first grating layer 19A, the first modulation layer 19M1 covers the first grating layer 19A, the first auxiliary grating structure 14M1 is disposed on a surface that is of the first modulation layer 19M1 and that is away from the first grating layer 19A, the second grating structure 14S2 is disposed between the second modulation layer 19M2 and the first waveguide substrate 19S1, and the second auxiliary grating structure 14M2 is disposed on a surface that is of the second modulation layer 19M2 and that is away from the first waveguide substrate 19S1.

Refer to FIG. 175C. The optical waveguide 10A includes the second modulation layer 19M2, the second grating layer 19B, the first waveguide substrate 19S1, the first grating layer 19A, and the first modulation layer 19M1 that are sequentially disposed in a stacked manner, the first grating structure 14S1 is disposed on the first grating layer 19A, the first modulation layer 19M1 covers the first grating layer 19A, the first auxiliary grating structure 14M1 is disposed on a surface that is of the first modulation layer 19M1 and that is away from the first grating layer 19A. The second grating structure 14S1 is disposed on the second grating layer 19B, and the second auxiliary grating structure 14M2 is disposed on a surface that is of the second modulation layer 19M2 and that is away from the second grating layer 19B.

On a basis of the implementations shown in FIG. 175A, FIG. 175B, and FIG. 175C, no grating structure may be disposed on a second modulation layer 19M2, that is, the second auxiliary grating structure 14M2 may not be disposed on the optical waveguide 10A.

In an implementation, a difference between a refractive index of the second modulation layer 19M2 and a refractive index of the second grating structure 14S2 is greater than or equal to 0.1. A thickness of the second modulation layer 19M2 may be 0.2 $\mu$m to 1.2 $\mu$m. The thickness of the second modulation layer 19M2 may be equal to that of the first modulation layer 19M1. The thickness of the second modulation layer M2 may be not equal to that of the first modulation layer 19M1.

In an implementation, this application provides a multi-layer single-sided optical waveguide. It may be understood that the optical waveguide has at least two layers of waveguide substrates, and each layer of waveguide substrate is a grating structure disposed on a single side.

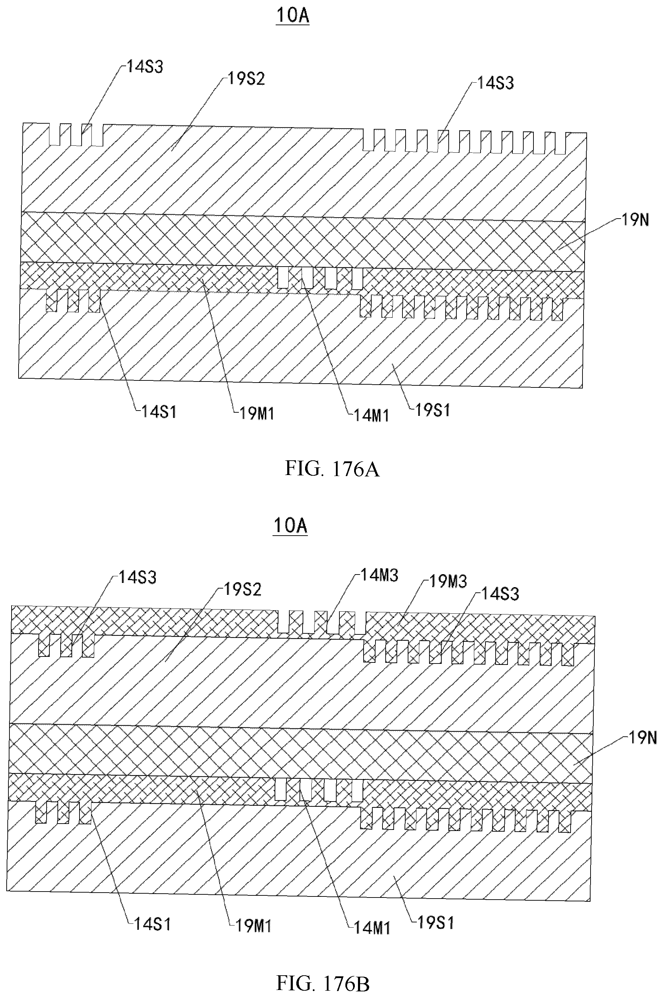

Refer to FIG. 176A. In an implementation, an optical waveguide 10A includes a first waveguide substrate 19S1 and a second waveguide substrate 19S2. Both the first waveguide substrate 19S1 and the second waveguide substrate 19S are flexible and can be freely bent and deformed, so that the optical waveguide 10A is flexible and can match any curved shape of a lens of a near-eye display device. Both the second waveguide substrate 19S2 and the first waveguide substrate 19S1 are used for total internal reflection of an optical path. A first grating structure 14S1 is disposed on a top surface of the first waveguide substrate 19S1, a first modulation layer 19M1 is disposed on a surface of the first grating structure 14S1, and a first auxiliary grating structure 14M1 is disposed on a surface of the first modulation layer 19M1. A third grating structure 14S3 is disposed on a top surface of the second waveguide substrate 19S2. The optical waveguide 10A further includes an optical limiting layer 19N, and the optical limiting layer 19N is located between the first modulation layer 19M1 and a bottom surface of the second waveguide substrate 19S2. The optical limiting layer 19N is in a transparent shape, and is configured to isolate the total internal reflection of optical paths of the first waveguide substrate 19S1 and the second waveguide substrate 19S2, to ensure total internal reflection of the first waveguide substrate 19S1 and total internal reflection of the second waveguide substrate 19S2. The optical limiting layer 19N is also flexible.

In an implementation, a thickness of the optical limiting layer 19N is less than or equal to 100 μm. In this solution, the thickness of the optical limiting layer is controlled to be less than or equal to 100 μm, which helps control thinning of the optical waveguide 10A, so that the optical waveguide 10A forms a thin film architecture, to achieve a good adhesion effect in a process of attaching the optical waveguide 10A to a curved lens surface.

In an implementation, a refractive index of the optical limiting layer 19N is less than or equal to 1.2, and the optical limiting layer 19N may be made of a low-refractive transparent filling adhesive, and may be formed through spin-coating or deposition.

Refer to FIG. 176B. In an implementation, on a basis of the implementation shown in FIG. 176A, the optical waveguide 10A further includes a third modulation layer 19M3, and the third modulation layer 19M3 covers a third grating structure 14S3, to protect the third grating structure 14S3 and modulate diffraction efficiency of the third grating structure 14S3. A third auxiliary grating structure 14M3 is further disposed on a surface of the third modulation layer 19M3, and the third auxiliary grating structure 14M3 is configured to modulate diffraction efficiency of the third grating structure 14S3.

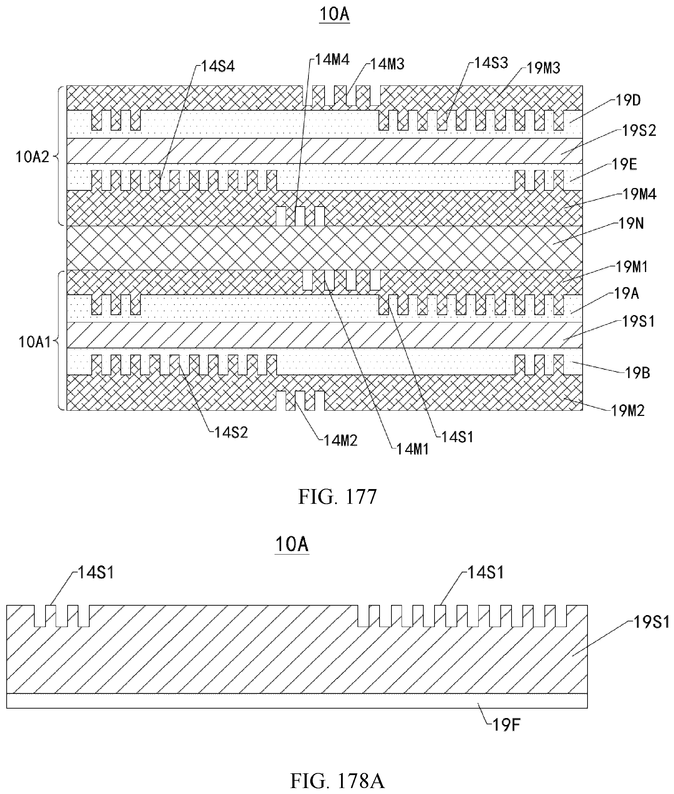

In an implementation, the optical waveguide is a multi-layer waveguide architecture, and each layer of waveguide architecture is a double-sided grating structure. In other words, grating structures are disposed on both a top surface and a bottom surface of a waveguide substrate of each layer of waveguide architecture. Refer to FIG. 177. The optical waveguide 10A includes a first-layer waveguide architecture 10A1, an optical limiting layer 19N, and a second-layer waveguide architecture 10A2 that are disposed in a stacked manner. The first layer waveguide architecture 10A1 includes a second modulation layer 19M2, a second grating layer 19B, a first waveguide substrate 19S1, a first grating layer 19A, and a first modulation layer 19M1 that are sequentially disposed in a stacked manner. A first grating structure 14S1 is disposed on the first grating layer 19A, and a first modulation layer 19M1 covers the first grating layer 19A, to protect the first grating structure 14S1 and modulate diffraction efficiency of the first grating structure 14S1. A first auxiliary grating structure 14M1 is disposed on a side that is of the first modulation layer 19M1 and that is away from the first grating layer 19A. The first auxiliary grating structure 14M1 is configured to modulate diffraction efficiency of the first grating structure 14S1. A second grating structure 14S2 is disposed on the second grating layer 19B, and the second modulation layer 19M2 covers the second grating layer 19B, to protect the second grating structure 14S2 and modulate diffraction efficiency of the second grating structure 14S2. A second auxiliary grating structure 14M2 is disposed on a side that is of the second modulation layer 19M2 and that is away from the second grating layer 19B. The second auxiliary grating structure 14M2 is configured to modulate diffraction efficiency of the second grating structure 14S2. The second-layer waveguide architecture 10A2 includes a fourth modulation layer 19M4, a fourth grating layer 19E, a second waveguide substrate 19S2, a third grating layer 19D, and a third modulation layer 19M3 that are sequentially disposed in a stacked manner. A third grating structure 14S3 is disposed on the third grating layer 19D, and the third modulation layer 19M3 covers the third grating layer 19D, to protect the third grating structure 14S3 and modulate diffraction efficiency of the third grating structure 14S3. A third auxiliary grating structure 14M3 is disposed on the third modulation layer 19M3, and the third auxiliary grating structure 14M3 is configured to modulate diffraction efficiency of the third grating structure 14S3. A fourth grating structure 14S4 is disposed on the fourth grating layer 19E, and the fourth modulation layer 19M4 covers the fourth grating layer 19E, to protect the fourth grating structure 14S4 and diffraction efficiency used to modulate the fourth grating structure 14S4. A fourth auxiliary grating structure 14M4 is disposed on a surface that is of the fourth modulation layer 19M4 and that is away from the fourth grating layer 19E, and the fourth auxiliary grating structure 14M4 is configured to modulate diffraction efficiency of the fourth grating structure 14S4.

The fourth modulation layer 19M4 and the first modulation layer 19M1 are distributed on two sides of the optical limiting layer 19N, and are respectively attached to a top surface and a bottom surface of the optical limiting layer 19N. There are refractive index differences between refractive indexes of the fourth modulation layer 19M4 and the first modulation layer 19M1 and a refractive index of the optical limiting layer 19N. For example, the refractive index difference is greater than or equal to 0.2 or greater than or equal to 0.4. It can be ensured, by restricting the refractive index difference, that the first-layer waveguide architecture 10A1 and the second-layer waveguide architecture 10A2 are isolated, to form independent paths for total internal reflection.

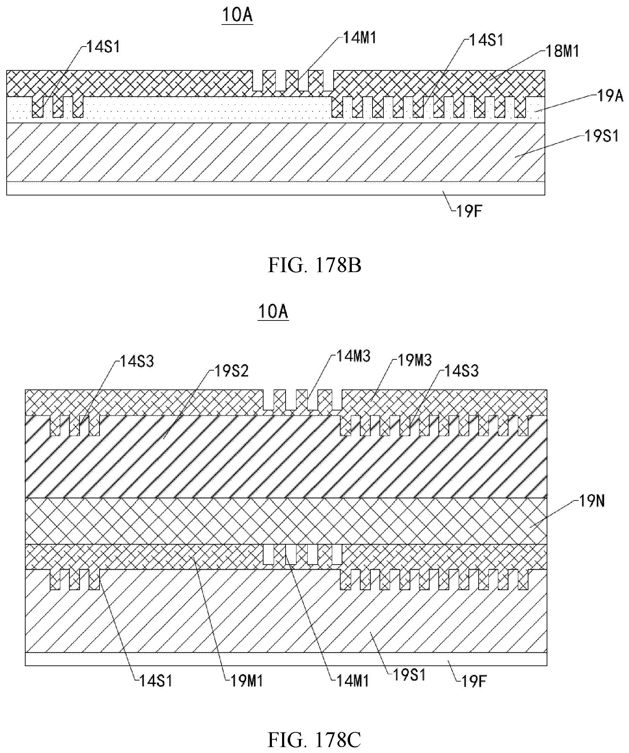

Refer to FIG. 178A, FIG. 178B, and FIG. 178C. In an implementation, the optical waveguide 10A further includes a flexible substrate layer 19F. The flexible substrate layer 19F and the first waveguide substrate 19S1 are disposed in a stacked manner, and are located on a side that is of the first waveguide substrate 19S1 and that is away from the first grating structure 14S1. The flexible substrate layer 19F is transparent and has a refractive index less than a refractive index of the first waveguide substrate 19S1, and the flexible substrate layer 19F is configured to be attached to a lens of a near-eye display device. In this solution, a flexible substrate layer 19F is added onto the first waveguide substrate 19S1, and the flexible substrate layer 19F is attached to the lens, so that the first waveguide substrate 19S1 can be prevented from being directly attached to the lens. If the first waveguide substrate 19S1 is directly attached to the lens, an adhesive for attaching may affect an optical parameter of the first waveguide substrate 19S1. The flexible substrate layer 19F can protect the first waveguide substrate 19S1, to ensure optical performance of the optical waveguide.

It may be understood that, in another implementation, the optical waveguide 10A provided in this application may not be provided with the flexible substrate layer 19F, and may be directly attached to the lens of the near-eye display device by using the first waveguide substrate 19S1.

This application provides a method for fabricating an optical waveguide, used to fabricate the flexible optical waveguide provided in any one of the foregoing implementations. In an implementation, the method for fabricating an optical waveguide includes the following steps:

> providing a rigid substrate, where the rigid substrate includes a fabrication plane;
> forming a sacrificial layer on the fabrication plane;
> fabricating the optical waveguide on the sacrificial layer, where the optical waveguide is flexible and can be attached to a curved lens of a near-eye display device; and
> dissolving the sacrificial layer to obtain the optical waveguide.

According to the method for fabricating an optical waveguide provided in this application, the optical waveguide is fabricated on the rigid substrate and the sacrificial layer by using a planar fabrication process, so that batch production is easy to implement. Then, the sacrificial layer is dissolved by using properties of the sacrificial layer to remove the rigid substrate, so as to form a flexible optical waveguide. The method for fabricating an optical waveguide provided in this application is easy to process, and has low fabrication costs. Flexibility performance of the optical waveguide can be ensured while an optical waveguide is being produced. In particular, a flexible optical waveguide whose surface has a relief grating may be fabricated on a large scale by using a nano-imprinting process.

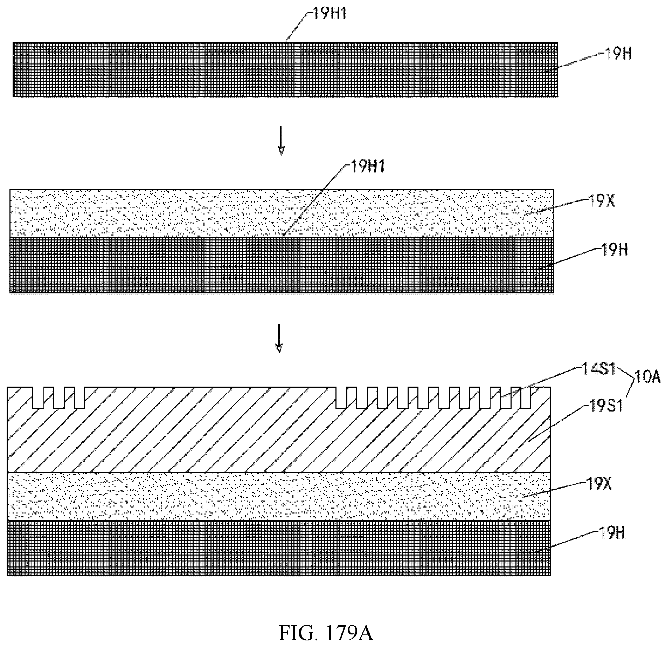

Refer to FIG. 179A. In an implementation, a method for fabricating an optical waveguide provided in this application includes the following steps:

> providing a rigid substrate 19H, where the rigid substrate 19H includes a fabrication plane 19H1, for example, the fabrication plane 19H1 is a top surface of the rigid substrate 19H;
> forming a sacrificial layer 19X on the fabrication plane 19H1, where specifically, a material of the sacrificial layer 19X may be disposed on the fabrication plane 19H1 by using a spin-coating process or a deposition process, to ensure that a surface of the sacrificial layer 19X is a planar in shape, and an optical waveguide needs to be fabricated on the surface of the sacrificial layer 19X;

fabricating an optical waveguide 10A on the sacrificial layer 19X, which specifically includes: disposing a first waveguide substrate 19S1 on the sacrificial layer 19X, and fabricating a first grating structure 14S1 on the first waveguide substrate 19S1, where a refractive index of the first waveguide substrate 19S1 is greater than or equal to 1.6, a thickness of the first waveguide substrate 19S1 is less than 300 $\mu$m, and the first waveguide substrate 19S1 is made of a flexible material, and after being separated from the rigid substrate 19H, the first waveguide substrate 19S1 can be freely bent and deformed, and can be attached to a curved lens of a near-eye display device; and

dissolving the sacrificial layer 19X, so that the optical waveguide 10A is separated from the rigid substrate 19H, to obtain a flexible optical waveguide 10A.

A single-layer single-sided optical waveguide 10A may be fabricated by using the foregoing method.

In an implementation, the optical waveguide fabricated in FIG. 179A may be used as an optical waveguide intermediate structure to continue to fabricate a single-layer double-sided optical waveguide architecture, that is, grating structures are disposed on both sides of the first waveguide substrate.

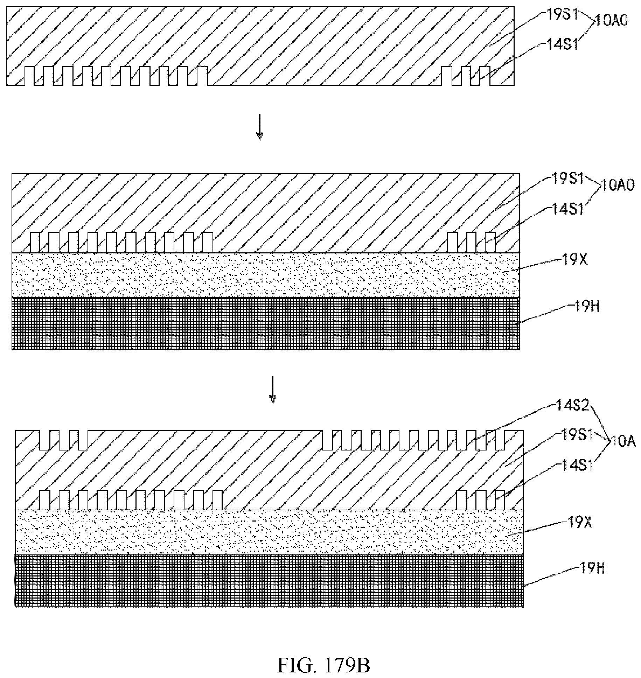

Refer to FIG. 179B. In an implementation, a method for fabricating an optical waveguide includes the following steps:

> providing an optical waveguide intermediate structure 10A0, where the optical waveguide intermediate structure 10A0 is flexible and includes a first waveguide substrate 19S1 and a first grating structure 14S1 formed on a surface of the first waveguide substrate 19S1;
> providing a rigid substrate 19H, and forming a sacrificial layer 19X on the rigid substrate 19H;
> disposing the optical waveguide intermediate structure 10A0 on the sacrificial layer 19X, where the first grating structure 14S1 is in full contact with the sacrificial layer 19X;
> fabricating a second grating structure 14S2 on a side that is of the first waveguide substrate 19S1 and that is away from the first grating structure 14S1, to form an optical waveguide 10A; and
> dissolving the sacrificial layer 19X, so that the optical waveguide 10A is separated from the rigid substrate 19H, to obtain a flexible optical waveguide 10A.

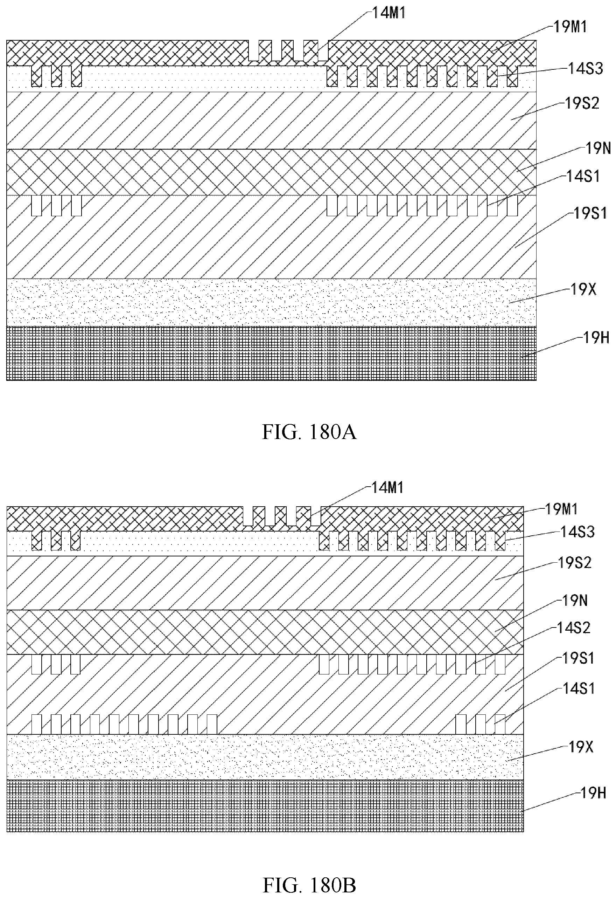

Refer to FIG. 180A. In an implementation, on a basis of the method for fabricating an optical waveguide provided in the implementation shown in FIG. 179A, an optical limiting layer 19N, a second waveguide substrate 19S2, and a third grating structure 14S3 may be further fabricated before the sacrificial layer is dissolved, to form a multi-layer optical waveguide architecture. The specific method includes the following steps:

forming a sacrificial layer 19X on a rigid substrate 19H, and disposing a first waveguide substrate 19S1 on the sacrificial layer 19X, where the first waveguide substrate 19S1 is used for total internal reflection of an optical path, and the first waveguide substrate 19S1 is flexible;

fabricating a first grating structure 14S1 on the first waveguide substrate 19S1;

forming an optical limiting layer 19N on the first grating structure 14S1, where the optical limiting layer 19N is also in flexible and transparent, and a refractive index of the optical limiting layer 19N is less than a refractive index of the first waveguide substrate 19S1;

fabricating a second waveguide substrate 19S2 on the optical limiting layer 19N, where the second waveguide substrate 19S2 is used for total internal reflection of an optical path, and the second waveguide substrate 19S2 is flexible; and

fabricating a third grating structure 14S3 on the second waveguide substrate 19S2.

Specifically, in the implementation shown in FIG. 180A, the third grating structure 14S3 is disposed on a grating layer, and the grating layer is coated on a surface of the second waveguide substrate 19S2. It may be understood that alternatively, the third grating structure 14S3 may be integrally formed on the second waveguide substrate 19S2 by using an etching process. In an implementation, a first modulation layer 19M1 may be disposed on a surface of the third grating structure 14S3, a first auxiliary grating structure 14M1 may be disposed on a surface of the first modulation layer 19M1, and the first auxiliary grating structure 14M1 is configured to modulate diffraction efficiency of the third grating structure 14S3.

Refer to FIG. 180B. In an implementation, on a basis of the method for fabricating an optical waveguide provided in the implementation shown in FIG. 179B, an optical limiting layer 19N, a second waveguide substrate 19S2, a third grating structure 14S3, and a first modulation layer 19M1 may be further fabricated before the sacrificial layer is dissolved, to form a multi-layer optical waveguide architecture. The first auxiliary grating structure 14M1 may be disposed on a surface of the first modulation layer 19M1, and the first auxiliary grating structure 14M1 is configured to modulate diffraction efficiency of the third grating structure 14S3.

In the description of this disclosure, it should be understood that:

The term "and/or" indicates that two solutions may exist separately or may both exist. For example, "A and/or B" includes three solutions: solution A, solution B, and solutions A and B.

The terms "center", "longitudinal", "transverse", "length", "width", "thickness", "up", "down", "front", "back", "left", "right", "vertical", "horizontal", "top", "bottom", "internal", "outside", "clockwise", "counterclockwise", "axial", "radial", "circular", or other orientation or position relationships indicated by the terms are based on an orientation or position relationship shown in the accompanying drawings, which is merely intended to facilitate description of this disclosure and simplify the description, but is not intended to indicate or imply that a specified apparatus or element must have a specific orientation, and be constructed and operated in a specific orientation. Therefore, this shall not be construed as a limitation on the present disclosure.

In addition, the terms "first" and "second" are merely intended for a purpose of description, and shall not be understood as an indication or implication of relative importance or implicit indication of the number of indicated technical features. Therefore, a feature limited by "first" or "second" may explicitly or implicitly include at least one of the features. In the descriptions about this disclosure, "a plurality of" means at least two, for example, two or three, unless otherwise specifically limited.

In this disclosure, unless otherwise specified and limited, the terms such as "mount", "link", "connect", and "fasten" should be understood broadly. For example, the term "connect" may be a fixed connection, may be a detachable connection, or may be integration; may be a mechanical connection or may be an electrical connection or a connection capable of achieving mutual communication; or may be a direct connection, may be an indirect connection implemented by using an intermediate medium, or may be communication inside two elements or an interaction relationship between two elements, unless otherwise specifically limited. A person of ordinary skill in the art may understand specific meanings of the foregoing terms in this disclosure based on a specific case.

In this disclosure, unless otherwise specified and limited, when a first feature is "above" or "below" a second feature, the first feature may be in direct contact with the second feature, or the first feature may be in indirect contact with the second feature through an intermediate medium. In addition, that a first feature is "above" a second feature may be that the first feature is directly above or obliquely above the second feature, or merely indicates that a horizontal height of the first feature is greater than a horizontal height of the second feature. That a first feature is "below" a second feature may be that the first feature is directly below or obliquely below the second feature, or merely indicates that a horizontal height of the first feature is less than a horizontal height of the second feature.

In this disclosure, the terms "an embodiment", "some embodiments", "example", "specific example", or "some examples" mean that specific characteristics, structures, materials, or features described with reference to the embodiment or example are included in at least one embodiment or example of this disclosure. In the specification, the foregoing example expressions of the terms are not necessarily with respect to a same embodiment or example. In addition, the described specific features, structures, materials, or characteristics may be combined in an appropriate manner in any one or more of the embodiments or examples. In addition, persons skilled in the art may integrate or combine different embodiments or examples or characteristics of different embodiments or examples described in this specification, provided that they do not conflict with each other.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A light combining unit, used in an optical engine of a near-eye display device, wherein the light combining unit comprises a first prism unit, a second prism unit, a third prism unit, and a fourth prism unit, the first prism unit and the third prism unit are of a pentahedron structure, and the second prism unit and the fourth prism unit are of a tetrahedron structure; the first prism unit, the second prism unit, the third prism unit, and the fourth prism unit are assembled to form a hexahedron architecture, an interconnection position between the first prism unit and the second prism unit is a first surface, an interconnection position between the third prism unit and the fourth prism unit is a second surface, an interconnection position between the first prism unit and the fourth prism unit is a third surface, and an interconnection position between the second prism unit and the third prism unit is a fourth surface; a first optical splitting film is disposed on the first surface and the second surface, a second optical splitting film is disposed on the third surface and the fourth surface, and wavelength ranges of light rays reflected by the first optical splitting film and the second optical splitting film are different; and the first surface and the second surface form a first diagonal plane of the hexahedron architecture, the third surface and the fourth surface form a second diagonal plane of the hexahedron structure, and an intersection line between the first diagonal plane and the second diagonal plane is a body diagonal of the hexahedron structure.

2. The light combining unit according to claim 1, wherein the first prism unit, the second prism unit, the third prism unit, and the fourth prism unit are all of integrated prism structures.

3. The light combining unit according to claim 2, wherein

   the first optical splitting film is configured to reflect light in a first wavelength range and transmit light in a second wavelength range and light in a third wavelength range, and the second optical splitting film is configured to reflect light in the second wavelength range and transmit light in the first wavelength range and light in the third wavelength range; or
   the first optical splitting film is configured to reflect light in a second wavelength range and transmit light in a first wavelength range and light in a third wavelength range, and the second optical splitting film is configured to reflect light in the first wavelength range and transmit light in the second wavelength range and light in the third wavelength range.

4. The light combining unit according to claim 1, wherein

   the first prism unit comprises a first sub-prism and a second sub-prism, and an interconnection position between the first sub-prism and the second sub-prism is a first sub-surface;
   the second prism unit comprises a third sub-prism and a fourth sub-prism, and an interconnection position between the third sub-prism and the fourth sub-prism is a second sub-surface;
   the third prism unit comprises a fifth sub-prism and a sixth sub-prism, and an interconnection position between the fifth sub-prism and the sixth sub-prism is a third sub-surface;
   the fourth prism unit comprises a seventh sub-prism and an eighth sub-prism, and an interconnection position between the seventh sub-prism and the eighth sub-prism is a fourth sub-surface; and
   the first sub-surface, the second sub-surface, the third sub-surface, and the fourth sub-surface form a third diagonal plane of the hexahedron structure, an intersection line between the third diagonal plane and the first diagonal plane is a body diagonal of the hexahedron structure, and a length of an intersection line between the third diagonal plane and the second diagonal plane is equal to an edge length of the hexahedron structure.

5. The light combining unit according to claim 4, wherein both the first sub-prism and the second sub-prism are pentahedron prisms; one of the third sub-prism and the fourth sub-prism is a tetrahedron prism, and the other is a pentahedron prism; both the fifth sub-prism and the sixth sub-prism are pentahedron prisms; and one of the seventh sub-prism and the eighth sub-prism is a tetrahedron prism, and the other is a pentahedron prism.

6. The light combining unit according to claim 4 or 5, wherein a third optical splitting film is disposed on the third diagonal plane, and the third optical splitting film, the first optical splitting film, and the second optical splitting film are respectively configured to reflect light rays in different wavelength ranges.

7. The light combining unit according to claim 6, wherein the second optical splitting film and the third optical splitting film each comprise four sub-films, and the first optical splitting film is of an integrated structure.

8. The light combining unit according to any one of claims 1 to 3, wherein the second optical splitting film comprises two sub-films, and the first optical splitting film is of an integrated structure.

9. An optical engine, comprising a light emitting unit, an optical imaging unit, and the light combining unit according to any one of claims 1 to 8, wherein the light combining unit is configured to combine monochromatic light emitted by the light emitting unit, and the optical imaging unit is located on a light exit side of the light combining unit.

10. The optical engine according to claim 9, wherein the light emitting unit comprises a first wavelength range emitting unit, a second wavelength range emitting unit, and a third wavelength range emitting unit; the first wavelength range emitting unit exactly faces a first light incident surface of the hexahedron structure of the light combining unit, the second wavelength range emitting unit exactly faces a second light incident surface of the hexahedron structure of the light combining unit, and the third wavelength range emitting unit exactly faces a third light incident surface of the hexahedron structure of the light combining unit; and the first light incident surface, the second light incident surface, and the third light incident surface are disposed perpendicular and adjacent to each other, both a normal direction of a light-emitting surface of the first wavelength range emitting unit and a normal direction of a light-emitting surface of the second wavelength range emitting unit are perpendicular to an optical axis of the optical imaging unit of the optical engine, and a normal direction of a light-emitting surface of the third wavelength range emitting unit is the same as an optical axis direction of the optical imaging unit of the optical engine.

11. The optical engine according to claim 9, wherein the light emitting unit comprises a first wavelength range emitting unit, a second wavelength range emitting unit, and a third wavelength range emitting unit; a light-emitting surface of the first wavelength range emitting unit exactly faces a first light incident surface of the hexahedron structure of the light combining unit, a light-emitting surface of the second wavelength range emitting unit exactly faces a second light incident surface of the hexahedron structure of the light combining unit, and a light-emitting surface of the third wavelength range emitting unit exactly faces a third light incident surface of the hexahedron structure of the light combining unit; and the first light incident surface and the second light incident surface are parallel to each other, the third light incident surface is perpendicular to the first light incident surface, and a normal direction of the light-emitting surface of the first wavelength range emitting unit, a normal direction of the light-emitting surface of the third wavelength range emitting unit, and a normal direction of the light-emitting surface of the second wavelength range emitting unit are all perpendicular to an optical axis of the optical imaging unit of the optical engine.

12. A near-eye display device, comprising a mechanical part and lenses, wherein the mechanical part comprises a temple and a frame, the temple is connected to the frame, the lens has an optical waveguide, the lens is fastened on the frame, the near-eye display device comprises the optical engine according to any one of claims 9 to 11, and the optical engine is fastened to the mechanical part.

13. The near-eye display device according to claim 12, wherein the near-eye display device is provided with a controller, the light emitting unit comprises a first flexible circuit board, a second flexible circuit board, and a third flexible circuit board, the first flexible circuit board is electrically connected between the first wavelength range emitting unit and the controller, the second flexible circuit board is electrically connected between the second wavelength range emitting unit and the controller, the third flexible circuit board is electrically connected between the third wavelength range emitting unit and the controller, and at least one of the first flexible circuit board, the second flexible circuit board, and the third flexible circuit board extends along the mechanical part without bending.

14. The near-eye display device according to claim 13, wherein the optical engine is fastened to the temple, at least one of the first flexible circuit board, the second flexible circuit board, and the third flexible circuit board extends along the temple without bending, an outer surface of the hexahedron structure of the light combining unit is a non-light-incident surface, the non-light-incident surface is adjacent to a light exit surface of the light combining unit, the non-light-incident surface faces an inner side of the temple, and the inner side of the temple is configured to be close to a human face.

15. An optical component, comprising an optical engine and an optical waveguide, wherein the optical waveguide comprises a waveguide substrate and an in-coupling grating, the waveguide substrate comprises an oblique surface, the oblique surface is located at a position at which the in-coupling grating and the waveguide substrate are combined, or is located at a light incident side of a position at which the in-coupling grating and the waveguide substrate are combined, the in-coupling grating is configured to receive light of the optical engine, the oblique surface faces the optical engine, the optical engine has an optical axis, a direction perpendicular to the optical axis is a first direction, and an included angle between the oblique surface and the first direction is greater than or equal to a half of a field of view of the optical engine, so that an edge light ray of the field of view of the optical engine that is reflected by the in-coupling grating is capable of being deflected out of the optical engine.

16. The optical component according to claim 15, wherein the field of view of the optical engine is a horizontal field of view or a vertical field of view.

17. The optical component according to claim 15 or 16, wherein the optical axis of the optical engine is a central axis of an optical effective region of the optical engine.

18. The optical component according to any one of claims 15 to 17, wherein the waveguide substrate is of an integrally formed structure, and the oblique surface is a structure formed by removing a part of material from the waveguide substrate.

19. The optical component according to claim 18, wherein the in-coupling grating is formed on the oblique surface, an included angle between a light ray reflected by the in-coupling grating and the optical axis is a second angle, an included angle between an edge light ray of the field of view of the optical engine that is incident on the in-coupling grating and the optical axis is a first angle, and the second angle is greater than the first angle.

20. The optical component according to claim 18, wherein the waveguide substrate comprises a main flat surface, the oblique surface is inclined relative to the main flat surface, the in-coupling grating is formed on the main flat surface, in an extension direction of the optical axis, the oblique surface is located between the in-coupling grating and the optical engine, an edge light ray of the field of view of the optical engine is incident on the in-coupling grating through the oblique surface, and the edge light ray of the field of view of the optical engine that is reflected by the in-coupling grating is deflected out of the optical engine through the oblique surface.

21. The optical component according to any one of claims 15 to 17, wherein the waveguide substrate comprises a waveguide body structure and an additional structure, the additional structure is fastened to a surface that is of the waveguide body structure and that faces the optical engine, the oblique surface is formed on the additional structure, and the oblique surface is located on a surface that is of the additional structure and that is away from the waveguide body structure.

22. The optical component according to claim 21, wherein the in-coupling grating is formed on the oblique surface, a light ray that is incident from the in-coupling grating enters the waveguide body structure after passing through the additional structure, an included angle between a light ray reflected by the in-coupling grating and the optical axis is a second angle, an included angle between an edge light ray of the field of view of the optical engine that is incident on the in-coupling grating and the optical axis is a first angle, and the second angle is greater than the first angle.

23. The optical component according to claim 21, wherein the waveguide body structure comprises a main flat surface, the oblique surface is inclined relative to the main flat surface, the in-coupling grating is formed on the main flat surface, in an extension direction of the optical axis, the oblique surface is located between the in-coupling grating and the optical engine, an edge light ray of the field of view of the optical engine enters the additional structure and the waveguide body structure through the oblique surface and is incident on the in-coupling grating, and the edge light ray of the field of view of the optical engine that is reflected by the in-coupling grating passes through the waveguide body structure and the additional structure, is emitted from the oblique surface, and is deflected out of the optical engine.

24. The optical component according to any one of claims 21 to 23, wherein a material of the additional structure is the same as a material of the waveguide body structure; and/or a refractive index of the additional structure is the same as a refractive index of the waveguide body structure.

25. The optical component according to claim 24, wherein

the additional structure and the waveguide body structure are bonded by using an optical adhesive, and a refractive index of the optical adhesive is the same as refractive indexes of the additional structure and the waveguide body structure; or
the additional structure and the waveguide body structure are combined in an intermolecular bonding manner.

26. A near-eye display device, comprising a mechanical part and the optical component according to any one of claims 15 to 25, wherein the optical component is mounted on the mechanical part.

27. An optical waveguide, comprising an in-coupling grating and an out-coupling grating, wherein the in-coupling grating is configured to couple a light ray into the optical waveguide and perform total internal reflection in the optical waveguide, the out-coupling grating is configured to couple a light ray out, the out-coupling grating comprises a first region and a second region, the first region is located on a light incident side of the second region along a first direction, the first region comprises a first sub-region and a second sub-region, the first sub-region and the second sub-region are arranged along a second direction, the second direction intersects with the first direction, types of gratings in both the first sub-region and the second sub-region are one-dimensional gratings, the second region is used to couple a light ray out, grating types of at least some gratings in the second region are two-dimensional gratings, a central axis of the second region extends and passes through the in-coupling grating, and the first sub-region and the second sub-region are distributed on two sides of the central axis.

28. The optical waveguide according to claim 27, wherein both the first sub-region and the second sub-region are in contact with the second region.

29. The optical waveguide according to claim 27, wherein a first spacing region is formed between the first sub-region and the second region, a second spacing region is formed between the second sub-region and the second region, and there is no grating structure in either the first spacing region or the second spacing region.

30. The optical waveguide according to claim 29, wherein a size of the first spacing region extending along the first direction is less than or equal to 4 millimeters, and a size of the second spacing region extending along the first direction is less than or equal to 4 millimeters.

31. The optical waveguide according to any one of claims 27 to 30, wherein a center of the in-coupling grating is located on the central axis of the second region.

32. The optical waveguide according to any one of claims 27 to 31, wherein the first sub-region and the second sub-region are mirror-symmetrically distributed by using the central axis as a center; or the first sub-region and the second sub-region have different areas.

33. The optical waveguide according to any one of claims 27 to 31, wherein a direction of a connection line between a center of the first sub-region and a center of the second sub-region is the second direction, and an included angle between the second direction and the central axis is less than 90 degrees.

34. The optical waveguide according to any one of claims 27 to 33, wherein a gate line extension direction of a one-dimensional grating in the first sub-region is a first gate line direction, a gate line extension direction of a one-dimensional grating in the second sub-region is a second gate line direction, a two-dimensional grating in the second region comprises a first gate line and a second gate line arranged to intersect each other, an extension direction of the first gate line is the first gate line direction, and an extension direction of the second gate line is a second gate line direction.

35. The optical waveguide according to claim 34, wherein a distribution period of the one-dimensional grating in the first sub-region is the same as a distribution period of the first gate line; and/or a distribution period of the one-dimensional grating in the second sub-region is the same as a distribution period of the second gate line.

36. The optical waveguide according to any one of claims 27 to 35, wherein the first sub-region is in contact with the second sub-region; or a third spacing region is formed between the first sub-region and the second sub-region.

37. The optical waveguide according to claim 36, wherein there is no grating structure in the third spacing region, and a size of the third spacing region extending along the second direction is less than or equal to a maximum radial size of the in-coupling grating.

38. The optical waveguide according to any one of claims 27 to 37, wherein types of all gratings in the second region are two-dimensional gratings.

39. The optical waveguide according to any one of claims 27 to 37, wherein the second region comprises N two-dimensional regions and N-1 one-dimensional regions, N ≥ 2, the N-1 one-dimensional regions each are located between two adjacent two-dimensional regions, one of the two-dimensional regions is adjacent to or close to the first region, a type of a grating in the one-dimensional region is a one-dimensional grating, and a type of a grating in the two-dimensional region is a two-dimensional grating.

40. The optical waveguide according to claim 39, wherein the one-dimensional region comprises a third sub-region and a fourth sub-region, the third sub-region and the fourth sub-region are arranged along the second direction and distributed on two sides of the central axis, a gate line direction of a part of a grating in the two-dimensional region is the same as a gate line direction of a grating in the third sub-region, and a gate line direction of a part of a grating in the two-dimensional region is the same as a gate line direction of a grating in the fourth sub-region.

41. A near-eye display device, comprising an optical engine and the optical waveguide according to any one of claims 27 to 40, wherein the optical engine is located on a light incident side of the in-coupling grating.

42. An optical waveguide, comprising an out-coupling grating, wherein the out-coupling grating comprises a plurality of sub-gratings arranged at intervals, a distance between two adjacent sub-gratings is L, 3 mm ≤ L ≤ 5 mm, L represents a distance between centers of the two adjacent sub-gratings, one of the sub-gratings is a first sub-grating, a separating region is provided between the first sub-grating and another sub-grating close to the first sub-grating, a maximum radial size of the first sub-grating is less than or equal to 1.5 mm, and there is no grating structure in the separating region.

43. The optical waveguide according to claim 42, wherein a maximum radial size of the first sub-grating is D, and 0.5 mm ≤ D ≤ 1 mm.

44. The optical waveguide according to claim 42, wherein a maximum radial size of each of the plurality of sub-gratings is D, and 0.25 mm ≤ D ≤ 0.75 mm, or 0.75 mm ≤ D ≤ 1.5 mm.

45. The optical waveguide according to any one of claims 42 to 44, wherein the plurality of sub-gratings are arranged in an array of multiple rows and multiple columns, and the array arrangement has a same row distance and a same column distance.

46. The optical waveguide according to any one of claims 42 to 44, wherein the plurality of sub-gratings are arranged in multiple rows, an arrangement direction of sub-gratings in each row is a first direction, odd-numbered rows and even-numbered rows in the multiple rows of the sub-gratings are disposed in a staggered manner, a second direction is perpendicular to the first direction, and in the second direction, the sub-grating in the odd-numbered row exactly faces the separating region between two adjacent sub-gratings in the even-numbered row.

47. The optical waveguide according to claim 46, wherein a distance between any two adjacently disposed sub-gratings is equal.

48. The optical waveguide according to any one of claims 42 to 47, wherein each sub-grating comprises grating microstructures arranged based on a preset period, and the preset period is 200 nm to 500 nm.

49. The out-coupling grating according to any one of claims 42 to 48, wherein the plurality of sub-gratings are coplanar.

50. The out-coupling grating according to any one of claims 42 to 48, wherein one of the two adjacent sub-gratings is located on a front surface of a waveguide substrate of the optical waveguide, the other of the two adjacent sub-gratings is located on a back surface of the waveguide substrate, a center of the sub-grating located on the front surface of the waveguide substrate is a center 1, a vertical projection of a center of the sub-grating located on the back surface of the waveguide substrate onto the front surface of the waveguide substrate is a center 2, and a distance between the two adjacent sub-gratings is a distance between the center 1 and the center 2.

51. The optical waveguide according to any one of claims 42 to 50, wherein the optical waveguide comprises the waveguide substrate, an in-coupling grating, a relay grating, and the out-coupling grating, the relay grating is located between the in-coupling grating and the out-coupling grating, the out-coupling grating comprises a first sub-grating region and a second sub-grating region, a distance between the first sub-grating region and the relay grating is less than a distance between the second sub-grating region and the relay grating, and a height of the sub-grating in the first sub-grating region is less than a height of the sub-grating in the second sub-grating region.

52. The optical waveguide according to claim 51, wherein the out-coupling grating comprises a first edge and a second edge, the first edge is an edge that is of the out-coupling grating and that is close to the relay grating, the second edge is an edge that is of the out-coupling grating and that is away from the relay grating, and in a direction from the first edge to the second edge, heights of the sub-gratings exhibit a gradual increase trend.

53. A near-eye display device, comprising an optical engine and the optical waveguide according to any one of claims 42 to 52, wherein the optical waveguide is configured to receive a light ray projected by the optical engine.

54. A near-eye display device, comprising an optical waveguide, a control unit, a pupil detection member, and a grating adjustment member, wherein

the optical waveguide comprises an out-coupling grating, the out-coupling grating comprises a plurality of sub-gratings, the plurality of sub-gratings are arranged in an array, a maximum radial size of each sub-grating is D, $D \leq 1.5$ mm, a distance between two adjacent sub-gratings is L', $D \leq L' \leq 4$ mm, and L' represents a distance between centers of the two adjacent sub-gratings; and
the pupil detection member is configured to detect a pupil size, the control unit is configured to receive a signal of the pupil detection member and drive the grating adjustment member, and the grating adjustment member is configured to control a part of the sub-gratings of the out-coupling grating to be turned on or off, so that a part of the sub-gratings are in a working state, wherein a distance between two adjacent sub-gratings in the working state is L, $3$ mm $\leq L \leq 5$ mm, and L represents a distance between centers of the two adjacent sub-gratings in the working state.

55. An optical waveguide, comprising a waveguide substrate and a grating structure formed on the waveguide substrate, wherein the grating structure comprises a plurality of core structures and a film structure; a refractive index of the film structure is different from a refractive index of the core structure, the plurality of core structures are sequentially arranged at intervals in a vector direction of the grating structure, each core structure comprises a connection end, a free end, and a side surface, the connection end is connected to the waveguide substrate, the free end and the connection end are disposed opposite to each other in a height direction of the core structure, and the side surface is connected between the connection end and the free end; and the film structure comprises a film body, a first end part, and a second end part, the film body wraps the side surface of the core structure, the first end part and the second end part are respectively located at two ends of the film body, the first end part is connected to the waveguide substrate, the second end part and the free end of the core structure are coplanar, and the free ends of all the core structures and the second end part of the film structure jointly form an end face of the grating structure.

56. The optical waveguide according to claim 55, wherein an end face of the free end of the core structure and an end face of the second end part of the film structure are coplanar.

57. The optical waveguide according to claim 55 or 56, wherein between adjacent core structures, the film structure comprises at least three film layers, the at least three film layers are disposed in a stacked manner between the side surfaces of the adjacent core structures, the at least three film layers have different refractive indexes, and along the vector direction of the grating structure, refractive indexes of the at least three film layers exhibit a gradient trend of sine distribution.

58. The optical waveguide according to claim 57, wherein between the adjacent core structures, the at least three film layers have different thicknesses; and a film layer with a largest thickness is adjacent to the core structure, and a thickness of the core structure is greater than that of the film layer with the largest thickness; or a film layer with a smallest thickness is adjacent to the core structure, and a thickness of the core structure is less than that of the film layer with the smallest thickness.

59. The optical waveguide according to claim 57 or 58, wherein one of the film layers comprises multiple layers of first sub-films and multiple layers of second sub-films that are alternately arranged in one-to-one correspondence, a refractive index of the first sub-film is N1, a refractive index of the second sub-film is N2, a refractive index of the film layer that comprises the multiple layers of first sub-films and the multiple layers of second sub-films is N, and N1 <N<N2.

60. The optical waveguide according to any one of claims 55 to 59, wherein a part of the film structure between the adjacent core structures is a seamless structure.

61. The optical waveguide according to any one of claims 55 to 59, wherein there is a gap in a middle position of the film structure between the adjacent core structures.

62. The optical waveguide according to claims 55 to 61, comprising an in-coupling grating, wherein the in-coupling grating comprises a first in-coupling structure and a second in-coupling structure, the first in-coupling structure and the second in-coupling structure are disposed opposite to each other and are respectively located on a top surface and a bottom surface of the waveguide substrate, the first in-coupling structure and the second in-coupling structure have different grating tilt angles, and the grating structure is at least a part of the in-coupling grating.

63. The optical waveguide according to claim 62, wherein each of the first in-coupling structure and the second in-coupling structure is the grating structure, a refractive index of a core structure of the first in-coupling structure is greater than a refractive index of a core structure of the second in-coupling structure, and a refractive index of a film structure of the first in-coupling structure is greater than a refractive index of a film structure of the second in-coupling structure.

64. A near-eye display device, comprising an optical engine and the optical waveguide according to any one of claims 55 to 63, wherein the optical waveguide is configured to receive a light ray projected by the optical engine.

65. An optical waveguide, comprising an in-coupling region, an out-coupling region, and a light propagation region, wherein an in-coupling grating is disposed in the in-coupling region, the in-coupling grating is configured to receive an incident light ray, the incident light ray undergoes total internal reflection in the light propagation region after entering the optical waveguide, an out-coupling grating is disposed in the out-coupling region, and the out-coupling grating is configured to couple a light ray out; and in the light propagation region, the optical waveguide comprises a medium layer and a first grating layer and a second grating layer located on two sides of the medium layer, at least one of the first grating layer and the second grating layer has different periods, and a refractive index of the medium layer is less than or equal to 1.5.

66. The optical waveguide according to claim 65, wherein each of the first grating layer and the second grating layer has different periods.

67. The optical waveguide according to claim 66, wherein both the first grating layer and the second grating layer are volume holographic gratings.

68. The optical waveguide according to any one of claims 65 to 67, wherein the optical waveguide further comprises a relay grating, in a transmission direction of an optical path, the relay grating is located between the in-coupling region and the out-coupling region, and the first grating layer and the second grating layer in the light propagation region are located between the in-coupling grating and the out-coupling grating and surround the relay grating.

69. The optical waveguide according to any one of claims 65 to 67, wherein the out-coupling grating is a two-dimensional grating, the light propagation region is located between the in-coupling grating and the out-coupling grating, and the first grating layer and the second grating layer fill all regions between the in-coupling grating and the out-coupling grating.

70. The optical waveguide according to any one of claims 65 to 69, wherein the optical waveguide comprises a functional region and an edge region, the in-coupling grating, the out-coupling grating, and the first grating layer and the second grating layer in the light propagation region are disposed in the functional region, and a refractive index of the edge region is less than a refractive index of the functional region or a material of the edge region is different from a material of the functional region.

71. The optical waveguide according to any one of claims 65 to 69, wherein period ranges of the first grating layer and the second grating layer are greater than or equal to 100 nm and less than or equal to 700 nm.

72. The optical waveguide according to any one of claims 65 to 71, wherein a volume shrinkage range of a material of the first grating layer and a volume shrinkage range of a material of the second grating layer are less than or equal to 0.1%.

73. A near-eye display device, comprising an optical engine and the optical waveguide according to any one of claims 65 to 72, wherein a light ray emitted by the optical engine is incident to the in-coupling grating to form an incident light ray.

74. An optical waveguide, comprising a waveguide substrate and an antireflective layer, wherein the antireflective layer is formed on a surface of the waveguide substrate, the antireflective layer comprises a volume holographic material, the antireflective layer comprises a high refractive index phase region and a low refractive index phase region that have different refractive indexes, the high refractive index phase region and the low refractive index phase region are disposed on the surface of the waveguide substrate in a stacked manner, the high refractive index phase region and the low refractive index phase region are different regions that are separated from each other, a refractive index range of the high refractive index phase region is 1.5 to 2.0, a refractive index range of the low refractive index phase region is 1.1 to 1.5, and a component in the high refractive index phase region is different from a component in the low refractive index phase region.

75. The optical waveguide according to claim 74, wherein there are a plurality of high refractive index phase regions, there are a plurality of low refractive index phase regions, and the plurality of high refractive index phase regions and the plurality of low refractive index phase regions are alternately distributed in a direction perpendicular to the surface of the waveguide substrate.

76. The optical waveguide according to claim 74 or 75, wherein the volume holographic material is mainly a polymer material, and main elements of the polymer material comprise: one or more or all of C, H, O, N, S, and P.

77. The optical waveguide according to claim 76, wherein the volume holographic material comprises nanoparticles.

78. The optical waveguide according to claim 77, wherein at least a part of the nanoparticles are distributed in the high refractive index phase region, and the nanoparticles distributed in the high refractive index phase region are one or more or all of titanium dioxide, zirconia, zinc sulfide, and carbon quantum dots; and/or
at least a part of the nanoparticles are distributed in the low refractive index phase region, and the nanoparticles distributed in the low refractive index phase region are one or both of silicon dioxide and magnesium fluoride.

79. The optical waveguide according to claim 77 or 78, wherein a volume fraction content of the nanoparticles is 0 to 60%.

80. The optical waveguide according to any one of claims 74 to 79, wherein each of the high refractive index phase region and the low refractive index phase region has multiple layers, and are sequentially alternately disposed on the surface of the waveguide substrate in a stacked manner.

81. The optical waveguide according to claim 80, wherein a thickness range of each high refractive index phase region or a thickness range of each low refractive index phase region is from 100 nm to 1000 nm.

82. The optical waveguide according to any one of claims 74 to 81, wherein the optical waveguide further comprises an in-coupling grating and an out-coupling grating, both the in-coupling grating and the out-coupling grating are formed on the surface of the waveguide substrate, a non-grating region is provided on the surface of the waveguide substrate, the non-grating region is a region other than the in-coupling grating and the in-coupling grating, and at least a part of the antireflective layer is located in the non-grating region.

83. The optical waveguide according to any one of claims 74 to 81, wherein the optical waveguide further comprises an in-coupling grating, a relay grating, and an out-coupling grating, the in-coupling grating, the relay grating, and the out-coupling grating are formed on the surface of the waveguide substrate, a non-grating region is provided on the surface of the waveguide substrate, the non-grating region is a region other than the in-coupling grating, the relay grating, and the out-coupling grating, and at least a part of the antireflective layer is located in the non-grating region.

84. The optical waveguide according to claim 82 or 83, wherein a part of the antireflective layer is located at a position of the out-coupling grating and forms, together with the out-coupling grating, a co-location structure, the co-location structure comprises grating microstructures arranged along a vector direction of the out-coupling grating, and the co-location structure further comprises the high refractive index phase region and the low refractive index phase region that are alternately distributed in a normal direction of the optical waveguide.

85. The optical waveguide according to claim 84, wherein a surface that is of the out-coupling grating and that is connected to the waveguide substrate is an out-coupling bottom surface of the out-coupling grating, a surface that is of the out-coupling grating and that is away from the waveguide substrate is an out-coupling top surface of the out-coupling grating, and a part of the antireflective layer that forms, together with the out-coupling grating, the co-location structure is formed between the out-coupling bottom surface and the out-coupling top surface.

86. A near-eye display device, comprising an optical engine and the optical waveguide according to any one of claims 74 to 85, wherein the optical engine is located on a light incident side of the optical waveguide.

87. An optical waveguide, used in a near-eye display device, wherein the optical waveguide comprises a first waveguide substrate, a first grating structure, and a first filling layer, the first grating structure is formed on a surface of the first waveguide substrate, the first filling layer and the first waveguide substrate are disposed in a stacked manner, the first filling layer and the first waveguide substrate jointly form a closed surrounding architecture, and the first grating structure is located inside the surrounding architecture, so that the first grating structure is isolated from outside air, wherein a difference between a refractive index of the first filling layer and a refractive index of air is less than or equal to 0.2.

88. The optical waveguide according to claim 87, wherein the first filling layer comprises a grating contact surface, and the grating contact surface has periodically arranged microstructures the same as those of the first grating structure, so that the grating contact surface of the first filling layer is attached to a surface of the microstructures of the first grating structure.

89. The optical waveguide according to claim 87, wherein the first filling layer comprises a grating contact surface, the grating contact surface is planar in shape, and there are periodically arranged slits between the first filling layer and the first grating structure.

90. The optical waveguide according to any one of claims 87 to 89, wherein the first filling layer meets one or a combination of the following conditions:

> light transmission of the first filling layer is greater than or equal to 80%;
> a thickness of the first filling layer is less than or equal to 1000 $\mu$m;
> a material of the first filling layer comprises any one or a combination of an aerogel material, a resin material, an inorganic material, or an organic material; or
> a material of the first filling layer is a silicon dioxide aerogel.

91. The optical waveguide according to any one of claims 87 to 90, wherein the optical waveguide further comprises a first cover plate, the first cover plate is fastened to the first waveguide substrate, the first filling layer is disposed between the first cover plate and the first waveguide substrate in a stacked manner, and the first filling layer is attached to the first cover plate.

92. The optical waveguide according to claim 91, wherein the first cover plate is fastened to the first waveguide substrate by using a dispensing structure, and the dispensing structure is distributed around the first filling layer.

93. The optical waveguide according to claim 91 or 92, wherein the optical waveguide further comprises a second grating structure, a second filling layer, and a second cover plate, the second grating structure and the first grating structure are distributed on two opposite sides of the first waveguide substrate, the second filling layer and the first waveguide substrate are disposed in a stacked manner, the second filling layer and the first waveguide substrate jointly enclose and surround the second grating structure, a difference between a refractive index of the second filling layer and the refractive index of air is less than or equal to 0.2, the second cover plate is fastened to the first waveguide substrate, the second filling layer is disposed between the second cover plate and the first waveguide substrate in a stacked manner, and the second filling layer is attached to the second cover plate.

94. The optical waveguide according to any one of claims 87 to 93, wherein the optical waveguide further comprises a second waveguide substrate and a third grating structure, the third grating structure is formed on the second waveguide substrate, the second waveguide substrate and the first waveguide substrate are disposed in a stacked manner, a third filling layer is disposed between the second waveguide substrate and the first optical waveguide substrate, and a difference between a refractive index of the third filling layer and the refractive index of air is less than or equal to 0.2.

95. The optical waveguide according to any one of claims 87 to 93, wherein the optical waveguide further comprises at least two second waveguide substrates, a third grating structure is disposed on each second waveguide substrate, the at least two second waveguide substrates are disposed in a stacked manner on a side that is of the first waveguide substrate and that is away from the first filling layer, third filling layers are respectively disposed between the second waveguide substrate and the first waveguide substrate and between adjacent second waveguide substrates, the third filling layer and the second waveguide substrate jointly surround the third grating structure, and a difference between a refractive index of the third filling layer and the refractive index of air is less than or equal to 0.2.

96. The optical waveguide according to any one of claims 87 to 90, wherein the optical waveguide further comprises a second waveguide substrate, the second waveguide substrate and the first waveguide substrate are disposed in a stacked manner, a third grating structure is disposed on a surface of the second waveguide substrate, the third grating structure and the first grating structure are disposed opposite to each other, the first filling layer is filled between the first waveguide substrate and the second waveguide substrate, and the first filling layer covers the second waveguide substrate and the third grating structure.

97. An optical waveguide, comprising a first waveguide substrate, a first grating structure, a waveguide filling structure, a third grating structure, and a first filling layer, wherein the first grating structure is formed on a surface of the first waveguide substrate, the waveguide filling structure wraps the first grating structure and covers the first waveguide substrate, the third grating structure is formed on a surface that is of the waveguide filling structure and that is away from the first waveguide substrate, the first filling layer covers the waveguide filling structure, the first filling layer and the waveguide filling structure jointly form a closed surrounding architecture, and the third grating structure is located in the surrounding architecture, so that the third grating structure is isolated from outside air, wherein a difference between a refractive index of the first filling layer and a refractive index of air is less than or equal to 0.2.

98. The optical waveguide according to claim 97, wherein a difference between a refractive index of the waveguide filling structure and a refractive index of the first waveguide substrate is between 0 and 0.5.

99. The optical waveguide according to claim 97 or 98, wherein the optical waveguide further comprises a first cover plate, and the first cover plate is located on a side that is of the first filling layer and that is away from the waveguide filling structure.

100.
The optical waveguide according to claim 99, wherein an edge of the waveguide filling structure is recessed relative to the first waveguide substrate, to reserve a position at the edge of the first waveguide substrate for disposing a dispensing structure, wherein the dispensing structure is fastened to the first cover plate and the first waveguide substrate.

101.
A near-eye display device, comprising an optical engine and the optical waveguide according to any one of claims 87 to 100, wherein the optical waveguide is located on a light exit side of the optical engine.

102.
A method for fabricating an optical waveguide, comprising:

providing a first cover plate, and coating a first filling material on the first cover plate, to form a first filling layer on the first cover plate;
providing a first waveguide substrate, wherein a first grating structure is disposed on the first waveguide substrate;
aligning the first cover plate and the first waveguide substrate, so that the first filling layer and the first waveguide substrate are combined and jointly enclose and surround the first grating structure; and
fastening the first cover plate to the first waveguide substrate, so that the first filling layer and the first waveguide substrate jointly form a closed surrounding architecture, the first grating structure is located in the surrounding architecture, and the first grating structure is isolated from outside air, wherein a difference between a refractive index of the first filling layer and a refractive index of air is less than or equal to 0.2.

103.
A method for fabricating an optical waveguide, comprising:

providing a first waveguide substrate, wherein a first grating structure is disposed on the first waveguide substrate;
providing a rigid mother mold, wherein the rigid mother mold has a grating mold structure, and the grating mold structure has a same form as the first grating structure;
performing hydrophobic processing on a surface that is of the rigid mother mold and that carries the grating mold structure and a surface of the grating mold structure;
coating a first filling material on the rigid mother mold, to form a first filling layer;
attaching a first cover plate to the first filling layer, so that the first cover plate and the first filling layer are combined together;
performing demolding, so that the first cover plate and the first filling layer are separated from the rigid mother mold;
aligning the first cover plate and the first waveguide substrate, so that the first filling layer and the first waveguide substrate jointly form a closed surrounding architecture, the first grating structure is located in the surrounding architecture, and the first grating structure is isolated from outside air, wherein a difference between a refractive index of the first filling layer and a refractive index of air is less than or equal to 0.2; and
fastening the first cover plate and the first waveguide substrate.

104.
A method for fabricating an optical waveguide, comprising:

providing an optical waveguide intermediate structure, wherein the optical waveguide intermediate structure comprises a first waveguide substrate, a first grating structure, and a first cover plate, the first grating structure is formed on a surface of the first waveguide substrate, the first cover plate and the first waveguide substrate are disposed in a stacked manner and are fastened, and a gap is formed between the first cover plate and the first waveguide substrate and between the first cover plate and the first grating structure;

providing an injection hole on the first cover plate; and

injecting a filling material through the injection hole to form a first filling layer, wherein the first filling layer and the first waveguide substrate jointly form a closed surrounding architecture, and the first grating structure is located in the surrounding architecture, so that the first grating structure is isolated from outside air, wherein a difference between a refractive index of the first filling layer and a refractive index of air is less than or equal to 0.2.

**105.**
A method for fabricating an optical waveguide, comprising:

providing a first waveguide substrate, wherein a first grating structure is disposed on the first waveguide substrate;

coating a filling material on a surface of the first waveguide substrate and a surface of the first grating structure to form a first filling layer, wherein the first filling layer and the first waveguide substrate jointly form a closed surrounding architecture, and the first grating structure is located in the surrounding architecture, so that the first grating structure is isolated from outside air, wherein a difference between a refractive index of the first filling layer and a refractive index of air is less than or equal to 0.2;

disposing a dispensing structure on an edge of the first filling layer and a surface of the first waveguide substrate; and

fastening a first cover plate to the dispensing structure, so that the first cover plate is fastened to the first waveguide structure.

**106.**
An optical waveguide, comprising a waveguide substrate and a grating structure, wherein the grating structure is combined with the waveguide substrate, the waveguide substrate comprises a first substrate layer and a second substrate layer, a refractive index of the first substrate layer is less than a refractive index of the second substrate layer, a difference between the refractive index of the second substrate layer and the refractive index of the first substrate layer is greater than or equal to 0.1, and a thickness of the second substrate layer is 50 microns to 300 microns; and the grating structure is located on a side that is of the second substrate layer and that is away from the first substrate layer, and/or the grating structure is located between the first substrate layer and the second substrate layer.

**107.**
The optical waveguide according to claim 106, wherein a material of the first substrate layer is glass, and the refractive index of the first substrate layer is less than or equal to 1.55.

**108.**
The optical waveguide according to claim 106 or 107, wherein the refractive index of the second substrate layer is greater than or equal to 1.65.

**109.**
The optical waveguide according to any one of claims 106 to 108, wherein the first substrate layer is configured to carry, in a process of fabricating the second substrate layer, a material for forming the second substrate layer, wherein the second substrate layer and the first substrate layer are combined into an integrated structure by using a fabrication process.

**110.**
The optical waveguide according to any one of claims 106 to 109, wherein groove-shaped microstructures are formed on a surface of the first substrate layer by using an etching process, and the second substrate layer is formed on the surface of the first substrate layer and is combined with the groove-shaped microstructures, to form at least a part of the grating structure.

**111.** The optical waveguide according to any one of claims 106 to 110, wherein a thickness of the waveguide substrate is less than 0.35 mm.

**112.**
The optical waveguide according to any one of claims 106 to 111, wherein a protection layer is disposed on a side that is of the second substrate layer and that is away from the first substrate layer.

**113.**
The optical waveguide according to any one of claims 106 to 112, wherein the optical waveguide comprises a functional region and an edge region, the edge region surrounds the functional region, the waveguide substrate and the grating structure are located in the functional region, a waveguide edge body is disposed in the edge region, the waveguide edge body is combined with an edge of the waveguide substrate, the waveguide edge body has light transmission, and density of the waveguide edge body is less than density of a material of the first waveguide substrate.

**114.**
The optical waveguide according to any one of claims 106 to 113, wherein the optical waveguide further comprises a wrapping layer, the wrapping layer fully or half wraps the waveguide substrate and the grating structure, an outer surface of the wrapping layer comprises a first surface, and the first surface is a curved surface, to correct different myopia degrees.

**115.**

A near-eye display device, comprising an optical engine and the optical waveguide according to any one of claims 106 to 114, wherein the optical waveguide is located on a light exit side of the optical engine.

**116.**

A method for fabricating an optical waveguide, comprising:

fabricating a first grating layer on a substrate layer, wherein the first grating layer has a first grating structure;

fabricating a second grating layer by using a grating structure mold, wherein the second grating layer is fabricated on a side that is of the first grating layer and that is away from the substrate layer, and the second grating layer has a second grating structure, and disposing an adhesion enhancement layer between the first grating layer and the second grating layer; and

removing the grating structure mold, so that the substrate layer, the first grating layer, the adhesion enhancement layer, and the second grating layer are combined to form an optical waveguide.

**117.**

The fabrication method according to claim 116, wherein the step of fabricating the second grating layer by using the grating structure mold comprises:

fabricating a medium layer on the first grating layer;

coating the adhesion enhancement layer on the medium layer;

coating a second imprint material layer on the adhesion enhancement layer; and

fabricating the second grating structure on the second imprint material layer by using the grating structure mold, to form the second grating layer.

**118.**

The fabrication method according to claim 117, wherein before the step of fabricating the second grating layer by using the grating structure mold, the fabrication method comprises: performing anti-sticking processing on a working surface of the grating structure mold, wherein in a process of fabricating the second grating layer on the second imprint material layer by using the grating structure mold, the working surface is in contact with the second imprint material layer.

**119.**

The fabrication method according to claim 117 or 118, wherein the step of fabricating a medium layer on the first grating layer comprises: forming the medium layer on the first grating layer by using a coating process.

**120.**

The fabrication method according to claim 119, wherein a material of the medium layer comprises an oxide or a nitride; and/or a refractive index of the medium layer is 1.8 to 2.3.

**121.**

The fabrication method according to claim 119, wherein the step of fabricating a medium layer on the first grating layer further comprises: performing surface processing on the medium layer by using a chemical-mechanical grinding process.

**122.**

The fabrication method according to any one of claims 117 to 121, wherein a refractive index of the second imprint material layer is 1.6 to 1.9, and/or a thickness of the second imprint material layer is 100 nm to 400 nm.

**123.**

The fabrication method according to any one of claims 116 to 122, wherein the step of fabricating the second grating layer by using the grating structure mold comprises:

providing the grating structure mold;

fabricating the second grating layer on the grating structure mold; and

bonding the second grating layer connected to the grating structure mold to the first grating layer by using the adhesion enhancement layer.

**124.**

The fabrication method according to claim 123, wherein the step of fabricating the second grating layer by using the grating structure mold comprises: first coating the adhesion enhancement layer on a surface that is of the second grating layer and that is away from the grating structure mold, and then bonding the first grating layer to the adhesion enhancement layer.

**125.**

The fabrication method according to claim 123 or 124, wherein the fabrication method further comprises: fabricating the medium layer on the first grating layer, and bonding the second grating layer connected to the grating structure mold to the medium layer by using the adhesion enhancement layer.

**126.**

The fabrication method according to claim 125, wherein a surface form of the medium layer is the same as a surface form of the first grating layer.

**127.**
The fabrication method according to claim 123 or 124, wherein in a process of bonding the second grating layer connected to the grating structure mold to the first grating layer by using the adhesion enhancement layer, the adhesion enhancement layer is in direct contact with the first grating layer.

**128.**
The fabrication method according to any one of claims 122 to 127, wherein before the step of fabricating the second grating layer on the grating structure mold, anti-sticking processing is performed on the working surface of the grating structure mold, and in a process of fabricating the second grating layer on the grating structure mold, the second grating layer is fabricated on the working surface.

**129.**
The fabrication method according to any one of claims 122 to 128, wherein the step of fabricating the first grating layer on the substrate layer comprises: coating a first imprint material layer on the substrate layer, and forming the first grating layer on the first imprint material layer by using a nano-imprinting process, wherein a force borne by the first imprint material in a process of forming the first grating layer is a first pressure, a force borne by the first grating layer and the second grating layer in a process of bonding the second grating layer connected to the grating structure mold to the first grating layer by using the adhesion enhancement layer is a second pressure, and the second pressure is less than or equal to the first pressure.

**130.**
An optical waveguide, comprising:

a substrate layer;
a first grating layer, disposed in a stacked manner with the substrate layer, wherein the first grating layer has a first grating structure; and
a second grating layer, disposed in a stacked manner on a side that is of the first grating layer and that is away from the substrate layer, wherein the second grating layer has a second grating structure, wherein
there is an adhesion enhancement layer between the first grating layer and the second grating layer.

**131.**
A near-eye display device, comprising an optical engine and the optical waveguide according to claim 130, wherein the optical waveguide is located on a light exit side of the optical engine.

**132.**
An optical waveguide, used in a near-eye display device, wherein the optical waveguide comprises an optical waveguide body, a first anti-reflection layer, a filling body layer, a second anti-reflection layer, and a surface protection layer that are sequentially disposed in a stacked manner, the first anti-reflection layer is located between the optical waveguide body and the filling body layer, and a difference between a refractive index of the filling body layer and a refractive index of air is within a first preset range; and the second anti-reflection layer is located between the filling body layer and the surface protection layer, a refractive index of the second anti-reflection layer exhibits a gradient change trend, a difference between a refractive index of a part that is of the second anti-reflection layer and that is adjacent to the filling body layer and the refractive index of the filling body layer is within a second preset range, and a difference between a refractive index of a part that is of the second anti-reflection layer and that is close to the surface protection layer and a refractive index of the surface protection layer is within a third preset range.

**133.**
The optical waveguide according to claim 132, wherein the optical waveguide meets any one or a combination of the following conditions:

the first preset range is a range less than or equal to 0.25;
the second preset range is a range less than or equal to 0.1; or
the third preset range is a range less than or equal to 0.1.

**134.**
The optical waveguide according to claim 132 or 133, wherein the difference between the refractive index of the filling body layer and the refractive index of air is between 0.1 and 0.25, and/or a thickness of the filling body layer is 30 $\mu$m to 50 $\mu$m.

**135.**
The optical waveguide according to any one of claims 132 to 134, wherein the filling body layer comprises a substrate and a refraction medium, and the refraction medium is dispersed in the substrate.

**136.**
The optical waveguide according to claim 135, wherein the resin particle is of an internal hollow structure.

**137.**
The optical waveguide according to any one of claims 132 to 134, wherein the filling body layer is an aerogel.

**138.**
The optical waveguide according to any one of claims 132 to 137, wherein the second anti-reflection layer comprises a plurality of second anti-reflection sublayers disposed in a stacked manner, and a difference between refractive indexes of any two adjacent second anti-reflection sublayers is within a preset range.

**139.**
The optical waveguide according to claim 138, wherein in a direction from the optical waveguide body to the surface protection layer, refractive indexes of the plurality of second anti-reflection sublayers increase along a gradient.

**140.**
The optical waveguide according to claim 138 or 139, wherein the second anti-reflection layer and the filling body layer are made of a same material but have different density; and/or the second anti-reflection layer and the filling body layer are formed by using a same fabrication process.

**141.**
The optical waveguide according to any one of claims 132 to 140, wherein the first anti-reflection layer is formed on a surface of the optical waveguide body through coating.

**142.**
A near-eye display device, comprising the optical waveguide according to any one of claims 132 to 141.

**143.**
A method for preparing an optical waveguide, comprising:

fabricating a first anti-reflection layer on an optical waveguide body, so that the first anti-reflection layer and the optical waveguide body are disposed in a stacked manner;
fabricating a filling body layer on a side that is of the first anti-reflection layer and that is away from the optical waveguide body;
fabricating a second anti-reflection layer on a side that is of the filling body layer and that is away from the first anti-reflection layer, wherein a refractive index of the second anti-reflection layer exhibits a gradient change trend; and
fabricating a surface protection layer on a side that is of the second anti-reflection layer and that is away from the filling body layer.

**144.**
The preparation method according to claim 143, wherein the step of fabricating a second anti-reflection layer on a side that is of the filling body layer and that is away from the first anti-reflection layer comprises:
fabricating, on the side that is of the filling body layer and that is away from the first anti-reflection layer, a plurality of second anti-reflection sublayers disposed in a stacked manner, wherein in a direction from the optical waveguide body to the surface protection layer, refractive indexes of the plurality of second anti-reflection sublayers increase along a gradient.

**145.**
The preparation method according to claim 144, wherein the step of fabricating, on the side that is of the filling body layer and that is away from the first anti-reflection layer, a plurality of second anti-reflection sublayers disposed in a stacked manner comprises:

adding a refraction medium to a substrate material, and mixing them evenly to obtain a filling body material;
mixing the filling body material and the substrate material based on a preset ratio to obtain a plurality of groups of second anti-reflection materials, wherein the plurality of groups of second anti-reflection materials have different refractive indexes; and
sequentially coating and curing the plurality of groups of second anti-reflection materials on the filling body layer, to obtain the plurality of second anti-reflection sublayers disposed in a stacked manner.

**146.**
The preparation method according to claim 144, wherein the step of fabricating, on the side that is of the filling body layer and that is away from the first anti-reflection layer, a plurality of second anti-reflection sublayers disposed in a stacked manner comprises:

adding a silicon source material to a solvent to obtain a plurality of groups of second anti-reflection materials, wherein the plurality of groups of second anti-reflection materials have different volume ratios of the silicon source material to the solvent; and
sequentially coating and curing the plurality of groups of second anti-reflection materials on the filling body layer, to obtain the plurality of second anti-reflection sublayers disposed in a stacked manner.

**147.**
An optical waveguide, used in a near-eye display device, and comprising a first waveguide substrate and a first grating structure formed on a surface of the first waveguide substrate, wherein the first waveguide substrate is used for total internal reflection of an optical path, both the first waveguide substrate and the first grating structure are flexible, and the optical waveguide has a deformable characteristic, so that the optical waveguide is capable of adapting to different-curvature lenses of the near-eye display device.

**148.**

The optical waveguide according to claim 147, wherein a refractive index of the first waveguide substrate is greater than or equal to 1.6, and a thickness of the first waveguide substrate is less than 300 $\mu$m.

**149.**

The optical waveguide according to claim 147, wherein a material of the first waveguide substrate is flexible glass or a flexible optical resin material.

**150.**

The optical waveguide according to any one of claims 147 to 149, wherein the first grating structure is integrally formed in the first waveguide substrate.

**151.**

The optical waveguide according to any one of claims 147 to 150, wherein the optical waveguide further comprises a first modulation layer, the first modulation layer and the first waveguide substrate are disposed in a stacked manner, a part of the first modulation layer is filled in the first grating structure, and a difference between a refractive index of the first modulation layer and a refractive index of the first grating structure is greater than or equal to 0.1.

**152.**

The optical waveguide according to claim 151, wherein the refractive index of the first modulation layer is less than the refractive index of the first grating structure; or the refractive index of the first modulation layer is greater than the refractive index of the first grating structure.

**153.**

The optical waveguide according to claim 151 or 152, wherein a first auxiliary grating structure is disposed on a surface that is of the first modulation layer and that is away from the first grating structure, and the first auxiliary grating structure is configured to modulate a light ray.

**154.**

The optical waveguide according to any one of claims 147 to 153, wherein the optical waveguide further comprises a second grating structure, and the first grating structure and the second grating structure are respectively located on two opposite sides of the first waveguide substrate.

**155.**

The optical waveguide according to any one of claims 147 to 154, wherein the optical waveguide further comprises a second waveguide substrate, an optical limiting layer, and a third grating structure, the second waveguide substrate is used for total internal reflection of the optical path, the second waveguide substrate is flexible, the optical limiting layer is disposed between the first waveguide substrate and the second waveguide substrate in a stacked manner, the optical limiting layer is also flexible and is transparent, a refractive index of the optical limiting layer is less than the refractive index of the first waveguide substrate and is also less than a refractive index of the second waveguide substrate, the optical limiting layer is configured to ensure total internal reflection of the first waveguide substrate and total internal reflection of the second waveguide substrate, and the third grating structure is formed on the second waveguide substrate.

**156.**

The optical waveguide according to any one of claims 147 to 155, wherein the optical waveguide further comprises a flexible substrate layer, the flexible substrate layer is disposed in a stacked manner with the first waveguide substrate, and is located on a side that is of the first waveguide substrate and that is away from the first grating structure, the flexible substrate layer is transparent and has a refractive index less than the refractive index of the first waveguide substrate, and the flexible substrate layer is configured to be attached to a lens of the near-eye display device.

**157.**

A method for fabricating an optical waveguide, wherein the fabrication method is used to fabricate the optical waveguide according to any one of claims 147 to 156, and the fabrication method comprises:

> providing a rigid substrate, wherein the rigid substrate comprises a fabrication plane;
> forming a sacrificial layer on the fabrication plane;
> fabricating the optical waveguide on the sacrificial layer; and
> dissolving the sacrificial layer to obtain the optical waveguide.

**158.**

The method for fabricating an optical waveguide according to claim 157, wherein the step of fabricating the optical waveguide on the sacrificial layer comprises:

> disposing a first waveguide substrate on the sacrificial layer, wherein a refractive index of the first waveguide substrate is greater than or equal to 1.6, and a thickness of the first waveguide substrate is less than 300 $\mu$m; and
> fabricating a first grating structure on the first waveguide substrate.

**159.**

The method for fabricating an optical waveguide according to claim 157, wherein the step of fabricating the optical waveguide on the sacrificial layer comprises:

> providing an optical waveguide intermediate structure, wherein the optical waveguide intermediate structure is flexible and comprises a first waveguide substrate and a first grating structure formed on a surface of the first waveguide substrate;

disposing the optical waveguide intermediate structure on the sacrificial layer, wherein the first grating structure is in full contact with the sacrificial layer; and

fabricating a second grating structure on a side that is of the first waveguide substrate and that is away from the first grating structure.

**160.**

The method for fabricating an optical waveguide according to claim 157, wherein the step of fabricating the optical waveguide on the sacrificial layer comprises:

disposing a first waveguide substrate on the sacrificial layer, wherein the first waveguide substrate is used for total internal reflection of an optical path, and the first waveguide substrate is flexible;

fabricating a first grating structure on the first waveguide substrate;

forming an optical limiting layer on the first grating structure, wherein the optical limiting layer is also flexible and is transparent, and a refractive index of the optical limiting layer is less than a refractive index of the first waveguide substrate;

fabricating a second waveguide substrate on the optical limiting layer, wherein the second waveguide substrate is used for total internal reflection of an optical path, and the second waveguide substrate is flexible; and

fabricating a third grating structure on the second waveguide substrate.

**161.**

A near-eye display device, comprising lenses and the optical waveguide according to any one of claims 147 to 156, wherein the lens comprises a curved surface part, and the optical waveguide is attached to a surface layer or an intermediate layer of the curved surface part of the lens.

1000

FIG. 1

1000

FIG. 2

1000

FIG. 3

FIG. 4

FIG. 5

FIG. 6

FIG. 7

FIG. 8

FIG. 9

FIG. 10A

FIG. 10B

FIG. 10C

FIG. 11

FIG. 12

FIG. 13

FIG. 14

FIG. 15

FIG. 16

FIG. 17

FIG. 18

<u>20</u>

FIG. 19

FIG. 20

213

S3

216

S1

S4

S2

S5

215

214

211

212

FIG. 21

200

FIG. 22

FIG. 23

FIG. 24A

FIG. 24B

23

21   22

Oblique surface
reflected light ray  191

11

23P

B1

19

In-coupling grating
reflected light ray

190

190

10A {
13
12
11
19

Incident edge light ray

β1   β2

23P

In-coupling grating
reflected light ray

FIG. 25A

Oblique surface
reflected light ray

191

11

23P

B2

21

22

23

β 3

19

190

190

In-coupling grating
reflected light ray

13
12
10A
11
19

FIG. 25B

FIG. 26A

In-coupling grating
reflected light ray

FIG. 26B

23

21  22

Oblique surface
reflected light ray  191

11

23P

B1

190

In-coupling grating
reflected light ray

193

19  192

Incident edge light ray

β1  β2

23P

In-coupling grating
reflected light ray

13
12
11
19

10A

FIG. 27A

Oblique surface reflected light ray

In-coupling grating reflected light ray

FIG. 27B

FIG. 28

FIG. 29

10A

FIG. 30

A light ray entering a two-dimensional grating is
divided into eight propagation directions

FIG. 31

Low out-
coupling
efficiency

High out-coupling
efficiency

Simulation diagram of light out-coupling
efficiency of a two-dimensional grating

FIG. 32

10A

FIG. 33

10A

FIG. 34

10A

FIG. 35

10A

FIG. 36

10A

FIG. 37

10A

FIG. 38

10A

FIG. 39

10A

FIG. 40

<u>10A</u>

FIG. 41

<u>10A</u>

FIG. 42A

10A

FIG. 42B

FIG. 43

FIG. 44

A

B

Crystalline
lens

Eyeball

A'

Retina

B'

FIG. 45

A

B

→

A'

Retina

B'

FIG. 46

FIG. 47

12

FIG. 48

FIG. 49A

FIG. 49B

FIG. 50

FIG. 51

FIG. 52

FIG. 53

FIG. 54

FIG. 55

FIG. 56

1000

FIG. 57

FIG. 58

12

FIG. 59

FIG. 60

FIG. 61

FIG. 62

FIG. 63

FIG. 64

FIG. 65

FIG. 66

FIG. 67

FIG. 68

FIG. 69

FIG. 70

10A

FIG. 71

10A

FIG. 72

FIG. 73

FIG. 74

10A

FIG. 75

FIG. 76

FIG. 77

FIG. 78

FIG. 79

FIG. 80

FIG. 81

FIG. 82

1st exposure: Angle 1    2nd exposure: Angle 2    3rd exposure: Angle 3

FIG. 83

10A

FIG. 84

FIG. 85

FIG. 86

FIG. 87

FIG. 88

10A

FIG. 89

FIG. 90

FIG. 91

FIG. 92

FIG. 93

10A

11
19S
16
12

19

FIG. 94

FIG. 95

Provide a substrate

⇓

Dispose a material layer on a surface of the substrate

⇓

Perform pre-processing on the substrate having the material layer

⇓

Perform a dual-beam exposure process

⇓

Perform curing for formation

FIG. 96

$n_1$ $n_2$

Dual-
beam
exposure →

Phase
separation →

〜 Monomer    ● Polymer and nanoparticle

FIG. 97

FIG. 98

FIG. 99

FIG. 100

FIG. 101

FIG. 102

FIG. 103

FIG. 104

FIG. 105

FIG. 106A

10A

14S1

19S1

154

15S3

14S3

19S2

FIG. 106B

10A

154

14S3

15A

15S1

154

19S3

14S1

19S1

FIG. 106C

FIG. 107

FIG. 108

FIG. 109

FIG. 110

FIG. 111

FIG. 112

FIG. 113

210

10A

FIG. 114

10A

FIG. 115

10A

FIG. 116

10A

FIG. 117

FIG. 118A

FIG. 118B

FIG. 118C

FIG. 119

10A

FIG. 120

10A

FIG. 121

10A

FIG. 122

10A

FIG. 123

10A      A-A

19D

19E1    14    19E1

19E2   19E   196   195   19E

19

FIG. 124

10A

B        B

19G

FIG. 125

10A       B-B

14     19G2

196

19

195

19G    19G1

FIG. 126

10A

B-B

19G2    14

196

19

195

19G   19G1

FIG. 127

10A

FIG. 128

10A

FIG. 129

FIG. 130

10A

14S2

A ———→                                                          ←——— B

19B0                                                            19B

114

115

19A0                                                            19A

14S1

114

19S

Y

X

FIG. 131

19A

14S1A        14S1B                    19A0

α   β

H1                                                        H3        Y

14S1                L1

X

FIG. 132

19A

14S1A            14S1B          19A0

H1                                                        H3

L1

FIG. 133

19B

14S2

14S2A L2 D2

19B0 H2 Y

H4

FIG. 134

19B

14S2

14S2A

19B0

14S2

FIG. 135

19B

19B0 14S2A 14S2

FIG. 136

10A

14S2

14S2

19B

19A

114

19S

114

115

14S1

FIG. 137

10A

14S2

19B

114

19A
114

115

19S

14S1

FIG. 138

10A

14S2

14S2

19B

19A
114

114

19S

115

14S1

FIG. 139

S1 — Fabricate a first grating layer on a substrate layer, so that the first grating layer and the substrate layer are disposed in a stacked manner

S2 — Fabricate a second grating layer by using a grating structure mold, where the second grating layer is fabricated on a side that is of the first grating layer and that is away from the substrate layer, and there is an adhesion enhancement layer between the first grating layer and the second grating layer

S3 — Remove the grating structure mold

FIG. 140

FIG. 141

FIG. 142

FIG. 143

FIG. 144

413

14S2

113S

114

14S1
19A
114
19S

FIG. 145

20

11

10A

12

Eye

FIG. 146

10A

115

114

113

112

111

FIG. 147

10A

1151

115

1142

114

1141

1132

113

1131

1122

112

1121

1112

111

1111

FIG. 148

113

113B

113A

Resin shell

Air core

FIG. 149

113

Aerogel

FIG. 150

114

114A

...

FIG. 151

114

FIG. 152

10A

FIG. 153

FIG. 154

FIG. 155

10A

FIG. 156

S1 — Fabricate a first anti-reflection layer on an optical waveguide body, so that the first anti-reflection layer and the optical waveguide body are disposed in a stacked manner

S2 — Fabricate a filling body layer on a side that is of the first anti-reflection layer and that is away from the optical waveguide body

S3 — Fabricate a second anti-reflection layer on a side that is of the filling body layer and that is away from the first anti-reflection layer, where a refractive index of the second anti-reflection layer exhibits a gradient change trend

S4 — Fabricate a cover plate on a side that is of the second anti-reflection layer and that is away from the filling body layer

FIG. 157

S21 — Add a refraction medium to a substrate material, and mix them evenly to obtain a filling body material

S22 — Coat the filling body material on a first anti-reflection layer by using a multi-time spin-coating method, roll coating with ultrasonic spraying, air spraying, or a Czochralski process

S23 — Cure the filling body material to obtain a body layer

FIG. 158

S211 — Add a refraction material to a dispersion liquid, and mix them evenly

S212 — Fabricate a refraction medium from the refraction material by using a spray granulation method, where a particle size of the refraction medium is 0.1 μm to 100 μm

FIG. 159

Fix, on a spin-coating base, an optical waveguide body on which a first anti-reflection layer is prepared

Dispose a filling body material on a side that is of the first anti-reflection layer and that faces away from the spin-coating base, and rotate the spin-coating base, so that the filling body material spreads uniformly

Perform UV irradiation, so that a catalyst is crosslinked with a functional group in a siloxane polymer, and the filling body material is cured to form a filling body layer

FIG. 160

S21'  Add a silicon source material to a solvent, and coat them on a first anti-reflection layer

S22'  Cure the silicon source material by using a two-step acid-base method and an alcohol supercritical drying method, to obtain a filling body layer

FIG. 161

Mix a silicon source and a solvent based on a specific volume ratio

Add an alkaline catalyst, so that hydrolysis and condensation of the silicon source can be performed, to obtain a silicon source material with fluidity

Place, on a spin-coating base, an optical waveguide body on which a first anti-reflection layer is prepared, and evenly coat the silicon source material on the first anti-reflection layer by rotating the spin-coating base

FIG. 162

S31 — Add a refraction medium to a substrate material, and mix them evenly to obtain a filling body material

S32 — Mix the filling body material and the substrate material based on a preset ratio to obtain a plurality of groups of second anti-reflection materials, where the plurality of groups of second anti-reflection materials have different refractive indexes

S33 — Sequentially coat and cure the plurality of groups of second anti-reflection materials on a filling body layer, to obtain a plurality of second anti-reflection sublayers disposed in a stacked manner

FIG. 163

Provide a plurality groups of filling body materials

Respectively add substrate materials of different mass to the plurality of groups of filling body materials

Perform thorough stirring to obtain a plurality of groups of anti-reflection materials with different refractive indexes

FIG. 164

S31' — Add a silicon source material to a solvent to obtain a plurality of groups of second anti-reflection materials, where the plurality of groups of second anti-reflection materials have different volume ratios of the silicon source material to the solvent

S32' — Sequentially coat and cure the plurality of groups of second anti-reflection materials on a filling body layer to obtain a plurality of second anti-reflection sublayers disposed in a stacked manner

FIG. 165

10A

14S1                                14S1

19S1

FIG. 166

10

10A

10

10A

FIG. 167

<u>10A</u>

14S1 —      19A      14S1

19S1

FIG. 168

<u>10A</u>

14S1    S11    14S1    12

11    14S2    19S1    S12    14S2

FIG. 169

<u>10A</u>

14S1    19A    14S1

14S2    19S1    14S2

FIG. 170

<u>10A</u>

14S1　　　19A　　　14S1

14S2　　19B　　19S1　　14S2

FIG. 171

<u>10A</u>

19M1

14S1　　19S1　　14S1

FIG. 172A

<u>10A</u>

19A　　19M1

14S1　　19S1　　14S1

FIG. 172B

10A

FIG. 173A

10A

FIG. 173B

10A

FIG. 173C

10A

FIG. 174A

10A

FIG. 174B

10A

FIG. 175A

10A

14S1    14M1    14S1    19M1
                          19A
                          19S1
                          19M2

14S2    14M2    14S2

FIG. 175B

10A

14S1    14M1    14S1    19M1
                          19A
                          19S1
                          19B
                          19M2

14S2    14M2    14S2

FIG. 175C

10A

FIG. 176A

10A

FIG. 176B

<u>10A</u>

FIG. 177

<u>10A</u>

FIG. 178A

10A

14S1    14M1    14S1    18M1

19A

19S1

19F

FIG. 178B

10A

14S3    19S2    14M3    19M3    14S3

19N

14S1    19M1    14M1    19S1    19F

FIG. 178C

FIG. 179A

FIG. 179B

14M1

19M1

14S3

19S2

19N

14S1

19S1

19X

19H

FIG. 180A

14M1

19M1

14S3

19S2

19N

14S2

19S1

14S1

19X

19H

FIG. 180B

## INTERNATIONAL SEARCH REPORT

| International application No. |
| --- |
| **PCT/CN2023/117571** |

**A. CLASSIFICATION OF SUBJECT MATTER**

G02B27/01(2006.01)i; G02B27/10(2006.01)i

According to International Patent Classification (IPC) or to both national classification and IPC

**B. FIELDS SEARCHED**

Minimum documentation searched (classification system followed by classification symbols)

IPC: G02B27 G02B5/04

Documentation searched other than minimum documentation to the extent that such documents are included in the fields searched

Electronic data base consulted during the international search (name of data base and, where practicable, search terms used)

CNABS, CNTXT: 合光, 合束, 合色, 第四, 第4, 棱镜, 分光, 分束, 分色, 半反半透, 部分, 反射, 透射 VEN, ENTXT, USTXT, WOTXT: combine, fourth, prism, split, semi, partial, reflect, transmission

**C. DOCUMENTS CONSIDERED TO BE RELEVANT**

| Category* | Citation of document, with indication, where appropriate, of the relevant passages | Relevant to claim No. |
| --- | --- | --- |
| X | CN 114879375 A (SINTAI OPTICAL (SHENZHEN) CO., LTD. et al.) 09 August 2022 (2022-08-09) <br> description, paragraphs 101-137, and figures 12A-14B | 1-14 |
| A | CN 105204171 A (YLX INCORPORATED) 30 December 2015 (2015-12-30) <br> entire document | 1-14 |
| A | JP H11281929 A (SONY CORP.) 15 October 1999 (1999-10-15) <br> entire document | 1-14 |
| A | CN 109387947 A (SHENZHEN LOCHN OPTICS TECHNOLOGY CO., LTD.) 26 February 2019 (2019-02-26) <br> entire document | 1-14 |
| A | CN 112180607 A (GUANGDONG OPPO MOBILE COMMUNICATIONS CO., LTD.) 05 January 2021 (2021-01-05) <br> entire document | 1-14 |

☐ Further documents are listed in the continuation of Box C. ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **21 November 2023** | **29 November 2023** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2023/117571**

**Box No. III    Observations where unity of invention is lacking (Continuation of item 3 of first sheet)**

This International Searching Authority found multiple inventions in this international application, as follows:

Claims 1-14 relate to a light combining unit comprising four prism units, an optical machine comprising the light combining unit, and a near-eye display device comprising the optical machine.

Claims 15-26 relate to an optical assembly comprising an optical waveguide having a bevel and a near-eye display device comprising the optical assembly.

Claims 27-41 relate to an optical waveguide comprising a coupling-out grating having a first region and a second region, and a near-eye display device comprising the optical waveguide.

Claims 42-54 relate to an optical waveguide comprising a coupling-out grating with a plurality of sub-gratings arranged at intervals, and a near-eye display device comprising the optical waveguide.

Claims 55-64 relate to an optical waveguide comprising a grating structure having a plurality of core structures and membrane structures, and a near-eye display device comprising the optical waveguide.

Claims 65-73 relate to an optical waveguide comprising a first grating layer, a second grating layer and a dielectric layer of which the refractive indexes are specific values, and a near-eye display device comprising the optical waveguide.

Claims 74-86 relate to an optical waveguide comprising an anti-reflection layer, and a near-eye display device comprising the optical waveguide.

Claims 87-105 relate to an optical waveguide comprising a filling layer of which the refractive index is a specific value, a near-eye display device comprising the optical waveguide, and a method for preparing the optical waveguide.

Claims 106-115 relate to an optical waveguide comprising a first substrate layer and a second substrate layer, and a near-eye display device comprising the optical waveguide.

Claims 116-131 relate to an optical waveguide comprising a tackifying layer, a preparation method for the optical waveguide, and a near-eye display device comprising the optical waveguide.

Claims 132-146 relate to an optical waveguide comprising a first anti-reflection layer and a second anti-reflection layer, and a near-eye display device comprising the optical waveguide and a preparation method therefor.

Claims 147-161 relate to an optical waveguide having a deformation characteristic, a preparation method for the optical waveguide, and a near-eye display device comprising the optical waveguide.

Form PCT/ISA/210 (continuation of first sheet) (July 2022)

**INTERNATIONAL SEARCH REPORT**

| International application No. |
| --- |
| **PCT/CN2023/117571** |

**Box No. III    Observations where unity of invention is lacking (Continuation of item 3 of first sheet)**

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☑ No required additional search fees were timely paid by the applicant. Consequently, this international search report is restricted to the invention first mentioned in the claims; it is covered by claims Nos.: **1-14**

**Remark on Protest**    ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (July 2022)

## INTERNATIONAL SEARCH REPORT
### Information on patent family members

| Patent document cited in search report | | | Publication date (day/month/year) | Patent family member(s) | | | Publication date (day/month/year) |
|---|---|---|---|---|---|---|---|
| CN | 114879375 | A | 09 August 2022 | CN | 114740585 | A | 12 July 2022 |
| | | | | US | 2022221729 | A1 | 14 July 2022 |
| CN | 105204171 | A | 30 December 2015 | CN | 105204171 | B | 01 February 2019 |
| | | | | CN | 203930219 | U | 05 November 2014 |
| JP | H11281929 | A | 15 October 1999 | | None | | |
| CN | 109387947 | A | 26 February 2019 | WO | 2020119003 | A1 | 18 June 2020 |
| | | | | CN | 209281084 | U | 20 August 2019 |
| CN | 112180607 | A | 05 January 2021 | CN | 213338223 | U | 01 June 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211092291

- CN 202211731720